# EUROPEAN PATENT SPECIFICATION

(11) **EP 4 123 737 B1**
(45) Date of publication and mention of the grant of the patent: **30.07.2025**
(21) Application number: 21772165.3
(22) Date of filing: 19.03.2021
(51) Int. Cl.: C09K 11/06, H10K 85/60, H10K 50/12, H10K 50/15

(54) **ORGANOELECTROLUMINESCENT DEVICE USING POLYCYCLIC AROMATIC COMPOUNDS**
ORGANOELEKTROLUMINESZENTE VORRICHTUNG MIT POLYCYCLISCHEN AROMATISCHEN VERBINDUNGEN
DISPOSITIF ÉLECTROLUMINESCENT ORGANIQUE UTILISANT DES COMPOSÉS AROMATIQUES POLYCYCLIQUES

(30) Priority: 19.03.2020 KR 20200033902
(43) Date of publication of application: 25.01.2023
(73) Proprietor: SFC Co., Ltd., Cheongju-si, Chungcheongbuk-do 28122 (KR)
(72) Inventor: LEE, Chun-young, Cheongju-si Chungcheongbuk-do 28122 (KR); SHIN, Yoo-na, Cheongju-si Chungcheongbuk-do 28122 (KR); KIM, Tae-young, Cheongju-si Chungcheongbuk-do 28122 (KR); KIM, Sung-woo, Cheongju-si Chungcheongbuk-do 28122 (KR); LEE, Ji-won, Cheongju-si Chungcheongbuk-do 28122 (KR)
(74) Representative: Grosse, Felix Christopher
(86) International application number: PCT/KR2021/003433
(87) International publication number: WO 2021/187947

(56) References cited:
- CN-A- 107 573 925
- KR-A- 20170 056 422
- KR-A- 20190 101 900
- KR-A- 20190 101 900
- KR-A- 20200 026 080
- KR-A- 20200 026 080
- US-A1- 2018 301 629

## Description

### Technical Field

The present invention relates to a highly efficient organic light-emitting device that exhibits remarkably improved luminous efficacy using a polycyclic aromatic derivative compound in an organic layer therein.

### Background Art

An organic light-emitting device is a self-luminous device that emits light when energy is released from excitons which are formed by recombination of electrons injected from an electron injection electrode (cathode) and holes injected from a hole injection electrode (anode) in a light-emitting layer. Such an organic light-emitting device attracts a great deal of attention as a next-generation light source due to applicability to full-color flat panel light-emitting displays based on advantages such as low driving voltage, high luminance, wide viewing angle, and rapid response speed thereof.

In order for the organic light-emitting device to exhibit the characteristics, the structure of the organic layer in the organic light-emitting device should be optimized, and the material constituting each organic layer, namely, a hole injection material, a hole transport material, a light-emitting material, an electron transport material, an electron injection material, or an electron blocking material should be based on stable and efficient ingredients. However, there is a continuing need to develop organic layer structures and respective materials thereof for stable and efficient organic light-emitting devices.

As such, there is a continuing need for the development of the structure of an organic light-emitting device capable of improving the luminous characteristics thereof and the development of novel materials supporting the structure.

KR20200026080 and KR20190101900 disclose OLEDs comprising a hole-injection layer, a hole-transport layer and a light-emitting layer.

### Technical Problem

Therefore, the present invention has been made in view of the above problems, and it is one object of the present invention to provide a highly efficient organic light-emitting device that can be operated at a low voltage and exhibits excellent external quantum efficiency based on compounds used for a light-emitting layer and compounds for a hole transport layer or a hole injection layer.

### Technical Solution

In accordance with the present invention, the above and other objects can be accomplished by the provision of an organic light-emitting device including a first electrode, a second electrode facing the first electrode, and a hole injection layer or a hole transport layer and a light-emitting layer interposed between the first electrode and the second electrode.

The organic light-emitting device according to the present invention includes (i) at least one compound represented by the following [Formula A] or [Formula B] in the hole injection layer or the hole transport layer, and (ii) a compound represented by the following [Formula C] or [Formula D] in the light-emitting layer. 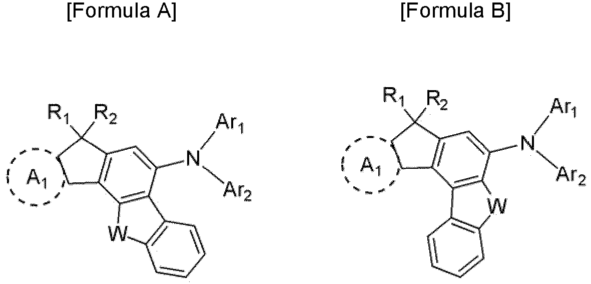 wherein at least one of Ar₁ and Ar₂ is represented by the following [Structural Formula 1]:

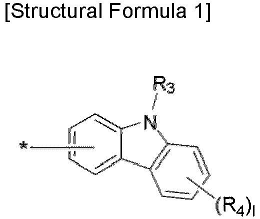

Specific structures of [Formula A] and [Formula B], the compounds obtained thereby, and definitions of A₁, R₁ to R₃ and Ar₁ to Ar₂ will be described later.

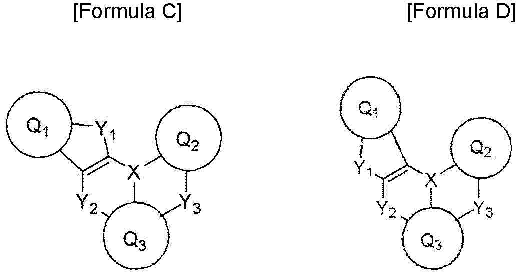

Specific structures of [Formula C] to [Formula D], the compounds obtained thereby, and substituents thereof will be described later.

### Advantageous Effects

The organic light-emitting device according to the present invention can be operated at a lower driving voltage, and exhibits excellent external quantum efficiency and thus high luminous efficacy by utilizing the compounds having characteristic structures as the hole transport material and the dopant material, respectively, in the hole injection layer or the hole transport layer, and the light-emitting layer.

Hereinafter, the present invention will be described in detail with reference to the annexed drawings.

In one aspect, the present invention is directed to an organic light-emitting device including a first electrode, a second electrode facing the first electrode, and a hole injection layer or a hole transport layer and a light-emitting layer interposed between the first electrode and the second electrode, wherein (i) the hole injection layer or the hole transport layer includes at least one compound represented by the following [Formula A] or [Formula B] and (ii) the light-emitting layer includes a compound represented by the following [Formula C] or [Formula D]. Based on this configuration, a highly efficient organic light-emitting device can be obtained. 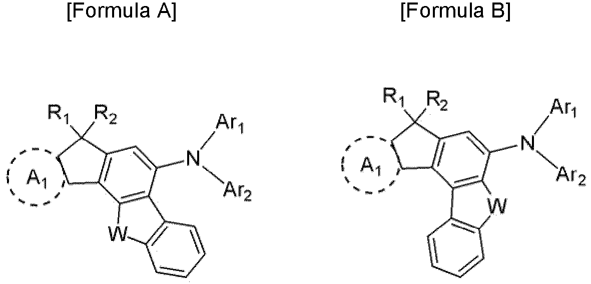 wherein
A₁ is selected from a substituted or unsubstituted C6-C30 aryl group, and a substituted or unsubstituted C2-C50 heteroaryl group,
W is an oxygen atom (O) or a sulfur atom (S),
R₁ and R₂ are identical to or different from each other, and are each independently selected from hydrogen, deuterium, a substituted or unsubstituted C1-C30 alkyl group, a substituted or unsubstituted C3-C30 cycloalkyl group, a substituted or unsubstituted C6-C50 aryl group, and a substituted or unsubstituted C2-C50 heteroaryl group, with the proviso that R₁ and R₂ are optionally bonded to each other to form an alicyclic or aromatic monocyclic or polycyclic ring, Ar₁ and Ar₂ are identical to or different from each other, and are each independently a substituted or unsubstituted C6-C50 aryl group, and a substituted or unsubstituted C2-C50 heteroaryl group, with the proviso that at least one of Ar₁ and Ar₂ is represented by the following Structural Formula 1: 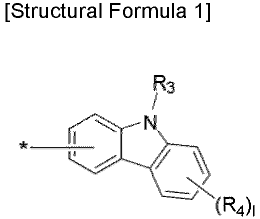
wherein
R₃ is selected from hydrogen, deuterium, a substituted or unsubstituted C1-C30 alkyl group, a substituted or unsubstituted C3-C30 cycloalkyl group, a substituted or unsubstituted C6-C50 aryl group, and a substituted or unsubstituted C2-C50 heteroaryl group,
R₄ is selected from hydrogen, deuterium, a cyano group, a halogen group, a hydroxyl group, a nitro group, a C1-C24 alkyl group, a C1-C24 halogenated alkyl group, a C1-C24 cycloalkyl group, a C1-C24 alkenyl group, a C1-C24 alkynyl group, a C1-C24 heteroalkyl group, a C6-C30 aryl group, a C6-C30 arylalkyl group, a C2-C30 heteroaryl group, a C2-C30 heteroarylalkyl group, a C1-C24 alkoxy group, a C1-C24 alkylamino group, a C6-C30 arylamino group, a C2-C30 heteroarylamino group, a C1-C24 alkylsilyl group, a C6-C30 arylsilyl group, and a C6-C30 aryloxy group,
I is an integer from 0 to 4, provided that when I is 2 or more, R₄'s are identical to or different from each other, and
"-*" means a site bonding to a nitrogen atom at the positions Ar₁ and Ar₂ in [Formula A] or [Formula B].

According to an embodiment of the present invention, R₁ and R₂ are each independently selected from a substituted or unsubstituted C1-C30 alkyl group, a substituted or unsubstituted C3-C30 cycloalkyl group, a substituted or unsubstituted C6-C50 aryl group, and a substituted or unsubstituted C2-C50 heteroaryl group.

In addition, when R₁ and R₂ are bonded to each other to form a ring, a compound represented by the following [Structural Formula 2] may be obtained: 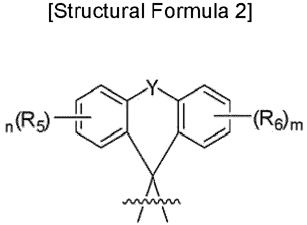 wherein
Y is a single bond, an oxygen atom (O) or a sulfur atom (S),
R₅ and R₆ are selected from hydrogen, deuterium, a cyano group, a halogen group, a hydroxyl group, a nitro group, a C1-C24 alkyl group, a C1-C24 halogenated alkyl group, a C1-C24 cycloalkyl group, a C1-C24 alkenyl group, a C1-C24 alkynyl group, a C1-C24 heteroalkyl group, a C6-C30 aryl group, a C6-C30 arylalkyl group, a C2-30 heteroaryl group, a C2-C30 heteroarylalkyl group, a C1-C24 alkoxy group, a C1-C24 alkylamino group, a C6-C30 arylamino group, a C2-30 heteroarylamino group, a C1-C24 alkylsilyl group, a C6-C30 arylsilyl group and a C6-C30 aryloxy group, n and m are each an integer from 0 to 4, with the proviso that, when n and m are each 2 or more, R₅'s and R₆'s are identical to or different from each other.

According to an embodiment of the present invention, A₁ may be represented by the following [Structural Formula 3]: 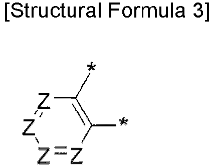 wherein
Z is N or CR, wherein R is selected from hydrogen, deuterium, a substituted or unsubstituted C1-C30 alkyl group, a substituted or unsubstituted C6-C50 aryl group, a substituted or unsubstituted C3-C30 cycloalkyl group, a substituted or unsubstituted C2-C50 heteroaryl group, a substituted or unsubstituted C1-C30 alkoxy group, a substituted or unsubstituted C6-C30 aryloxy group, a substituted or unsubstituted C1-C30 alkylthioxy group, a substituted or unsubstituted C5-C30 arylthioxy group, a substituted or unsubstituted C1-C30 alkylamine group, a substituted or unsubstituted C5-C30 arylamine group, a substituted or unsubstituted C1-C30 alkylsilyl group, a substituted or unsubstituted C5-C30 arylsilyl group, a nitro group, a cyano group, and a halogen group, and
R's are optionally bonded to each other or each thereof is optionally bonded to an adjacent substituent to form at least one alicyclic or aromatic monocyclic or polycyclic ring, and the carbon atom of the formed alicyclic, aromatic monocyclic or polycyclic ring is substituted with at least one heteroatom selected from (N), a sulfur atom (S), and an oxygen atom (O). 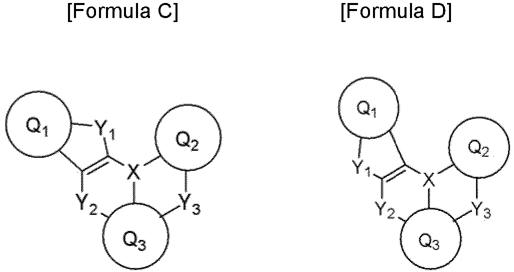
wherein
Q₁ to Q₃ are identical to or different from each other, and are each independently a substituted or unsubstituted aromatic C6-C50 hydrocarbon ring, or a substituted or unsubstituted C2-C50 aromatic heterocyclic group,
Y₁ to Y₃ are identical to or different from each other, and are each independently selected from N-R₁, CR₂R₃, O, S, Se, and SiR₄R₅,
X is selected from B, P and P=O and, in a preferred embodiment of the present invention, X is B, and in this case, a polycyclic aromatic derivative compound containing boron (B) is structurally used as a dopant in the light-emitting layer of a device to impart high efficiency to the organic light-emitting device, and
R₁ to R₅ are identical to or different from each other, and are each independently hydrogen, deuterium, a substituted or unsubstituted C1-C30 alkyl group, a substituted or unsubstituted C6-C50 aryl group, a substituted or unsubstituted C3-C30 cycloalkyl group, a substituted or unsubstituted C2-C50 heteroaryl group, a substituted or unsubstituted C1-C30 alkoxy group, a substituted or unsubstituted C6-C30 aryloxy group, a substituted or unsubstituted C1-C30 alkylthioxy group, a substituted or unsubstituted C5-C30 arylthioxy group, a substituted or unsubstituted C1-C30 alkylamine group, a substituted or unsubstituted C5-C30 arylamine group, a substituted or unsubstituted C1-C30 alkylsilyl group, a substituted or unsubstituted C5-C30 arylsilyl group, a nitro group, a cyano group, and a halogen group,
with the proviso that each of R₁ to R₅ is optionally bonded to the ring Q₁ to Q₃ to further form an alicyclic or aromatic monocyclic or polycyclic ring, and R₂ and R₃, and R₄ and R₅ are optionally bonded to each other to further form an alicyclic or aromatic monocyclic or polycyclic ring.

According to an embodiment of the present invention, [Formula C] or [Formula D] may form a skeleton structure such as the following [Formula C-1] to [Formula C-3], [Formula D-1] and [Formula D-2], in particular, various polycyclic aromatic skeleton structures. A highly efficient organic light-emitting device can be realized by satisfying the characteristics required for the compounds for light-emitting layers of organic light-emitting devices based thereon. 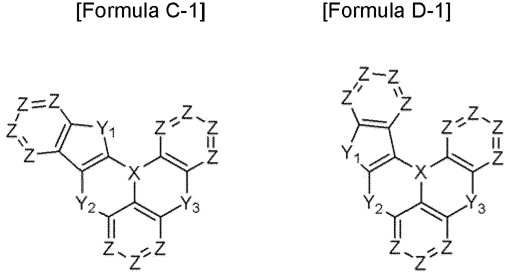 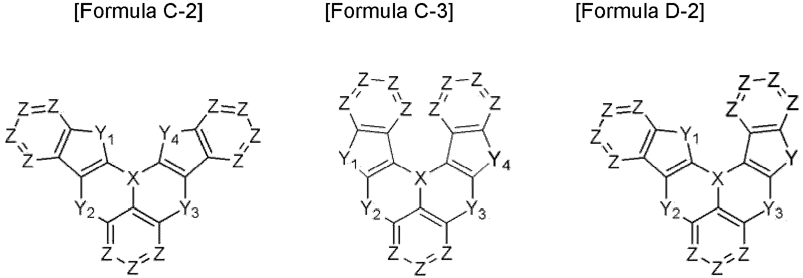 wherein
Z is CR or N, wherein R's are identical to or different from each other and are each independently selected from hydrogen, deuterium, a substituted or unsubstituted C1-C30 alkyl group, a substituted or unsubstituted C6-C50 aryl group, a substituted or unsubstituted C3-C30 cycloalkyl group, a substituted or unsubstituted C2-C50 heteroaryl group, a substituted or unsubstituted C1-C30 alkoxy group, a substituted or unsubstituted C6-C30 aryloxy group, a substituted or unsubstituted C1-C30 alkylthioxy group, a substituted or unsubstituted C6-C30 arylthioxy group, a substituted or unsubstituted C1-C30 alkylsilyl group, a substituted or unsubstituted C6-C30 arylsilyl group, a nitro group, a cyano group, a halogen group and -N(R₆)(R₇).

In an embodiment of the present invention, at least one of R's is -N(R₆)(R₇).

Also, R's are optionally bonded to each other or each thereof is optionally bonded to an adjacent substituent to form at least one alicyclic or aromatic monocyclic or polycyclic ring, and the carbon atom of the formed alicyclic, aromatic monocyclic or polycyclic ring is substituted with at least one heteroatom selected from (N), a sulfur atom (S), and an oxygen atom (O).

R₆ and R₇ are identical to or different from each other, and are each independently selected from hydrogen, deuterium, a substituted or unsubstituted C1-C30 alkyl group, a substituted or unsubstituted C6-C50 aryl group, a substituted or unsubstituted C3-C30 cycloalkyl group, and a substituted or unsubstituted C2-C50 heteroaryl group, with the proviso that R₆ and R₇ are optionally bonded to each other to form an alicyclic or aromatic monocyclic or polycyclic ring.

X and Y₁ to Y₄ are as defined in X and Y₁ to Y₃ [Formula C] and [Formula D].

Meanwhile, as used herein, the term "substituted" indicates substitution of various substituents defined in [Formula A] to [Formula D] with one or more substituents selected from deuterium, a cyano group, a halogen group, a hydroxyl group, a nitro group, an alkyl group, a halogenated alkyl group, a cycloalkyl group, an alkenyl group, an alkynyl group, a heteroalkyl group, an aryl group, an arylalkyl group, an alkylaryl group, a heteroaryl group, a heteroarylalkyl group, an alkoxy group, an amine group, a silyl group, an aryloxy group and a mixed aliphatic-aromatic ring group, or substitution with a substituent including two or more of the substituents linked to each other. The term "unsubstituted" in the same definition indicates having no substituent.

In addition, the range of the number of the carbon atoms of the alkyl group or aryl group in the term "substituted or unsubstituted C1-C30 alkyl group", "substituted or unsubstituted C6-C50 aryl group" or the like refers to the total number of carbon atoms constituting the alkyl or aryl moiety when the corresponding group is not substituted without considering the number of carbon atoms in the substituent(s). For example, a phenyl group substituted at the para position with a butyl group corresponds to an aryl group having 6 carbon atoms substituted with a butyl group having 4 carbon atoms.

In addition, as used herein, the expression "a substituent is bonded to an adjacent substituent to form a ring" means that the corresponding substituent is bonded to the adjacent substituent to form a substituted or unsubstituted alicyclic or aromatic ring, and the term "adjacent substituent" may mean a substituent substituted for an atom which is directly attached to an atom substituted with the corresponding substituent, a substituent sterically disposed at the nearest position to the corresponding substituent, or another substituent substituted for an atom which is substituted with the corresponding substituent. For example, two substituents substituted at the ortho position in a benzene ring and two substituents substituted at the same carbon in the aliphatic ring may be considered "adjacent" to each other.

As used herein, the alkyl group may be a linear or branched alkyl group. Examples of the alkyl group include, but are not limited to, a methyl group, an ethyl group, a propyl group, an n-propyl group, an isopropyl group, a butyl group, an n-butyl group, an isobutyl group, a tert-butyl group, a sec-butyl group, a 1-methylbutyl group, a 1-ethylbutyl group, a pentyl group, an n-pentyl group, an isopentyl group, a neopentyl group, a tert-pentyl group, a hexyl group, an n-hexyl group, a 1-methylpentyl group, a 2-methylpentyl group, a 4-methyl-2-pentyl group, a 3,3-dimethylbutyl group, a 2-ethylbutyl group, a heptyl group, an n-heptyl group, a 1-methylhexyl group, a cyclopentylmethyl group, a cyclohexylmethyl group, an octyl group, an n-octyl group, a tert-octyl group, a 1-methylheptyl group, a 2-ethylhexyl group, a 2-propylpentyl group, an n-nonyl group, a 2,2-dimethylheptyl group, a 1-ethyl-propyl group, a 1,1-dimethyl-propyl group, an isohexyl group, a 2-methylpentyl group, a 4-methylhexyl group, a 5-methylhexyl group, and the like.

As used herein, the alkenyl group may include a linear or branched alkenyl group and may be further substituted with another substituent. Specifically, examples of the alkenyl group include, but are not limited to, a vinyl group, a 1-propenyl group, an isopropenyl group, a 1-butenyl group, a 2-butenyl group, a 3-butenyl group, a 1-pentenyl group, a 2-pentenyl group, a 3-pentenyl group, a 3-methyl-1-butenyl group, a 1,3-butadienyl group, an allyl group, a 1-phenylvinyl-1-yl group, a 2-phenylvinyl-1-yl group, a 2,2-diphenylvinyl-1-yl group, a 2-phenyl-2-(naphthyl-1-yl)vinyl-1-yl group, a 2,2-bis(diphenyl-1-yl)vinyl-1-yl group, a stilbenyl group, a styrenyl group, and the like.

As used herein, the alkynyl group may also include a linear or branched alkynyl group, and may be further substituted with another substituent, and examples of the substituent may include, but are not limited to, ethynyl, 2-propynyl, and the like.

As used herein, the aromatic hydrocarbon ring or the aryl group may be monocyclic or polycyclic, examples of the monocyclic aryl group include a phenyl group, a biphenyl group, a terphenyl group, a stilbene group, and the like, and examples of the polycyclic aryl group include, but are not limited to, a naphthyl group, an anthracenyl group, a phenanthrenyl group, a pyrenyl group, a perylenyl group, a tetracenyl group, a chrysenyl group, a fluorenyl group, an acenaphthcenyl group, a triphenylene group, a fluoranthene group, and the like, but the scope of the present invention is not limited thereto.

As used herein, the aromatic heterocyclic or heteroaryl group is an aromatic ring containing at least one heteroatom and examples thereof include, but are not limited to, thiophene, furan, pyrrole, imidazole, triazole, oxazole, oxadiazole, triazole, pyridyl, bipyridyl, pyrimidyl, triazine, triazole, acridyl, pyridazine, pyrazinyl, quinolinyl, quinazoline, quinoxalinyl, phthalazinyl, pyridopyrimidinyl, pyridopyrazinyl, pyrazinopyrazinyl, isoquinoline, indole, carbazole, benzoxazole, benzimidazole, benzothiazole, benzocarbazole, benzothiophene, dibenzothiophene, benzofuranyl, dibenzofuranyl, phenanthroline, thiazolyl, isoxazolyl, oxadiazolyl, thiadiazolyl, benzothiazolyl, and phenothiazinyl groups and the like.

As used herein, the aliphatic hydrocarbon ring refers to a non-aromatic ring that contains only carbon and hydrogen atoms, for example, includes a monocyclic or polycyclic ring, and may be further substituted with another substituent. The term "polycyclic" means that the polycyclic group may be directly attached to or fused with at least one other cyclic group, the other cyclic group may be an aliphatic hydrocarbon ring, or a different type of ring group, for example, an aliphatic heterocyclic group, an aryl group, a heteroaryl group, and the like. Specifically, examples thereof include, but are not limited to, cycloalkyls such as a cyclopropyl group, a cyclobutyl group, a cyclopentyl group, an adamantyl group, a 3-methylcyclopentyl group, a 2,3-dimethylcyclopentyl group, a cyclohexyl group, a 3-methylcyclohexyl group, a 4-methylcyclohexyl group, a 2,3-dimethylcyclohexyl group, a 3,4,5-trimethylcyclohexyl group, a 4-tert-butylcyclohexyl group, a cycloheptyl group, and a cyclooctyl group, cycloalkanes such as cyclohexane and cyclopentane, and cycloalkenes such as cyclohexene and cyclobutene.

As used herein, the aliphatic heterocyclic ring refers to an aliphatic ring that contains at least one of heteroatoms such as O, S, Se, N and Si, also includes a monocyclic or polycyclic ring, and may be further substituted with another substituent. The term "polycyclic" means that the polycyclic group may be directly attached to or fused with at least one other cyclic group, and the other cyclic group may be an aliphatic hydrocarbon ring, or a different type of ring group, for example, an aliphatic heterocyclic group, an aryl group, a heteroaryl group, or the like.

As used herein, the mixed aliphatic-aromatic ring group refers to a ring in which two or more rings are attached to and fused with each other, and aliphatic and aromatic rings are fused together to be overall non-aromatic, and a polycyclic mixed aliphatic-aromatic ring may contain a heteroatom selected from N, O, P and S, in addition to C.

As used herein, specifically, the alkoxy group may be methoxy, ethoxy, propoxy, isobutyloxy, sec-butyloxy, pentyloxy, iso-amyloxy, hexyloxy, or the like, but is not limited thereto.

As used herein, the silyl group is represented by -SiH₃, and may be an alkylsilyl group, an arylsilyl group, an alkylarylsilyl group, an arylheteroarylsilyl group, or the like, and specific examples of the silyl group include trimethylsilyl, triethylsilyl, triphenylsilyl, trimethoxysilyl, dimethoxyphenylsilyl, diphenylmethylsilyl, diphenylvinylsilyl, methylcyclobutylsilyl, dimethylfurylsilyl, and the like.

As used herein, the amine group is represented by -NH₂, or may be an alkylamine group, an arylamine group, an arylheteroarylamine group, or the like. The arylamine group refers to amine substituted with aryl, the alkylamine group refers to amine substituted with alkyl, and the arylheteroarylamine group refers to an amine substituted with aryl and heteroaryl. For example, the arylamine group includes a substituted or unsubstituted monoarylamine group, a substituted or unsubstituted diarylamine group, or a substituted or unsubstituted triarylamine group. The aryl group and the heteroaryl group in the arylamine group and the arylheteroarylamine group may be a monocyclic aryl group or a monocyclic heteroaryl group, or a polycyclic aryl group or a polycyclic heteroaryl group. The arylamine group and the arylheteroarylamine group that contain two or more aryl groups and two or more heteroaryl groups, respectively, include a monocyclic aryl group (heteroaryl group), a polycyclic aryl group (heteroaryl group), or both of the monocyclic aryl group (heteroaryl group) and the polycyclic aryl group (heteroaryl group). In addition, the aryl group and the heteroaryl group in the arylamine group and the arylheteroarylamine group may be selected from examples of aryl groups and heteroaryl groups described above.

As used herein, examples of the aryl group in the aryloxy group and the arylthioxy group are identical to examples of the aryl group described above and specifically, examples of the aryloxy group include a phenoxy group, a p-tolyloxy group, an m-tolyloxy group, a 3,5-dimethylphenoxy group, a 2,4,6-trimethylphenoxy group, a p-tert-butylphenoxy group, a 3-biphenyloxy group, a 4-biphenyloxy group, a 1-naphthyloxy group, a 2-naphthyloxy group, a 4-methyl-1-naphthyloxy group, a 5-methyl-2-naphthyloxy group, a 1-anthryloxy group, a 2-anthryloxy group, a 9-anthryloxy group, a 1-phenanthryloxy group, a 3-phenanthryloxy group, a 9-phenanthryloxy group, and the like, and examples of the arylthioxy group include, but are not limited to, a phenylthioxy group, a 2-methylphenylthioxy group, a 4-tert-butylphenylthioxy group, and the like.

In the present invention, examples of the halogen group include fluorine, chlorine, bromine, and iodine.

More specifically, the compound represented by [Formula A] or [Formula B] according to the present invention is selected from the compounds represented by following formulas, which clearly show specific substituents, but these compounds should not be construed as limiting the scope of [Formula A] or [Formula B] according to the present invention.

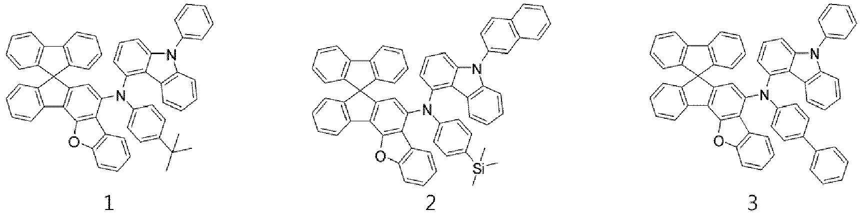

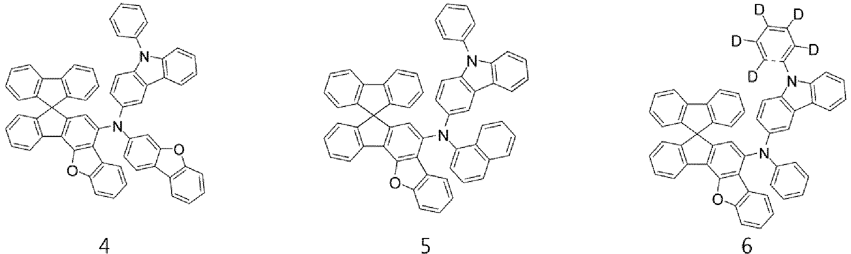

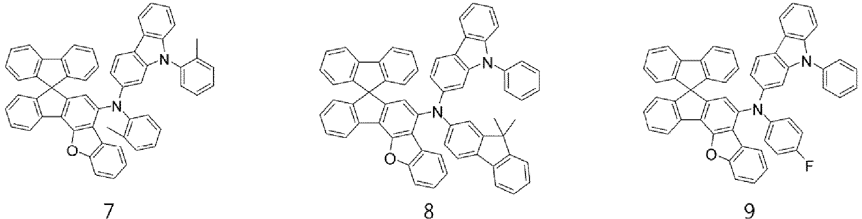

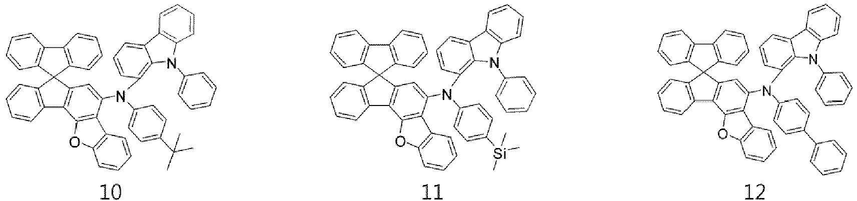

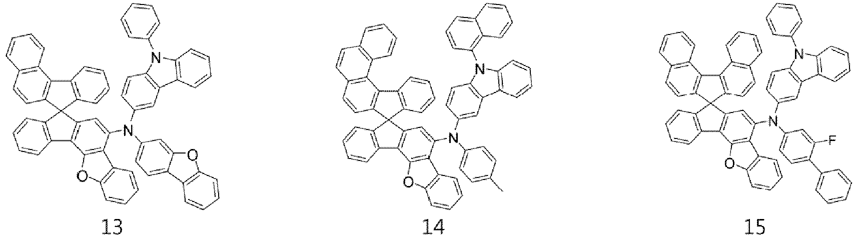

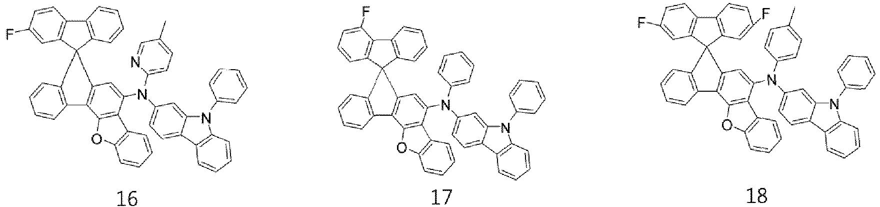

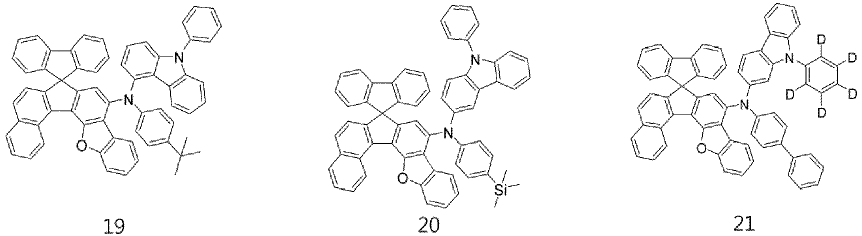

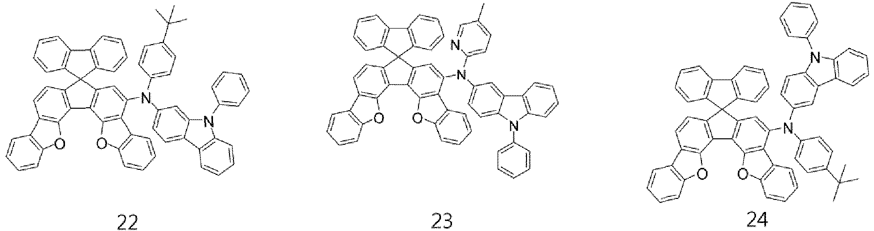

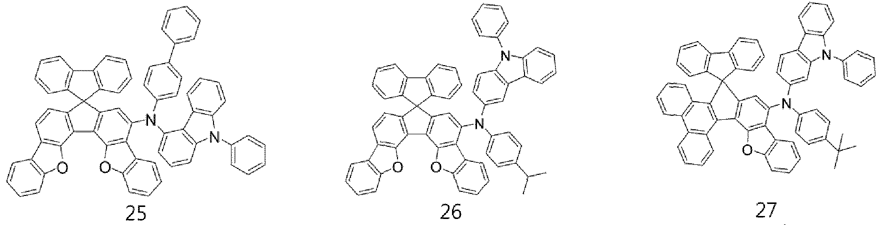

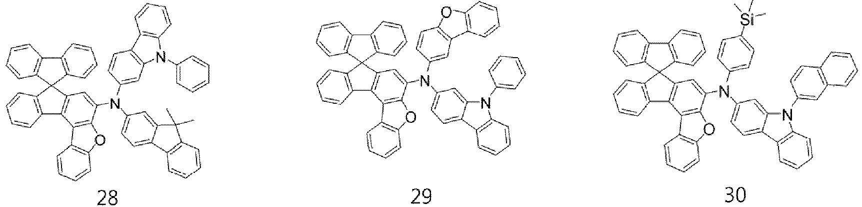

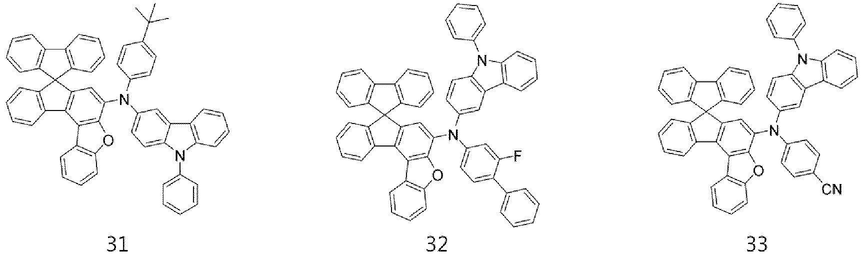

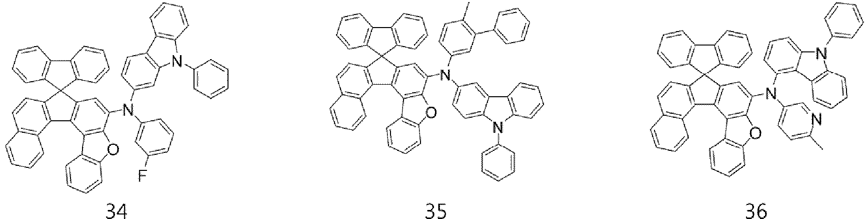

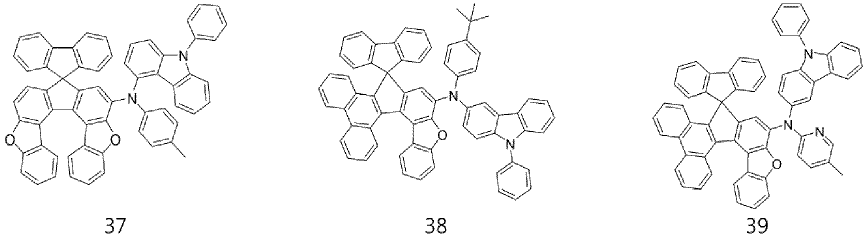

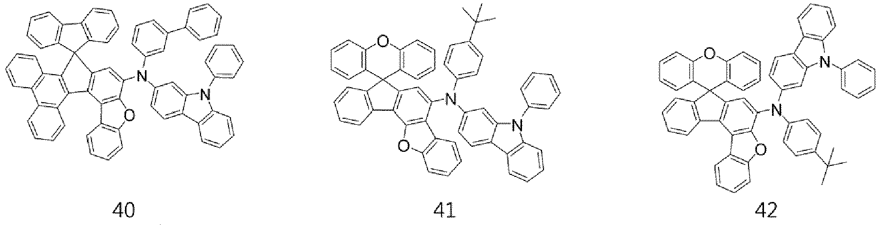

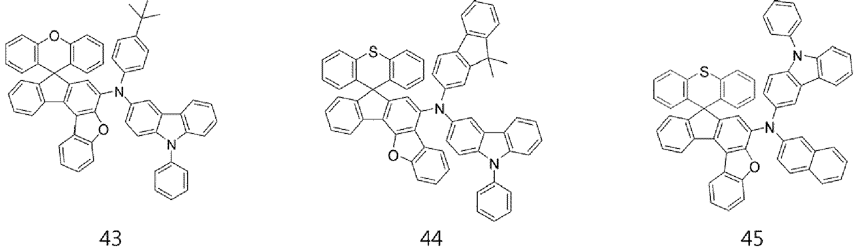

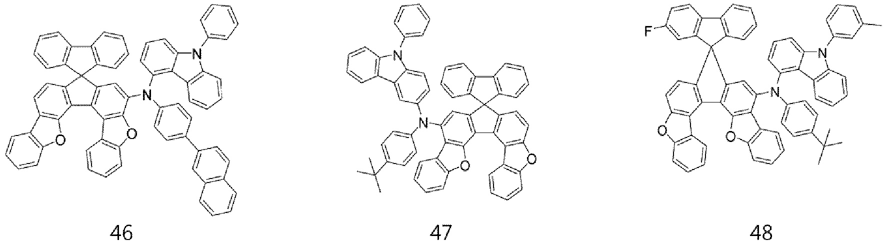

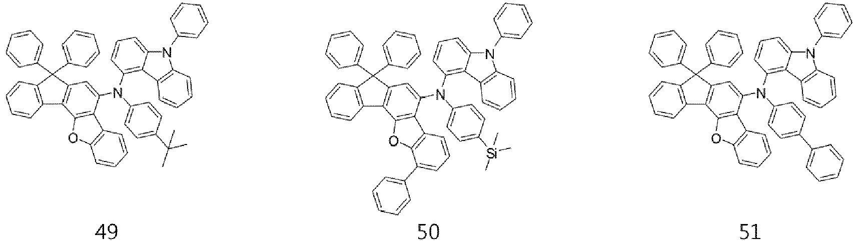

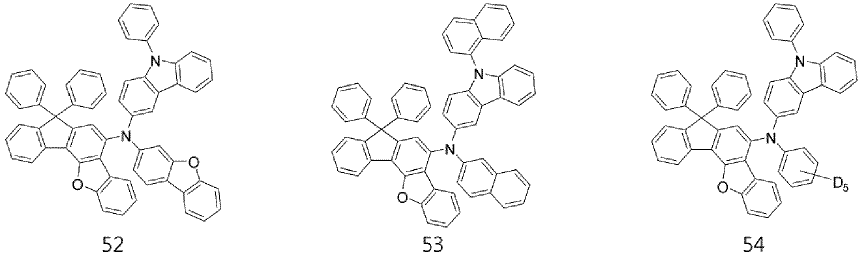

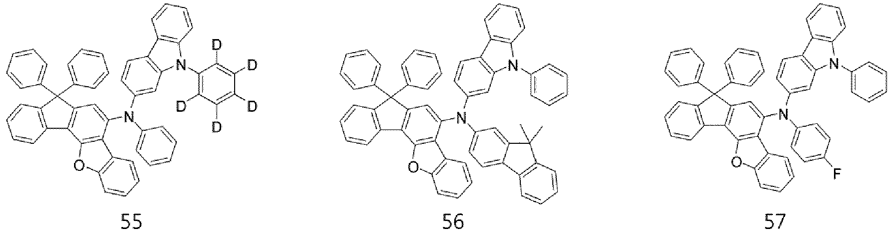

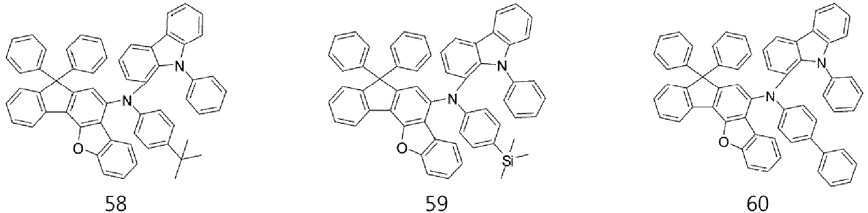

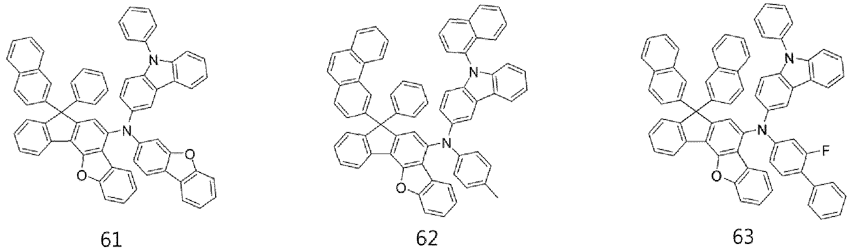

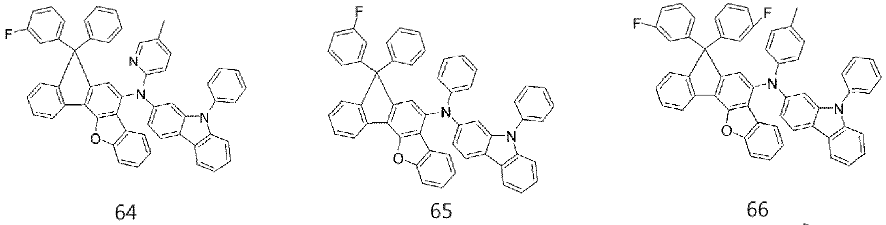

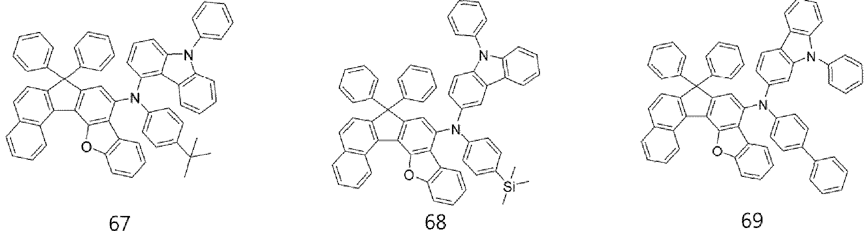

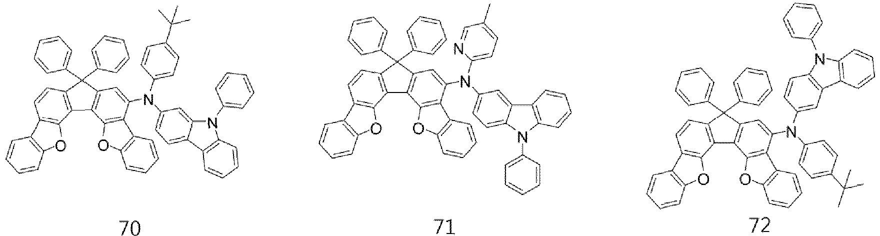

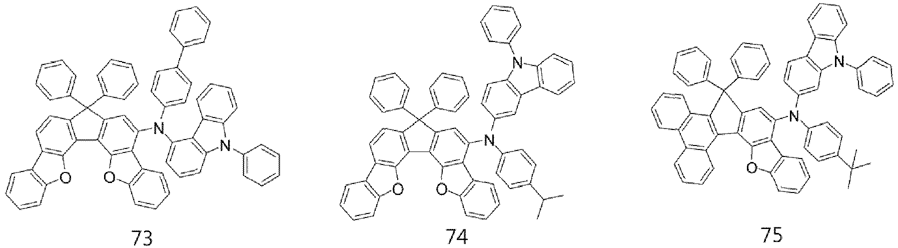

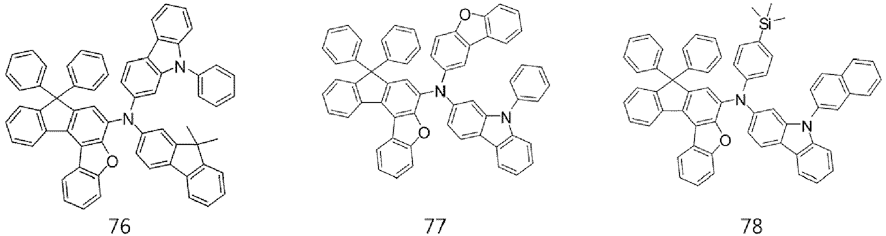

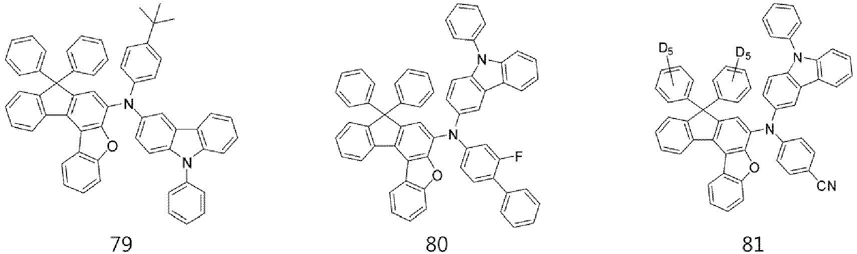

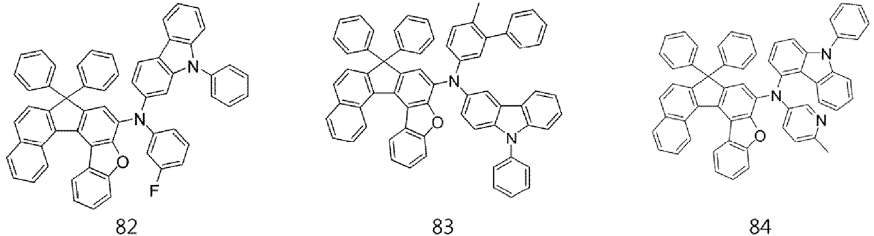

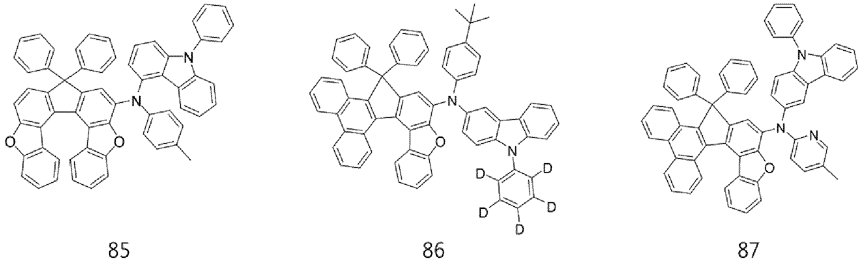

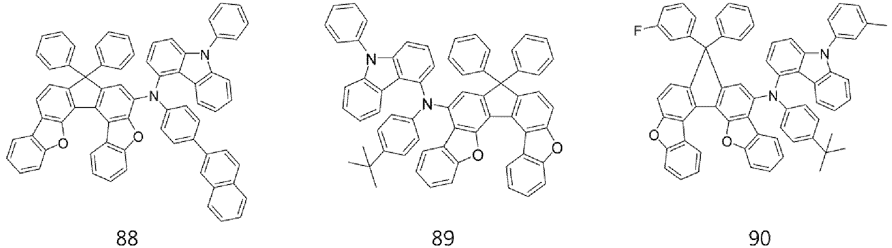

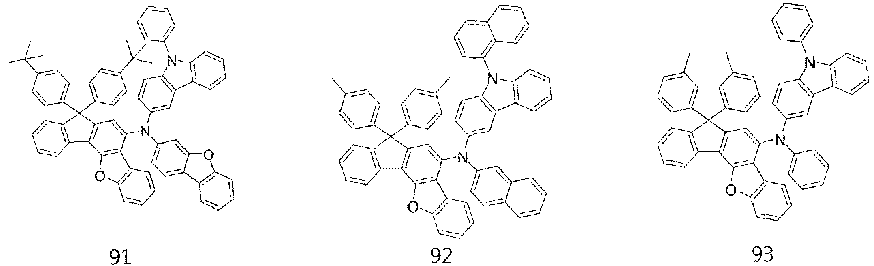

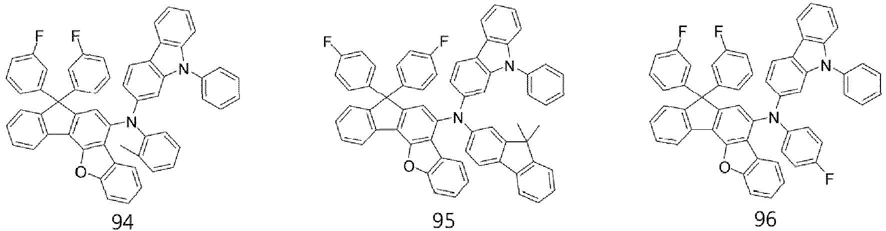

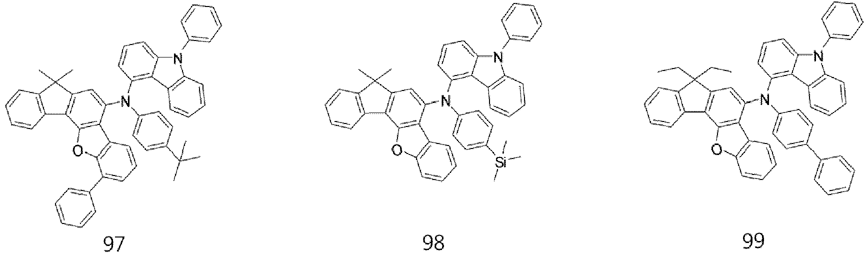

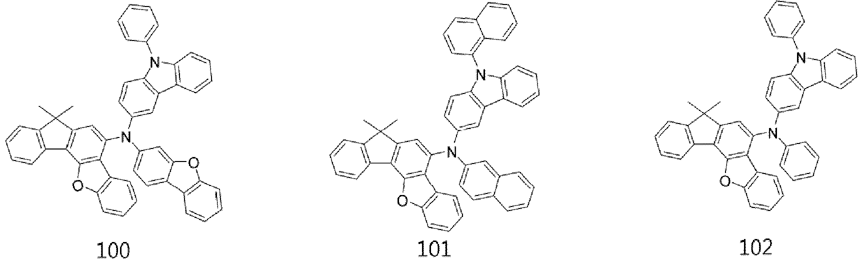

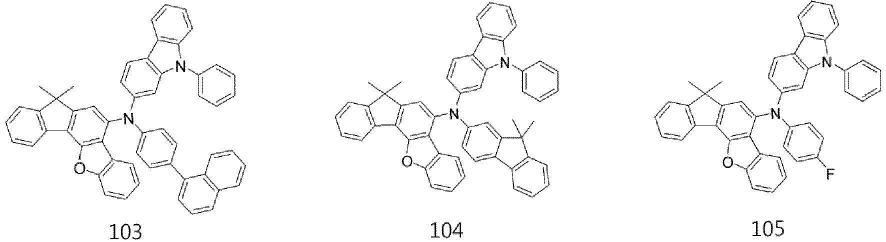

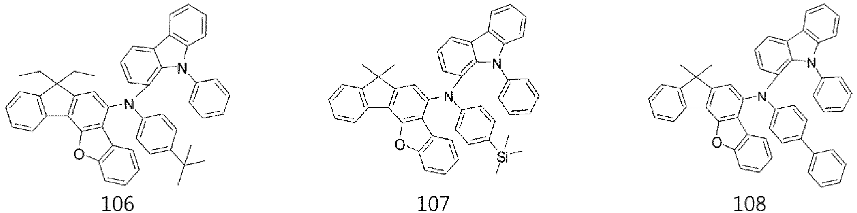

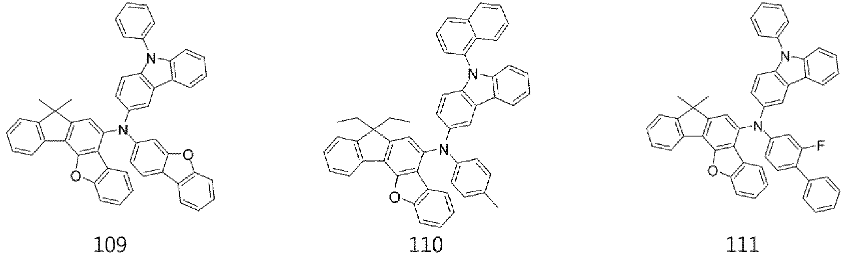

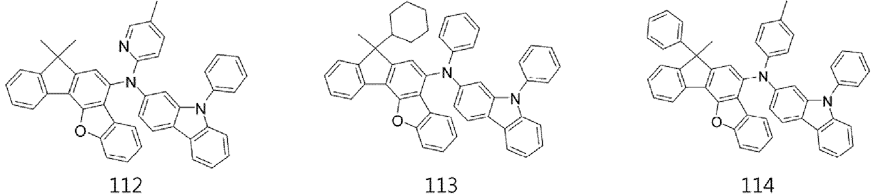

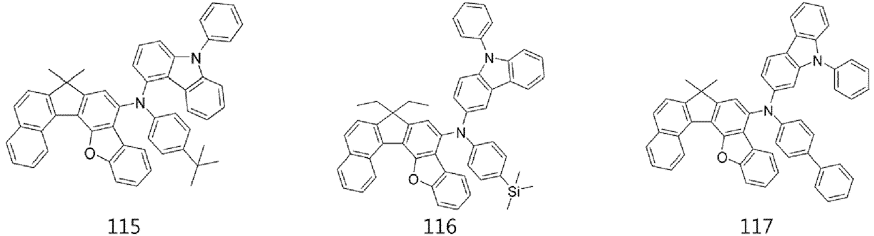

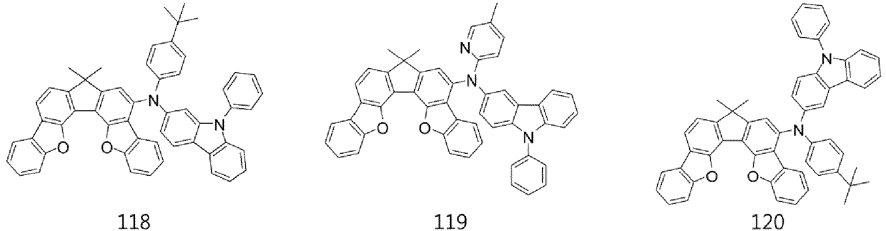

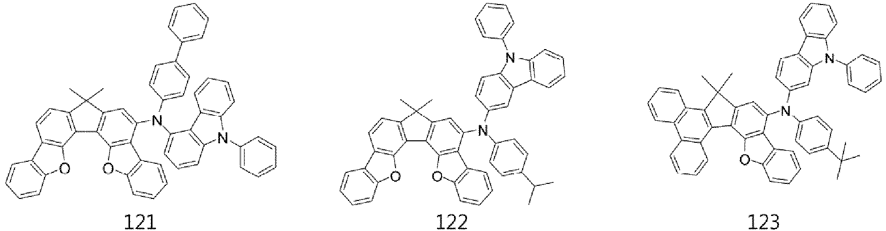

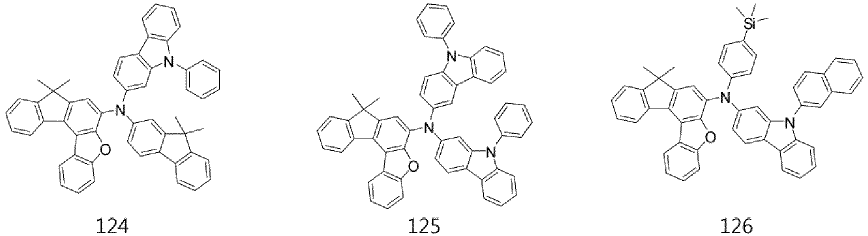

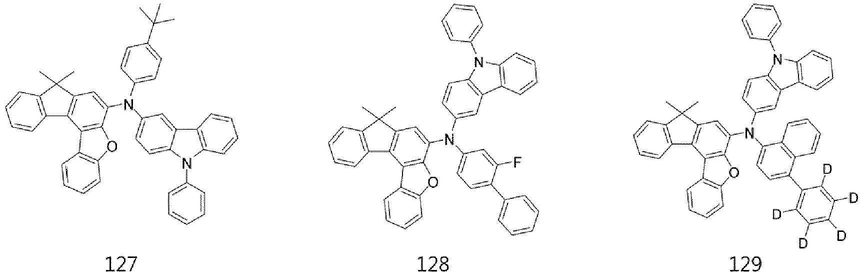

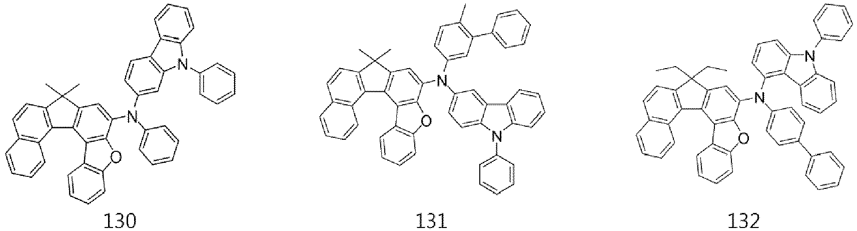

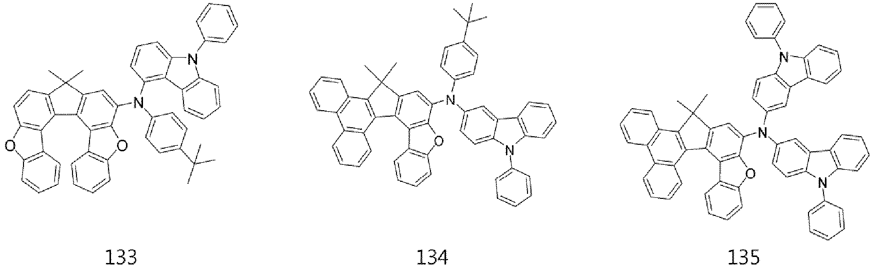

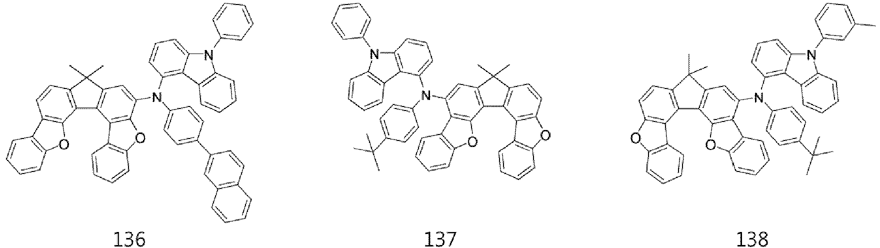

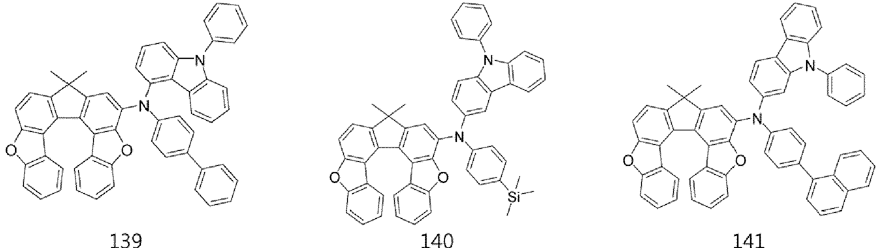

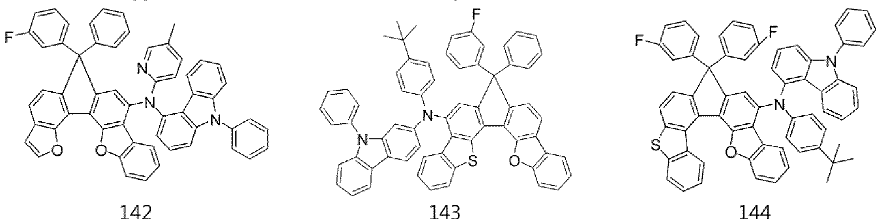

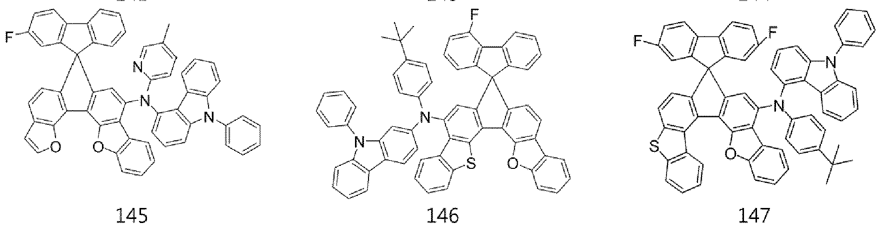

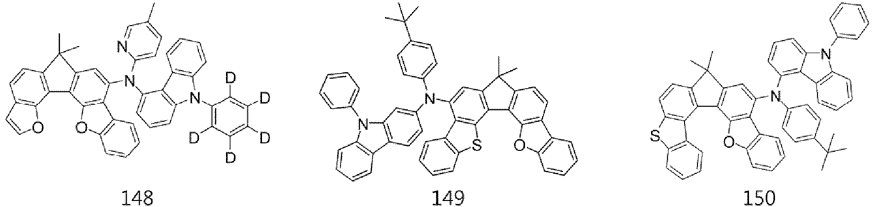

In addition, more specifically, the polycyclic aromatic derivative compound represented by [Formula C] or [Formula D] according to the present invention, used as the dopant for the light-emitting layer, is selected from the following compounds, which clearly show specific substituents, but these compounds should not be construed as limiting the scope of [Formula C] or [Formula D] according to the present invention.

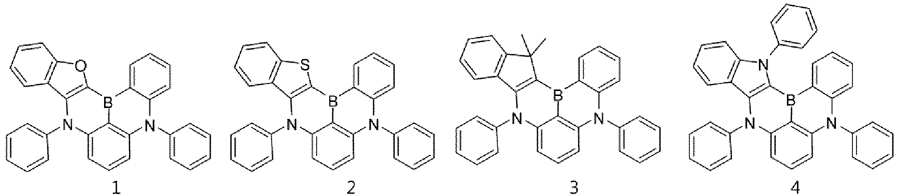

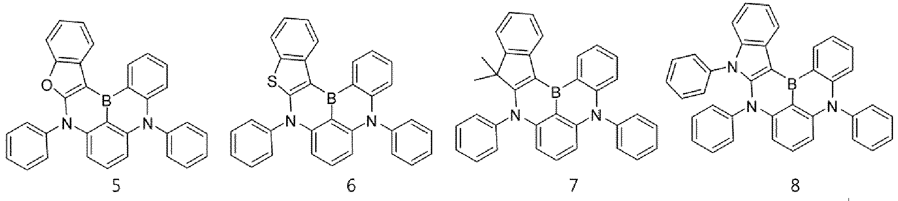

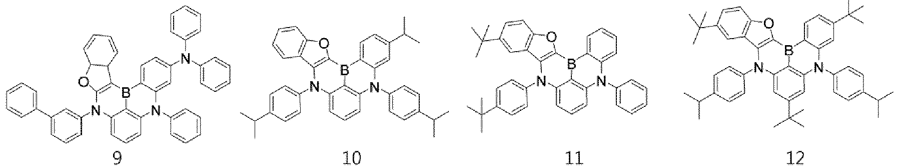

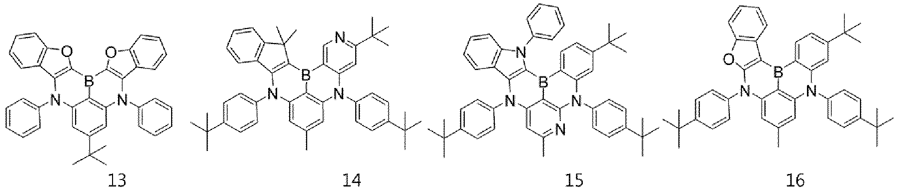

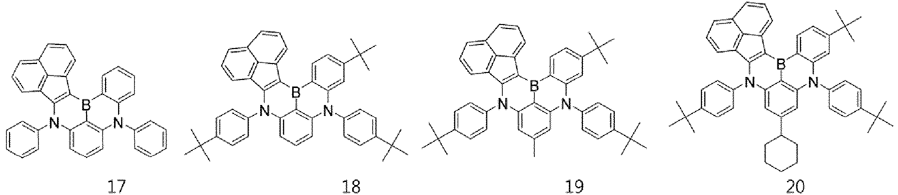

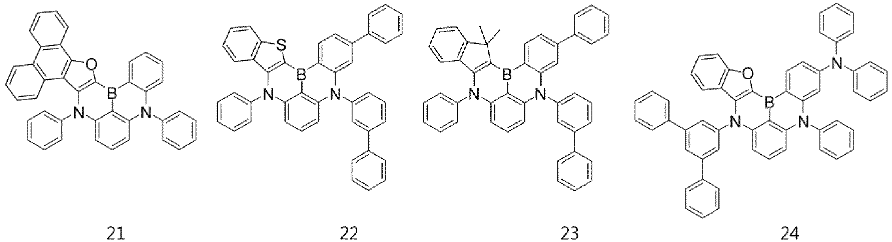

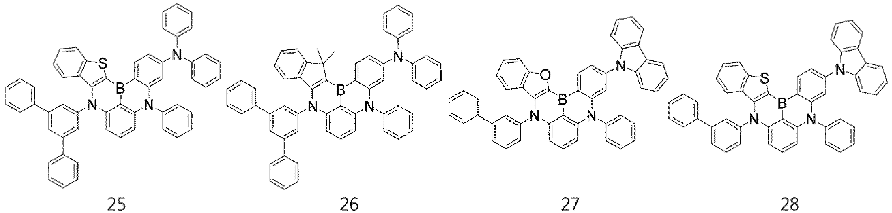

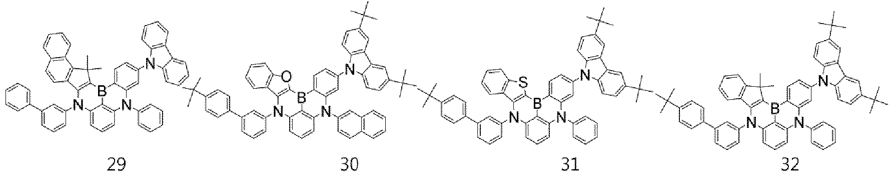

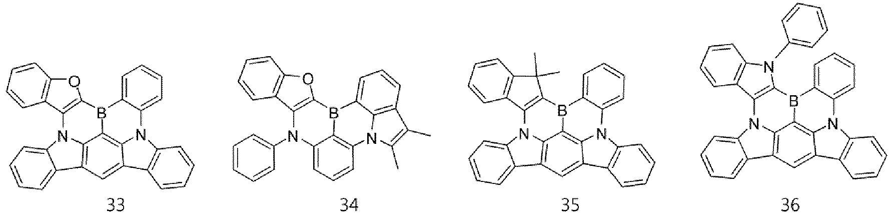

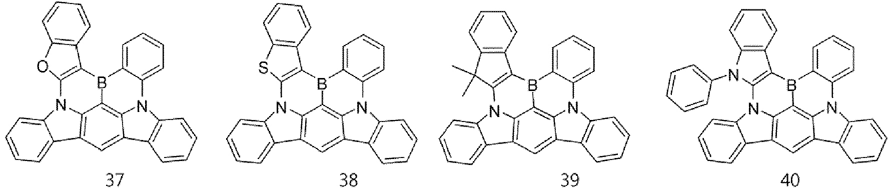

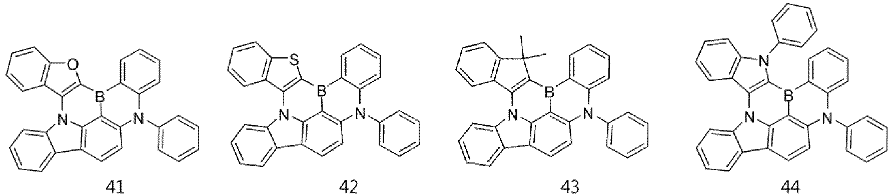

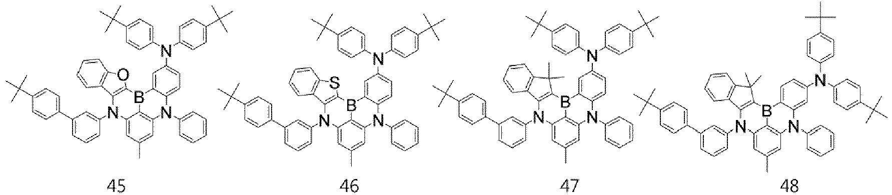

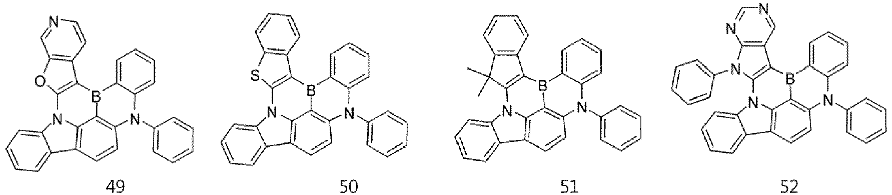

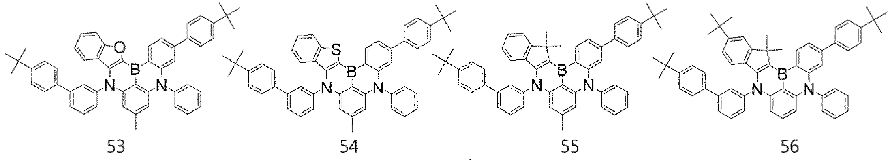

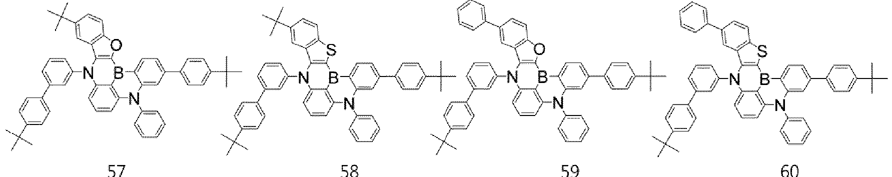

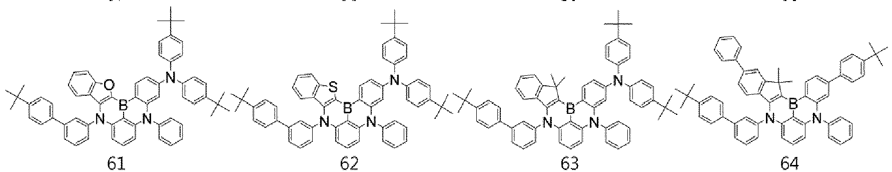

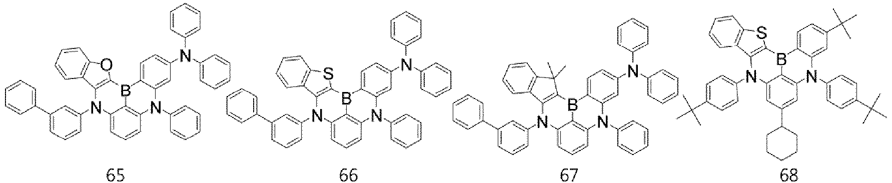

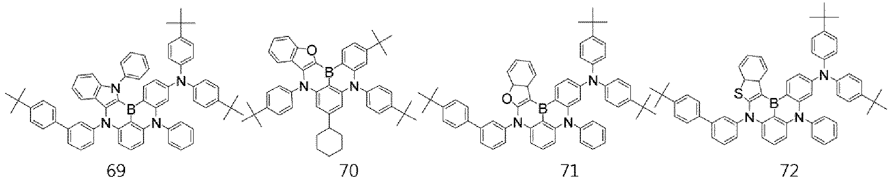

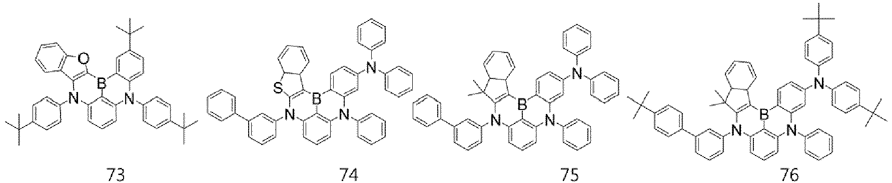

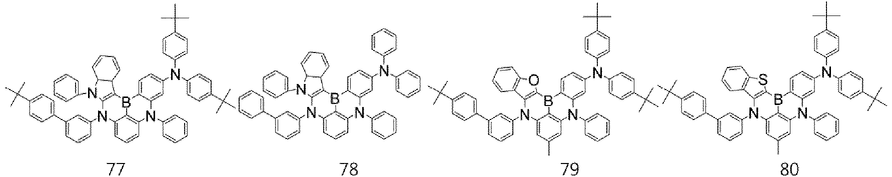

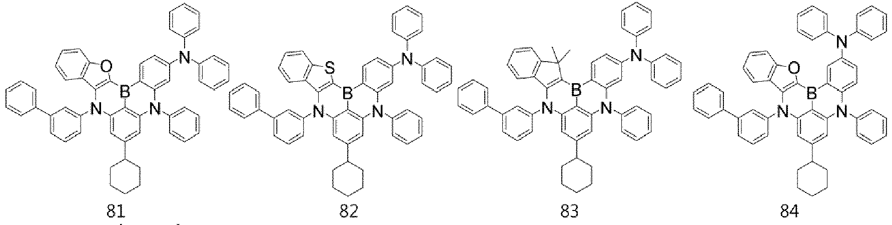

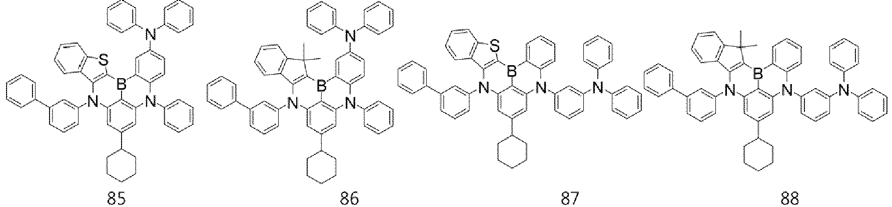

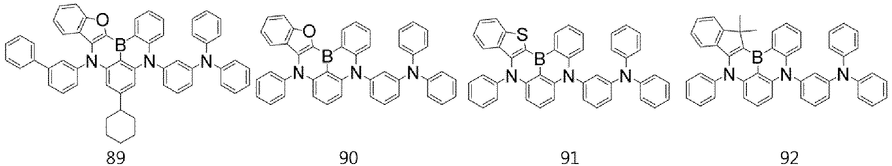

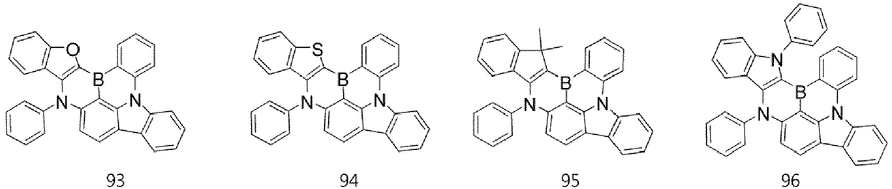

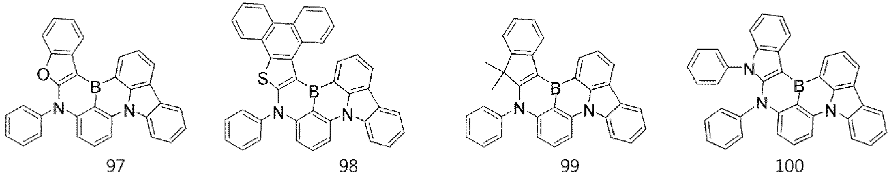

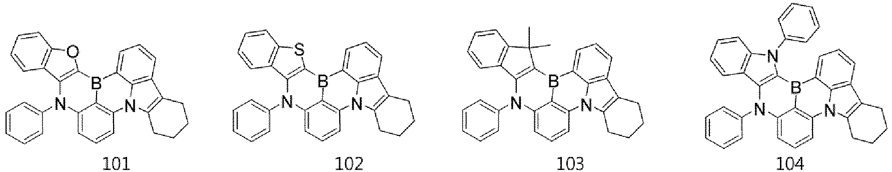

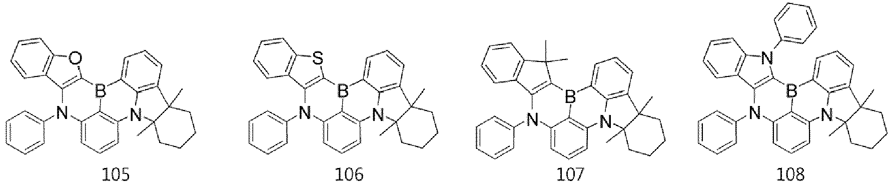

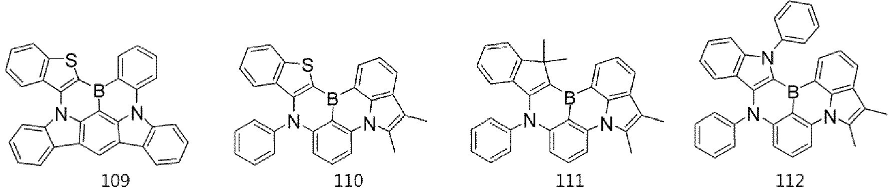

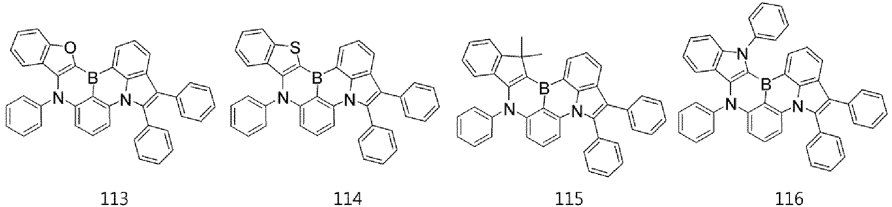

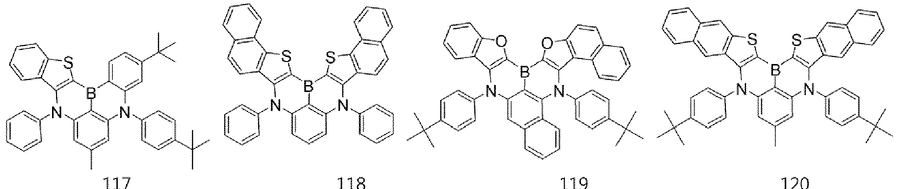

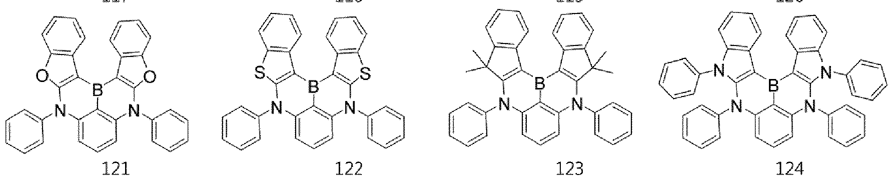

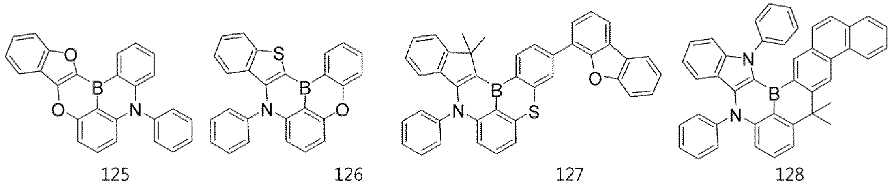

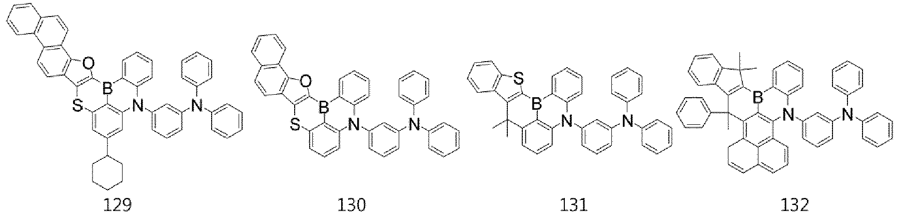

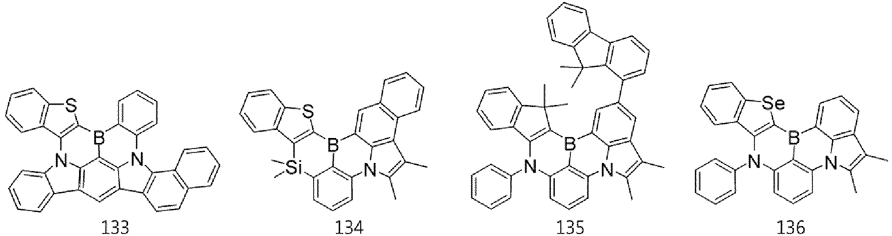

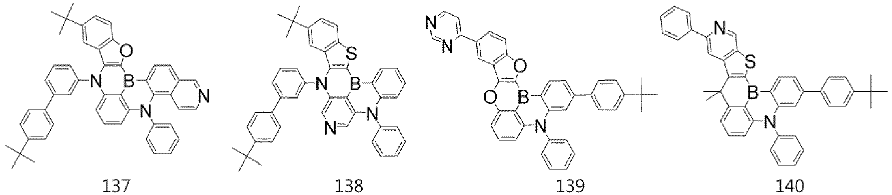

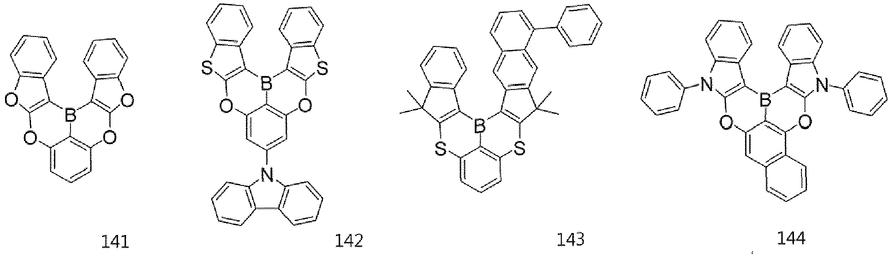

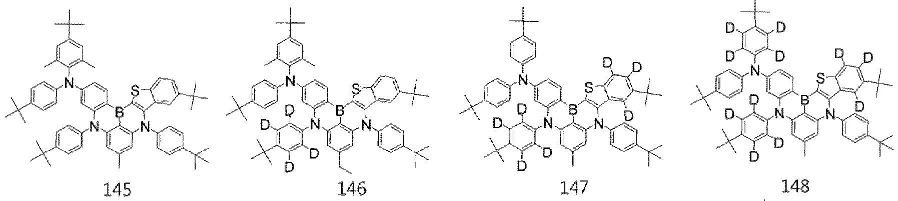

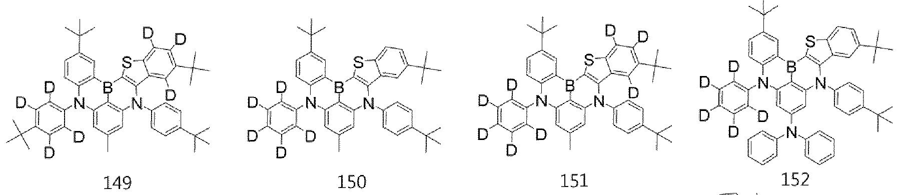

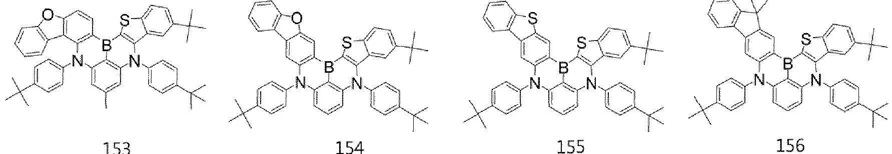

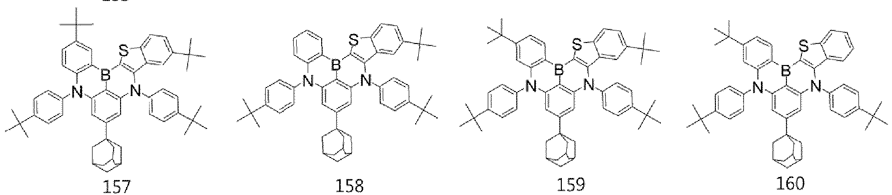

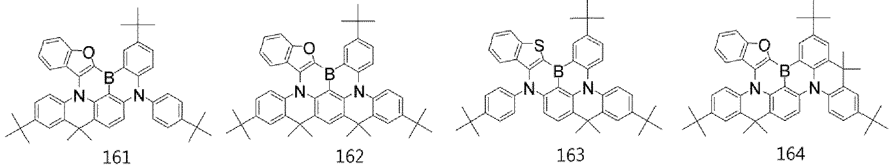

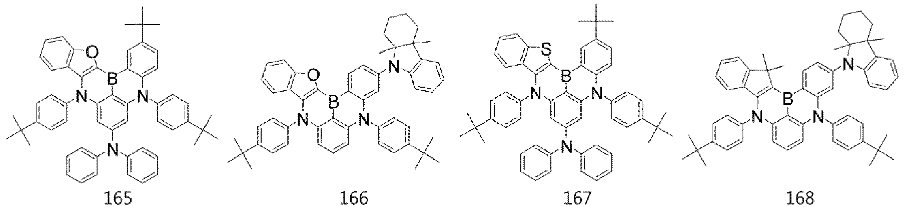

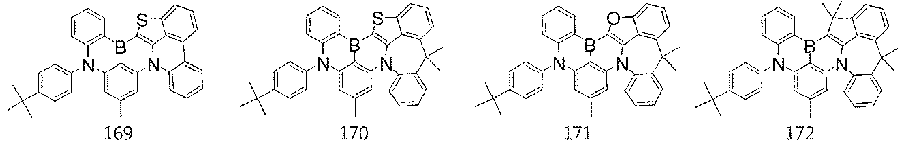

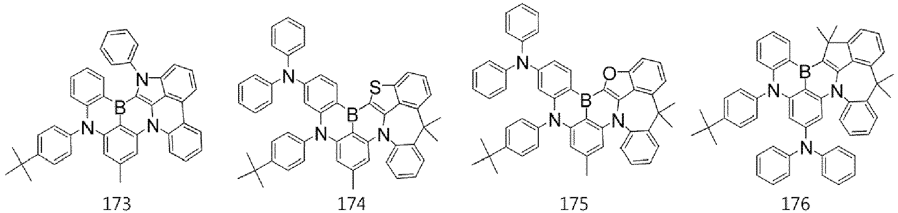

As can be seen from the specific compounds, an organic light-emitting material having the intrinsic properties of the substituent can be synthesized, in particular, a dopant material used in the light-emitting layer can be prepared by forming a polycyclic aromatic structure including B, P, and P=O and introducing substituents therein and a highly efficient organic light-emitting device can be realized by applying the compound represented by [Formula A] or [Formula B] according to the present invention to the device.

In addition, in another aspect, the present invention is directed to an organic light-emitting device including a first electrode, a second electrode, and a hole injection layer and/or a hole transport layer and a light-emitting layer interposed between the first electrode and the second electrode, and the organic light-emitting device may be fabricated using a conventional method and materials for fabricating devices using the compound of [Formula A] or [Formula B] in the hole injection layer, the hole transport layer, and a functional layer capable of injecting and/or transporting holes, and the compound of [Formula B] or [Formula C] as a dopant in the light-emitting layer.

In addition to the light-emitting layer, the hole injection layer, the hole transport layer, and the functional layer capable of injecting and/or transporting holes, the organic light-emitting device according to the present invention may further include an electron transport layer, an electron injection layer, an electron blocking layer, a hole blocking layer, and the like, and the organic light-emitting device may use materials for the respective layers.

Specifically, the organic light-emitting device according to the present invention may use the following anthracene derivative compound as a host compound for the light-emitting layer.

The organic material layer structure of the preferred organic light-emitting device according to the present invention will be described in more detail in the following Examples.

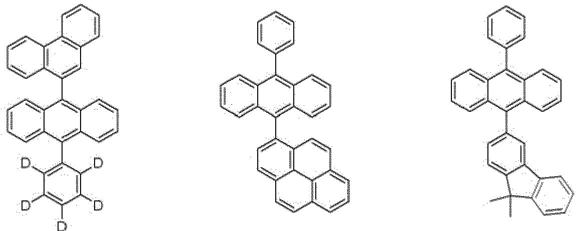

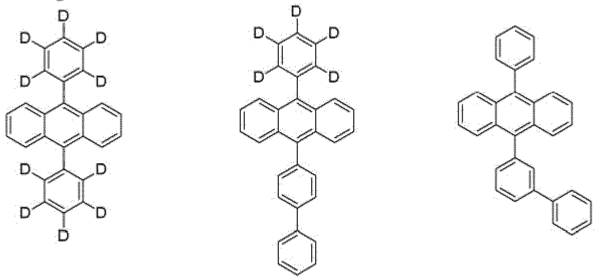

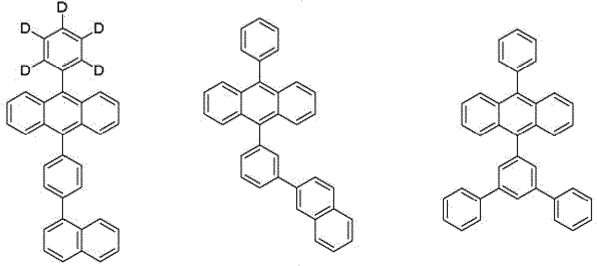

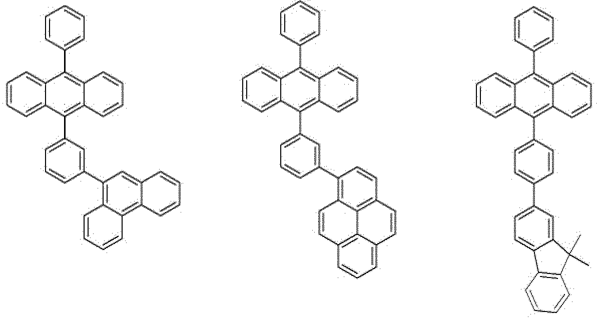

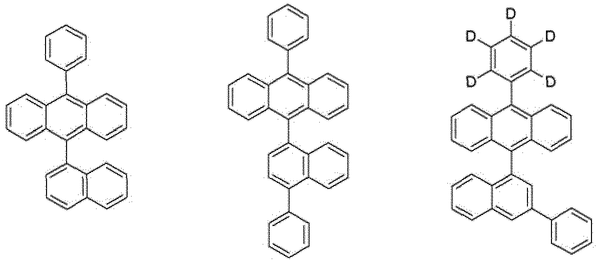

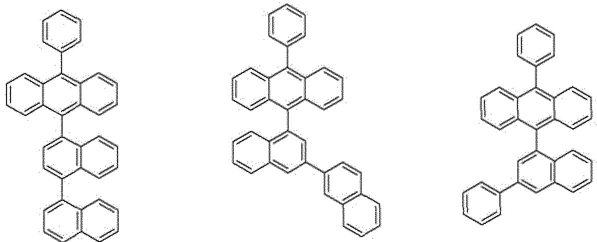

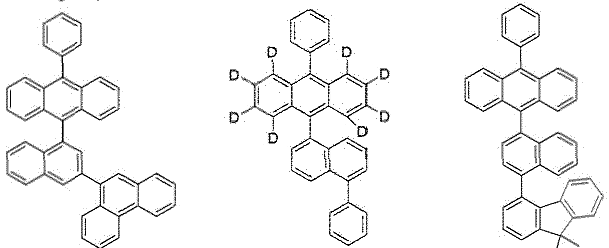

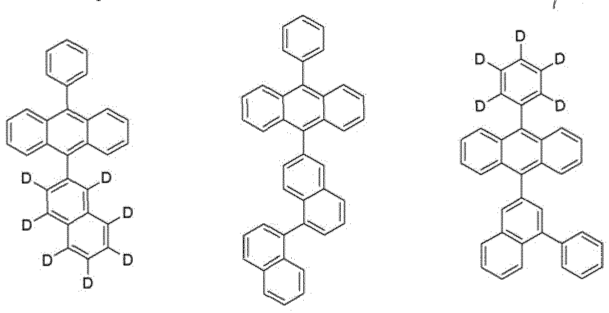

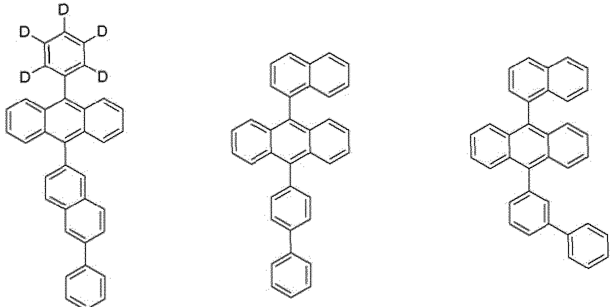

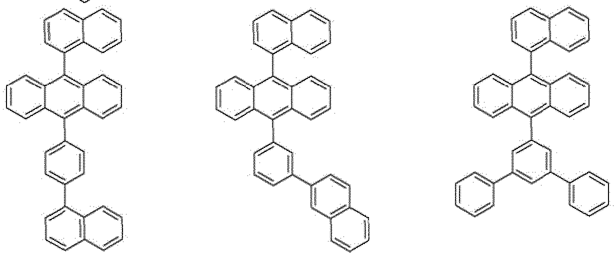

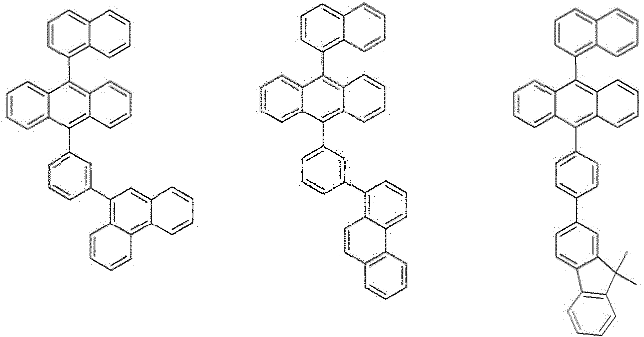

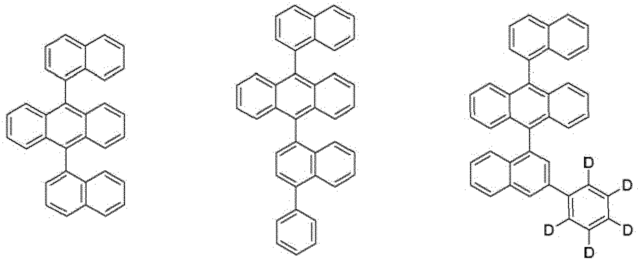

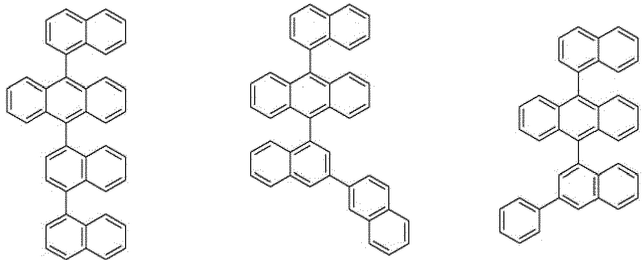

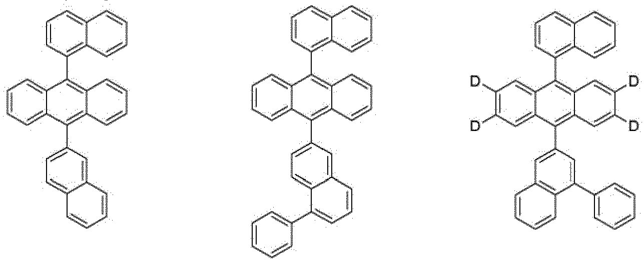

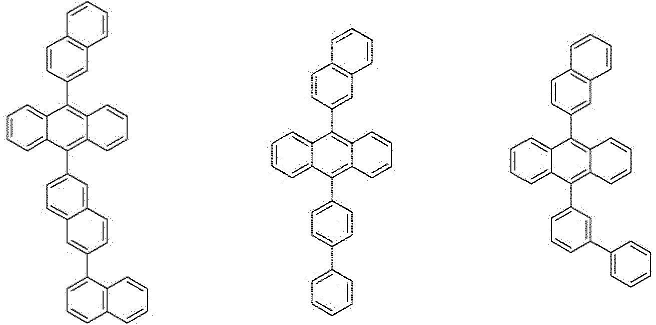

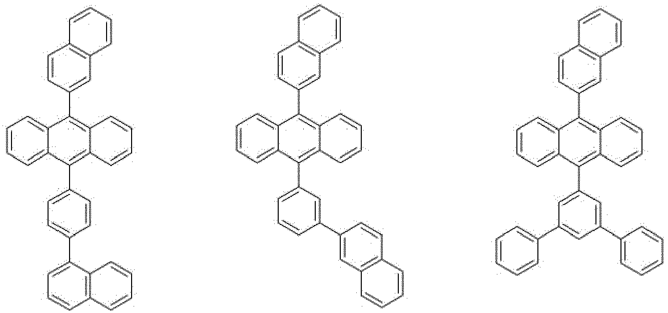

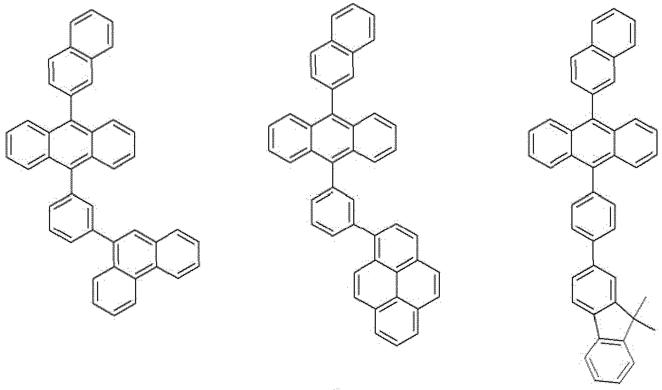

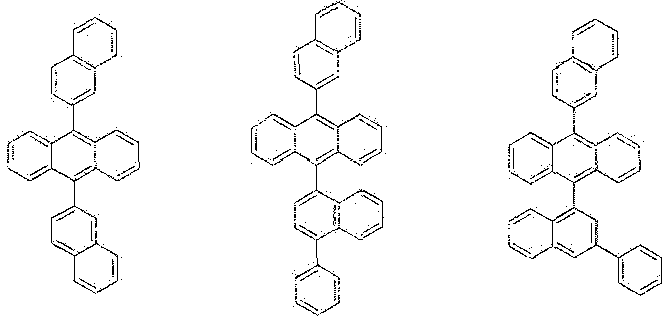

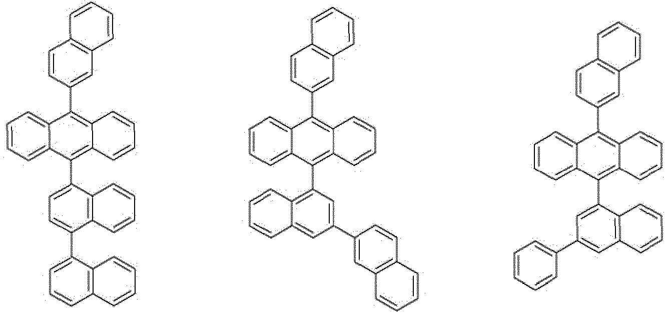

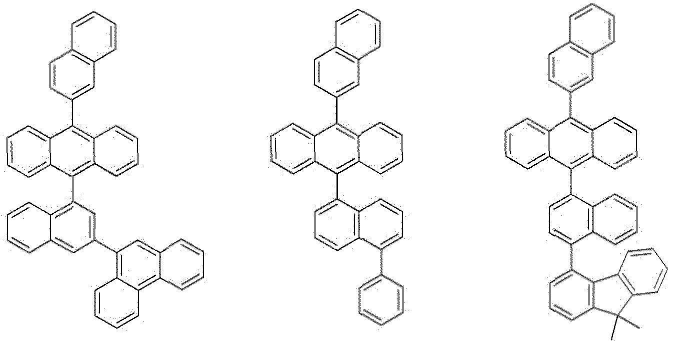

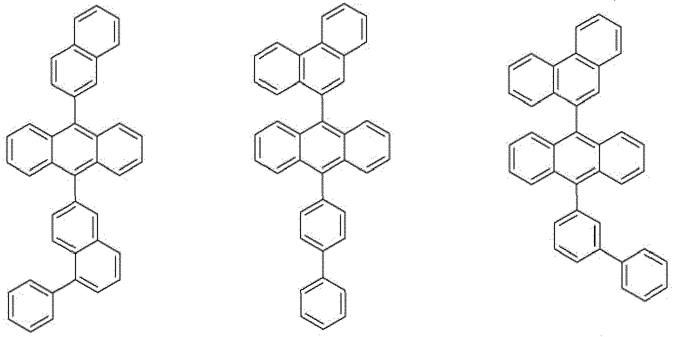

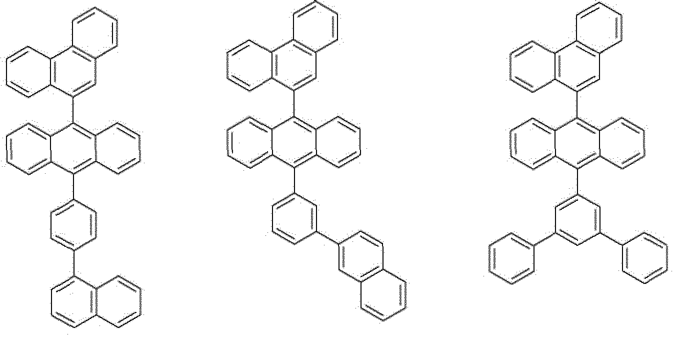

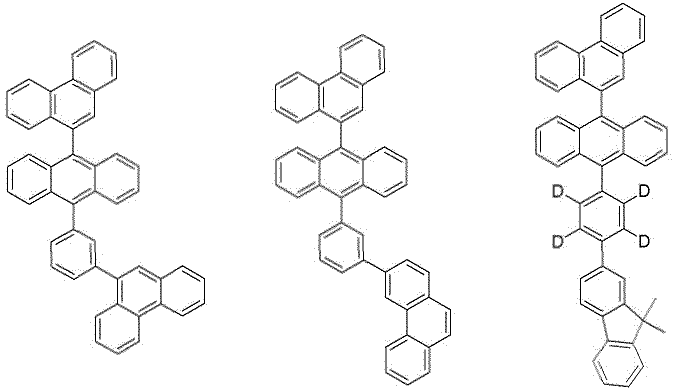

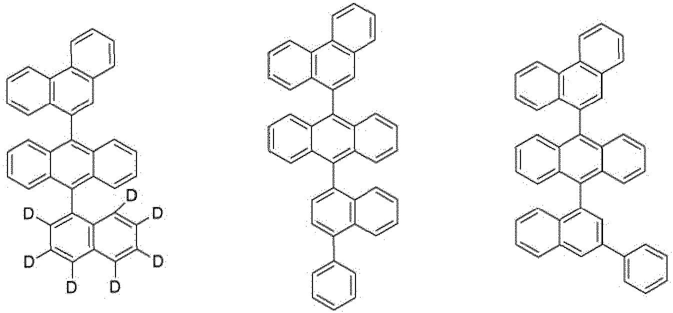

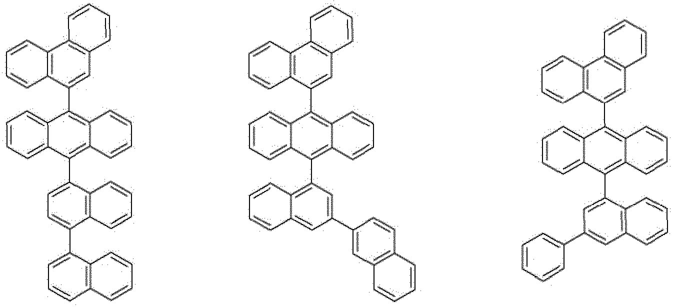

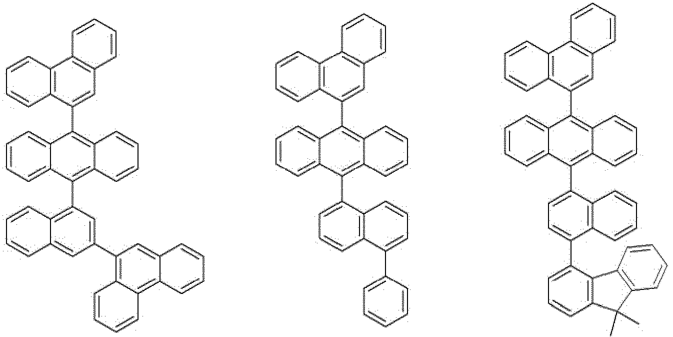

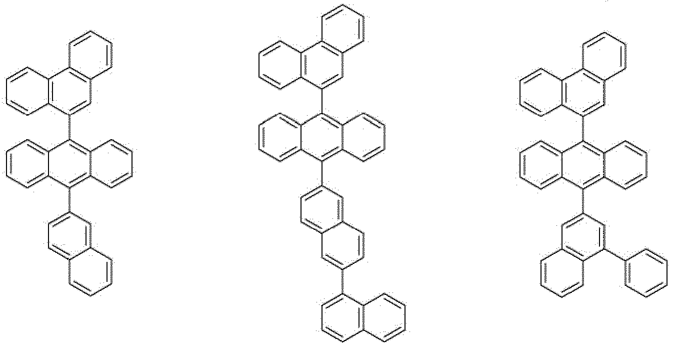

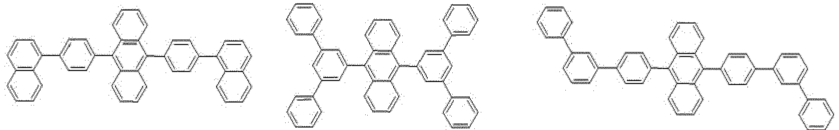

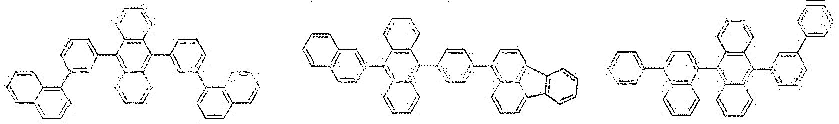

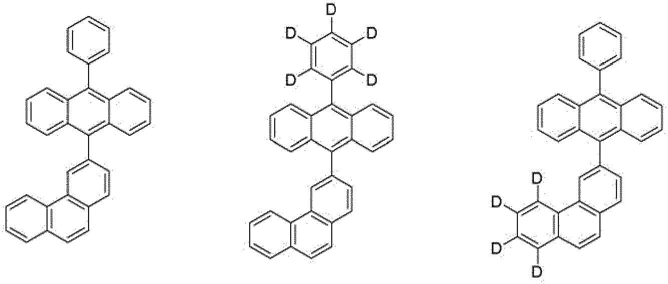

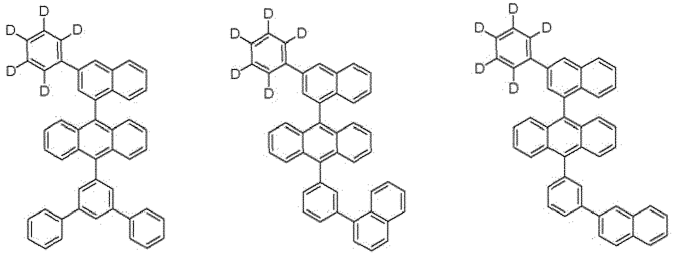

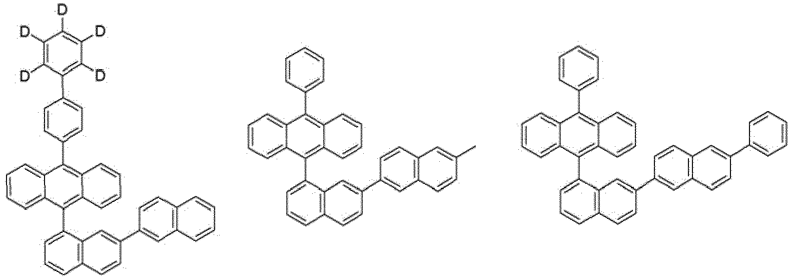

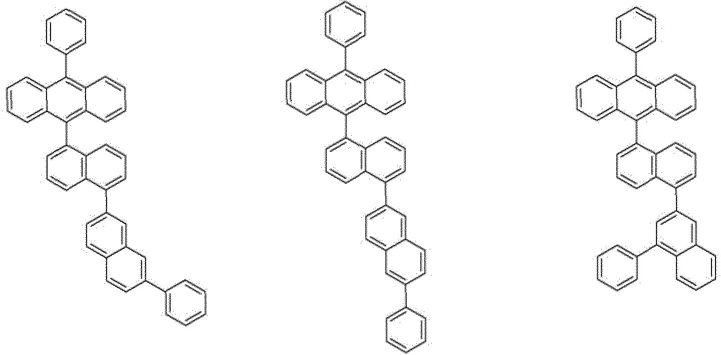

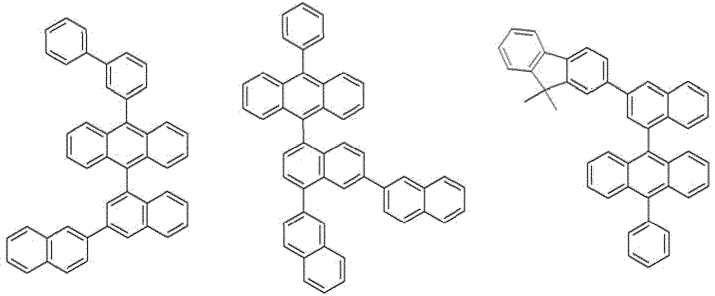

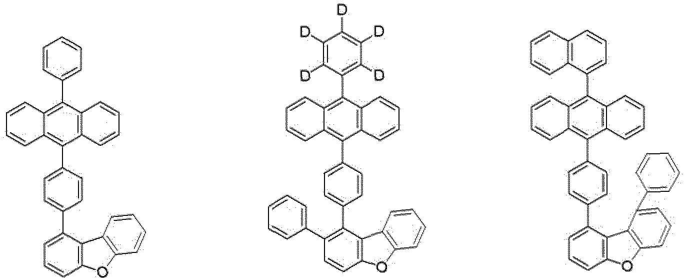

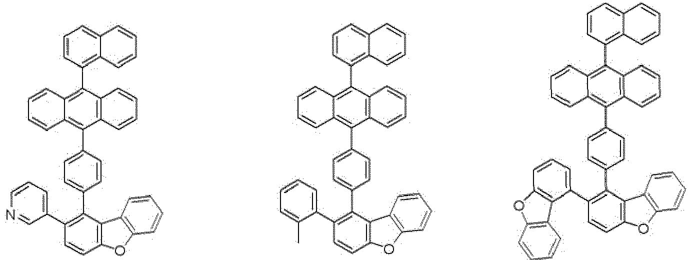

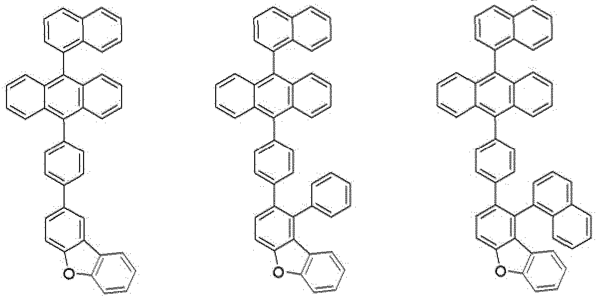

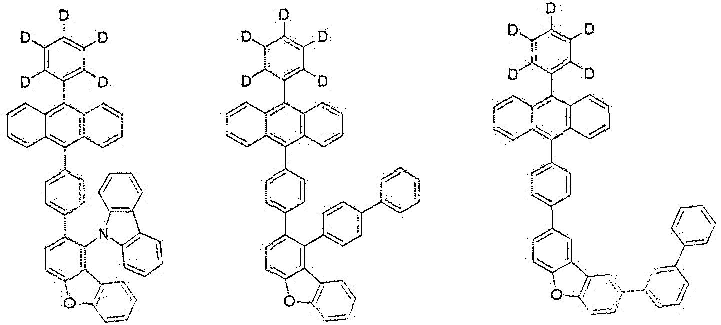

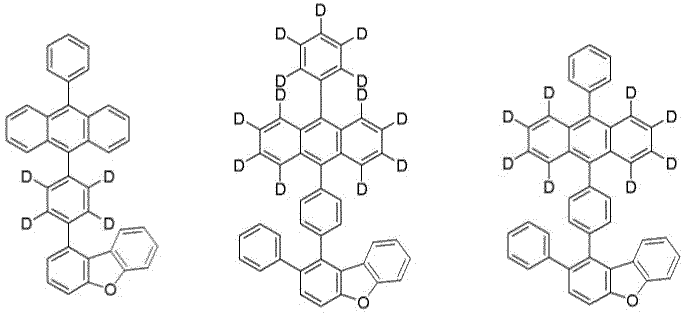

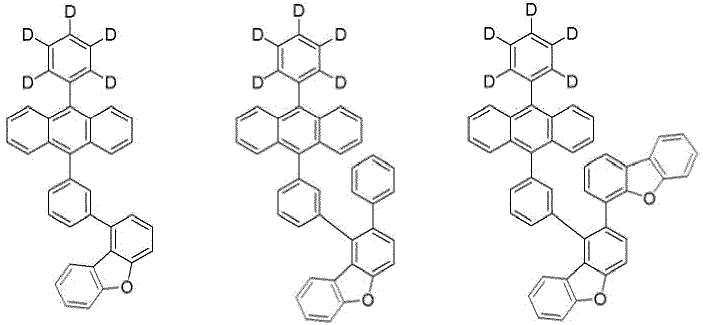

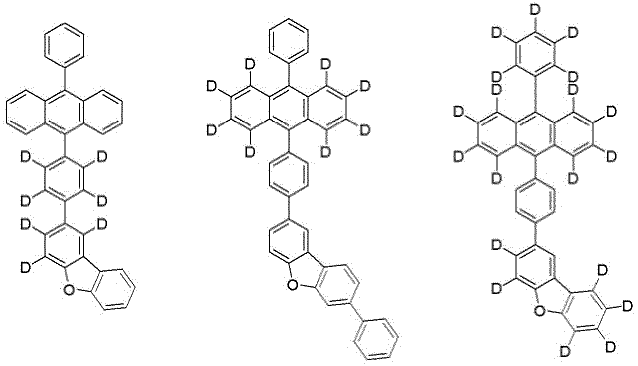

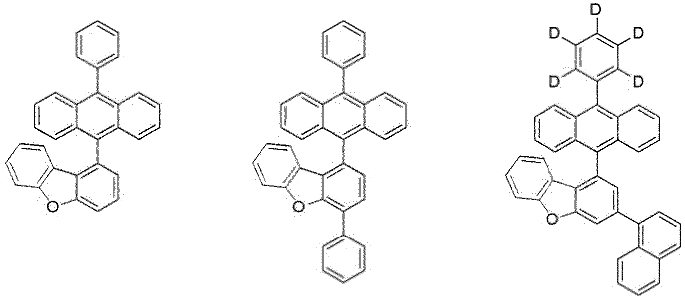

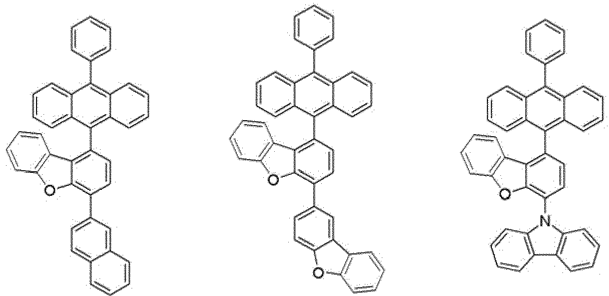

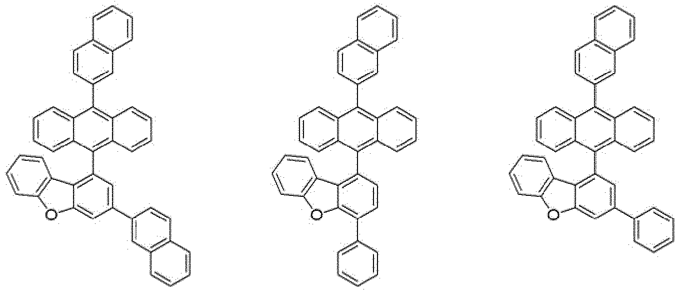

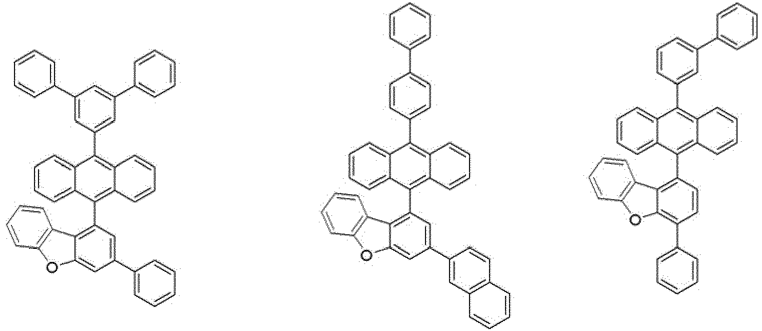

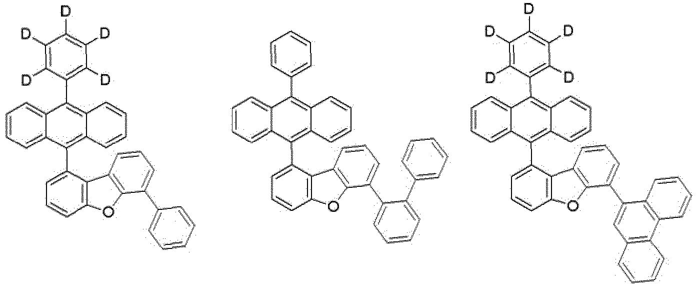

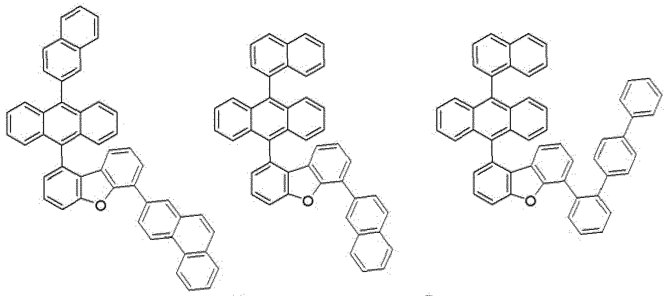

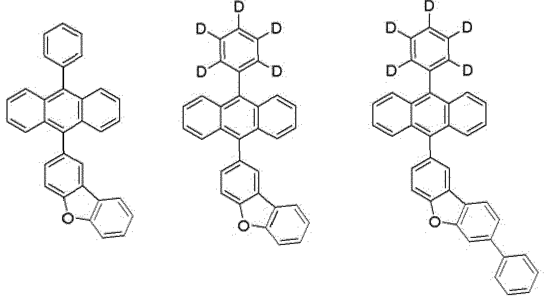

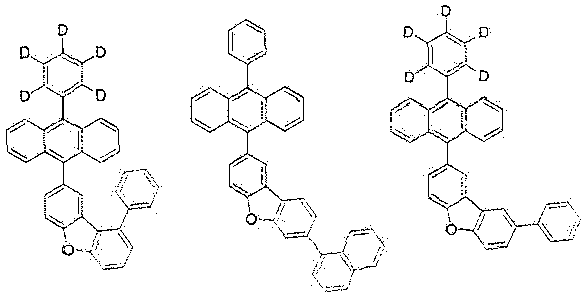

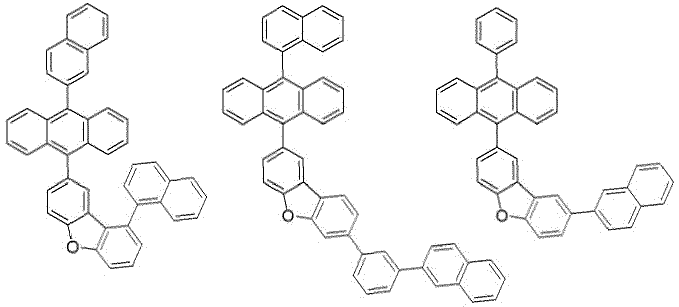

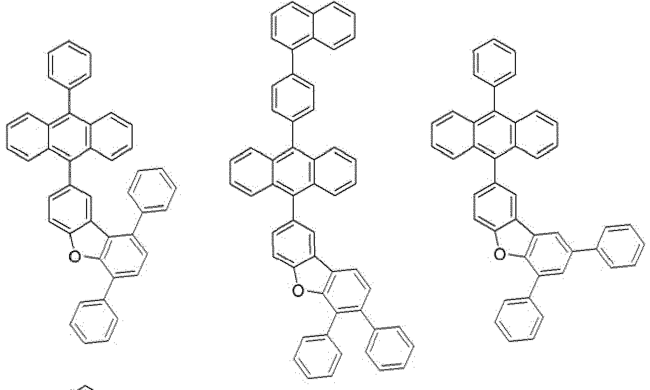

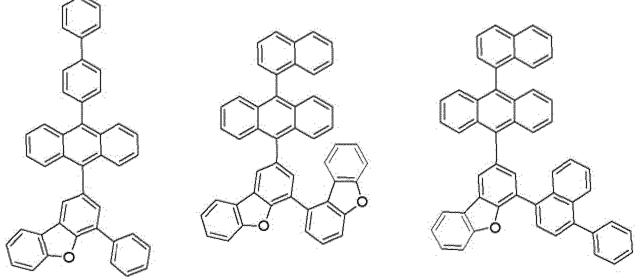

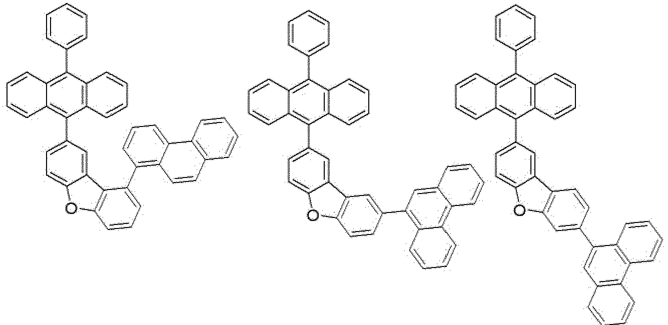

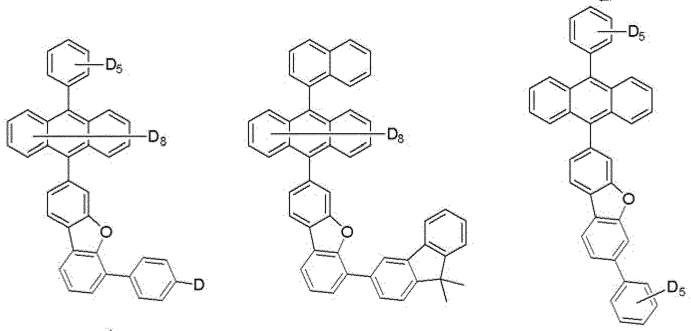

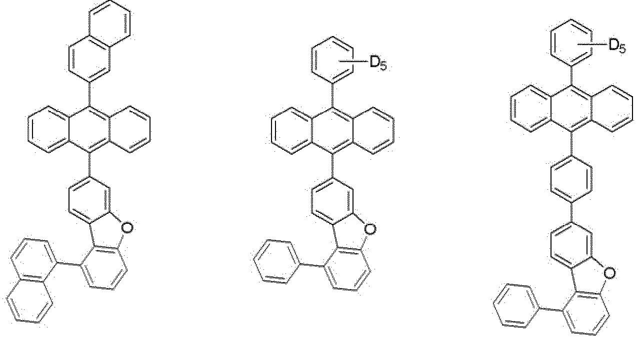

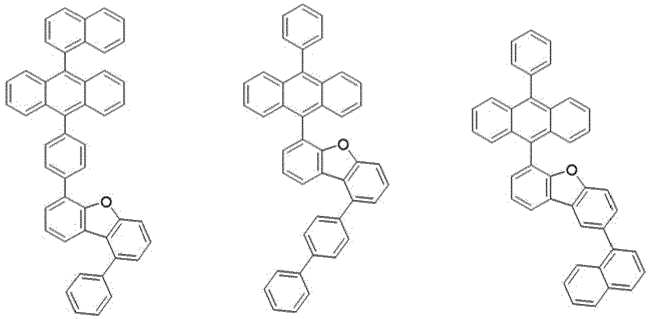

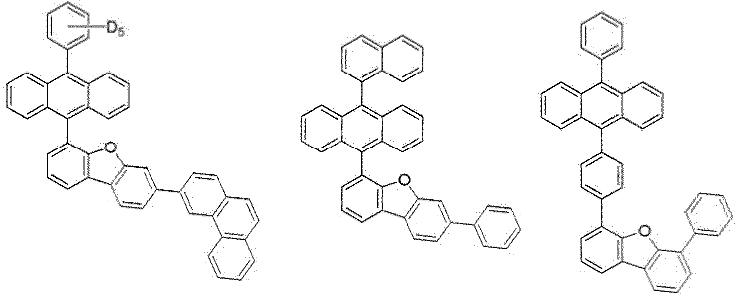

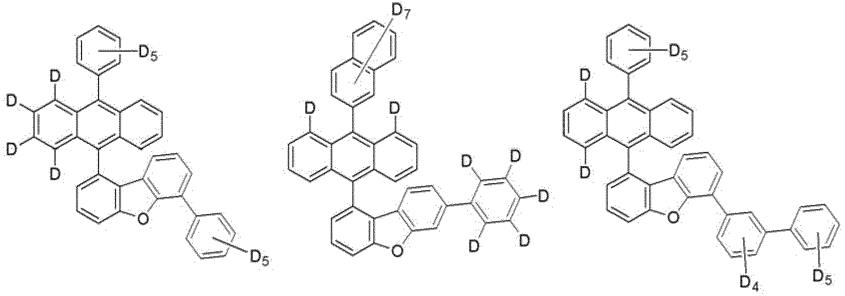

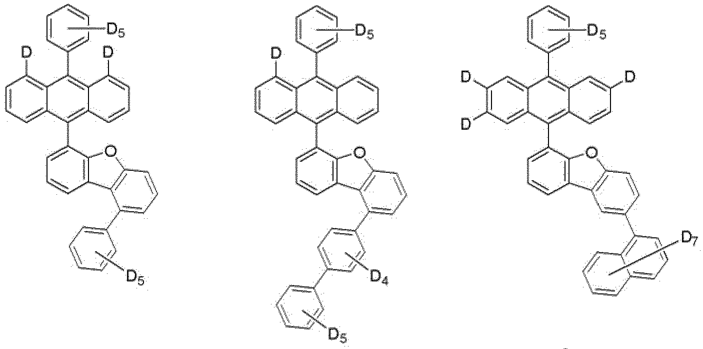

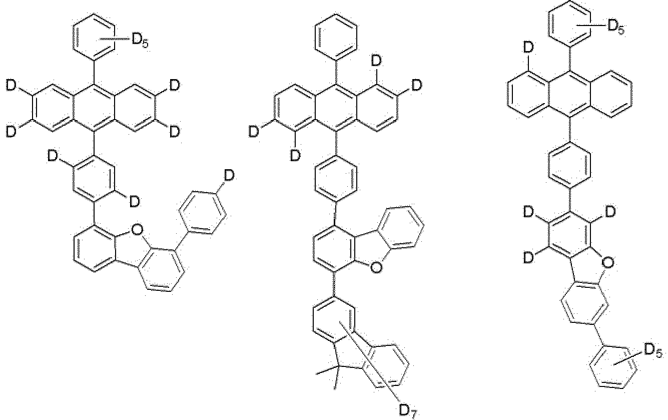

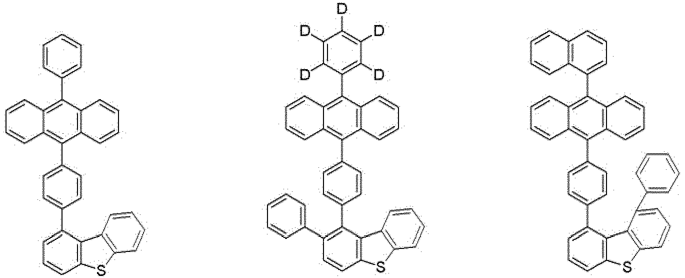

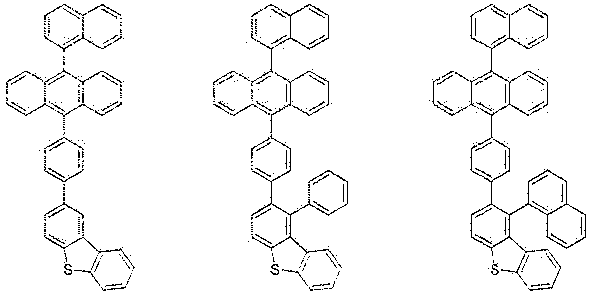

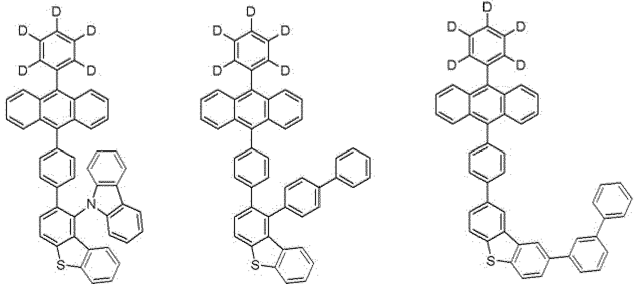

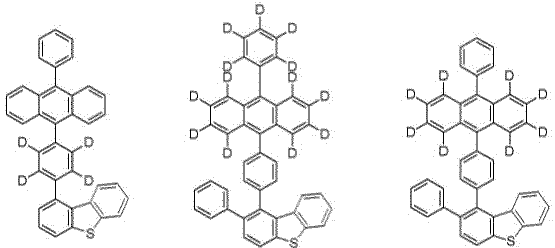

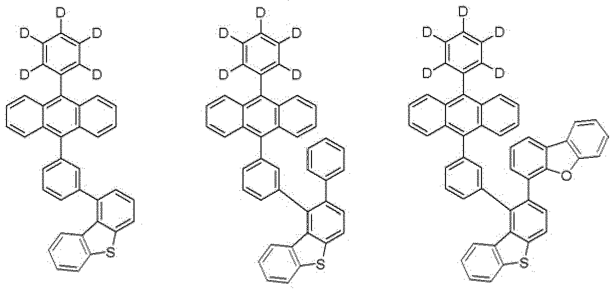

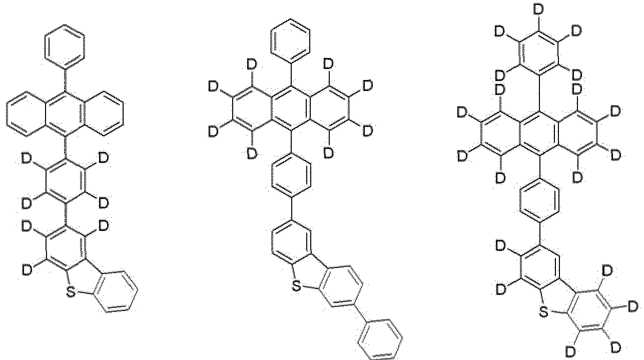

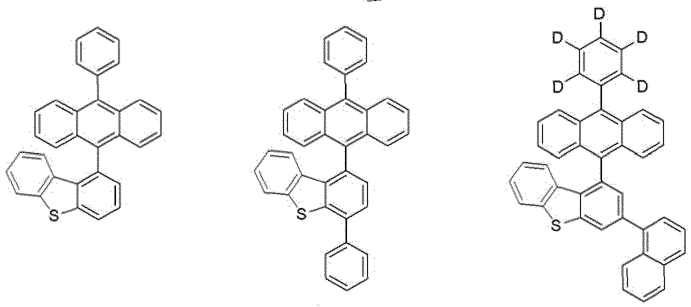

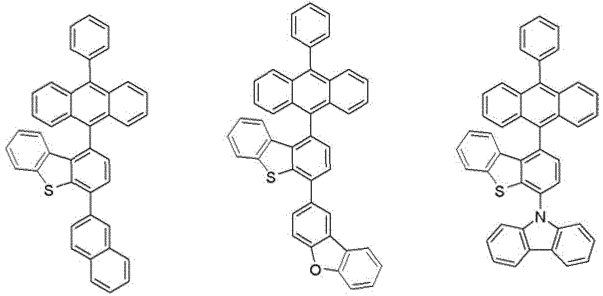

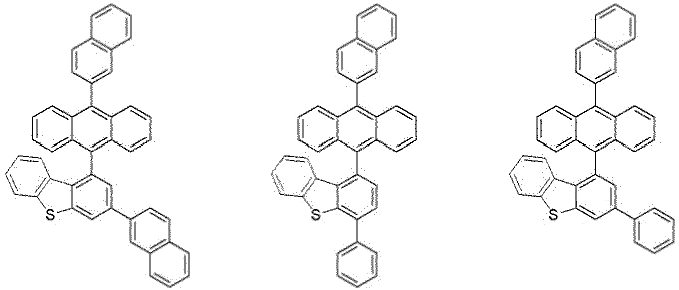

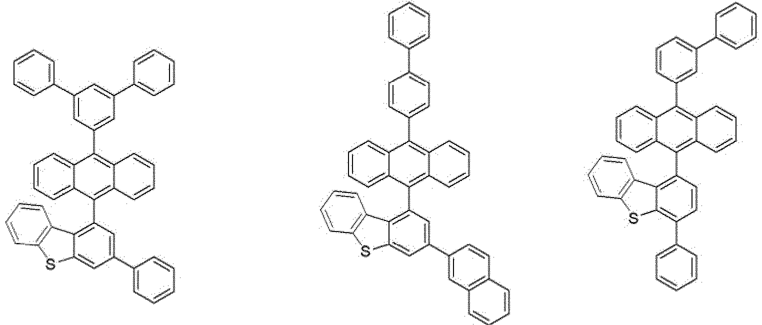

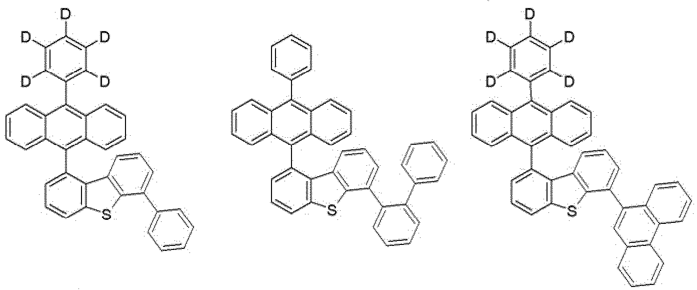

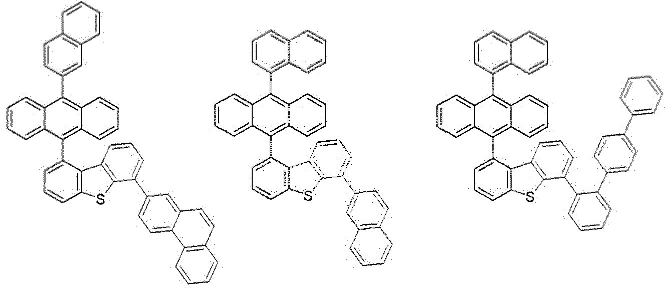

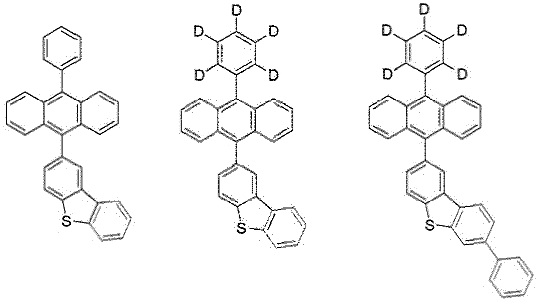

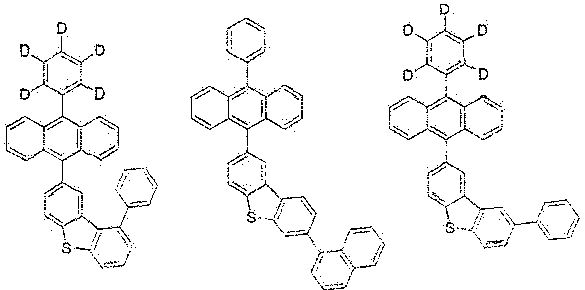

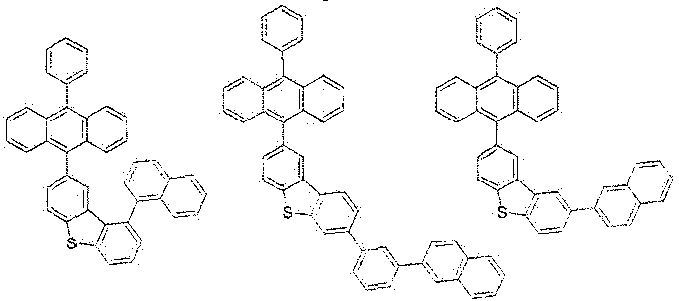

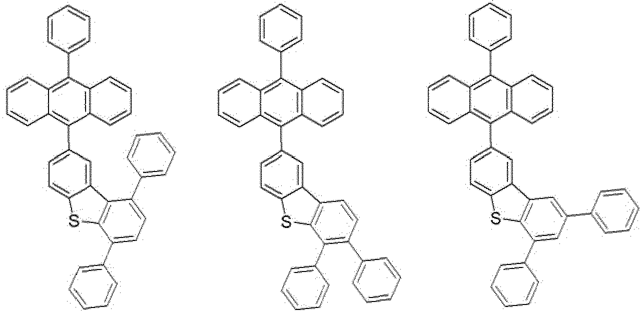

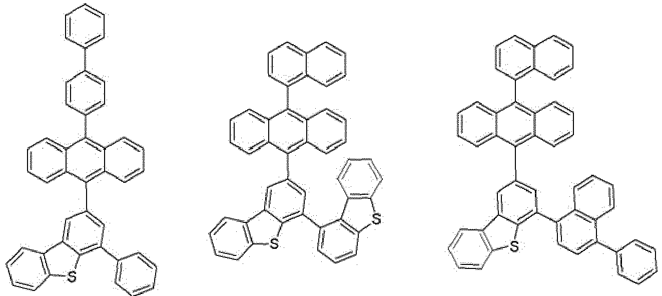

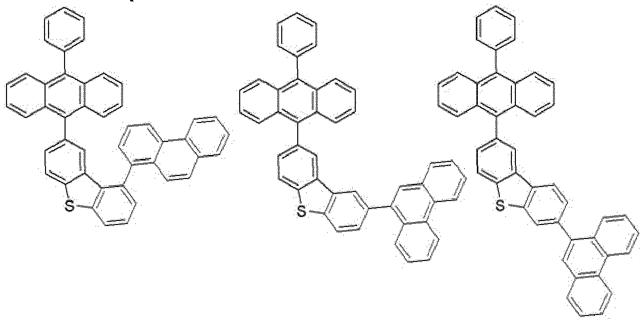

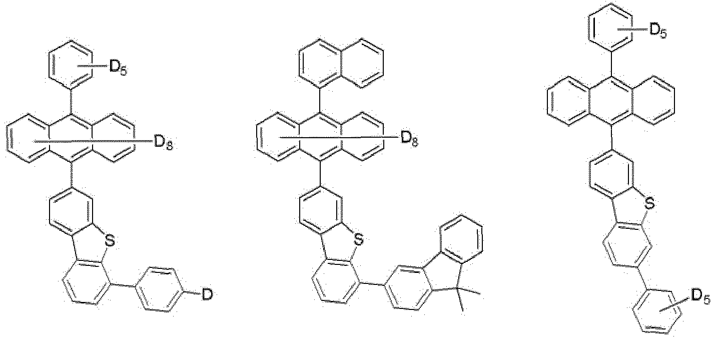

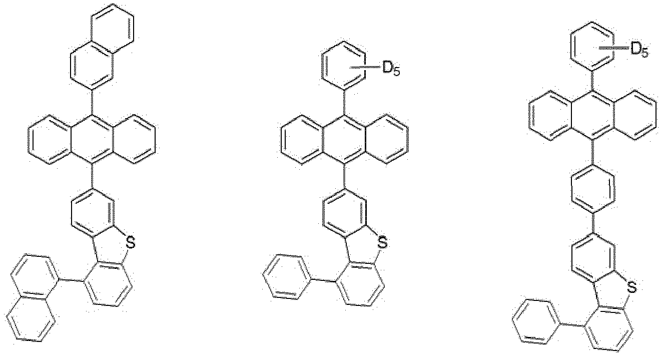

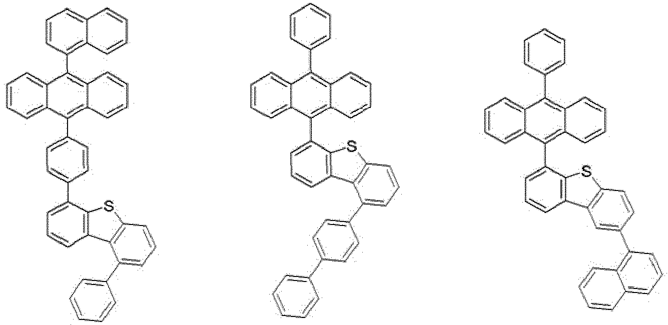

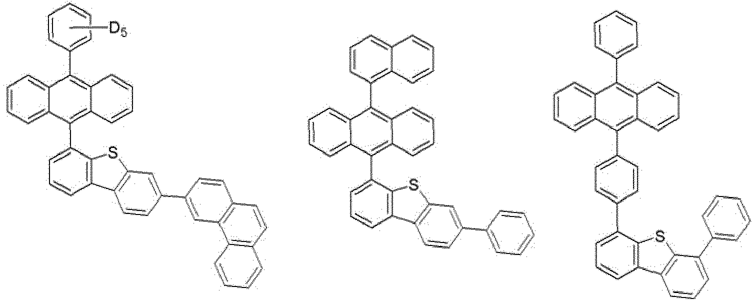

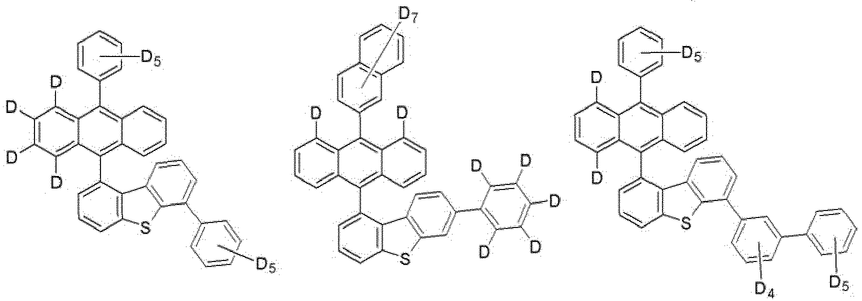

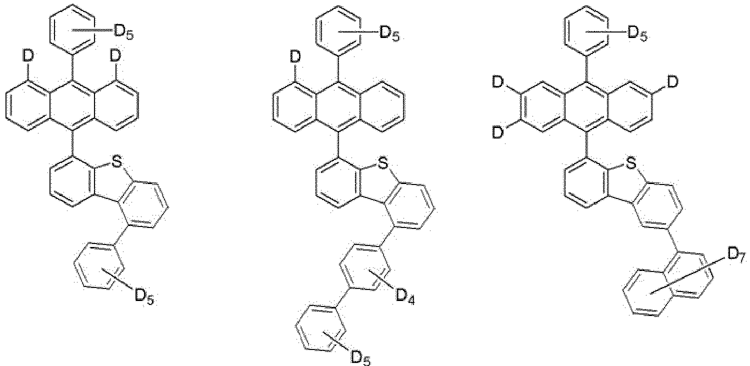

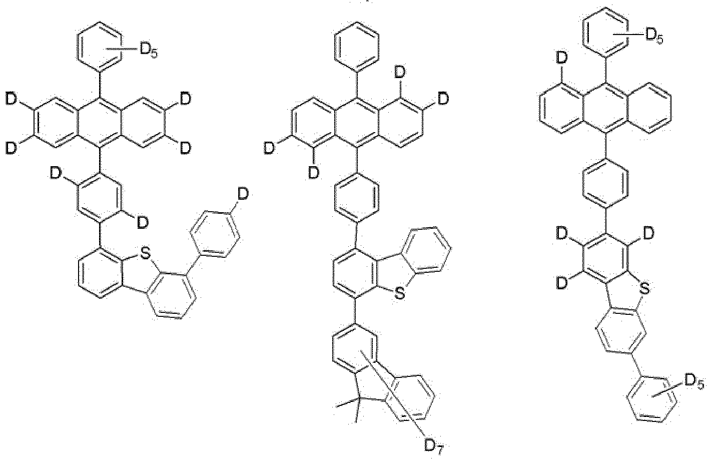

Meanwhile, a detailed structure of the organic light-emitting device according to an embodiment of the present invention, a method of manufacturing the same, and materials for the organic layers will be described as follows.

First, a substrate is coated with a material for an anode to form the anode. The substrate used herein is a substrate generally used for organic light-emitting devices and is preferably an organic substrate or a transparent plastic substrate that has excellent transparency, surface evenness, handleability and waterproofness. In addition, a material for the anode is indium tin oxide (ITO), indium zinc oxide (IZO), tin oxide (SnO₂), zinc oxide (ZnO), or the like, which is transparent and has excellent conductivity.

A hole injection layer is formed on the anode by vacuum thermal evaporation or spin coating using a material for the hole injection layer, and then a hole transport layer is formed on the hole injection layer by vacuum thermal evaporation or spin coating using a material for the hole transport layer.

The material for the hole injection layer may be used without particular limitation as long as it is commonly used in the art and specific examples thereof include 2-TNATA [4,4',4"-tris(2-naphthylphenyl-phenylamino)-triphenylamine], NPD [N,N'-di(1-naphthyl)-N,N'-diphenylbenzidine)], TPD [N,N'-diphenyl-N,N'-bis(3-methylphenyl)-1,1'-biphenyl-4,4'-diamine], DNTPD [N,N'-diphenyl-N,N'-bis-[4-(phenyl-m-tolyl-amino)-phenyl]-biphenyl-4,4'-diamine], and the like.

In addition, the material for the hole transport layer is also used without particular limitation as long as it is commonly used in the art and is, for example, N,N'-bis(3-methylphenyl)-N,N'-diphenyl-[1,1-biphenyl]-4,4'-diamine (TPD) or N,N'-di(naphthalen-1-yl)-N,N'-diphenylbenzidine (α-NPD).

Subsequently, a hole auxiliary layer and a light-emitting layer are sequentially stacked on the hole transport layer, and a hole blocking layer is selectively deposited on the light-emitting layer by vacuum deposition or spin coating to form a thin film. Because the lifetime and efficiency of the device are reduced when holes are introduced into the cathode through the organic light-emitting layer, the hole blocking layer is formed using a material having a very low HOMO (highest occupied molecular orbital) level so as to prevent this problem. The hole blocking material used herein is not particularly limited and is typically BAlq, BCP or TPBI that has an electron transport ability and has an ionization potential higher than that of a light-emitting compound.

The material used for the hole blocking layer may be BAlq, BCP, Bphen, TPBI, NTAZ, BeBq₂, OXD-7, Liq, or the like, but is not limited thereto.

An electron transport layer is deposited on the hole blocking layer through vacuum deposition or spin coating and a metal for forming a cathode is formed on the electron injection layer through vacuum thermal evaporation to form a cathode. As a result, an organic light-emitting device according to an embodiment is completed.

Here, the metal for forming the cathode may be lithium (Li), magnesium (Mg), aluminum (Al), aluminum-lithium (Al-Li), calcium (Ca), magnesium-indium (Mg-In), magnesium-silver (Mg-Ag) or the like. A transmissive cathode using ITO or IZO may be used in order to obtain a top-emission type light-emitting device.

The material for the electron transport layer functions to stably transport electrons injected from the cathode and may be a well-known electron transport material. Examples of the well-known electron transport material include quinoline derivatives, especially, tris(8-quinolinolate)aluminum (Alq3), TAZ, BAlq, beryllium bis(benzoquinolin-10-olate: Bebq2) and oxadiazole derivatives (PBD, BMD, BND, etc.).

In addition, each of the organic layers may be formed by a monomolecular deposition or solution process. The deposition is a method of forming a thin film by evaporating a material for forming each layer through heating in the presence of a vacuum or low pressure and the solution process is a method of forming a thin film by mixing a material for forming each layer with a solvent and forming the thin film from the mixture through a method such as inkjet printing, roll-to-roll coating, screen printing, spray coating, dip coating, or spin coating.

In addition, the organic light-emitting device according to the present invention may further include a light-emitting layer of a blue light-emitting material, a green light-emitting material, or a red light-emitting material that emits light in a wavelength range of 380 nm to 800 nm. That is, the light-emitting layer of the present invention includes a plurality of light-emitting layers, and a blue light-emitting material, a green light-emitting material, or a red light-emitting material in the additionally formed light-emitting layer may be a fluorescent material or a phosphorescent material.

In addition, the organic light-emitting device is used for a display or lighting system selected from flat panel displays, flexible displays, monochromatic or white flat panel lighting systems, monochromatic or white flexible lighting systems, vehicle displays, and displays for virtual or augmented reality.

### Mode for Invention

Hereinafter, the present invention will be described in more detail with reference to preferred examples. However, it will be obvious to those skilled in the art that these examples are merely provided for illustration of the present invention, and should not be construed as limiting the scope of the present invention.

### Synthesis Example 1. Synthesis of Formula 5

### Synthesis Example 1-(1): Synthesis of Intermediate 1-a

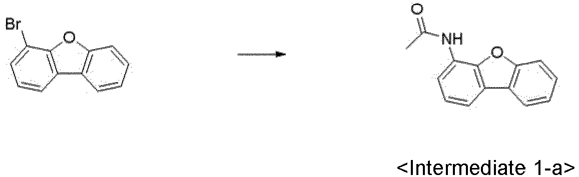

4-bromodibenzofuran (100 g, 0.405 mol), (1R,2R)-cyclohexane-1,2-diamine (46.2 g, 0.404 mol), acetamide (71.7 g, 1.21 mol), Copper (I) iodide (77.1 g, 0404 mol), potassium carbonate (200 g, 0.809 mol) and 1,000 ml of toluene were added to a round bottom flask and then stirred under reflux overnight. After the reaction was completed, the reaction product was filtered through a celite pad and washed with ethyl acetate. The filtrate was extracted with water and ethyl acetate, and the organic layer was separated. The organic layer was dehydrated with magnesium sulfate, filtered and concentrated under reduced pressure. The result was recrystallized in dichloromethane and petroleum ether to obtain 50 g of <Intermediate 1-a>. (yield 32%)

### Synthesis Example 1-(2): Synthesis of Intermediate 1-b

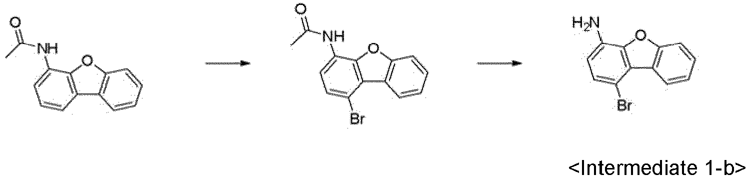

<Intermediate 1-a> (50 g, 0.222 mol) was dissolved in 600 mL of acetic acid in a round-bottom flask and stirred at room temperature. A dilution of bromine (11.37 mL, 0.222 mol) in 200 mL of acetic acid was added dropwise to the reaction solution, followed by stirring for about 4 hours. After completion of the reaction, the resulting solid was filtered and washed with water. The solid was dissolved in 1,000 mL of a tetrahydrofuran/water/ethanol (1:1:1) solution, potassium hydroxide (250 g, 1.11 mol) was added thereto, and the mixture was stirred under reflux overnight. After completion of the reaction, the solvent was concentrated under reduced pressure and extracted with ethyl acetate and water. The organic layer was separated, dehydrated with magnesium sulfate, filtered, and concentrated under reduced pressure. The result was recrystallized with ethyl acetate and heptane to obtain 40 g of <Intermediate 1-b>. (yield 68%)

### Synthesis Example 1-(3): Synthesis of Intermediate 1-c

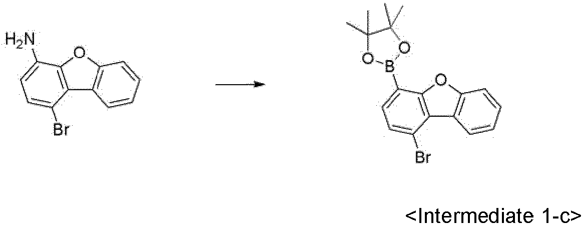

<Intermediate 1-b> (40 g, 0.153 mol), bis(pinacolato)diboron (51.7 g, 0.183 mol), and 400 ml of acetonitrile were added to a round-bottom flask and stirred at room temperature. Tert-butylnitrite (26.2 g, 0229 mol) was added portionwise to the reaction solution, followed by stirring at 80°C for 2 hours. After completion of the reaction, the reaction product was cooled to room temperature. The reaction solution was concentrated under reduced pressure and separated by column chromatography to obtain 20 g of <Intermediate 1-c>. (yield 35%)

### Synthesis Example 1-(4): Synthesis of Intermediate 1-d

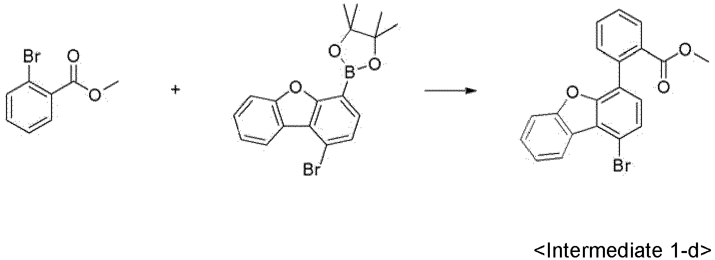

Methyl 2-bromo-benzoate (15.7 g, 73 mmol), <Intermediate 1-c> (32.8 g, 88 mmol), tetrakis(triphenylphosphine)palladium (1.7 g, 0.15 mmol) and potassium carbonate (20.2 g, 146.7 mmol) were added to a round-bottom flask, and 125 mL of toluene, 125 mL of tetrahydrofuran, and 50 mL of water were further added thereto. The temperature of the reactor was raised to 80°C and stirring was performed for 10 hours. When the reaction was completed, the temperature of the reactor was lowered to room temperature, the reaction product was extracted with ethyl acetate, and the organic layer was separated. The organic layer was concentrated under reduced pressure and separated by column chromatography to obtain 18.6 g of <Intermediate 1-d>. (yield 67%)

### Synthesis Example 1-(5): Synthesis of Intermediate 1-e

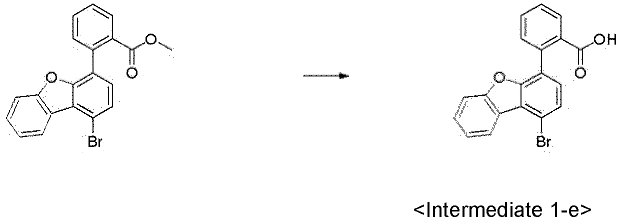

<Intermediate 1-d> (17.1 g, 45 mmol), sodium hydroxide (2.14 g, 54 mmol), and 170 mL of ethanol were added to a round-bottom flask, followed by stirring under reflux for 48 hours. Completion of the reaction was identified by thin layer chromatography and then the reaction product was cooled to room temperature. The cooled solution was acidified by dropwise addition of 2-normal hydrochloric acid thereto and the resulting solid was stirred for 30 minutes and then filtered. The resulting product was recrystallized with dichloromethane and n-hexane to obtain 14.2 g of <Intermediate 1-e>. (yield 86%)

### Synthesis Example 1-(6): Synthesis of Intermediate 1-f

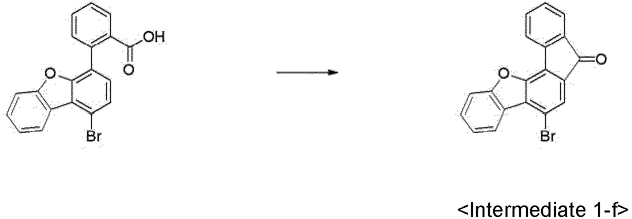

<Intermediate 1-e> (14.3 g, 39 mmol) and 145 mL of methanesulfonic acid were added to a round-bottom flask, the temperature was raised to 80°C, and the mixture was stirred for 3 hours. Completion of the reaction was identified by thin film chromatography and then the reaction product was cooled to room temperature. The reaction solution was slowly added dropwise to 150 mL of ice water, followed by stirring for 30 minutes. The resulting solid was filtered and washed with water and methanol to obtain 12.0 g of <Intermediate 1-f>. (yield 88%)

### Synthesis Example 1-(7): Synthesis of Intermediate 1-q

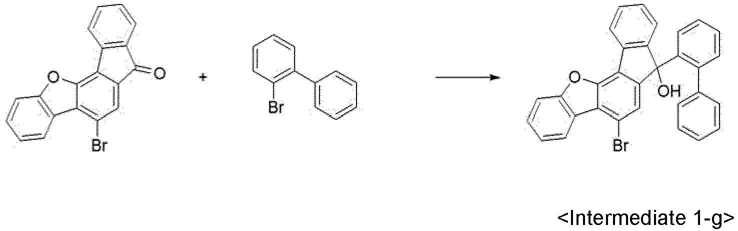

2-bromobiphenyl (8.4 g, 0.036 mol) and 110 mL of tetrahydrofuran were added to a round-bottom flask, and cooled to -78°C in a nitrogen atmosphere. Normal butyllithium (19.3 mL, 0.031 mol) was added dropwise to the cooled reaction solution at the same temperature. <Intermediate 1-f> (9.1 g, 0.026 mol) was added portionwise to the reaction solution, followed by stirring at room temperature. When the color of the reaction solution changed, completion of the reaction was identified by TLC. The reaction was terminated by addition of 50 mL of H₂O and the reaction product was extracted with ethyl acetate and water. The organic layer was separated, concentrated under reduced pressure and recrystallized with acetonitrile to obtain 10.2 g of <Intermediate 1-g>. (yield 78%)

### Synthesis Example 1-(8): Synthesis of Intermediate 1-h

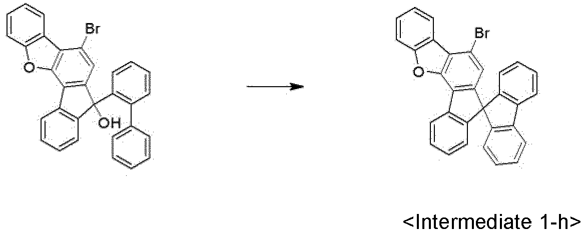

<Intermediate 1-g> (10.6 g, 0.021 mol), 120 mL of acetic acid, and 2 mL of sulfuric acid were added to a round-bottom flask, followed by stirring under reflux for 5 hours. When a solid was formed, completion of the reaction was identified by thin film chromatography and the reaction product was then cooled to room temperature. The resulting solid was filtered, washed with H₂O and methanol, dissolved in monochlorobenzene, filtered through silica gel, concentrated and cooled to room temperature to obtain 8.6 g of <Intermediate 1-h>. (yield 84%)

### Synthesis Example 1-(9): Synthesis of Intermediate 1-i

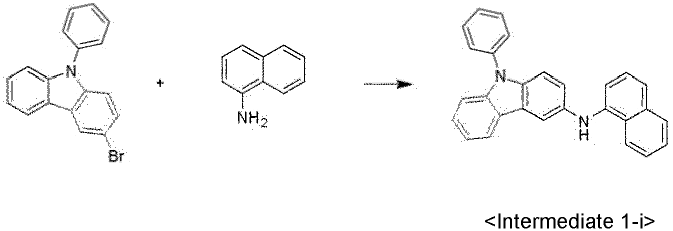

3-bromo-9-phenyl-9H-carbazole (11.3 g, 0.035 mol), 1-naphthylamine (5.6 g, 0.039 mol), tris(dibenzylideneacetone)dipalladium (0) (0.65 g, 0.0007 mol), sodium tert-butoxide (6.79 g, 0.0706 mol), 2,2'-bis(diphenylphosphino)-1,1'-binaphthalene (0.44 g, 0.0007 mol) and 100 mL of toluene were added to a round-bottom flask, followed by stirring under reflux for 3 hours. After completion of the reaction, the mixture was cooled to room temperature and extracted with ethyl acetate and water. The organic layer was separated, dehydrated with magnesium sulfate, and then concentrated under reduced pressure. The result was separated by column chromatography to obtain 11.3 g of <Intermediate 1-i>. (yield 84%)

### Synthesis Example 1-(10): Synthesis of Formula 5

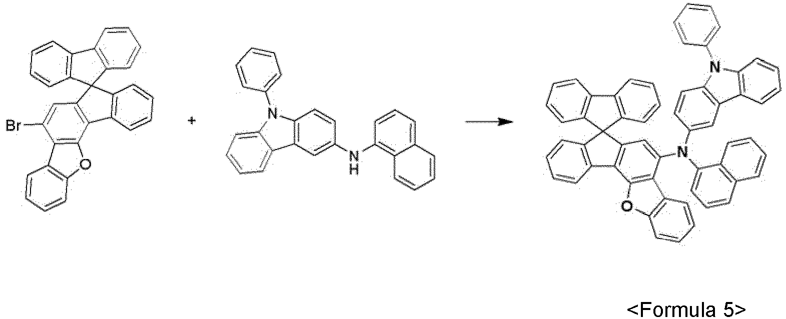

<Intermediate 1-h> (4.4 g, 0.009 mol), <Intermediate 1-i> (5.0 g, 0.013 mol), palladium (II) acetate (0.08 g, 0.4 mmol), sodium tert-butoxide (3.4 g, 0.035 mol), tri-tert-butylphosphine (0.07 g, 0.4 mmol), and toluene (60 mL) were added to a round-bottom flask, followed by stirring under reflux for 2 hours. After completion of the reaction, the reaction product was cooled to room temperature. The reaction solution was extracted with dichloromethane and water. The organic layer was separated, dehydrated with magnesium sulfate, and then concentrated under reduced pressure. The product was separated, purified by column chromatography and recrystallized with dichloromethane and acetone to obtain 3.3 g of <Formula 5> (yield 46%). MS (MALDI-TOF): m/z 788.28[M⁺]

### Synthesis Example 2: Synthesis of Formula 8

### Synthesis Example 2-(1): Synthesis of Formula 8

<Formula 8> (yield 44%) was synthesized in the same manner as in Synthesis Example 1-(9) and Synthesis Example 1-(10) except that 2-bromo-9-phenyl-9H-carbazole was used instead of 3-bromo-9-phenyl-9H-carbazole used in Synthesis Example 1-(9), and 2-amino-9,9-dimethylfluorene was used instead of 1-naphthylamine.
MS (MALDI-TOF) : m/z 854.33[M⁺]

### Synthesis Example 3: Synthesis of Formula 47

### Synthesis Example 3-(1): Synthesis of Intermediate 3-a

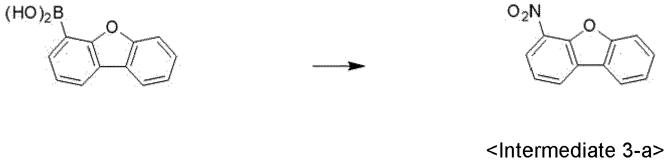

4-dibenzofuranboronic acid (85.0 g, 401 mmol), bismuth (III) nitrate pentahydrate (99.2 g, 200 mmol), and 400 mL of toluene were added to a round-bottom flask, followed by stirring at 70°C in a nitrogen atmosphere for 3 hours. After completion of the reaction, the reaction product was cooled to room temperature and the resulting solid was filtered. The filtrate was washed with toluene to obtain 61.5 g of <Intermediate 3-a>. (yield 72%)

### Synthesis Example 3-(2): Synthesis of Intermediate 3-b

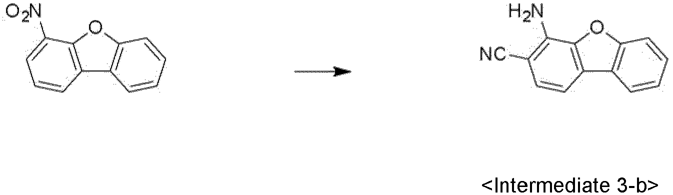

Ethylcyanoacetate (202.9 g, 1.794 mol) and 500 ml of dimethylformamide were added to a round-bottom flask. Potassium hydroxide (67.10 g, 1.196 mol) and potassium cyanide (38.95 g, 0.598 mol) were further added thereto, and 200 mL of dimethylformamide was further added thereto, followed by stirring at room temperature. <Intermediate 3-a> (127. g, 0.737 mol) was added portionwise to the reaction solution, followed by stirring at 50°C for 72 hours. After completion of the reaction, 200 mL of a sodium hydroxide aqueous solution (25%) was added to the reaction product, followed by stirring under reflux for 3 hours. The reaction product was cooled to room temperature and extracted with ethyl acetate and water. The organic layer was separated, concentrated under reduced pressure, and then purified by column chromatography to obtain 20.0 g of <Intermediate 3-b>. (yield 16%)

### Synthesis Example 3-(3): Synthesis of Intermediate 3-c

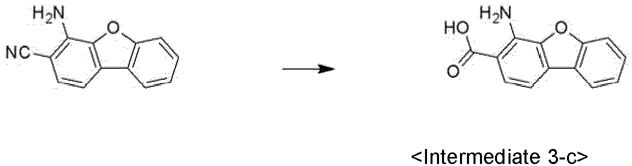

<Intermediate 3-b> (20.0 g, 96 mmol), 600 mL of ethanol, and 170 mL of an aqueous potassium hydroxide solution (142.26 g, 2.53 mol) were added to a round-bottom flask, followed by stirring under reflux for 12 hours. When the reaction was completed, the reaction product was cooled to room temperature. 400 mL of 6N hydrochloric acid was added to the reaction solution to acidify the reaction product, and the resulting solid was stirred for 20 minutes and then filtered. The solid was washed with ethanol to obtain 17.0 g of <Intermediate 3-c>. (yield 88%)

### Synthesis Example 3-(4): Synthesis of Intermediate 3-d

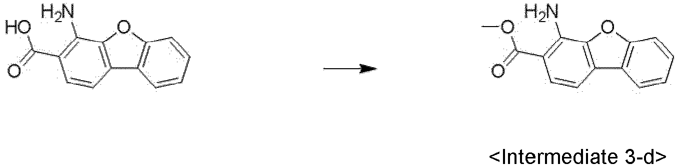

<Intermediate 3-c> (17.0 g, 75 mmol) and 15 mL of sulfuric acid were added to a round-bottom flask, followed by stirring under reflux for 72 hours. After completion of the reaction, the mixture was cooled to room temperature and extracted with ethyl acetate and water. The organic layer was separated and washed with an aqueous sodium hydrogen carbonate solution. An excess of methanol was added to the organic layer during concentration under reduced pressure and the resulting solid was filtered to obtain 14.0 g of <Intermediate 3-d>. (yield 78%)

### Synthesis Example 3-(5): Synthesis of Intermediate 3-e

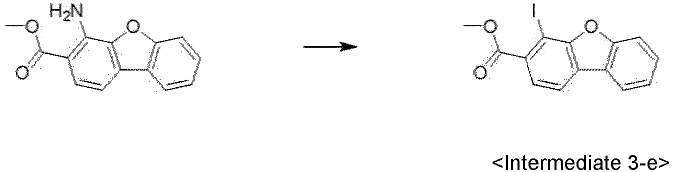

<Intermediate 3-d> (12 g, 50 mmol), 15 mL of hydrochloric acid, and 75 mL of water were added to a round-bottom flask, cooled to 0°C and stirred for 1 hour. 38 mL (5.6 g, 81 mmol) of an aqueous sodium nitrite solution was added dropwise at the same temperature to the reaction solution, followed by stirring for 1 hour. 38 mL of an aqueous potassium iodide solution (22.4 g, 135 mmol) was added dropwise while the temperature of the reaction solution was kept within 5°C or less. The resulting product was stirred at room temperature for 5 hours. After completion of the reaction, the mixture was washed with an aqueous sodium thiosulfate solution and extracted with ethyl acetate and water. The organic layer was separated, concentrated under reduced pressure, and then separated by column chromatography to obtain 11 g of <Intermediate 3-e>. (yield 91%)

### Synthesis Example 3-(6): Synthesis of Intermediate 3-f

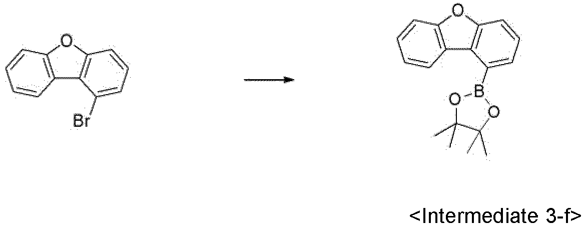

1-bromodibenzofuran (20.0 g, 81 mmol), bis(pinacolato)diboron (26.7 g, 105 mmol), [1,1'-bis(diphenylphosphino)ferrocene]dichloro palladium (1.3 g, 0.002 mol), potassium acetate (19.9 g, 202 mmol), and 200 mL of 1,4-dioxane were added to a round-bottom flask, followed by stirring under reflux for 10 hours. The reaction product was concentrated under reduced pressure and then was separated by column chromatography. The result was recrystallized with dichloromethane and heptane to obtain 17.0 g of <Intermediate 3-f>. (yield 70%)

### Synthesis Example 3-(7): Synthesis of Intermediate 3-q

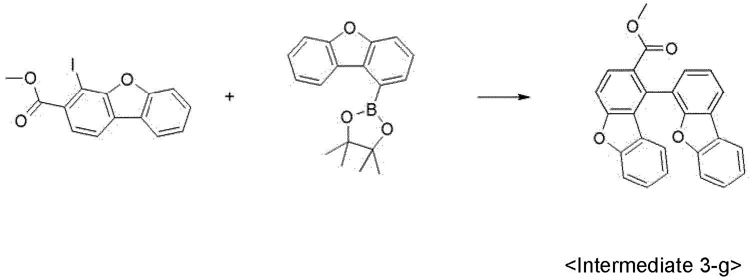

<Intermediate 3-g> (yield 75%) was obtained in the same synthesis manner as in Synthesis Example 1-(4), except that <Intermediate 3-e> was used instead of methyl 2-bromo-benzoate and <Intermediate 3-f> was used instead of <Intermediate 1-c>.

### Synthesis Example 3-(8): Synthesis of Intermediate 3-h

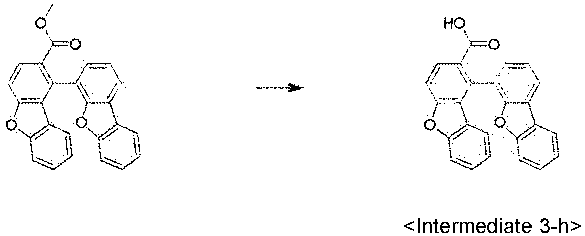

<Intermediate 3-h> (yield 77%) was obtained in the same synthesis manner as in Synthesis Example 1-(5), except that <Intermediate 3-g> was used instead of <Intermediate 1-d>.

### Synthesis Example 3-(9): Synthesis of Intermediate 3-i

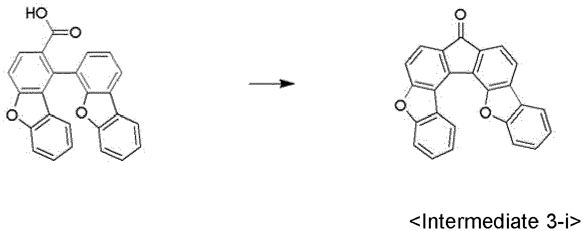

<Intermediate 3-i> (yield 94%) was obtained in the same synthesis manner as in Synthesis Example 1-(6), except that <Intermediate 3-h> was used instead of <Intermediate 1-e>.

### Synthesis Example 3-(10): Synthesis of Intermediate 3-j

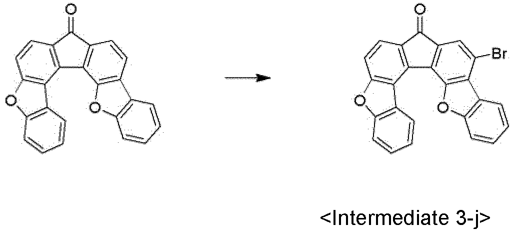

<Intermediate 3-i> (44 g, 122 mmol>, 600 mL of dichloromethane was added to a round-bottom flask, followed by stirring at room temperature. A dilution of bromine (13.7 mL, 85 mmol) in 50 mL of dichloromethane was added dropwise, followed by stirring for about 3 hours. The reaction product was recrystallized with methanol to obtain 40.7 g of <Intermediate 3-j>. (yield 76%)

### Synthesis Example 3-(11): Synthesis of Intermediate 3-k

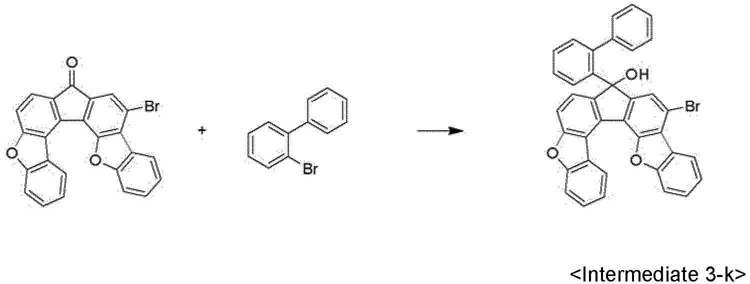

<Intermediate 3-k> (yield 74%) was obtained in the same synthesis manner as in Synthesis Example 1-(7), except that <Intermediate 3-j> was used instead of <Intermediate 1-f>.

### Synthesis Example 3-(12): Synthesis of Intermediate 3-l

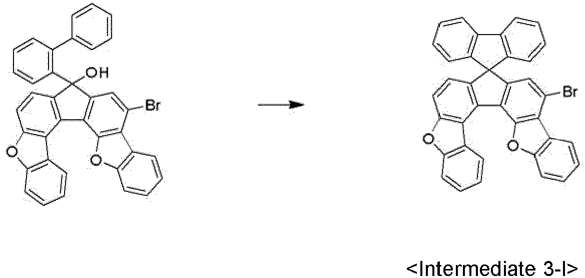

<Intermediate 3-l> (yield 86%) was obtained in the same synthesis manner as in Synthesis Example 1-(8), except that <Intermediate 3-k> was used instead of <Intermediate 1-g>.

### Synthesis Example 3-(13): Synthesis of Formula 47

<Formula 47> (yield 45%) was obtained in the same synthesis manner as in Synthesis Example 1-(9) and Synthesis Example 1-(10) except that 4-tert-butylaniline was used instead of 1-naphthylamine in Synthesis Example 1-(9) and <Intermediate 3-l> was used instead of <Intermediate 1-h> in Synthesis Example 1-(10).

MS (MALDI-TOF) : m/z 884.34[M⁺]

### Synthesis Example 4: Synthesis of Formula 54

### Synthesis Example 4-(1): Synthesis of Intermediate 4-a

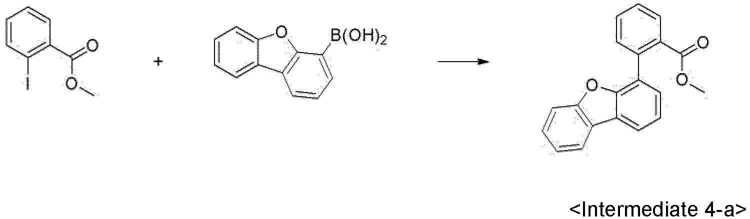

Methyl 2-iodobenzoate (19.1 g, 73 mmol), 4-dibenzofuran boronic acid (18.7 g, 88 mmol), tetrakis (triphenylphosphine)palladium (1.7 g, 0.15 mmol), and potassium carbonate (20.2 g, 146.7 mmol) were added to a round-bottom flask, and 125 mL of toluene, 125 mL of tetrahydrofuran, and 50 mL of water were further added thereto. The temperature of the reactor was raised to 80°C, followed by stirring for 10 hours. When the reaction was completed, the temperature of the reactor was lowered to room temperature, the reaction product was extracted with ethyl acetate, and the organic layer was separated. The organic layer was concentrated under reduced pressure and separated by column chromatography to obtain 9.5 g of <Intermediate 4-a>. (yield 43%)

### Synthesis Example 4-(2): Synthesis of Intermediate 4-b

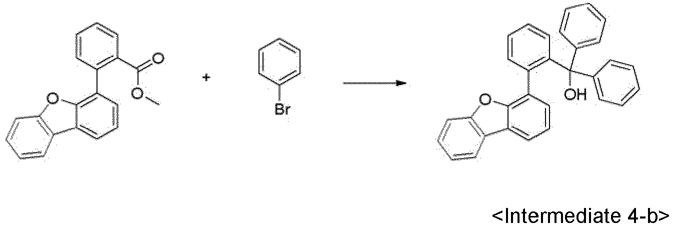

Bromobenzene (13.2 g, 83.97 mmol) and 250 mL of tetrahydrofuran were added to a round-bottom flask, followed by stirring in a nitrogen atmosphere at low temperature. About 58 mL of n-butyllithium was slowly added dropwise at -78°C for 2 hours and then <Intermediate 4-a> (9.4 g, 31.1 mmol) was added thereto. After completion of the reaction, 100 mL of water was added, followed by stirring for 30 minutes and extraction to obtain 3.2 g of <Intermediate 4-b>. (yield 24%)

### Synthesis Example 4-(3): Synthesis of Intermediate 4-c

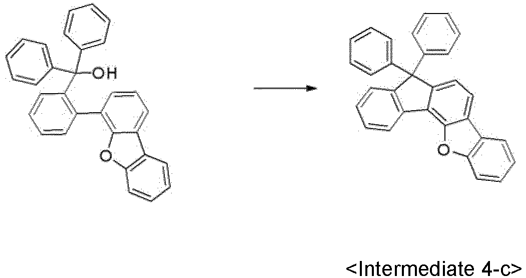

<Intermediate 4-b> (55.0 g, 129 mmol), 500 mL of acetic acid, and 10 mL of sulfuric acid were added to a round-bottom flask, followed by stirring under reflux for 5 hours. After completion of the reaction, the reaction product was cooled to room temperature and the resulting solid was filtered. The result was washed with methanol to obtain 50 g of <Intermediate 4-c>. (yield 95%)

### Synthesis Example 4-(4): Synthesis of Intermediate 4-d

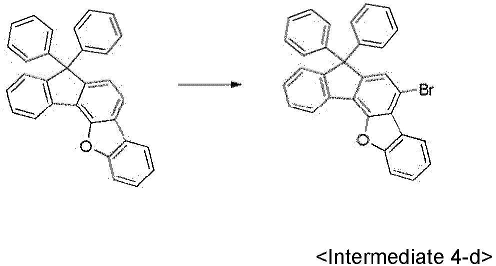

<Intermediate 4-c> (50 g, 122 mmol>, 600 mL of dichloromethane was added to a round-bottom flask, followed by stirring at room temperature. A dilution of bromine (13.7 mL, 85 mmol) in 50 mL of dichloromethane was added dropwise, followed by stirring for about 3 hours. The reaction product was recrystallized with methanol to obtain 45 g of <Intermediate 4-d>. (yield 76%)

### Synthesis Example 4-(5): Synthesis of Formula 54

<Formula 54> (yield 44%) was obtained in the same synthesis manner as in Synthesis Example 1-(9) and Synthesis Example 1-(10) except that aniline-2,3,4,5,6-d5 was used instead of 1-naphthylamine in Synthesis Example 1-(9) and <Intermediate 4-d> was used instead of <Intermediate 1-h> in Synthesis Example 1-(10).

MS (MALDI-TOF) : m/z 745.31[M⁺]

### Synthesis Example 5: Synthesis of Formula 52

### Synthesis Example 5-(1): Synthesis of Formula 52

<Formula 52> (yield 45%) was obtained in the same synthesis manner as in Synthesis Example 1-(9) and Synthesis Example 1-(10) except that 3-aminodibenzofuran was used instead of 1-naphthylamine in Synthesis Example 1-(9) and <Intermediate 4-d> was used instead of <Intermediate 1-h> in Synthesis Example 1-(10).
MS (MALDI-TOF) : m/z 830.29[M⁺]

### Synthesis Example 6: Synthesis of Formula 41

### Synthesis Example 6-(1): Synthesis of Intermediate 6-a

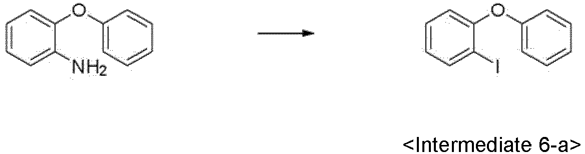

2-phenoxyaniline (25.0 g, 0.135 mol), 30 mL of hydrochloric acid, and 150 mL of water were added to a round-bottom flask, cooled to 0°C and stirred for 1 hour. 75 mL (11.2 g, 0.162 mmol) of an aqueous sodium nitrite solution was added dropwise at the same temperature to the reaction solution, followed by stirring for 1 hour. 75 mL of an aqueous potassium iodide solution (44.8 g, 0.270 mol) was added dropwise while the temperature of the reaction solution was kept within 5°C or less. The resulting product was stirred at room temperature for 5 hours. After completion of the reaction, the mixture was washed with an aqueous sodium thiosulfate solution and extracted with ethyl acetate and water. The organic layer was separated, concentrated under reduced pressure, and then separated by column chromatography to obtain 22.6 g of <Intermediate 6-a>. (yield 56%)

### Synthesis Example 6-(2): Synthesis of Intermediate 6-b

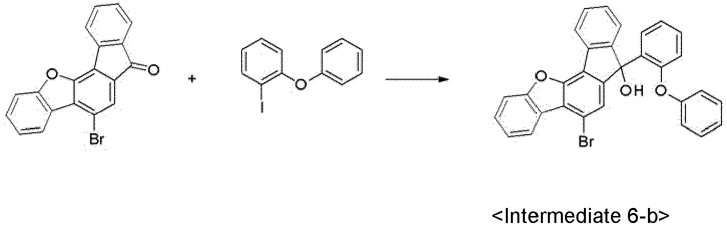

<Intermediate 6-b> (yield 70%) was obtained in the same synthesis manner as in in Synthesis Example 1-(7), except that <Intermediate 6-a> was used instead of 2-bromobiphenyl used in Synthesis Example 1-(7).

### Synthesis Example 6-(3): Synthesis of Intermediate 6-c

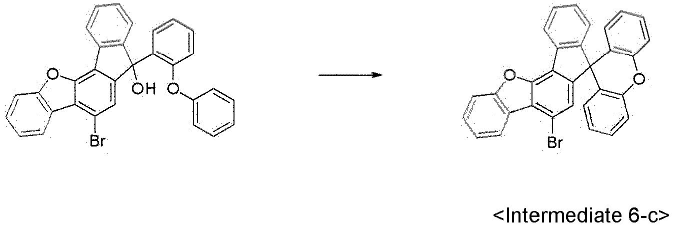

<Intermediate 6-c> (yield 75%) was obtained in the same synthesis manner as in Synthesis Example 1-(8), except that <Intermediate 6-b> was used instead of <Intermediate 1-g> used in Synthesis Example 1-(8).

### Synthesis Example 6-(4): Synthesis of Formula 41

<Formula 41> (yield 44%) was obtained in the same synthesis manner as in Synthesis Example 1-(9) and Synthesis Example 1-(10), except that 2-bromo-9-phenyl-9H-carbazole was used instead of 3-bromo-9-phenyl-9H-carbazole used in Synthesis Example 1-(9), 4-tert-butylaniline was used instead of 1-naphthylamine and <Intermediate 6-c> was used instead of <Intermediate 1-h> used in Synthesis Example 1-(10).
MS (MALDI-TOF): m/z 810.32 [M⁺]

### Synthesis Example 7: Synthesis of Formula 88

### Synthesis Example 7-(1): Synthesis of Intermediate 7-a

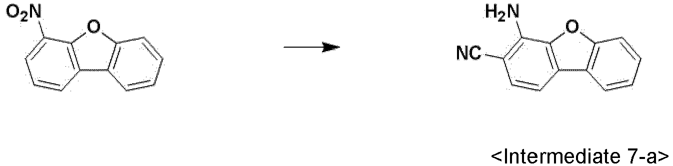

Ethyl cyanoacetate (202.9 g, 1.794 mol) and 500 ml of dimethylformamide were added to a round-bottom flask. Potassium hydroxide (67.1 g, 1.196 mol) and potassium cyanide (38.95 g, 0.598 mol) were further added thereto, and 200 mL of dimethylformamide was further added thereto, followed by stirring at room temperature. 4-nitrobenzofuran (127.5 g, 0.737 mol) was added portionwise to the reaction solution, followed by stirring at 50°C for 72 hours. After completion of the reaction, 200 mL of an aqueous sodium hydroxide solution (25%) was added to the reaction product, followed by stirring under reflux for 3 hours. The reaction product was cooled to room temperature and extracted with ethyl acetate and water. The organic layer was separated, concentrated under reduced pressure, and then purified by column chromatography to obtain 20.0 g of <Intermediate 7-a>. (yield 17%)

### Synthesis Example 7-(2): Synthesis of Intermediate 7-b

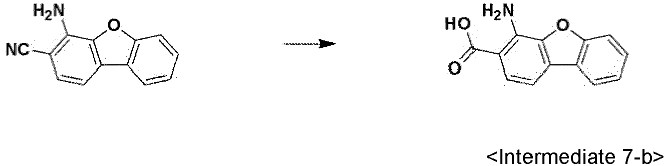

<Intermediate 7-a> (20.0 g, 96 mmol), 600 mL of ethanol, and 170 mL (142.26 g, 2.53 mol) of an aqueous potassium hydroxide solution were added to a round-bottom flask, followed by stirring under reflux for 12 hours. When the reaction was completed, the reaction product was cooled to room temperature. 400 mL of 6N hydrochloric acid was added to the reaction solution to acidify the reaction product, and the resulting solid was stirred for 20 minutes and then filtered. The solid was washed with ethanol to obtain 17.0 g of <Intermediate 7-b>. (yield 88%)

### Synthesis Example 7-(3): Synthesis of Intermediate 7-c

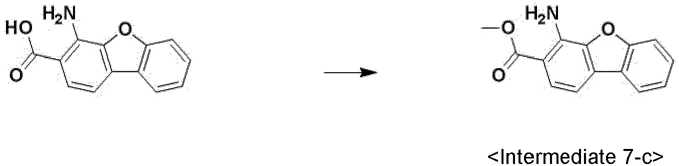

<Intermediate 7-b> (17.0 g, 75 mmol) and 15 mL of sulfuric acid were added to a round-bottom flask, followed by stirring under reflux for 72 hours. After completion of the reaction, the mixture was cooled to room temperature and extracted with ethyl acetate and water. The organic layer was separated and washed with an aqueous sodium hydrogen carbonate solution. An excess of methanol was added to the organic layer during concentration under reduced pressure and the resulting solid was filtered to obtain 14.0 g of <Intermediate 7-c>. (yield 78%)

### Synthesis Example 7-(4): Synthesis of Intermediate 7-d

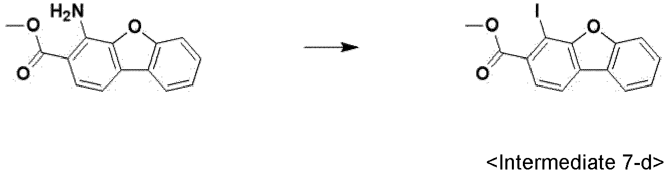

<Intermediate 7-c> (14.0 g, 0.058 mmol), 20 mL of hydrochloric acid, and 100 mL of water were added to a round-bottom flask, cooled to 0°C and stirred for 1 hour. 50 mL (7.4 g, 0.116 mol) of an aqueous sodium nitrite solution was added dropwise at the same temperature to the reaction solution, followed by stirring for 1 hour. 100 mL of an aqueous potassium iodide solution (30.0 g, 0.180 mol) was added dropwise while the temperature of the reaction solution was kept within 5°C or less. The resulting product was stirred at room temperature for 5 hours. After completion of the reaction, the mixture was washed with an aqueous sodium thiosulfate solution and extracted with ethyl acetate and water. The organic layer was separated, concentrated under reduced pressure, and then separated by column chromatography to obtain 9.1 g of <Intermediate 7-d>. (yield 48%)

### Synthesis Example 7-(5): Synthesis of Intermediate 7-e

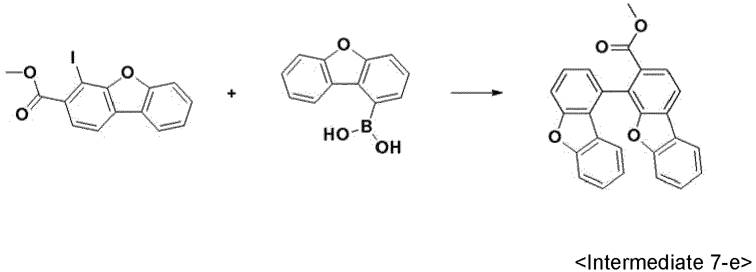

<Intermediate 7-d> (9.3 g, 25 mmol), 1-dibenzofuran boronic acid (8.3 g, 28 mmol), tetrakis(triphenylphosphine)palladium (0.6 g, 0.05 mmol) and potassium carbonate (6.7 g, 50 mmol) were added to a round-bottom flask, and 50 mL of toluene, 50 mL of tetrahydrofuran, and 20 mL of water were further added thereto. The temperature of the reactor was raised to 80°C and stirring was performed for 10 hours. When the reaction was completed, the temperature of the reactor was lowered to room temperature, the reaction product was extracted with ethyl acetate, and the organic layer was separated. The organic layer was concentrated under reduced pressure and separated by column chromatography to obtain 5.3 g of <Intermediate 7-e>. (yield 52%)

### Synthesis Example 7-(6): Synthesis of Intermediate 7-f

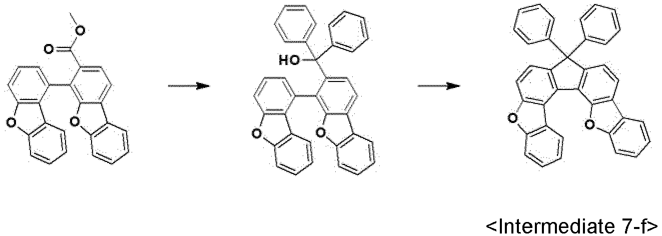

Bromobenzene (25.5 g, 0.163 mol) and 170 mL of tetrahydrofuran were added to a round-bottom flask and the resulting product was cooled to -78°C under a nitrogen atmosphere. Butyllithium (1.6 M) (95.6 mL, 0.153 mol) was slowly added dropwise to the cooled reaction solution. The resulting product was stirred at the same temperature for 1 hour and <Intermediate 7-e> (20.0 g, 0.051 mol) was added thereto, followed by stirring at room temperature for 3 hours. After completion of the reaction, 50 mL of water was added, followed by stirring for 30 minutes. The result was extracted with ethyl acetate and water and the organic layer was separated and concentrated under reduced pressure. 200 mL of acetic acid and 1 mL of hydrochloric acid were added to the concentrate, followed by stirring at an elevated temperature of 80°C. After completion of the reaction, the mixture was filtered at room temperature and washed with methanol to obtain 20.0 g of <Intermediate 7-f>. (yield 78%)

### Synthesis Example 7-(7): Synthesis of Intermediate 7-q

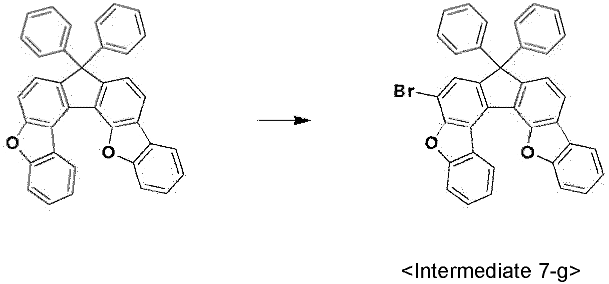

<Intermediate 7-g> (yield 55%) was obtained in the same synthesis manner as in in Synthesis Example 3-(10), except that <Intermediate 7-f> was used instead of <Intermediate 3-i> used in Synthesis Example 3-(10).

### Synthesis Example 7-(8): Synthesis of Formula 88

<Formula 88> (yield 46%) was obtained in the same synthesis manner as in Synthesis Example 1-(9) and Synthesis Example 1-(10), except that 4-bromo-9-phenyl-9H-carbazole was used instead of 3-bromo-9-phenyl-9H-carbazole used in Synthesis Example 1-(9), and <Intermediate 7-g> was used instead of <Intermediate 1-h> used in Synthesis Example 1-(10). MS (MALDI-TOF): m/z 956.34 [M⁺]

### Synthesis Example 8: Synthesis of Formula 101

### Synthesis Example 8-(1): Synthesis of Intermediate 8-a

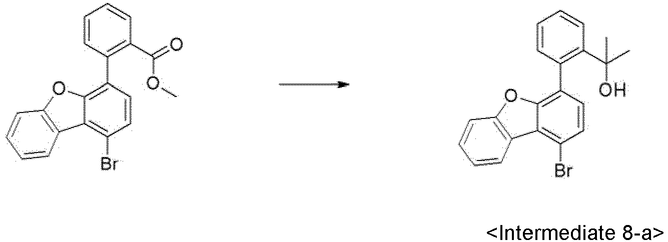

<Intermediate 1-d> (30.5 g, 80 mmol) was added to a round-bottom flask containing 250 mL of tetrahydrofuran, and then the temperature was lowered to -78°C under nitrogen. 30 minutes later, 1.0 M methyl magnesium bromide (210 mL, 240 mmol) was slowly added dropwise. 1 hour later, 1.0 M methyl magnesium bromide (210 mL, 240 mmol) was slowly added dropwise and then warmed to room temperature. The reaction product was stirred at room temperature for about 2 hours, and an aqueous ammonium chloride solution was added dropwise thereto. The result was extracted, distilled under reduced pressure, and recrystallized with hexane to obtain 24.4 g of <Intermediate 8-a> (yield 80%).

### Synthesis Example 8-(2): Synthesis of Intermediate 8-b

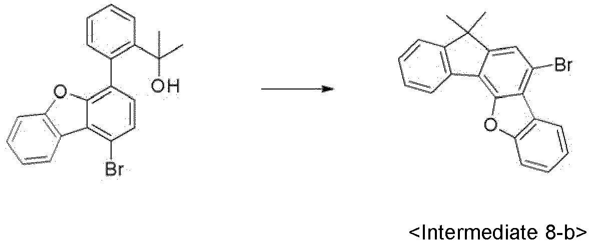

<Intermediate 8-a> (25.2 g, 66 mmol) was added to a round-bottom flask containing 300 mL of acetic acid, followed by stirring at -0°C for 10 minutes. 350 mL of phosphoric acid was added thereto, followed by stirring at room temperature for about 1 hour. The product was neutralized with an aqueous sodium hydroxide solution, extracted, and then concentrated under reduced pressure. The result was separated by column chromatography to obtain 17.5 g of <Intermediate 8-b>. (yield 73%)

### Synthesis Example 8-(3): Synthesis of Formula 101

<Formula 101> (yield 45%) was obtained in the same synthesis manner as in Synthesis Example 1-(9) and Synthesis Example 1-(10), except that 3-bromo-9-(1-naphtyl)-9H-carbazole was used instead of 3-bromo-9-phenyl-9H-carbazole used in Synthesis Example 1-(9), 2-naphthylamine was used instead of 1-naphthylamine, and <Intermediate 8-b> was used instead of <Intermediate 1-h> used in Synthesis Example 1-(10).
MS (MALDI-TOF): m/z 716.28 [M⁺]

### Synthesis Example 9: Synthesis of Formula 102

### Synthesis Example 9-(1): Synthesis of Formula 102

<Formula 102> (yield 48%) was obtained in the same synthesis manner as in Synthesis Example 1-(9) and Synthesis Example 1-(10), except that aniline was used instead of 1-naphthylamine used in Synthesis Example 1-(9), and <Intermediate 8-b> was used instead of <Intermediate 1-h> used in Synthesis Example 1-(10).
MS (MALDI-TOF): m/z 616.25 [M⁺]

### Synthesis Example 10: Synthesis of Formula 103

### Synthesis Example 10-(1): Synthesis of Formula 103

<Formula 103> (yield 43%) was obtained in the same synthesis manner as in Synthesis Example 1-(9) and Synthesis Example 1-(10), except that 2-bromo-9-phenyl-9H-carbazole was used instead of 3-bromo-9-phenyl-9H-carbazole used in Synthesis Example 1-(9), 4-(1-naphthyl)aniline was used instead of 1-naphthylamine, and <Intermediate 8-b> was used instead of <Intermediate 1-h> used in Synthesis Example 1-(10).
MS (MALDI-TOF) : m/z 742.30 [M⁺]

### Synthesis Example 11: Synthesis of Formula 104

### Synthesis Example 11-(1): Synthesis of Formula 104

<Formula 104> (yield 44%) was obtained in the same synthesis manner as in in Synthesis Example 1-(9) and Synthesis Example 1-(10), except that 2-bromo-9-phenyl-9H-carbazole was used instead of 3-bromo-9-phenyl-9H-carbazole used in Synthesis Example 1-(9), 2-amino-9,9-dimethylfluorene was used instead of 1-naphthylamine, and <Intermediate 8-b> was used instead of <Intermediate 1-h> used in Synthesis Example 1-(10).
MS (MALDI-TOF): m/z 732.31 [M⁺]

### Synthesis Example 12: Synthesis of Formula 91

### Synthesis Example 12-(1): Synthesis of Intermediate 12-a

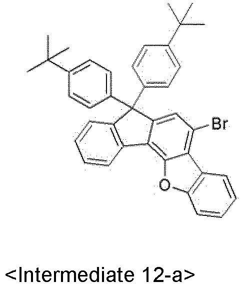

<Intermediate 12-a> (yield 70%) was obtained in the same synthesis manner as in Synthesis Example 4-(2) to Synthesis Example 4-(4), except that 1-bromo-4-tert-butylbenzene was used instead of bromobenzene used in Synthesis Example 4-(2).

### Synthesis Example 12-(2): Synthesis of Formula 91

<Formula 91> (yield 45%) was obtained in the same synthesis manner as in Synthesis Example 1-(9) and Synthesis Example 1-(10), except that 3-aminodibenzofuran was used instead of 1-naphthylamine and <Intermediate 12-a> was used instead of <Intermediate 1-h> used in Synthesis Example 1-(10).
MS (MALDI-TOF): m/z 942.42 [M⁺]

### <[Formula C] or [Formula D] Synthesis Example>

### Synthesis Example 1. Synthesis of Compound 1

### Synthesis Example 1-1. Synthesis of <Intermediate 1-a>

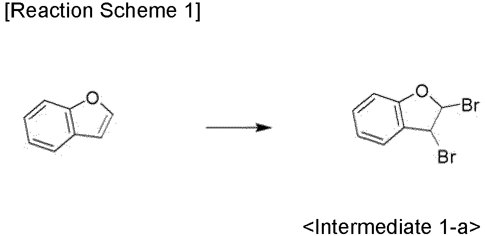

50 g (423 mmol) of benzofuran and 500 mL of dichloromethane are added to a 1 L reactor, followed by stirring. The reaction product was cooled to -10°C, and a dilution of 67.7 g (423 mmol) of bromine in 100 mL of dichloromethane was added dropwise to the reaction product, followed by stirring at 0°C for 2 hours. After completion of the reaction, an aqueous sodium thiosulfate solution was added thereto, followed by stirring and extraction with ethyl acetate and H₂O. The organic layer was concentrated under reduced pressure and recrystallized with ethanol to obtain 100 g of <Intermediate 1-a>. (yield 93%)

### Synthesis Example 1-2. Synthesis of <Intermediate 1-b>

### <Intermediate 1-b> was synthesized by the following [Reaction Scheme 2].

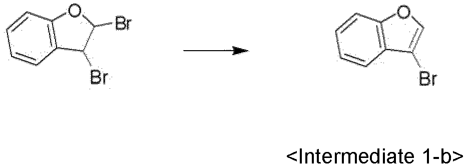

48.6 g (866 mmol) of potassium hydroxide was dissolved in 400 mL of ethanol in a 1L reactor. A solution of 120 g (433 mmol) of <Intermediate 1-A> in ethanol was added dropwise thereto at 0°C, followed by stirring under reflux for 2 hours. After completion of the reaction, the ethanol organic layer was concentrated under reduced pressure and extracted with ethyl acetate and water. The result was separated by column chromatography to obtain 42 g of <intermediate 1-b>. (yield 50%)

### Synthesis Example 1-3. Synthesis of <Intermediate 1-c>

### <Intermediate 1-c> was synthesized by the following [Reaction Scheme 3].

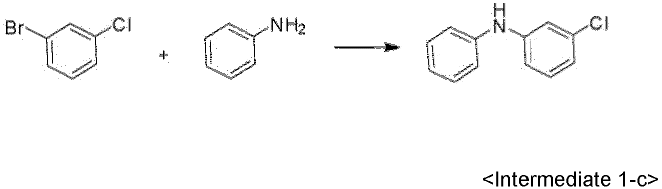

4.5 g (16 mmol) of 1-bromo-3-iodobenzene, 5.8 g (16 mmol) of aniline, 0.1 g (1 mmol) of palladium acetate, 3 g (32 mmol) of sodium tert-butoxide, 0.2 g (1 mmol) of bis(diphenylphosphino)-1,1'-binaphthyl and 45 mL of toluene were added to a 100 mL reactor, followed by stirring under reflux for 24 hours. After completion of the reaction, the product was filtered and the filtrate was concentrated and separated by column chromatography to obtain 5.2 g of <Intermediate 1-c>. (yield 82%)

### Synthesis Example 1-4. Synthesis of <Intermediate 1-d>

### <Intermediate 1-d> was synthesized by the following [Reaction Scheme 4].

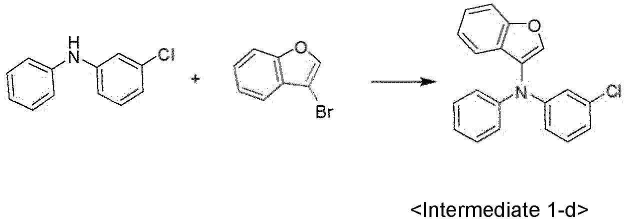

20 g (98 mmol) of <Intermediate 1-c>, 18.4 g (98 mmol) of <Intermediate 1-b>, 0.5 g (2 mmol) of palladium acetate, 18.9 g (196 mmol) of sodium tert-butoxide, 0.8 g (4 mmol) of tri-tert-butylphosphine, and 200 mL of toluene were added to a 250 mL reactor, followed by stirring under reflux for 5 hours. After completion of the reaction, the product was filtered and the filtrate was concentrated and separated by column chromatography to obtain 22 g of <Intermediate 1-d>. (yield 75%)

### Synthesis Example 1-5. Synthesis of <Intermediate 1-e>

### <Intermediate 1-e> was synthesized by the following [Reaction Scheme 5].

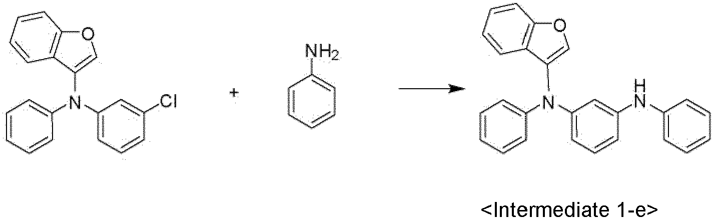

18.5 g of <Intermediate 1-e> was obtained in the same manner as in Synthesis Example 1-3, except that <Intermediate 1-d> was used instead of 1-bromo-4-iodobenzene. (yield 74.1%)

### Synthesis Example 1-6. Synthesis of <Intermediate 1-f>

### <Intermediate 1-f> was synthesized by the following [Reaction Scheme 6].

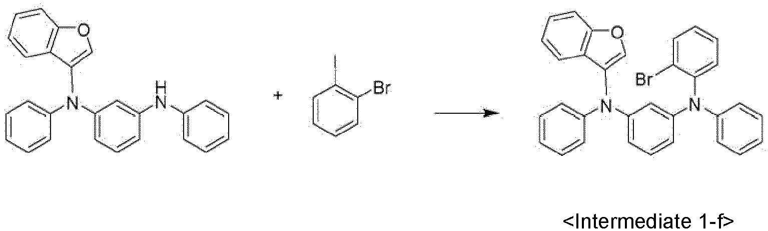

12 g of <Intermediate 1-f> was obtained in the same manner as in Synthesis Example 1-4, except that <Intermediate 1-e> and 1-bromo-2-iodobenzene were used instead of <Intermediate 1-c> and <Intermediate 1-b>. (yield 84.1%)

### Synthesis Example 1-7. Synthesis of <Compound 1>

### <Compound 1> was synthesized by the following [Reaction Scheme 7].

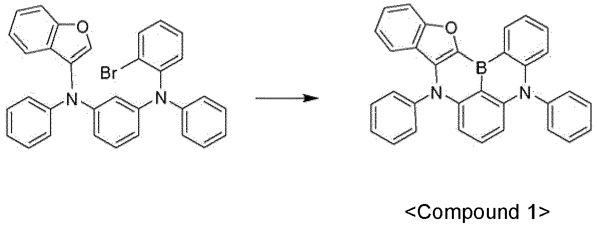

12 g (23 mmol) of <Intermediate 1-f> and 120 mL of tert-butylbenzene were added to a 300 mL reactor. 42.5 mL (68 mmol) of n-butyllithium was added dropwise thereto at -78°C. Then, the mixture was stirred at 60°C for 3 hours. Then, the heptane was removed by purging with nitrogen at 60°C. 11.3 g (45 mmol) of boron tribromide was added dropwise at -78°C. Then, the mixture was stirred at room temperature for 1 hour, and 5.9 g (45 mmol) of N,N-diisopropylethylamine was added dropwise at 0°C. Then, the mixture was stirred at 120°C for 2 hours. After completion of the reaction, a sodium acetate solution was added thereto at room temperature, followed by stirring. The result was extracted with ethyl acetate, and the organic layer was concentrated and separated by column chromatography to obtain 0.8 g of <Compound 1>. (yield 13%)
MS (MALDI-TOF): m/z 460.17 [M⁺]

### Synthesis Example 2. Synthesis of Compound 2

### Synthesis Example 2-1. Synthesis of <Intermediate 2-a>

### <Intermediate 2-a> was synthesized by the following [Reaction Scheme 8].

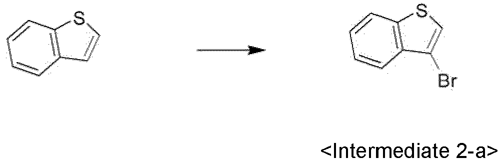

50 g (373 mmol) of benzothiophene and 500 mL of dichloromethane are added to a 1 L reactor, followed by stirring. The reaction product was cooled to -0°C, and a dilution of 59.5 g (373 mmol) of bromine in 100 mL of chloroform was added dropwise to the reaction product, followed by stirring at room temperature for 4 hours. After completion of the reaction, an aqueous sodium thiosulfate solution was added thereto, followed by stirring and extraction with ethyl acetate and H₂O. The organic layer was concentrated under reduced pressure and separated by column chromatography to obtain 70 g of <Intermediate 2-a>. (yield 91%)

### Synthesis Example 2-2. Synthesis of <Intermediate 2-b>

### <Intermediate 2-b> was synthesized by the following [Reaction Scheme 9].

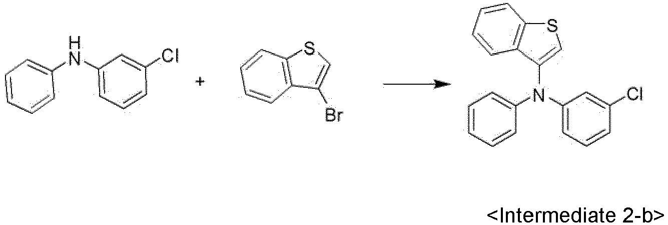

32 g of <Intermediate 2-b> was obtained in the same manner as in Synthesis Example 1-4, except that <Intermediate 2-a> was used instead of <Intermediate 1-b>. (yield 75.4%)

### Synthesis Example 2-3. Synthesis of <Intermediate 2-c>

### <Intermediate 2-c> was synthesized by the following [Reaction Scheme 10].

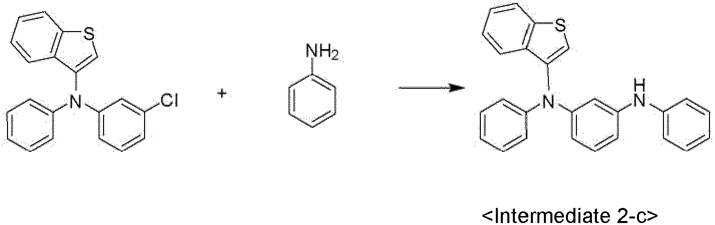

24.5 g of <Intermediate 2-c> was obtained in the same manner as in Synthesis Example 1-3, except that <Intermediate 2-b> was used instead of 1-bromo-4-iodobenzene. (yield 73.1%)

### Synthesis Example 2-4. Synthesis of < Intermediate 2-d>

### <Intermediate 2-d> was synthesized by the following [Reaction Scheme 11].

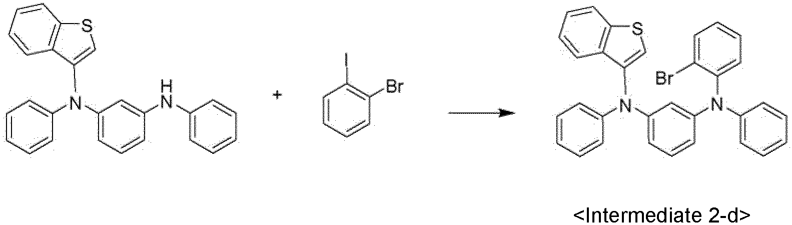

21 g of <Intermediate 2-d> was obtained in the same manner as in Synthesis Example 1-4, except that <Intermediate 2-c> and 1-bromo-2-iodobenzene were used instead of <Intermediate 1-c> and <Intermediate 1-b>. (yield 77.5%)

### Synthesis Example 2-5. Synthesis of <Compound 2>

### <Compound 2> was synthesized by the following [Reaction Scheme 12].

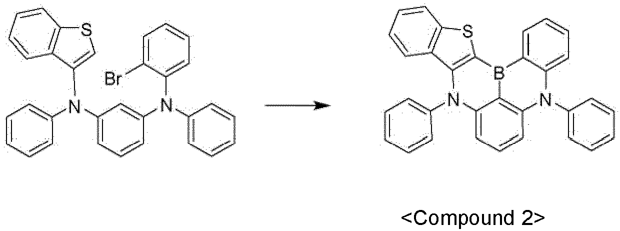

1.5 g of <Compound 2> was obtained in the same manner as in Synthesis Example 1-7, except that <Intermediate 2-d> was used instead of <Intermediate 1-f>. (yield 10.1%)
MS (MALDI-TOF): m/z 467.15 [M⁺]

### Synthesis Example 3. Synthesis of Compound 13

### Synthesis Example 3-1. Synthesis of <Intermediate 3-a>

### <Intermediate 3-a> was synthesized by the following [Reaction Scheme 13].

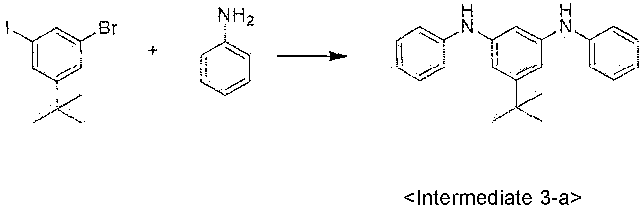

50 g (177 mmol) of 1-bromo-3(tert-butyl)-5-iodobenzene, 36.2 g (389 mmol) of aniline, 1.6 g (7 mmol) of palladium acetate, 51 g (530 mmol) of sodium tert-butoxide, 4.4 g (7 mmol) of bis(diphenylphosphino)-1,1'-binaphthyl, and 500 mL of toluene were added to a 1L reactor, followed by stirring under reflux for 24 hours. After completion of the reaction, the reaction product was filtered. The filtrate was concentrated and separated by column chromatography to obtain 42.5 g of <Intermediate 3-a>. (yield 50%)

### Synthesis Example 3-2. Synthesis of <Intermediate 3-b>

### <Intermediate 3-b> was synthesized by the following [Reaction Scheme 14].

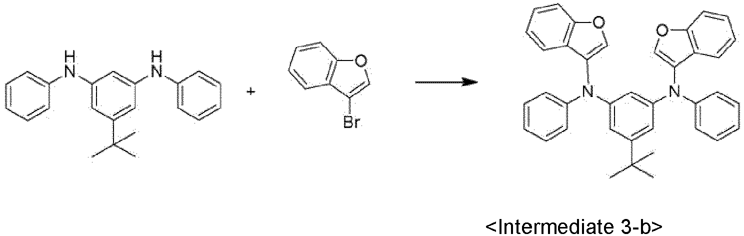

11 g (42 mmol) of <Intermediate 3-a>, 20 g (101 mmol) of <Intermediate 1-b>, 1 g (2 mmol) of palladium acetate, 12.2 g (127 mmol) of sodium tert-butoxide, 0.7 g (3 mmol) of tri-tert-butylphosphine and 150 mL of toluene were added to a 250 mL reactor, followed by stirring under reflux for 5 hours. After completion of the reaction, the reaction product was filtered and the filtrate was concentrated and then separated by column chromatography to obtain 11 g of <Intermediate 3-b>. (yield 65%)

### Synthesis Example 3-3. Synthesis of <Compound 13>

### <Compound 13> was synthesized by the following [Reaction Scheme 15].

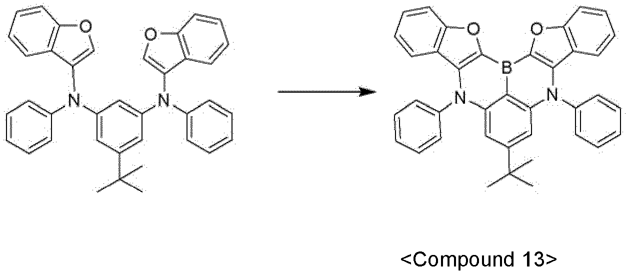

0.5 g of <Compound 13> was obtained in the same manner as in Synthesis Example 1-7, except that <Intermediate 3-b> was used instead of <Intermediate 1-f>. (yield 8%) MS (MALDI-TOF): m/z 556.23 [M⁺]

### Synthesis Example 4. Synthesis of Compound 65

### Synthesis Example 4-1. Synthesis of <Intermediate 4-a>

### <Intermediate 4-a> was synthesized by the following [Reaction Scheme 16].

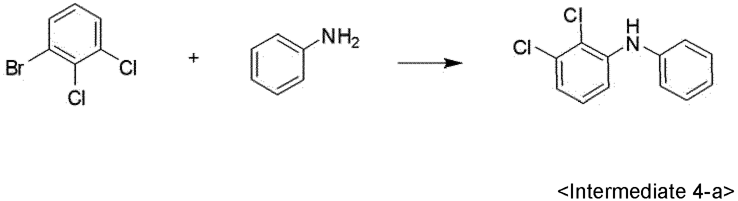

35.6 g of <Intermediate 4-a> was obtained in the same manner as in Synthesis Example 1-3, except that 1-bromo-2,3-dichlorobenzene was used instead of 1-bromo-4-iodobenzene. (yield 71.2%)

### Synthesis Example 4-2. Synthesis of <Intermediate 4-b>

### <Intermediate 4-b> was synthesized by the following [Reaction Scheme 17].

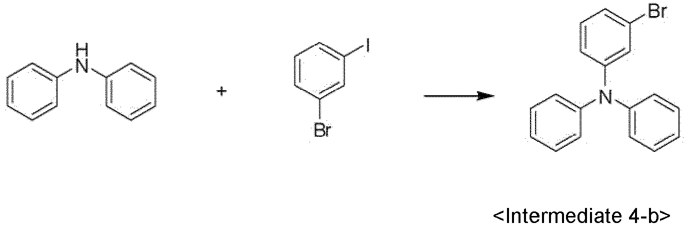

60.0 g (355 mmol) of diphenylamine, 100.3 g (355 mmol) of 1-bromo-3-iodobenzene, 0.8 g (4 mmol) of palladium acetate, 2 g (4 mmol) of xantphos, 68.2 g (709 mmol) of sodium tertiary butoxide, and 700 mL of toluene were added to a 2 L reactor, followed by stirring under reflux for 2 hours. After completion of the reaction, the resulting product was filtered at room temperature, concentrated under reduced pressure, and separated by column chromatography to obtain 97 g of <Intermediate 4-b>. (yield 91.2%)

### Synthesis Example 4-3. Synthesis of <Intermediate 4-c>

### <Intermediate 4-c> was synthesized by the following [Reaction Scheme 18].

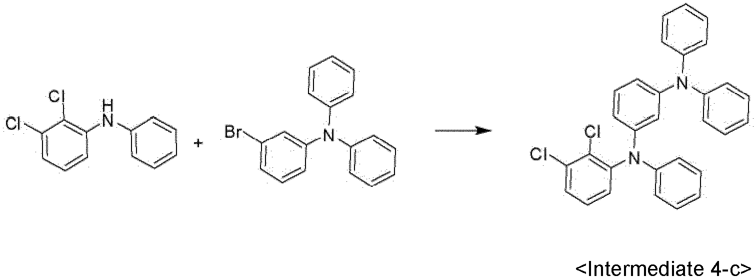

31 g of <Intermediate 4-c> was obtained in the same manner as in Synthesis Example 1-4, except that <Intermediate 4-a> and <Intermediate 4-b> were used instead of <Intermediate 1-c> and <Intermediate 1-b>. (yield 77.7%)

### Synthesis Example 4-4. Synthesis of <Intermediate 4-d>

### <Intermediate 4-d> was synthesized by the following [Reaction Scheme 19].

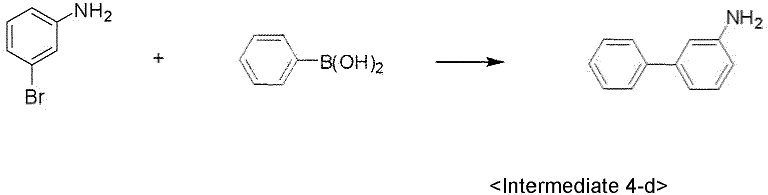

30 g (174 mmol) of 3-bromoaniline, 25.5 g (209 mmol) of phenylboronic acid, 4 g (3 mmol) of tetrakis(triphenylphosphine)palladium, 48.2 g (349 mmol) of potassium carbonate, 150 mL of 1,4-dioxane, 150 mL of toluene, and 90 mL of distilled water were added to a 1 L reactor, followed by stirring under reflux for 4 hours. After completion of the reaction, the layers were separated at room temperature, and the organic layer was concentrated under reduced pressure and separated by column chromatography to obtain 24 g of <Intermediate 4-d>. (yield 80%)

### Synthesis Example 4-5. Synthesis of <Intermediate 4-e>

### <Intermediate 4-e> was synthesized by the following [Reaction Scheme 20].

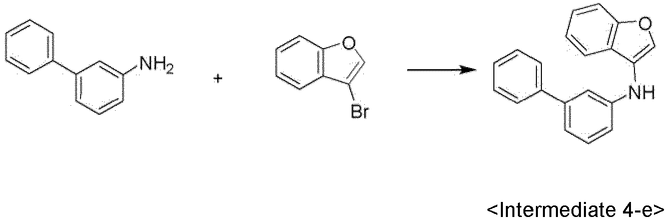

31.6 g of <Intermediate 4-e> was obtained in the same manner as in Synthesis Example 1-3, except that <Intermediate 4-d> and <Intermediate 1-b> were used instead of 1-bromo-4-iodobenzene and aniline. (yield 68.2%)

### Synthesis Example 4-6. Synthesis of <Intermediate 4-f>

### <Intermediate 4-f> was synthesized by the following [Reaction Scheme 21].

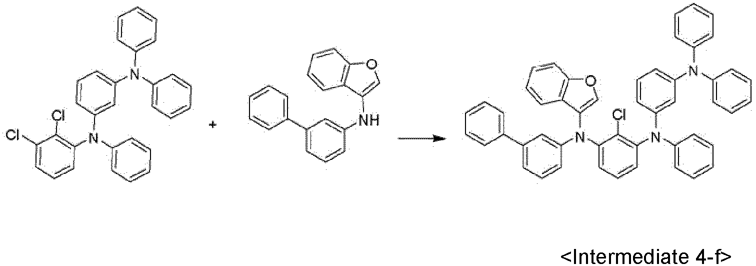

21 g of <Intermediate 4-f> was obtained in the same manner as in Synthesis Example 1-4, except that <Intermediate 4-c> and <Intermediate 4-e> were used instead of <Intermediate 1-c> and <Intermediate 1-b>. (yield 67.7%)

### Synthesis Example 4-7. Synthesis of <Compound 65>

### <Compound 65> was synthesized by the following [Reaction Scheme 22].

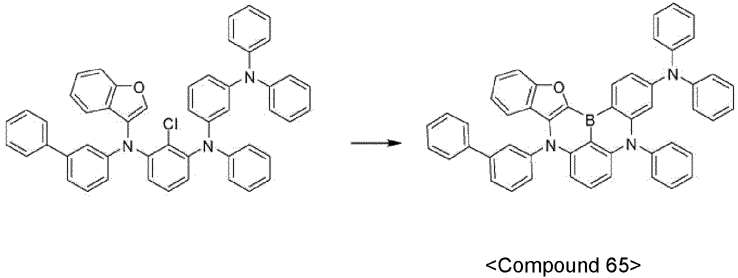

21 g (37 mmol) of <Intermediate 4-f> and tert-butylbenzene were added to a 250 mL reactor. 42.4 mL (74 mmol) of n-butyllithium was added dropwise thereto at -78°C. Then, the mixture was stirred at 60°C for 3 hours. Then, the pentane was removed at 60°C by nitrogen purging. 7.1 mL (74 mmol) of boron tribromide was added dropwise at -78°C. Then, the mixture was stirred at room temperature for 1 hour, and 6 g (74 mmol) of N,N-diisopropylethylamine was added dropwise at 0°C. Then, the mixture was stirred at 120°C for 2 hours. After completion of the reaction, a sodium acetate solution was added thereto at room temperature, followed by stirring. The result was extracted with ethyl acetate, and the organic layer was concentrated and separated by column chromatography to obtain 2.0 g of <Compound 65>. (yield 17.4%) MS (MALDI-TOF): m/z 703.28 [M⁺]

### Synthesis Example 5. Synthesis of Compound 73

### Synthesis Example 5-1. Synthesis of <Intermediate 5-a>

### <Intermediate 5-a> was synthesized by the following [Reaction Scheme 23].

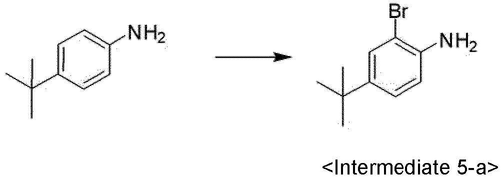

40 g (236 mmol) of 4-tert-butylaniline was dissolved in 400 mL of methylene chloride in a 1 L reactor, followed by stirring at 0°C. Then, 42 g (236 mmol) of N-bromosuccinimide was slowly added to the reactor. The reaction product was warmed to room temperature and was stirred for 4 hours. After completion of the reaction, H₂O was added dropwise thereto at room temperature and extracted with methylene chloride. The organic layer was concentrated and separated by column chromatography to obtain 48 g of <Intermediate 5-a> (yield 80%).

### Synthesis Example 5-2. Synthesis of <Intermediate 5-b>

### <Intermediate 5-b> was synthesized by the following [Reaction Scheme 24].

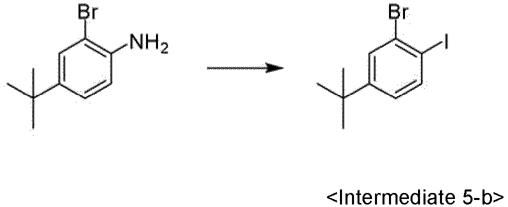

80 g (351 mmol) of <Intermediate 5-a> and 450 mL of water are added to a 2 L reactor, followed by stirring. 104 mL of sulfuric acid was further added thereto. A solution of 31.5 g (456 mmol) of sodium nitrite in 240 mL of water was added dropwise thereto at 0°C. Then, the mixture was stirred at 0°C for 2 hours. A solution of 116.4 g (701 mmol) of potassium iodide in 450 mL of water was added dropwise at 0°C. Then, the mixture was stirred at room temperature for 6 hours. After completion of the reaction, an aqueous sodium thiosulfate solution was added thereto at room temperature, followed by stirring. The reaction product was extracted with ethyl acetate and the organic layer was concentrated and separated by column chromatography to obtain 58 g of <Intermediate 5-b>. (yield 51%)

### Synthesis Example 5-3. Synthesis of <Intermediate 5-c>

### <Intermediate 5-c> was synthesized by the following [Reaction Scheme 25].

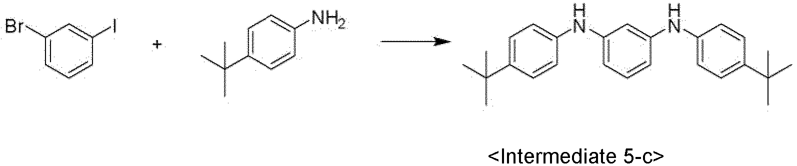

95 g of <Intermediate 4-c> was obtained in the same manner as in Synthesis Example 3-1, except that 4-tert-butylaniline was used instead of aniline. (yield 80.4%)

### Synthesis Example 5-4. Synthesis of <Intermediate 5-d>

### <Intermediate 5-d> was synthesized by the following [Reaction Scheme 26].

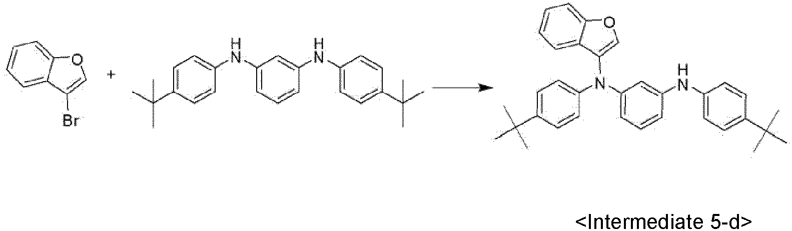

31 g of <Intermediate 5-d> was obtained in the same manner as in Synthesis Example 1-4, except that <Intermediate 5-c> was used instead of <Intermediate 1-c>. (yield 71.5%)

### Synthesis Example 5-5. Synthesis of <Intermediate 5-e>

### <Intermediate 5-e> was synthesized by the following [Reaction Scheme 27].

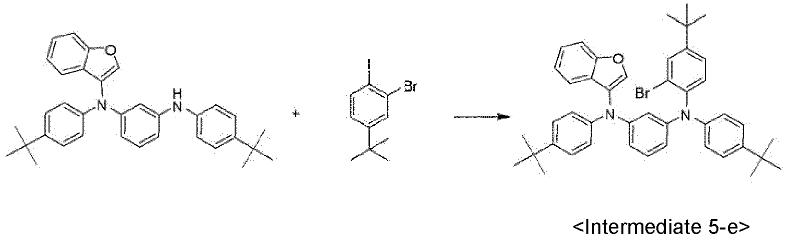

24 g of <Intermediate 5-e> was obtained in the same manner as in Synthesis Example 1-4, except that <Intermediate 5-d> and <Intermediate 5-b> were used instead of <Intermediate 1-c> and <Intermediate 1-b> (yield 67.1%)

### Synthesis Example 5-6. Synthesis of <Compound 73>

### <Compound 73> was synthesized by the following [Reaction Scheme 28].

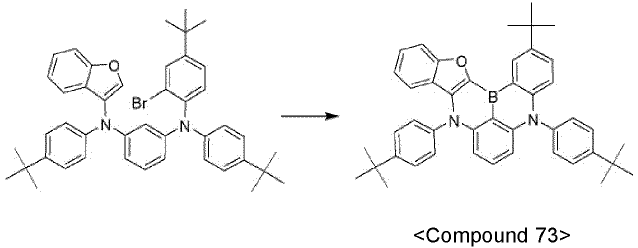

2.4 g of <Compound 73> was obtained in the same manner as in Synthesis Example 1-7, except that <Intermediate 5-e> was used instead of <Intermediate 1-f>. (yield 15%)
MS (MALDI-TOF): m/z 628.36 [M⁺]

### Synthesis Example 6. Synthesis of Compound 109

### Synthesis Example 6-1. Synthesis of <Intermediate 6-a>

### <Intermediate 6-a> was synthesized by the following [Reaction Scheme 29].

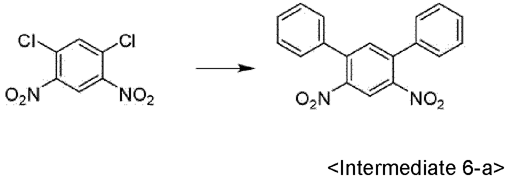

40.0 g (123 mmol) of 1,5-dichloro-2,4-dinitrobenzene, 44.9 g (368 mmol) of phenylboronic acid, 2.8 g (2.5 mmol) of tetrakis(triphenylphosphine) palladium, 50.9 g (368 mmol) of potassium carbonate, 120 mL of 1,4-dioxane, 200 mL of toluene and 120 mL of water were added to a 1 L reactor, followed by stirring under reflux. After completion of the reaction, the reaction product was extracted with water and ethyl acetate and the organic layer was concentrated and separated by column chromatography to obtain 27.5 g of <Intermediate 6-a>. (yield 70%)

### Synthesis Example 6-2: Synthesis of <Intermediate 6-b>

### <Intermediate 6-b> was synthesized by the following [Reaction Scheme 30].

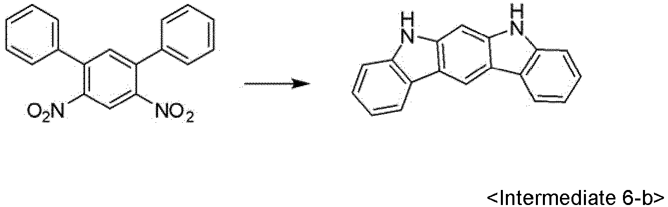

27.5 g (86 mmol) of <Intermediate 6-a>, 57.8 g (348 mmol) of triphenylphosphine, and 300 mL of dichlorobenzene were added to a 1 L reactor, followed by stirring under reflux for 3 days. After completion of the reaction, the dichlorobenzene was removed and the residue was separated by column chromatography to obtain 10.8 g of <Intermediate 6-b>. (yield 49.0%)

### Synthesis Example 6-3. Synthesis of <Intermediate 6-c>

### <Intermediate 6-c> was synthesized by the following [Reaction Scheme 31].

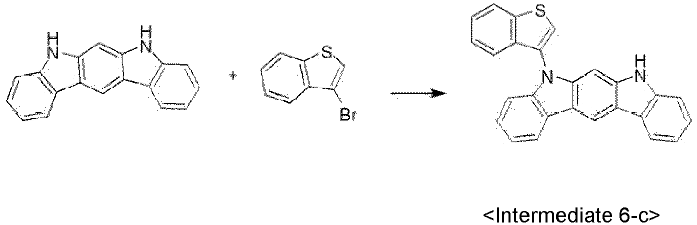

10.8 g (42 mmol) of <Intermediate 6-b>, 11.0 g (10.8 mmol) of <Intermediate 2-a>, 10.7 g (1 mmol) of a copper powder, 4.5 g (17 mmol) of 18-crown-6-ether, 34.9 g (253 mmol) of potassium carbonate, and 110 mL of dichlorobenzene were added to a 250 mL reactor, followed by stirring under reflux at 180°C for 24 hours. After completion of the reaction, the dichlorobenzene was removed and the residue was separated by column chromatography to obtain 9.5 g of <Intermediate 6-c>. (yield 52%)

### Synthesis Example 6-4. Synthesis of <Intermediate 6-d>

### <Intermediate 6-d> was synthesized by the following [Reaction Scheme 32].

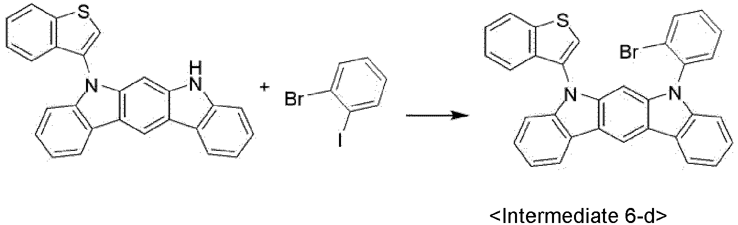

14 g of <Intermediate 6-d> was obtained in the same manner as in Synthesis Example 6-3, except that <Intermediate 6-c> and 1-bromo-2-iodobenzene were used instead of <Intermediate 1-c> and <Intermediate 2-a> (yield 67.1%)

### Synthesis Example 6-5. Synthesis of <Compound 109>

### <Compound 109> was synthesized by the following [Reaction Scheme 33].

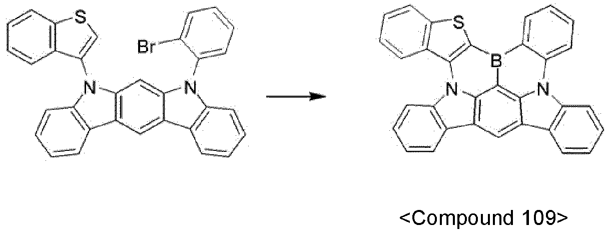

2.1 g of <Compound 109> was obtained in the same manner as in Synthesis Example 1-7, except that <Intermediate 6-d> was used instead of <Intermediate 1-f> (yield 14%)
MS (MALDI-TOF): m/z 472.12 [M⁺]

### Synthesis Example 7. Synthesis of Compound 126

### Synthesis Example 7-1. Synthesis of <Intermediate 7-a>

### <Intermediate 7-a> was synthesized by the following [Reaction Scheme 34].

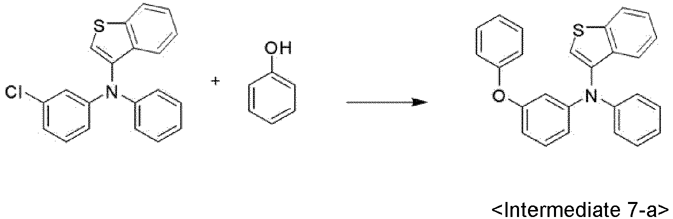

30.0 g (150 mmol) of <Intermediate 2-b>, 31.2 g (160 mmol) of phenol, 45.7 g (300 mmol) of potassium carbonate and 250 mL of NMP were added to a 500 mL reactor, followed by stirring under reflux at 160°C for 12 hours. After completion of the reaction, the reaction product was cooled to room temperature, the NMP was distilled off under reduced pressure and the residue was extracted with water and ethyl acetate. The solvent was concentrated under reduced pressure and separated by column chromatography to obtain 22 g of <Intermediate 7-a>. (yield 68%)

### Synthesis Example 7-2. Synthesis of <Compound 126>

### <Compound 126> was synthesized by the following [Reaction Scheme 35].

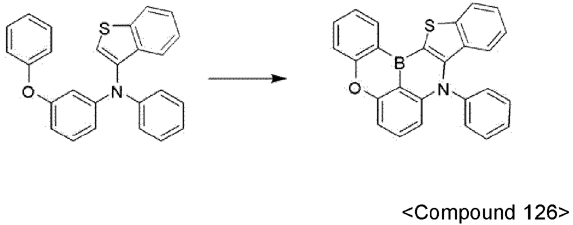

1.2 g of <Compound 126> was obtained in the same manner as in Synthesis Example 1-7, except that <Intermediate 7-a> was used instead of <Intermediate 1-f> (yield 13.4%) MS (MALDI-TOF): m/z 401.10 [M⁺]

### Synthesis Example 8. Synthesis of Compound 145

### Synthesis Example 8-1. Synthesis of <Intermediate 8-a>

### <Intermediate 8-a> was synthesized by the following [Reaction Scheme 36].

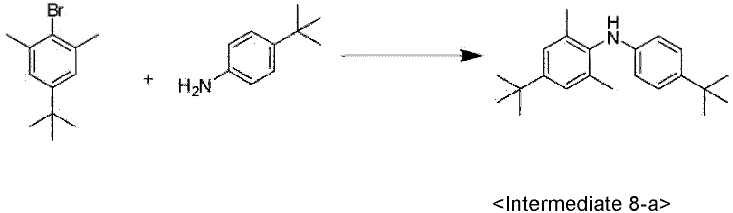

41.6 g of <Intermediate 8-a> was obtained in the same manner as in Synthesis Example 1-3, except that 2-bromo-5-tert-butyl-1,3-dimethylbenzene and 4-tert-butylaniline were used instead of 1-bromo-3-iodobenzene and aniline (yield 88.2%)

### Synthesis Example 8-2. Synthesis of <Intermediate 8-b>

### <Intermediate 8-b> was synthesized by the following [Reaction Scheme 37].

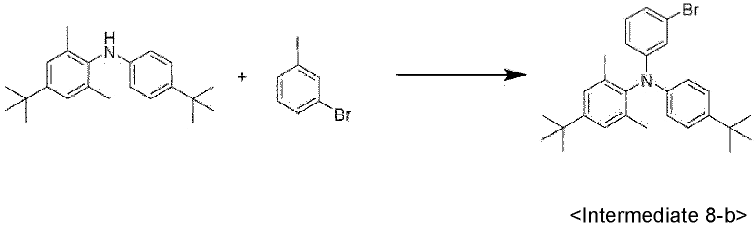

37.6 g of <Intermediate 8-b> was obtained in the same manner as in Synthesis Example 4-2, except that <Intermediate 8-a> was used instead of diphenylamine. (yield 78.4%)

### Synthesis Example 8-3. Synthesis of <Intermediate 8-c>

### <Intermediate 8-c> was synthesized by the following [Reaction Scheme 38].

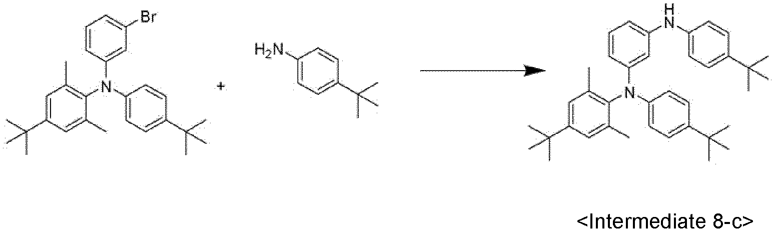

31.2 g of <Intermediate 8-c> was obtained in the same manner as in Synthesis Example 1-3, except that <Intermediate 8-b> and 4-tert-butylaniline were used instead of 1-bromo-3-iodobenzene and aniline. (yield 74.2%)

### Synthesis Example 8-4. Synthesis of <Intermediate 8-d>

### <Intermediate 8-d> was synthesized by the following [Reaction Scheme 39].

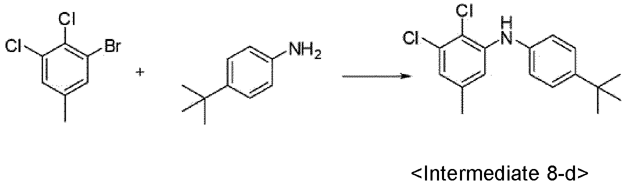

30.3 g of <Intermediate 8-d> was obtained in the same manner as in Synthesis Example 1-3, except that 1-bromo-2,3-dichloro-5-ethylbenzene and 4-tert-butylaniline were used instead of 1-bromo-3-iodobenzene and aniline. (yield 89.8%)

### Synthesis Example 8-5. Synthesis of <Intermediate 8-e>

### <Intermediate 8-e> was synthesized by the following [Reaction Scheme 40].

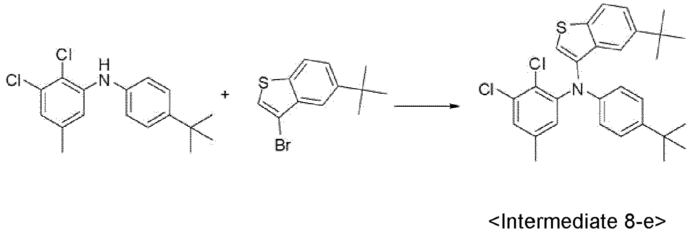

27.4 g of <Intermediate 8-e> was obtained in the same manner as in Synthesis Example 1-4, except that <Intermediate 8-d> and 3-bromo-5-(tert-butyl)benzothiophene were used instead of <Intermediate 1-c> and <Intermediate 1-b>. (yield 77.1%)

### Synthesis Example 8-6. Synthesis of <Intermediate 8-f>

### <Intermediate 8-f> was synthesized by the following [Reaction Scheme 41].

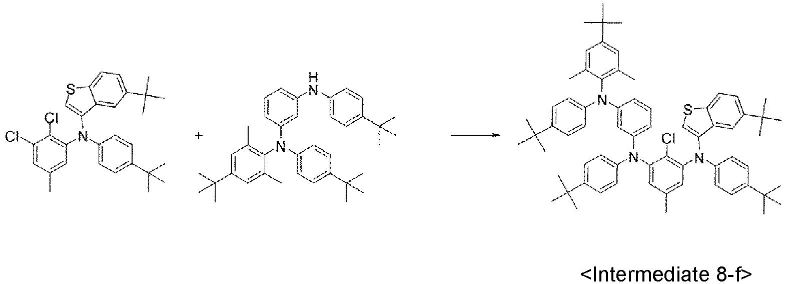

21 g of <Intermediate 8-f> was obtained in the same manner as in Synthesis Example 1-4, except that <Intermediate 8-e> and <Intermediate 8-c> were used instead of <Intermediate 1-c> and <Intermediate 1-b>. (yield 74.1%)

### Synthesis Example 8-7. Synthesis of <Compound 145>

### <Compound 145> was synthesized by the following [Reaction Scheme 42].

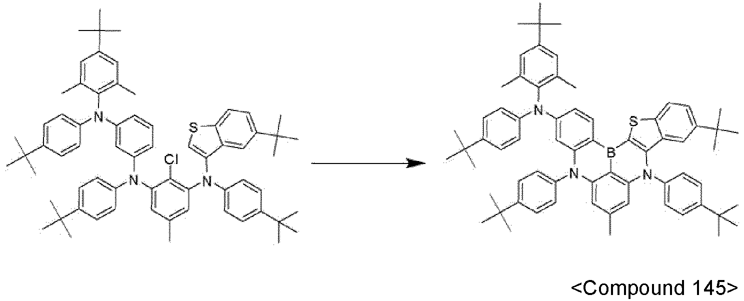

3.4 g of <Compound 145> was obtained in the same manner as in Synthesis Example 1-7, except that <Intermediate 8-f> was used instead of <Intermediate 1-f>. (yield 19.4%) MS [M]⁺ 979.60

### Synthesis Example 9. Synthesis of Compound 150

### Synthesis Example 9-1. Synthesis of <Intermediate 9-a>

### <Intermediate 9-a> was synthesized by the following [Reaction Scheme 43].

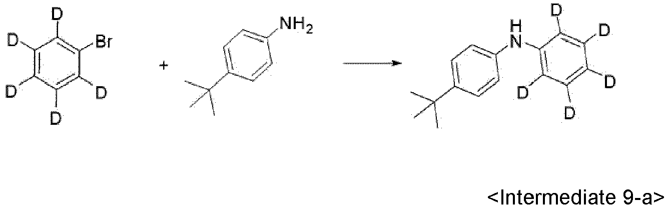

32.7 g of <Intermediate 9-a> was obtained in the same manner as in Synthesis Example 1-3, except that bromobenzene-d5 and 4-tert-butylaniline were used instead of 1-bromo-3-iodobenzene and aniline. (yield 78.2%)

### Synthesis Example 9-2. Synthesis of <Intermediate 9-b>

### <Intermediate 9-b> was synthesized by the following [Reaction Scheme 44].

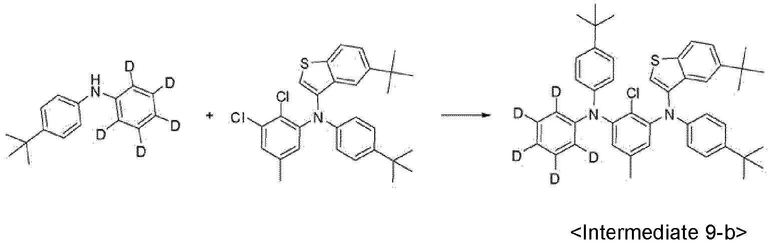

34.2 g of <Intermediate 9-b> was obtained in the same manner as in Synthesis Example 1-4, except that <Intermediate 8-e> and <Intermediate 9-a> were used instead of <Intermediate 1-c> and <Intermediate 1-b>. (yield 84.1%)

### Synthesis Example 9-3. Synthesis of <Compound 150>

### <Compound 150> was synthesized by the following [Reaction Scheme 45].

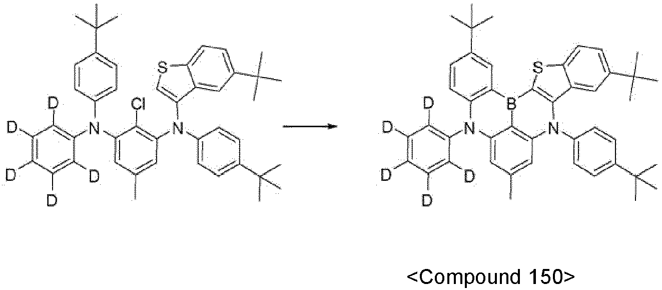

2.7 g of <Compound 150> was obtained in the same manner as in Synthesis Example 1-7, except that <Intermediate 9-b> was used instead of <Intermediate 1-f>. (yield 11.4%)
MS [M]⁺ 663.39

### Synthesis Example 10. Synthesis of Compound 153

### Synthesis Example 10-1. Synthesis of <Intermediate 10-a>

### <Intermediate 10-a> was synthesized by the following [Reaction Scheme 46].

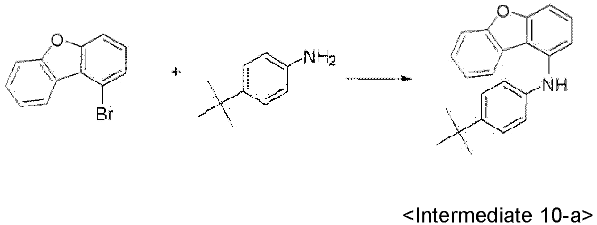

25.6 g of <Intermediate 10-a> was obtained in the same manner as in Synthesis Example 1-3, except that 1-bromo-dibenzofuran and 4-tert-butylaniline were used instead of 1-bromo-3-iodobenzene and aniline. (yield 79.2%)

### Synthesis Example 10-2. Synthesis of <Intermediate 10-b>

### <Intermediate 10-b> was synthesized by the following [Reaction Scheme 47].

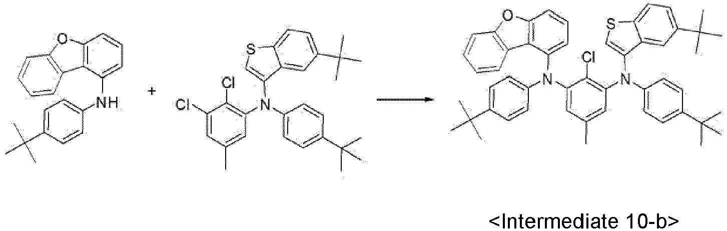

18.6 g of <Intermediate 10-b> was obtained in the same manner as in Synthesis Example 1-4, except that <Intermediate 8-e> and <Intermediate 10-a> were used instead of <Intermediate 1-c> and <Intermediate 1-b>. (yield 74.1%)

### Synthesis Example 10-3. Synthesis of <Compound 153>

### <Compound 153> was synthesized by the following [Reaction Scheme 48].

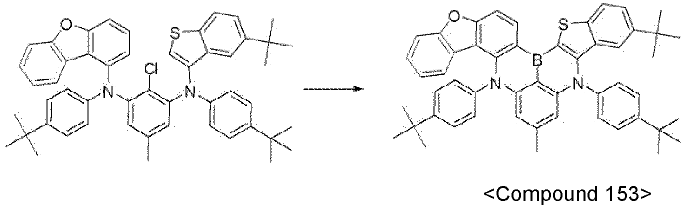

3.4 g of <Compound 153> was obtained in the same manner as in Synthesis Example 1-7, except that <Intermediate 10-b> was used instead of <Intermediate 1-f>. (yield 15.4%)
MS [M]⁺ 748.37

### Examples 1 to 20: Fabrication of organic light-emitting devices

ITO glass was patterned such that a light-emitting area of the ITO glass was adjusted to 2 mm × 2 mm and was then washed. The ITO glass was mounted in a vacuum chamber, a base pressure was set to 1.3 × 10⁻⁵ Pa (1 × 10⁻⁷ torr), and 2-TNATA (400Å) and a material for a hole transport layer shown in [Table 1] (200 Å) were sequentially deposited on the ITO glass. Then, a mixture of [BH] as a host and the compound shown in the following Table 1 as a dopant (3 wt%) was deposited to a thickness of 250Å to form a light-emitting layer. Then, a compound of [Formula E-1] was deposited thereon to a thickness of 300Å to form an electron transport layer, Liq was deposited thereon to a thickness of 10Å to form an electron injection layer, and Al was deposited thereon to a thickness of 1,000Å to form a cathode. As a result, an organic light-emitting device was fabricated. The properties of the organic light-emitting device were measured at 10 mA/cm².

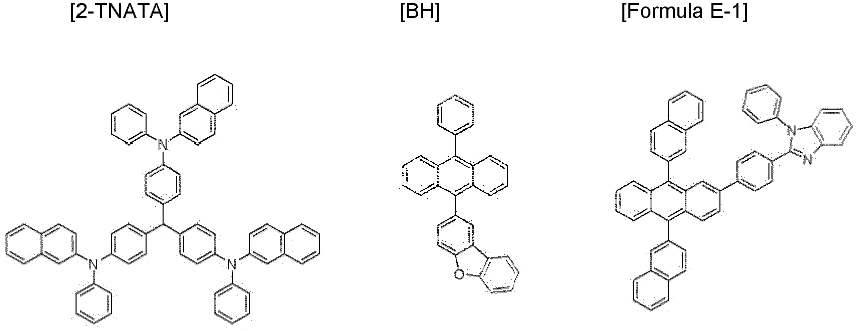

### Comparative Examples 1 to 10

Organic light-emitting devices were fabricated in the same manner as in Examples above, except that [HT1] and [HT2], and [BD1] and [BD2] were used instead of the compound used as the hole transport layer materials and dopant compounds, respectively, in Examples 1 to 20. The properties of the organic light-emitting devices were measured at 10 mA/cm². The structures of [HT1], [HT2], [BD1] and [BD2] are as follows.

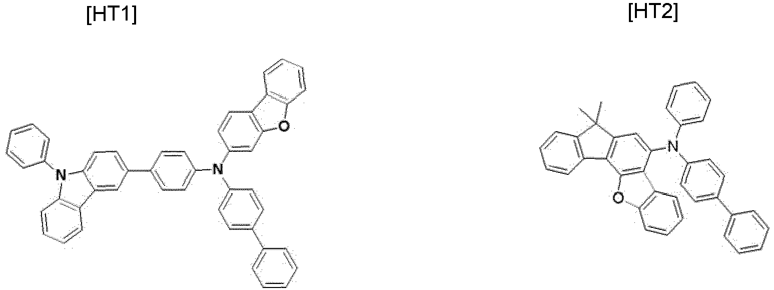

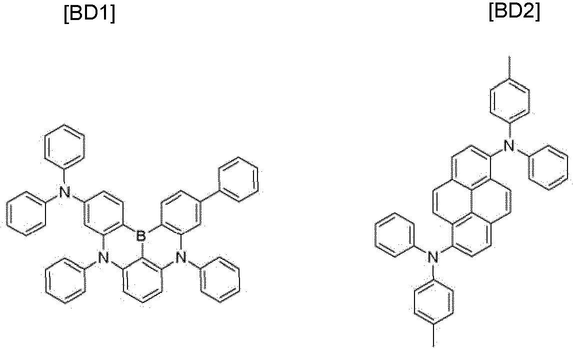

**[Table 1]**

| Item | Hole transport layer (Formula A/B) | Dopant compound (Formula C/D) | Voltage (V) | External quantum efficiency (%) |
|---|---|---|---|---|
| Example 1 | 5 | 1 | 3.6 | 12.1 |
| Example 2 | 47 | 1 | 3.5 | 12.2 |
| Example 3 | 52 | 1 | 3.6 | 12.5 |
| Example 4 | 88 | 1 | 3.6 | 11.9 |
| Example 5 | 104 | 1 | 3.6 | 11.8 |
| Example 6 | 8 | 2 | 3.5 | 12.2 |
| Example 7 | 54 | 2 | 3.5 | 12.7 |
| Example 8 | 41 | 2 | 3.6 | 12.3 |
| Example 9 | 101 | 2 | 3.6 | 12.5 |
| Example 10 | 91 | 2 | 3.5 | 11.8 |
| Example 11 | 5 | 13 | 3.6 | 11.8 |
| Example 12 | 47 | 13 | 3.6 | 11.7 |
| Example 13 | 52 | 13 | 3.6 | 12.6 |
| Example 14 | 88 | 13 | 3.5 | 12.0 |
| Example 15 | 104 | 13 | 3.5 | 11.9 |
| Example 16 | 8 | 65 | 3.6 | 11.6 |
| Example 17 | 54 | 65 | 3.7 | 12.6 |
| Example 18 | 41 | 65 | 3.7 | 11.6 |
| Example 19 | 101 | 65 | 3.8 | 11.8 |
| Example 20 | 91 | 65 | 3.7 | 12.0 |

**[Table 2]**

| Item | Hole transport layer | Dopant compound | Voltage (V) | External quantum efficiency (%) |
|---|---|---|---|---|
| Comparative Example 1 | 5 | BD 1 | 3.8 | 8.1 |
| Comparative Example 2 | 47 | BD 1 | 3.7 | 8.2 |
| Comparative Example 3 | 52 | BD 1 | 3.7 | 8.5 |
| Comparative Example 4 | 88 | BD 1 | 3.8 | 8.6 |
| Comparative Example 5 | 104 | BD 1 | 3.8 | 8.8 |
| Comparative Example 6 | 8 | BD 2 | 3.7 | 7.2 |
| Comparative Example 7 | 54 | BD 2 | 3.8 | 7.7 |
| Comparative Example 8 | 41 | BD 2 | 3.8 | 7.4 |
| Comparative Example 9 | 101 | BD 2 | 3.9 | 7.5 |
| Comparative Example 10 | 91 | BD 2 | 3.8 | 7.8 |

As can be seen from [Table 1] and [Table 2] above, the organic light-emitting device according to the present invention using the hole transport material (Formula A/B) in the hole transport layer, and using the dopant material [Formula C/D] according to the present invention in the light-emitting layer can be operated at a lower voltage and exhibit improved luminous efficacy based on remarkably improved external quantum efficiency compared to the organic light-emitting devices using the conventional compounds represented by HT1 and HT2, the organic light-emitting devices using the conventional compounds represented by BD1 and BD2, and the organic light-emitting device without using the combination of materials according to the present invention.

### Industrial Applicability

The organic light-emitting device according to the present invention can be operated at a lower driving voltage and exhibits excellent external quantum efficiency and thus high luminous efficacy by utilizing the compounds having characteristic structures as a hole transport material and a dopant material, respectively, in the hole injection layer or the hole transport layer, and the light-emitting layer, and thus is industrially applicable to flat panel displays, flexible displays, monochromatic or white flat panel lighting systems, monochromatic or white flexible lighting systems, vehicle displays, displays for virtual or augmented reality and the like.

## Claims

1. An organic light-emitting device comprising:
a first electrode;
a second electrode facing the first electrode; and
a hole injection layer or a hole transport layer and a light-emitting layer interposed between the first electrode and the second electrode,
wherein
(i) the hole injection layer or the hole transport layer comprises at least one compound represented by the following [Formula A] or [Formula B], and
(ii) the light-emitting layer comprises a compound represented by the following [Formula C] or [Formula D]: 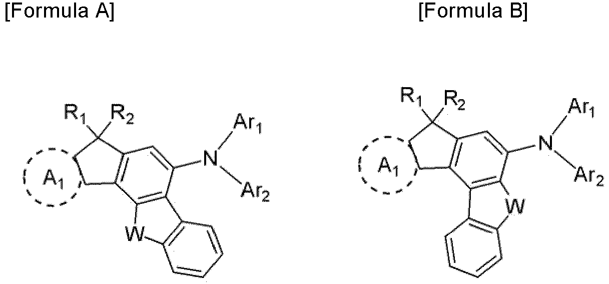
wherein
A₁ is selected from a substituted or unsubstituted C6-C30 aryl group, and a substituted or
unsubstituted C2-C50 heteroaryl group,
W is an oxygen atom (O) or a sulfur atom (S),
R₁ and R₂ are identical to or different from each other, and are each independently selected from hydrogen, deuterium, a substituted or unsubstituted C1-C30 alkyl group, a substituted or unsubstituted C3-C30 cycloalkyl group, a substituted or unsubstituted C6-C50 aryl group, and a substituted or unsubstituted C2-C50 heteroaryl group, with the proviso that R₁ and R₂ are optionally bonded to each other to form an alicyclic or aromatic monocyclic or polycyclic ring,
Ar₁ and Ar₂ are identical to or different from each other, and are each independently selected from a substituted or unsubstituted C6-C50 aryl group, and a substituted or unsubstituted C2-C50 heteroaryl group, with the proviso that at least one of Ar₁ and Ar₂ is represented by the following Structural Formula 1: 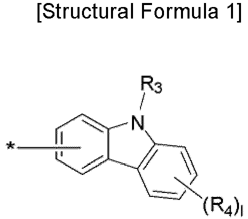
wherein
R₃ is selected from hydrogen, deuterium, a substituted or unsubstituted C1-C30 alkyl group, a substituted or unsubstituted C3-C30 cycloalkyl group, a substituted or unsubstituted C6-C50 aryl group, and a substituted or unsubstituted C2-C50 heteroaryl group,
R₄ is selected from hydrogen, deuterium, a cyano group, a halogen group, a hydroxyl group, a nitro group, a C1-C24 alkyl group, a C1-C24 halogenated alkyl group, a C1-C24 cycloalkyl group, a C1-C24 alkenyl group, a C1-C24 alkynyl group, a C1-C24 heteroalkyl group, a C6-C30 aryl group, a C6-C30 arylalkyl group, a C2-C30 heteroaryl group, a C2-C30 heteroarylalkyl group, a C1-C24 alkoxy group, a C1-C24 alkylamino group, a C6-C30 arylamino group, a C2-C30 heteroarylamino group, a C1-C24 alkylsilyl group, a C6-C30 arylsilyl group, and a C6-C30 aryloxy group,
I is an integer from 0 to 4, provided that when I is 2 or more, R₄'s are identical to or different from each other, and
"-*" means a site bonding to a nitrogen atom at the positions Ar₁ and Ar₂ in [Formula A] or [Formula B], 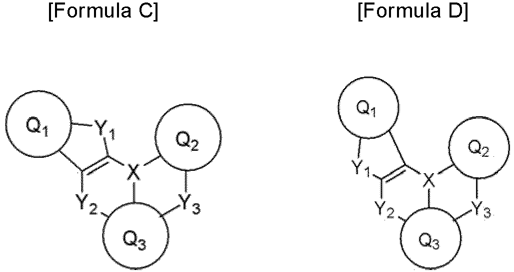
wherein
Q₁ to Q₃ are identical to or different from each other, and are each independently a substituted or unsubstituted aromatic C6-C50 hydrocarbon ring, or a substituted or unsubstituted C2-C50 aromatic heterocyclic group;
Y₁ to Y₃ are identical to or different from each other, and are each independently selected from N-R₁, CR₂R₃, O, S, Se, and SiR₄R₅;
X is selected from B, P and P=O; and
R₁ to R₅ are identical to or different from each other, and are each independently selected from hydrogen, deuterium, a substituted or unsubstituted C1-C30 alkyl group, a substituted or unsubstituted C6-C50 aryl group, a substituted or unsubstituted C3-C30 cycloalkyl group, substituted or unsubstituted C2-C50 heteroaryl group, a substituted or unsubstituted C1-C30 alkoxy group, a substituted or unsubstituted C6-C30 aryloxy group, a substituted or unsubstituted C1-C30 alkylthioxy group, a substituted or unsubstituted C5-C30 arylthioxy group, a substituted or unsubstituted C1-C30 alkylamine group, a substituted or unsubstituted C5-C30 arylamine group, a substituted or unsubstituted C1-C30 alkylsilyl group, a substituted or unsubstituted C5-C30 arylsilyl group, a nitro group, a cyano group, and a halogen group, with the proviso that each of R₁ to R₅ is optionally bonded to the ring Q₁ to Q₃ to further form an alicyclic or aromatic monocyclic or polycyclic ring, and R₂ and R₃, and R₄ and R₅ are optionally bonded to each other to further form an alicyclic or aromatic monocyclic or polycyclic ring.

2. The organic light-emitting device according to claim 1, wherein [Formula C] or [Formula D] is represented by the following [Formula C-1] or [Formula D-1]: 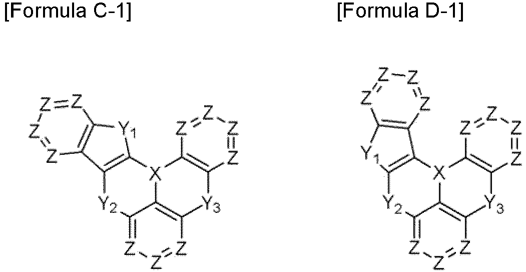 wherein
Z is CR or N, with the proviso that Z's and are identical to or different from each other and R's are identical to or different from each other,
wherein R's are each independently selected from hydrogen, deuterium, a substituted or unsubstituted C1-C30 alkyl group, a substituted or unsubstituted C6-C50 aryl group, a substituted or unsubstituted C3-C30 cycloalkyl group, a substituted or unsubstituted C2-C50 heteroaryl group, a substituted or unsubstituted C1-C30 alkoxy group, a substituted or unsubstituted C6-C30 aryloxy group, a substituted or unsubstituted C1-C30 alkylthioxy group, a substituted or unsubstituted C5-C30 arylthioxy group, a substituted or unsubstituted C1-C30 alkylamine group, a substituted or unsubstituted C5-C30 arylamine group, a substituted or unsubstituted C1-C30 alkylsilyl group, a substituted or unsubstituted C5-C30 arylsilyl group, a nitro group, a cyano group, a halogen group and - N(R₆)(R₇), and
R's are optionally bonded to each other or each thereof is optionally bonded to an adjacent substituent to form at least one alicyclic or aromatic monocyclic or polycyclic ring, and the carbon atom of the formed alicyclic, aromatic monocyclic or polycyclic ring is substituted with at least one heteroatom selected from (N), a sulfur atom (S), and an oxygen atom (O), R₆ and R₇ are identical to or different from each other, and are each independently selected from hydrogen, deuterium, a substituted or unsubstituted C1-C30 alkyl group, a substituted or unsubstituted C6-C50 aryl group, a substituted or unsubstituted C3-C30 cycloalkyl group, and a substituted or unsubstituted C2-C50 heteroaryl group, with the proviso that R₆ and R₇ are optionally bonded to each other to form an alicyclic or aromatic monocyclic or polycyclic ring, and
X and Y₁ to Y₃ are as defined in [Formula C] and [Formula D] above.

3. The organic light-emitting device according to claim 1, wherein [Formula C] or [Formula D] is represented by any one of the following [Formula C-2], [Formula C-3] and [Formula D-2]: 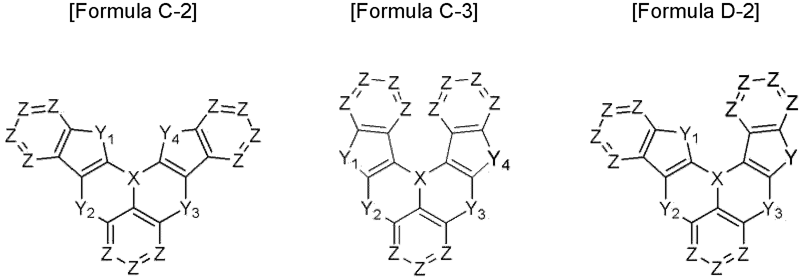 wherein
Z is CR or N, with the proviso that Z's are identical to or different from each other and R's are identical to or different from each other,
wherein R's are each independently selected from hydrogen, deuterium, a substituted or unsubstituted C1-C30 alkyl group, a substituted or unsubstituted C6-C50 aryl group, a substituted or unsubstituted C3-C30 cycloalkyl group, a substituted or unsubstituted C2-C50 heteroaryl group, a substituted or unsubstituted C1-C30 alkoxy group, a substituted or unsubstituted C6-C30 aryloxy group, a substituted or unsubstituted C1-C30 alkylthioxy group, a substituted or unsubstituted C5-C30 arylthioxy group, a substituted or unsubstituted C1-C30 alkylamine group, a substituted or unsubstituted C5-C30 arylamine group, a substituted or unsubstituted C1-C30 alkylsilyl group, a substituted or unsubstituted C5-C30 arylsilyl group, a nitro group, a cyano group, a halogen group and - N(R₆)(R₇), and
R's are optionally bonded to each other or each thereof is optionally bonded to an adjacent substituent to form at least one alicyclic or aromatic monocyclic or polycyclic ring, and the carbon atom of the formed alicyclic, aromatic monocyclic or polycyclic ring is substituted with at least one heteroatom selected from (N), a sulfur atom (S), and an oxygen atom (O), R₆ and R₇ are identical to or different from each other, and are each independently selected from hydrogen, deuterium, a substituted or unsubstituted C1-C30 alkyl group, a substituted or unsubstituted C6-C50 aryl group, a substituted or unsubstituted C3-C30 cycloalkyl group, and a substituted or unsubstituted C2-C50 heteroaryl group, with the proviso that R₆ and R₇ are optionally bonded to each other to form an alicyclic or aromatic monocyclic or polycyclic ring, and
X and Y₁ to Y₄ are as defined in X and Y₁ to Y₃ [Formula C] and [Formula D] above.

4. The organic light-emitting device according to claim 2, wherein at least one of R's is - N(R₆)(R₇).

5. The organic light-emitting device according to claim 3, wherein at least one of R's is - N(R₆)(R₇).

6. The organic light-emitting device according to claim 1, wherein the compound represented by [Formula A] or [Formula B] is selected from the compounds represented by the following formulas.

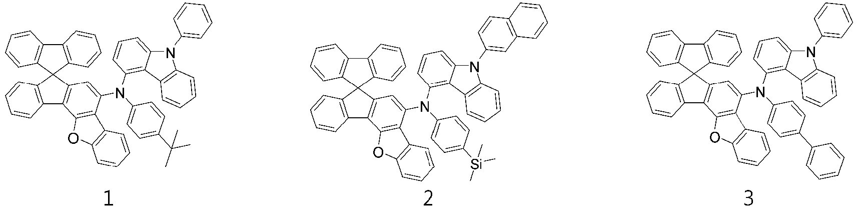

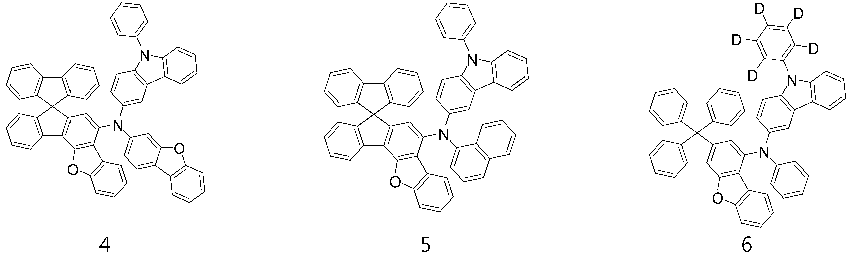

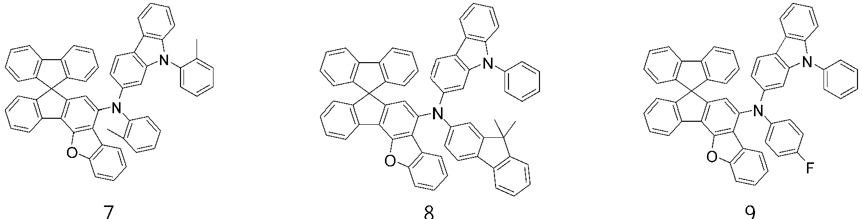

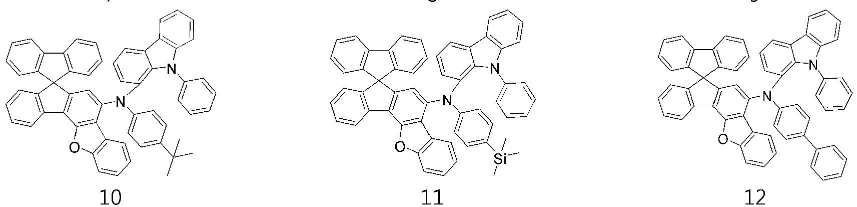

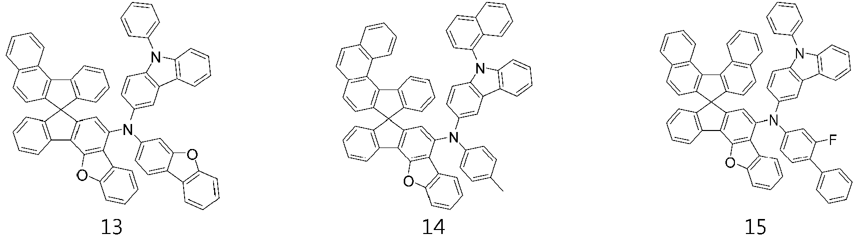

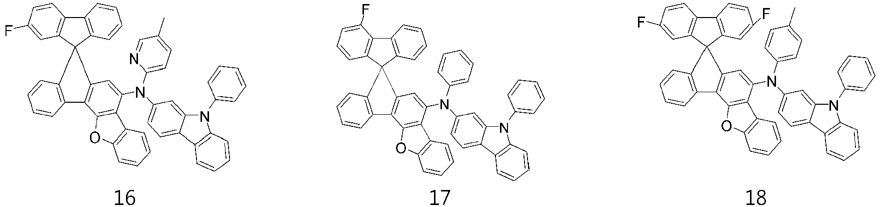

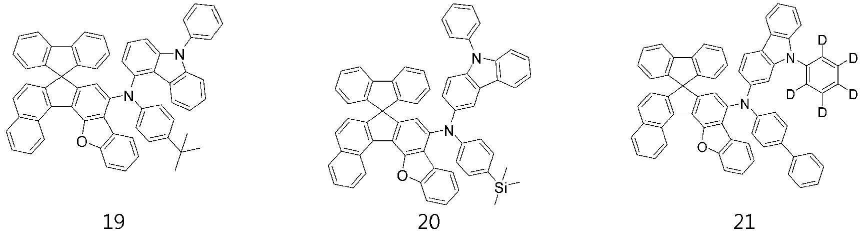

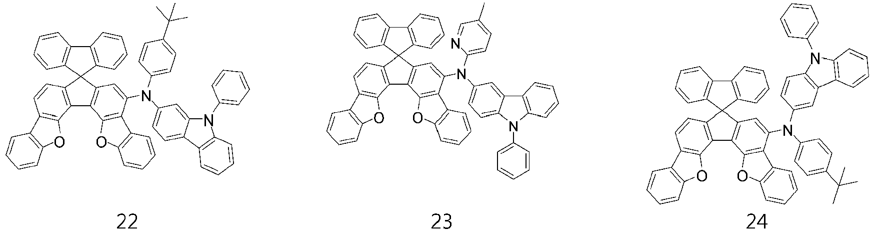

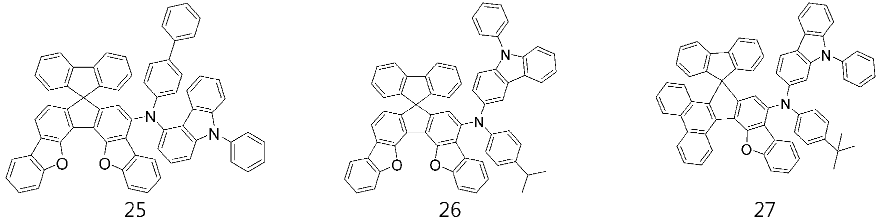

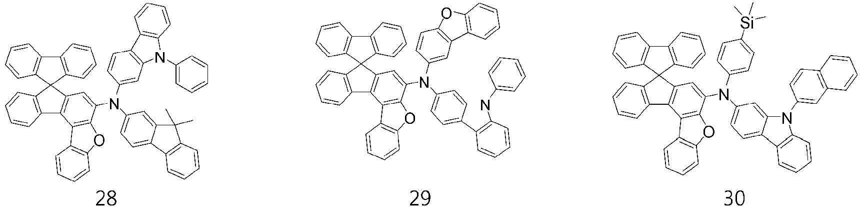

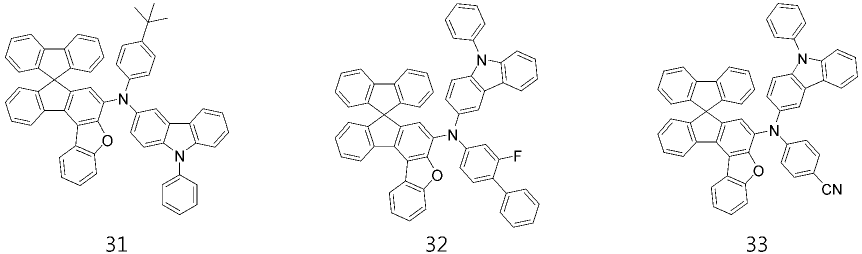

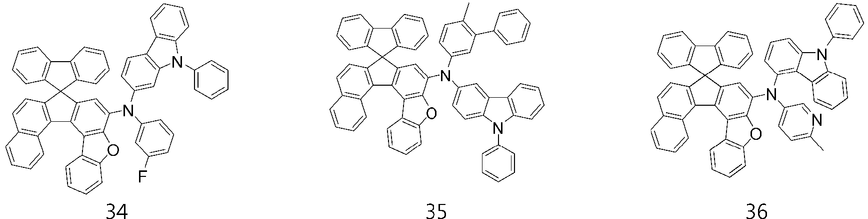

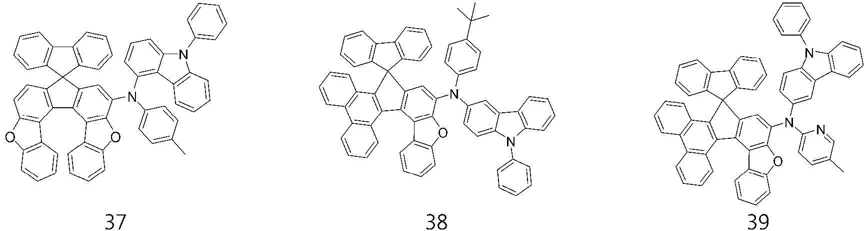

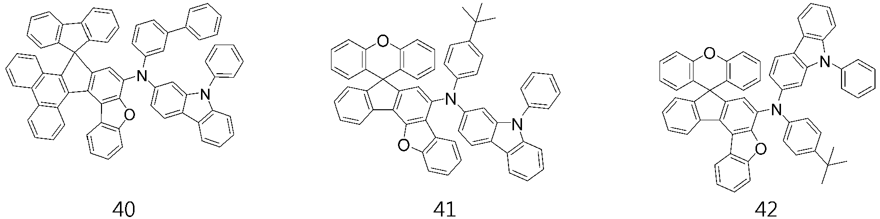

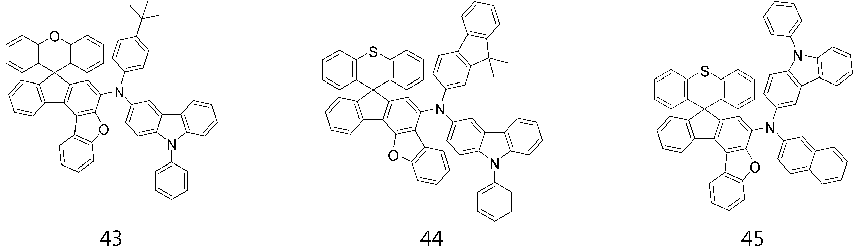

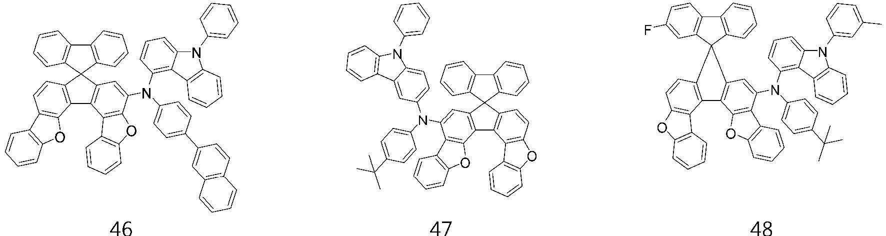

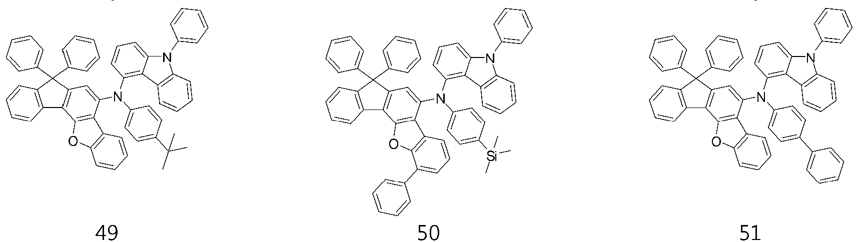

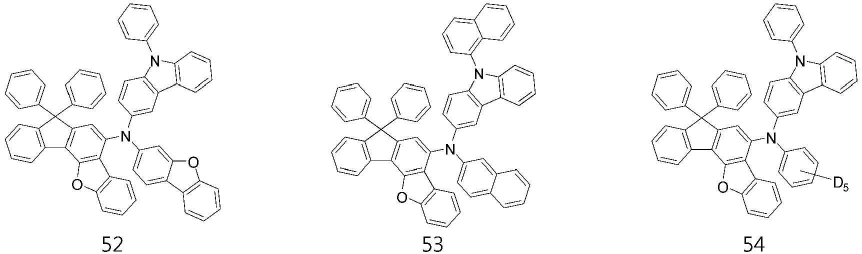

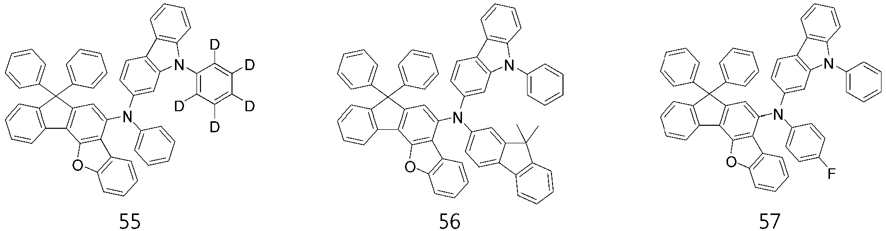

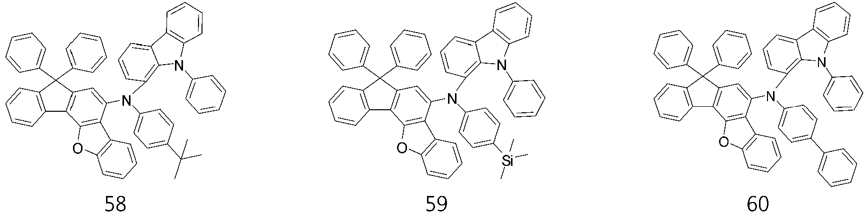

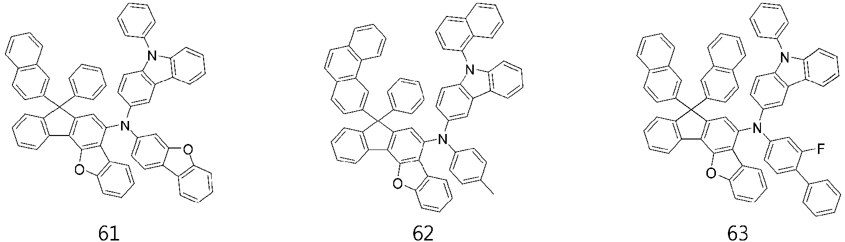

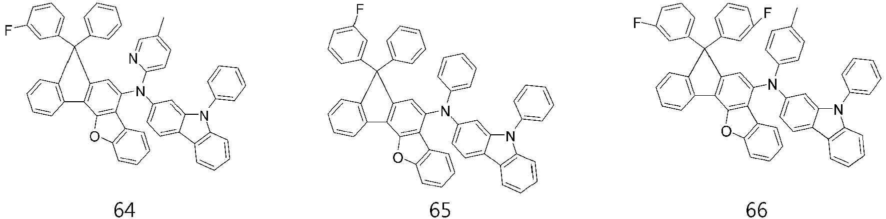

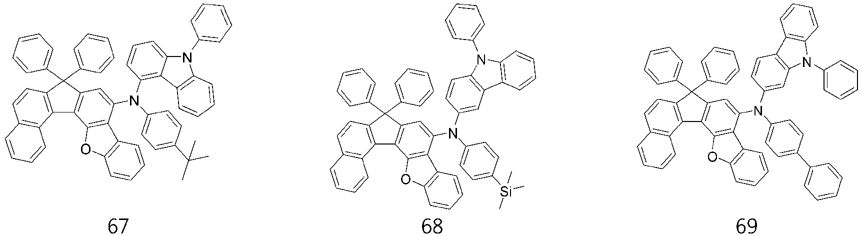

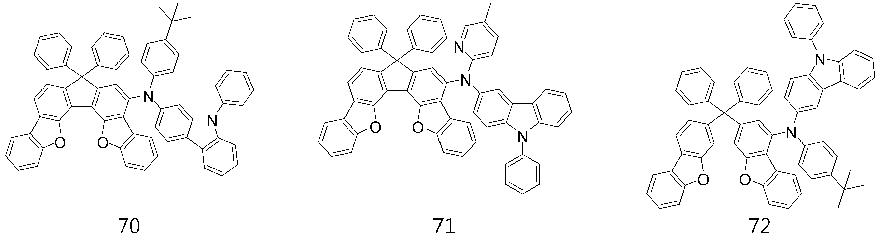

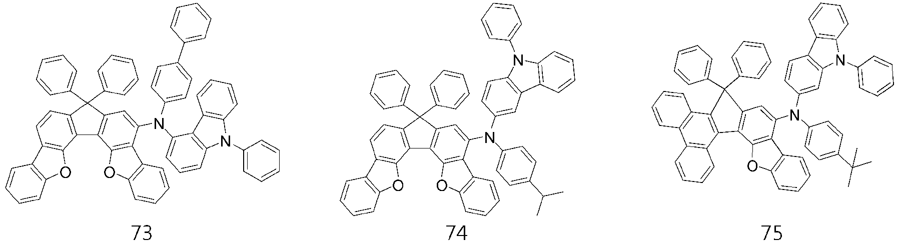

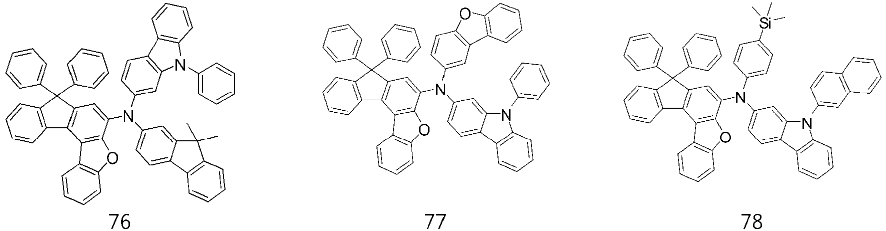

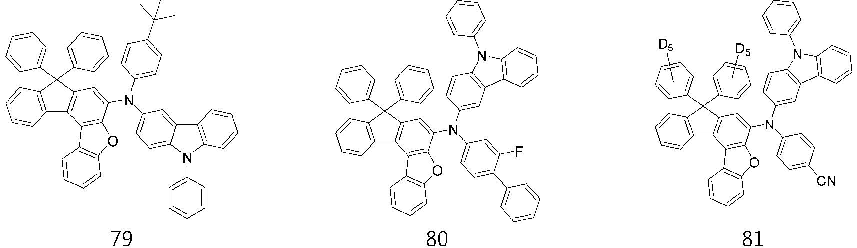

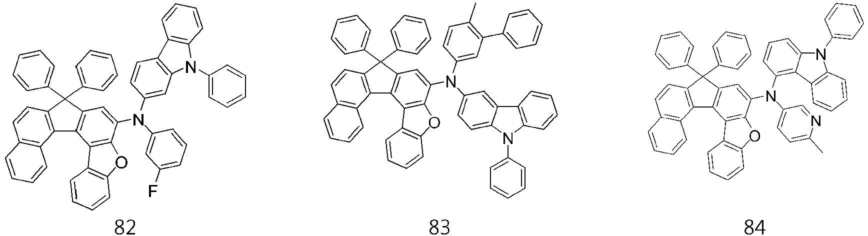

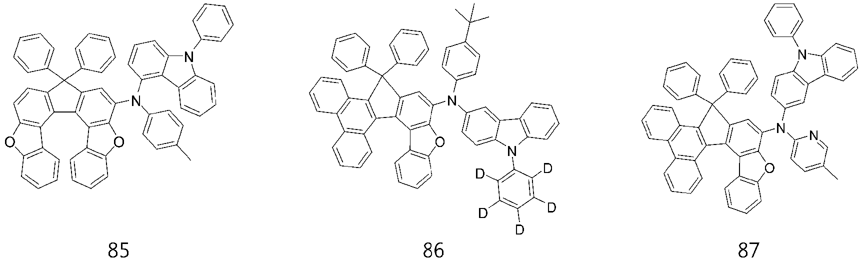

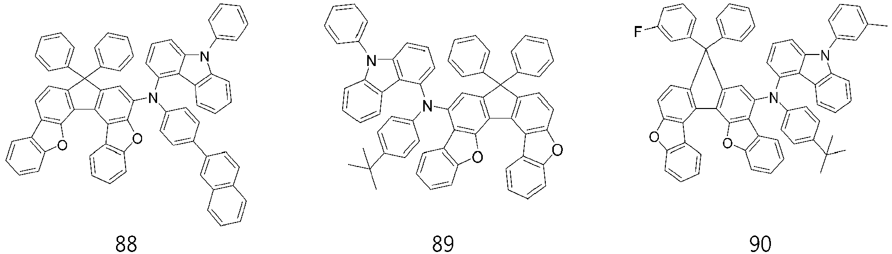

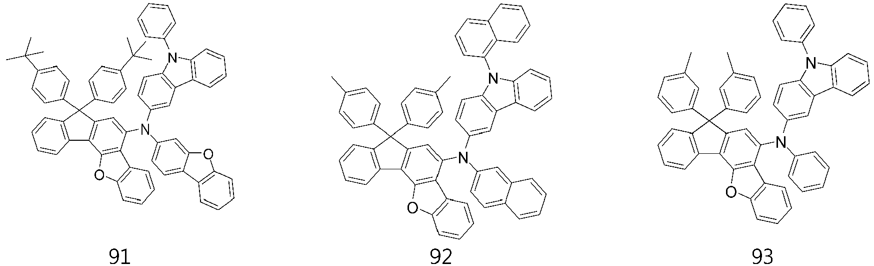

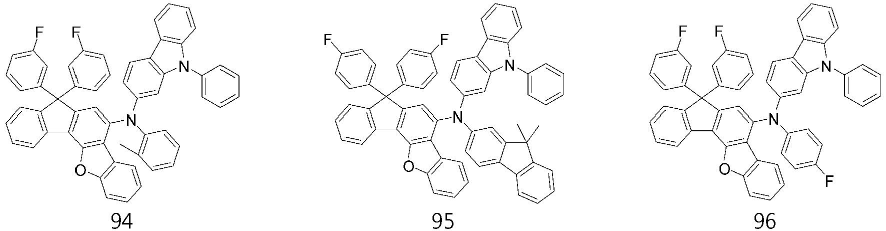

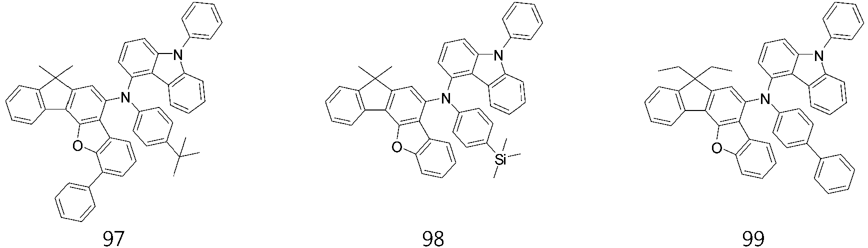

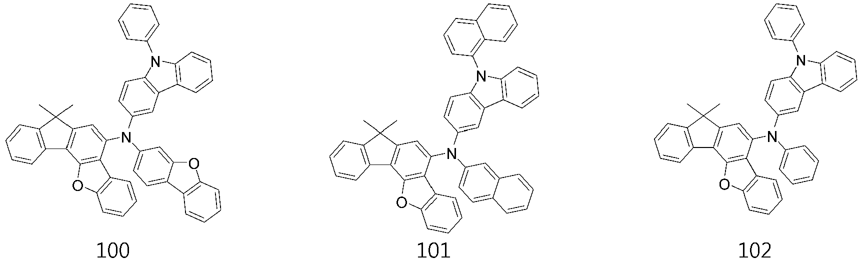

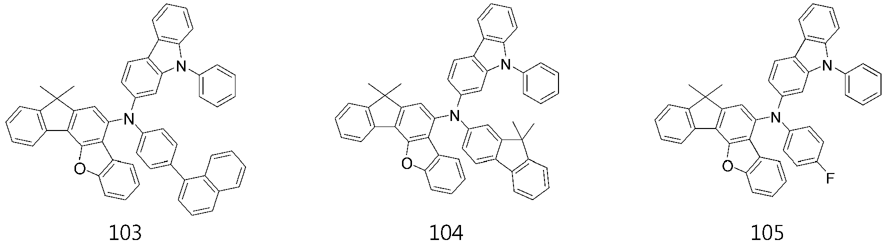

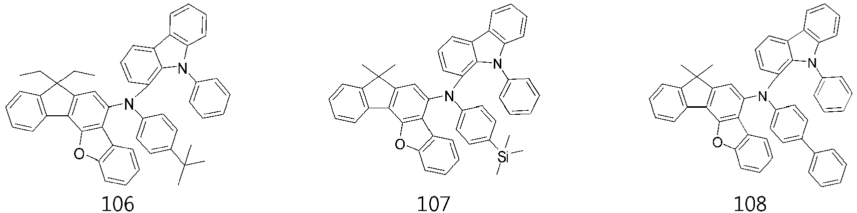

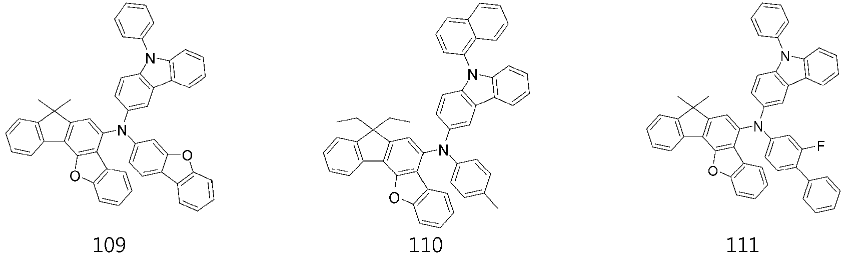

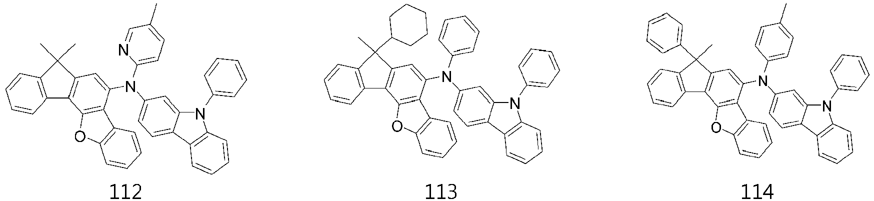

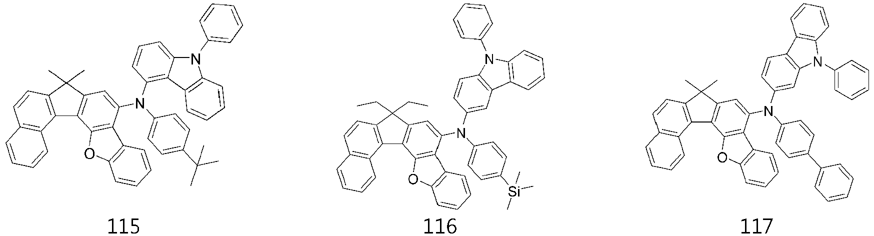

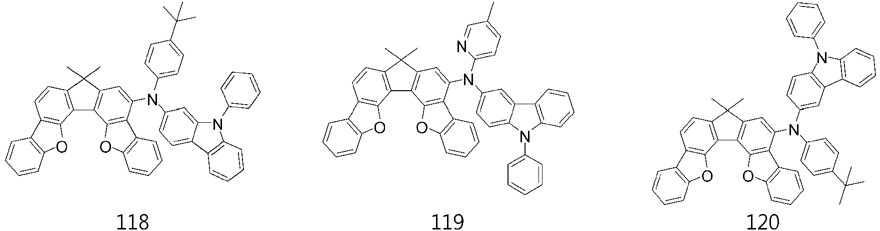

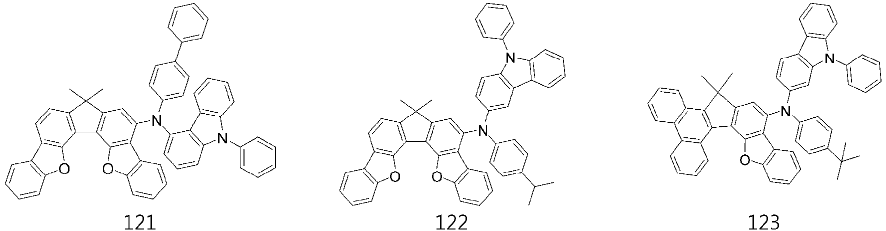

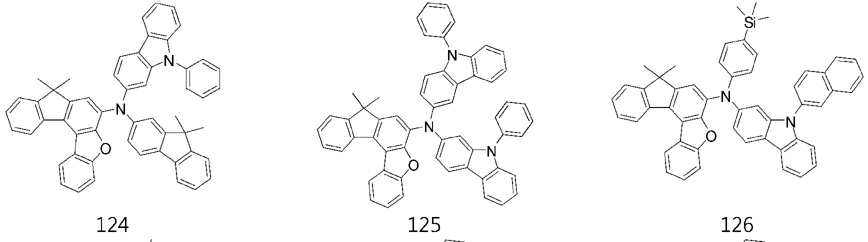

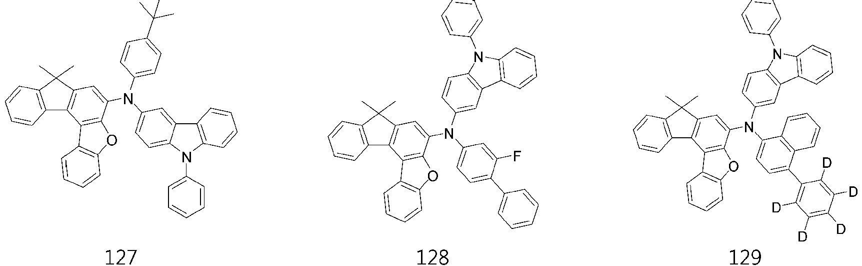

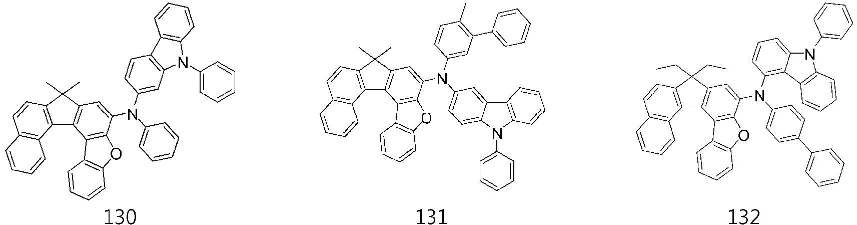

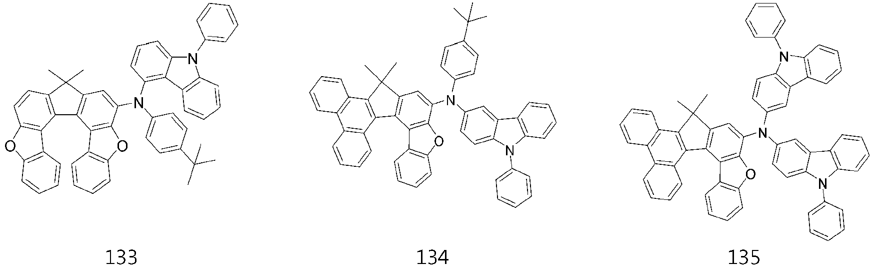

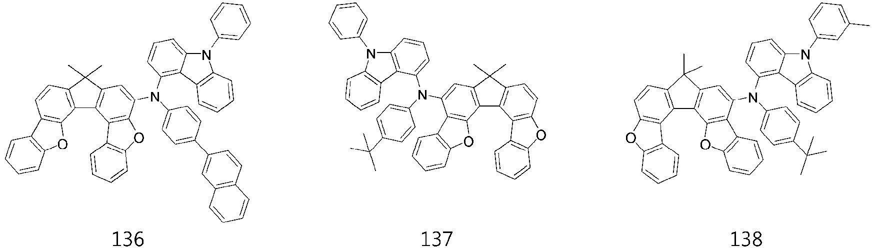

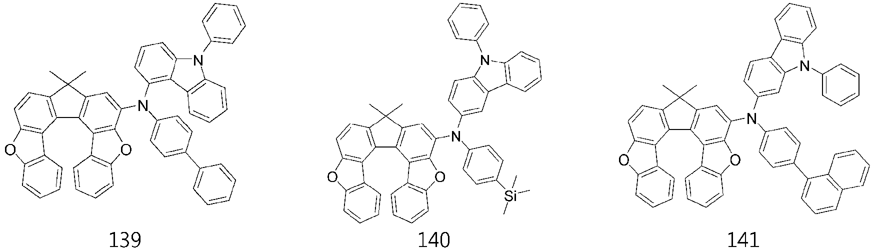

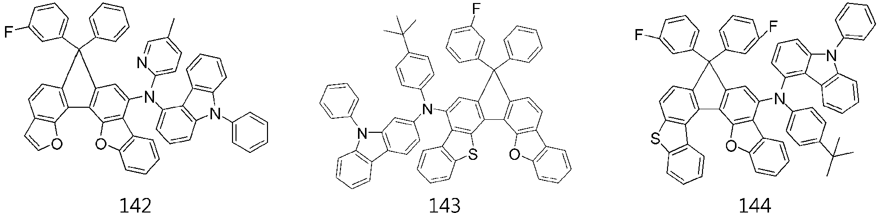

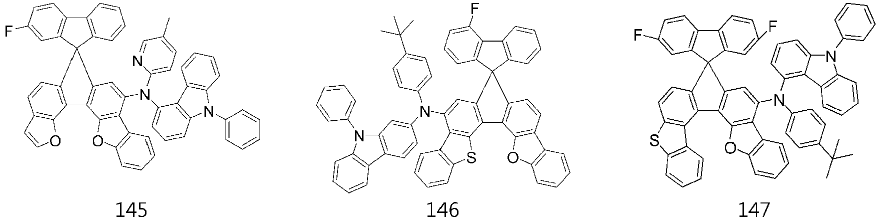

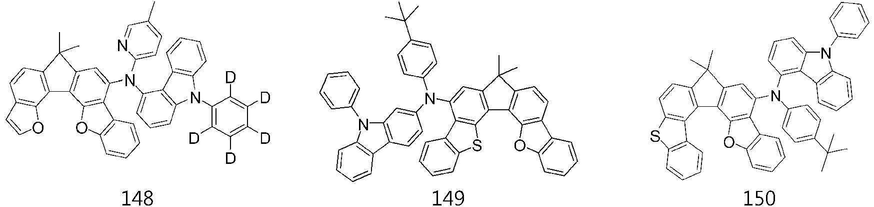

7. The organic light-emitting device according to claim 1, wherein the compound represented by [Formula C] or [Formula D] is selected from the compounds represented by the following formulas:

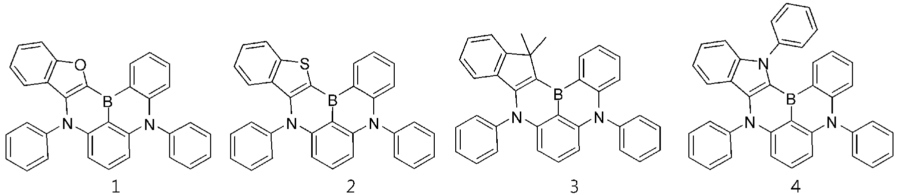

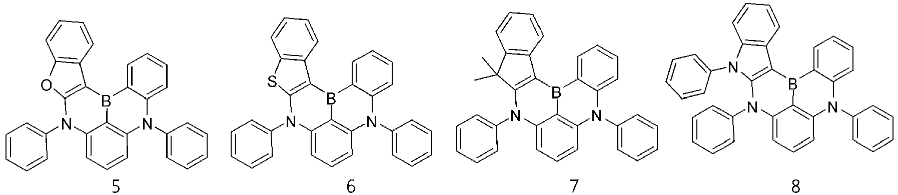

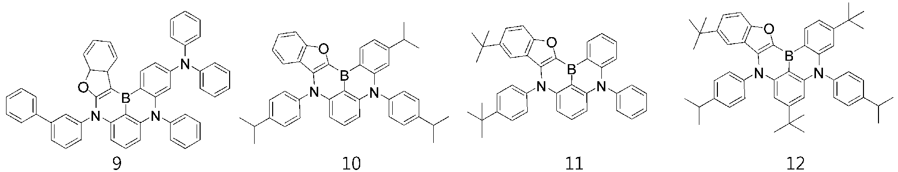

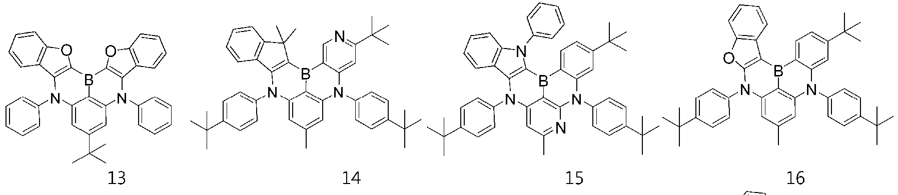

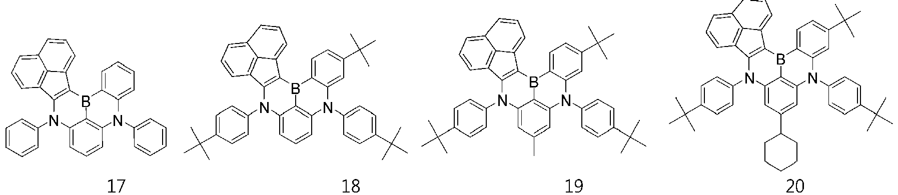

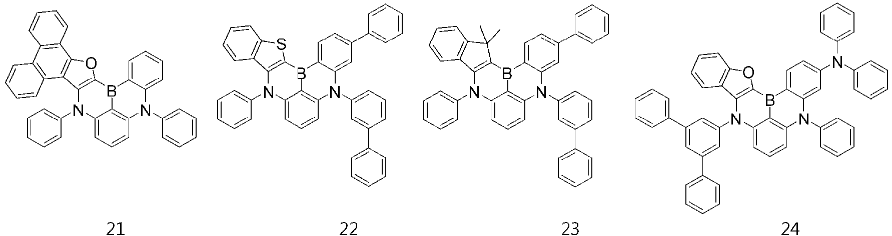

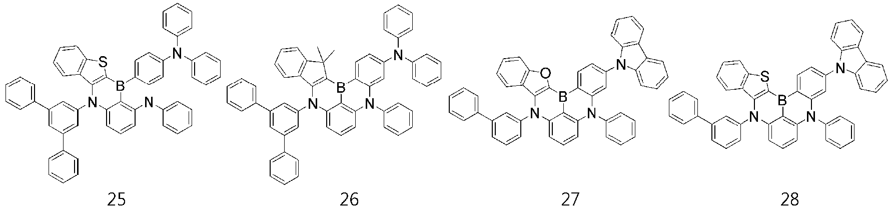

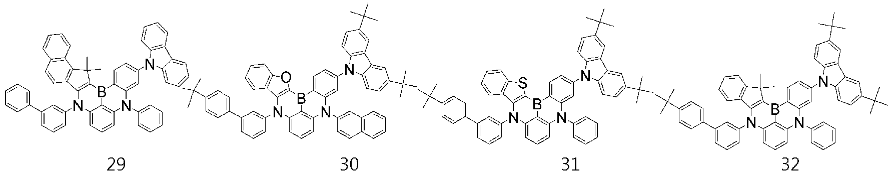

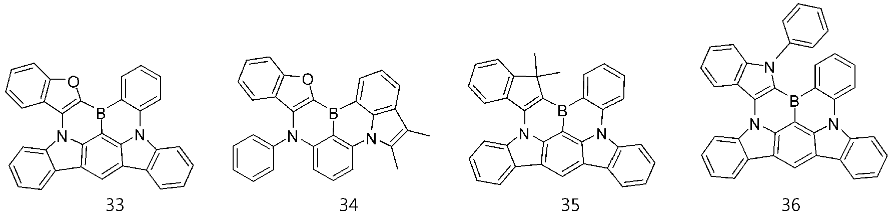

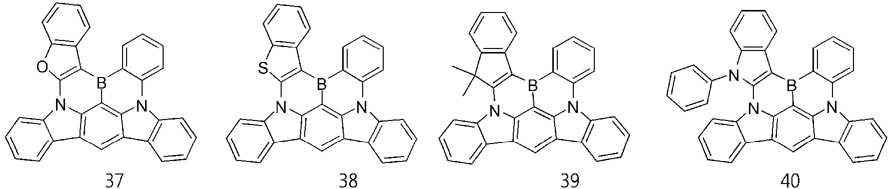

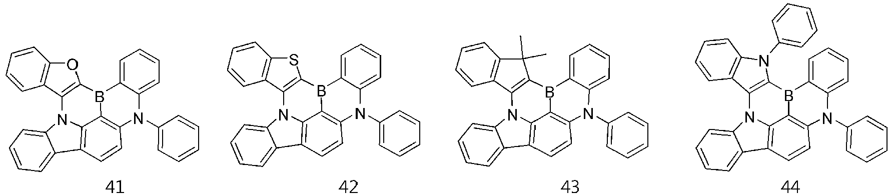

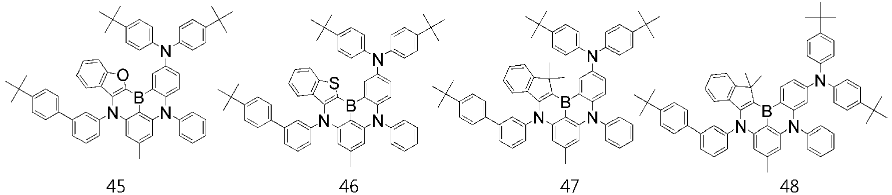

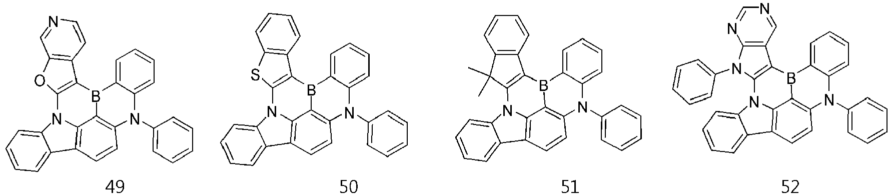

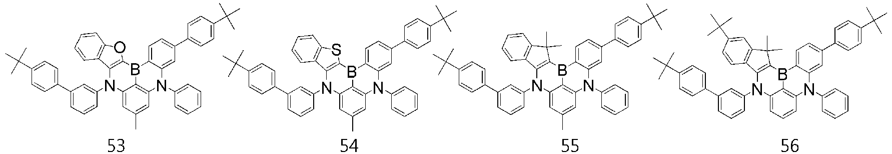

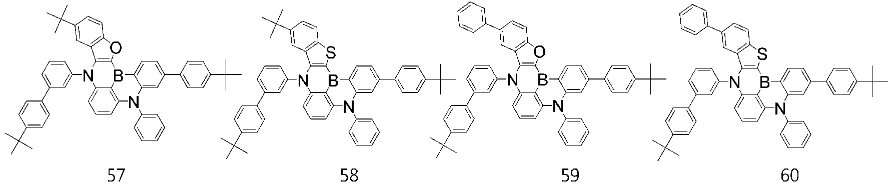

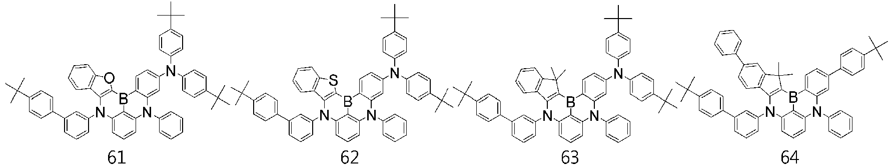

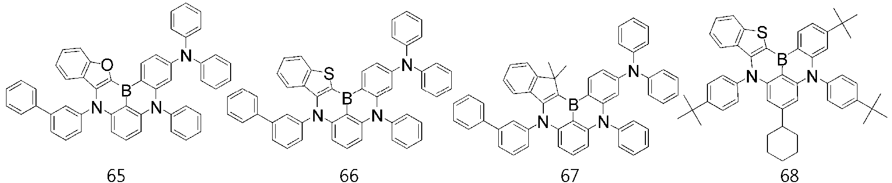

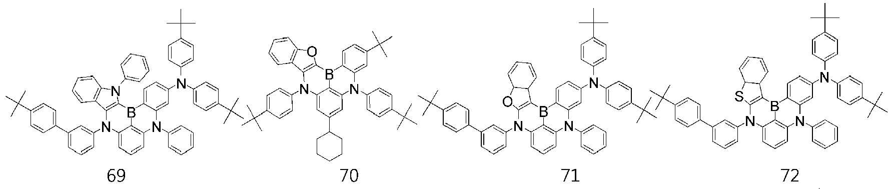

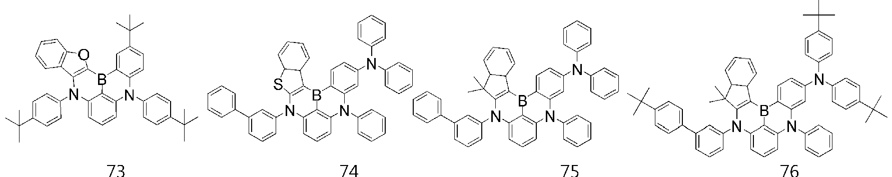

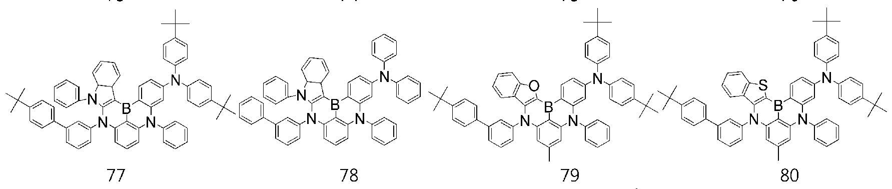

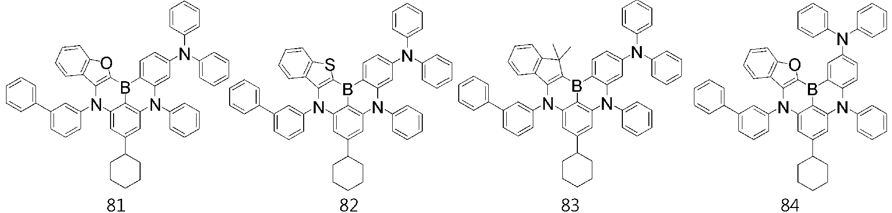

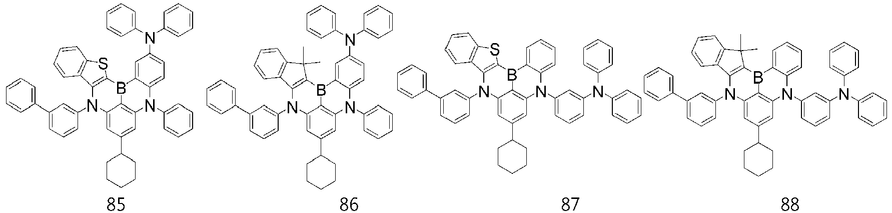

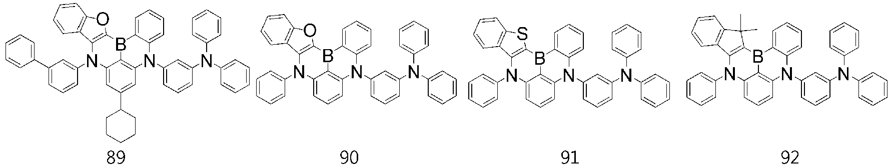

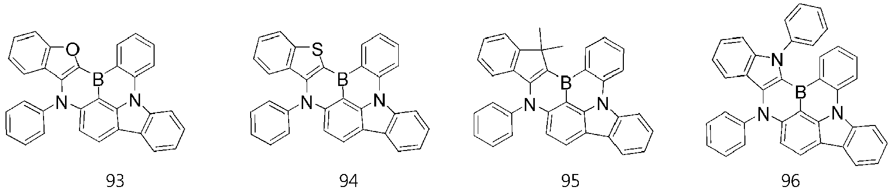

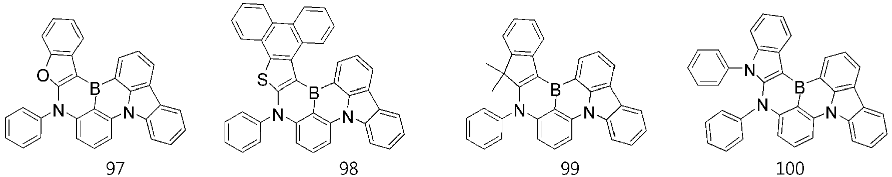

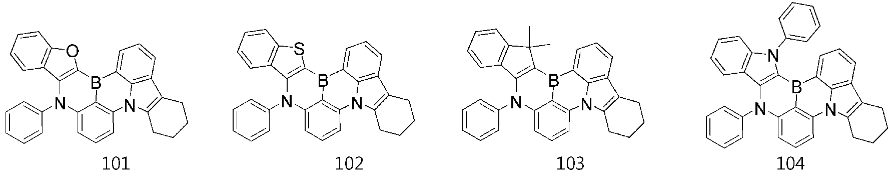

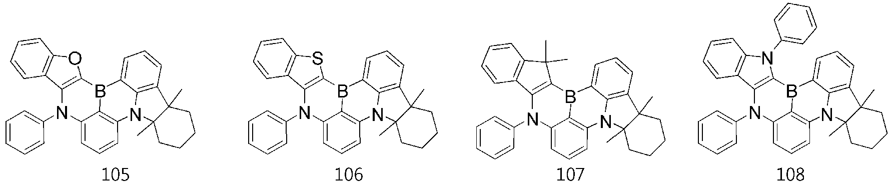

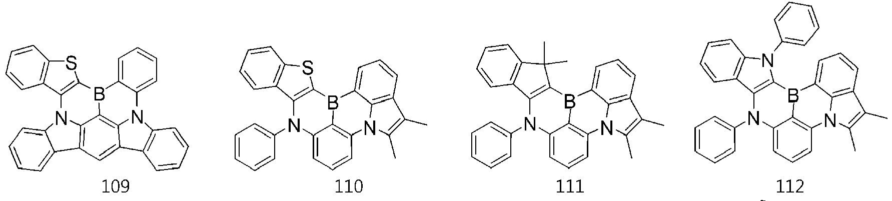

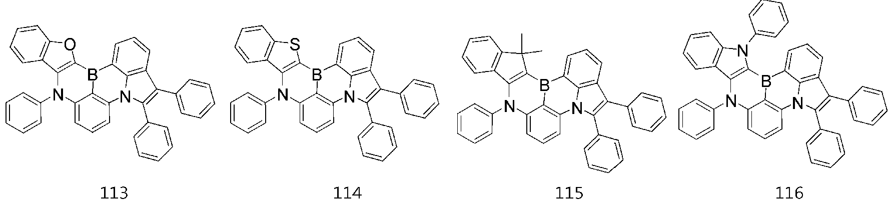

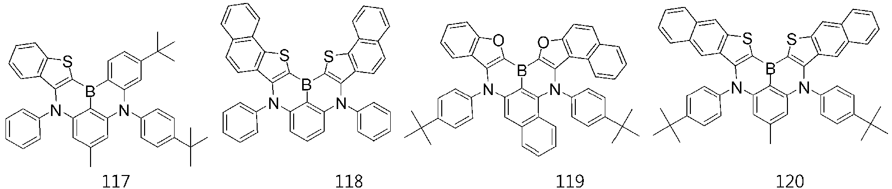

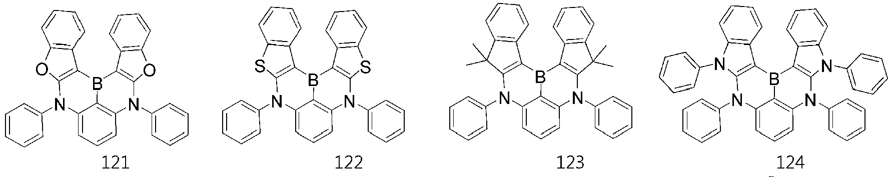

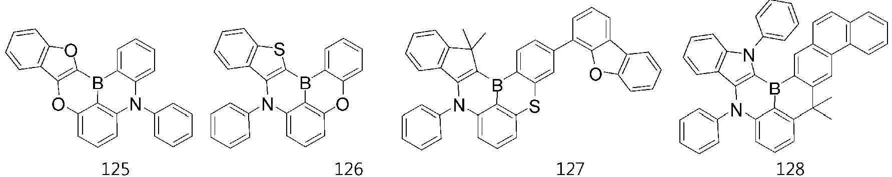

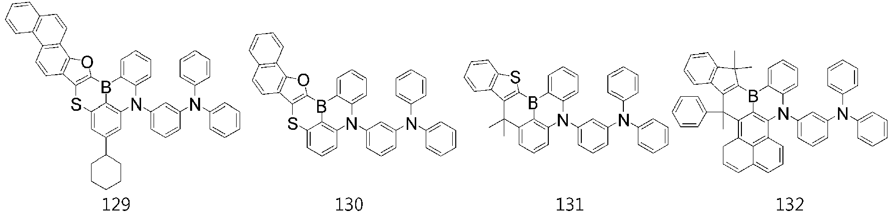

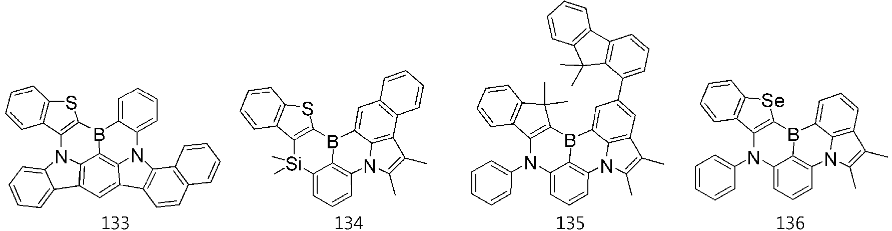

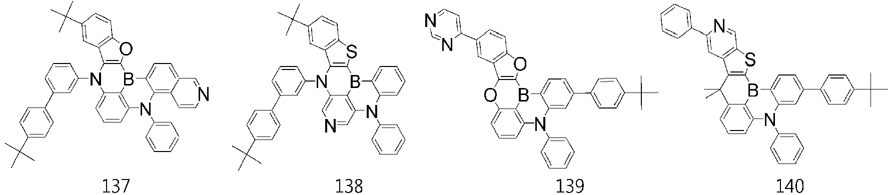

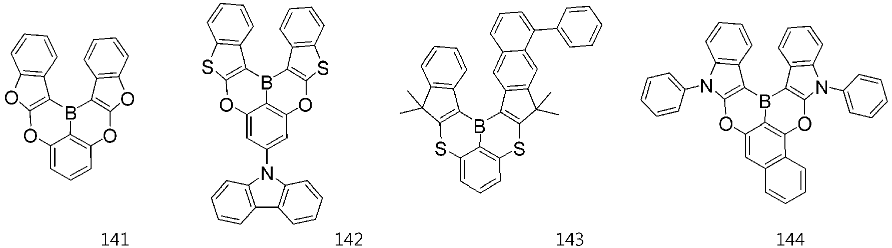

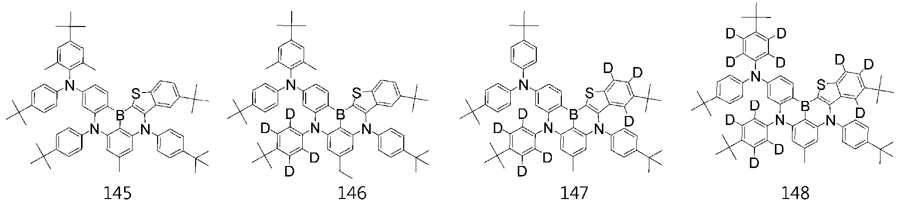

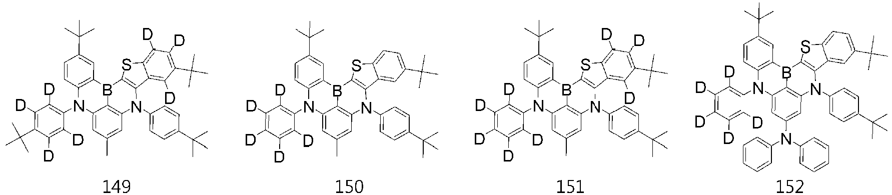

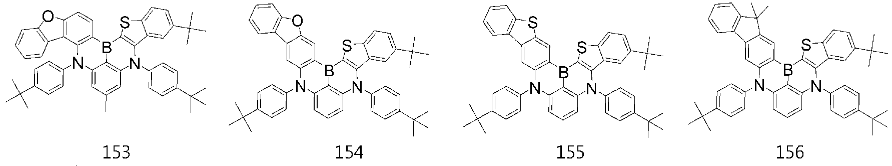

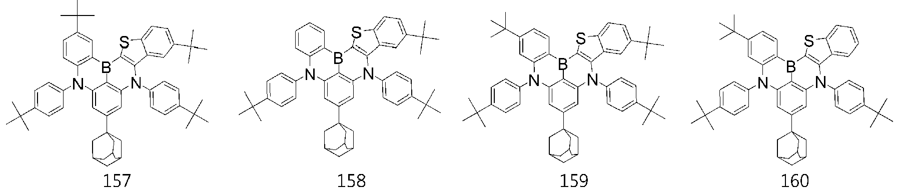

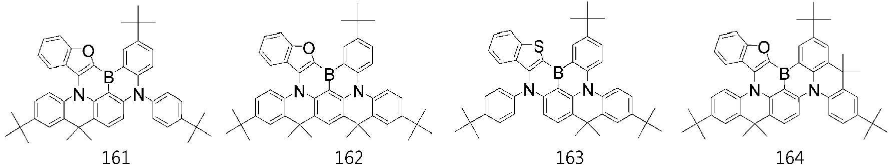

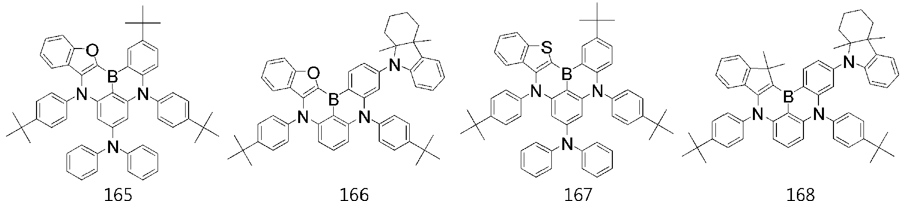

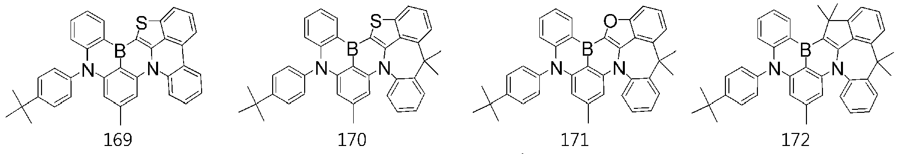

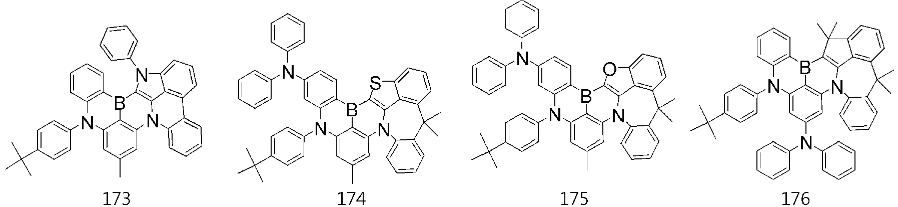

8. The organic light-emitting device according to claim 1, further comprising at least one selected from an electron injection layer, an electron transport layer, an electron blocking layer, a hole blocking layer and a hole auxiliary layer, in addition to the hole injection layer, the hole transport layer and the light emitting layer, between the first electrode and the second electrode.

9. The organic light-emitting device according to claim 8, wherein at least one selected from the layers is formed by a deposition process or a solution process.

10. The organic light-emitting device according to claim 1, wherein the organic light-emitting device is used for a display or lighting system selected from flat panel displays, flexible displays, monochromatic or white flat panel lighting systems, monochromatic or white flexible lighting systems, vehicle displays, and displays for virtual or augmented reality.

## Patentansprüche

1. Ein organisches lichtemittierendes Bauteil, umfassend:
eine erste Elektrode;
eine zweite Elektrode, die der ersten Elektrode gegenüberliegt; und
eine Lochinjektionsschicht oder eine Lochtransportschicht und eine lichtemittierende Schicht, die zwischen der ersten Elektrode und der zweiten Elektrode angeordnet ist,
wobei
(i) die Lochinjektionsschicht oder die Lochtransportschicht mindestens eine Verbindung umfasst, die durch die folgende [Formel A] oder [Formel B] dargestellt wird, und
(ii) ie lichtemittierende Schicht eine Verbindung umfasst, die durch die folgende [Formel C] oder [Formel D] dargestellt wird: 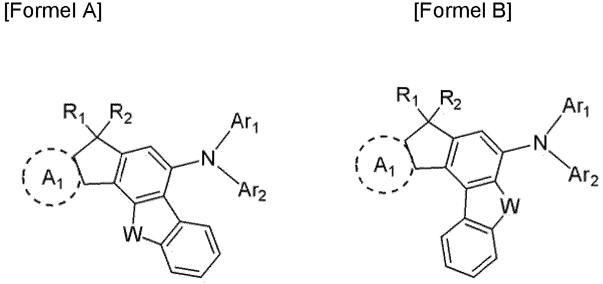
wobei
A₁ aus einer substituierten oder unsubstituierten C6-C30-Arylgruppe und einer substituierten oder unsubstituierten C2-C50-Heteroarylgruppe ausgewählt ist,
W ein Sauerstoffatom (O) oder ein Schwefelatom (S) ist,
R₁ und R₂ identisch oder voneinander verschieden sind und jeweils unabhängig voneinander ausgewählt sind aus Wasserstoff, Deuterium, einer substituierten oder unsubstituierten C1-C30-Alkylgruppe, einer substituierten oder unsubstituierten C3-C30-Cycloalkylgruppe, einer substituierten oder unsubstituierten C6-C50-Arylgruppe und einer substituierten oder unsubstituierten C2-C50-Heteroarylgruppe, mit der Maßgabe, dass R1 und R2 optional miteinander verbunden sind, um einen alicyclischen oder aromatischen monocyclischen oder polycyclischen Ring zu bilden,
Ar₁ and Ar₂ identisch oder voneinander verschieden sind und jeweils unabhängig voneinander ausgewählt sind aus einer substituierten oder unsubstituierten C6-C50-Arylgruppe und einer substituierten oder unsubstituierten C2-C50-Heteroarylgruppe, mit der Maßgabe, dass mindestens eines von Ar1 und Ar2 durch die folgende Strukturformel 1 dargestellt ist: 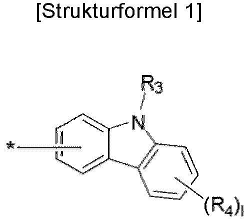
wobei
R₃ ausgewählt ist aus Wasserstoff, Deuterium, einer substituierten oder unsubstituierten C1-C30-Alkylgruppe, einer substituierten oder unsubstituierten C3-C30-Cycloalkylgruppe, einer substituierten oder unsubstituierten C6-C50-Arylgruppe und einer substituierten oder unsubstituierten C2-C50-Heteroarylgruppe,
R₄ ausgewählt ist aus Wasserstoff, Deuterium, einer Cyanogruppe, einer Halogengruppe, einer Hydroxylgruppe, einer Nitrogruppe, einer C1-C24-Alkylgruppe, einer C1-C24-halogenierten Alkylgruppe, einer C1-C24-Cycloalkylgruppe, einer C1-C24-Alkenylgruppe, einer C1-C24-Alkinylgruppe, einer C1-C24-Heteroalkylgruppe, einer C6-C30-Arylgruppe, einer C6-C30-Arylalkylgruppe, einer C2-C30-Heteroarylgruppe, einer C2-C30-Heteroarylalkylgruppe, einer C1-C24-Alkoxygruppe, einer C1-C24-Alkylaminogruppe, einer C6-C30-Arylaminogruppe, einer C2-C30-Heteroarylaminogruppe, einer C1-C24-Alkylsilylgruppe, einer C6-C30- Arylsilylgruppe und einer C6-C30-Aryloxygruppe,
I eine ganze Zahl von 0 bis 4 ist, vorausgesetzt, dass, wenn I 2 oder mehr ist, die R4-Gruppen identisch oder voneinander verschieden sind, und
"-*" eine Stelle bedeutet, die an ein Stickstoffatom an den Positionen Ar1 und Ar2 in [Formel A] oder [Formel B] gebunden ist, 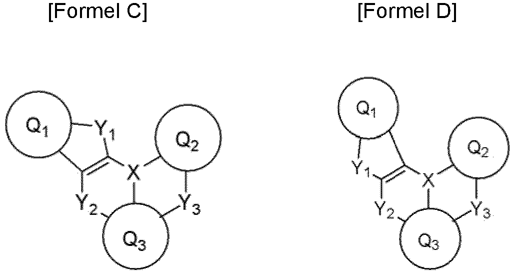
wobei
Q₁ bis Q₃ identisch oder voneinander verschieden sind und jeweils unabhängig voneinander einen substituierten oder unsubstituierten aromatischen C6-C50-Kohlenwasserstoffring oder eine substituierte oder unsubstituierte aromatische C2-C50-heterocyclische Gruppe darstellen;
Y₁ bis Y₃ indentisch oder voneinander verschieden sind und jeweils unabhängig voneinander ausgewählt sind aus N-R₁, CR₂R₃, O, S, Se, und SiR₄R₅;
X ausgewählt ist aus B, P und P=O; und
R₁ bis R₅ identisch oder voneinander verschieden sind und jeweils unabhängig voneinander ausgewählt sind aus Wasserstoff, Deuterium, einer substituierten oder unsubstituierten C1-C30-Alkylgruppe, einer substituierten oder unsubstituierten C6-C50-Arylgruppe, einer substituierten oder unsubstituierten C3-C30-Cycloalkylgruppe, einer substituierten oder unsubstituierten C2-C50-Heteroarylgruppe, eine substituierte oder unsubstituierte C1-C30-Alkoxygruppe, eine substituierte oder unsubstituierte C6-C30-Aryloxygruppe, eine substituierte oder unsubstituierte C1-C30-Alkylthioxygruppe, eine substituierte oder unsubstituierte C5-C30-Arylthioxygruppe, eine substituierte oder unsubstituierte C1-C30-Alkylaminogruppe, eine substituierte oder unsubstituierte C5-C30-Arylaminogruppe, eine substituierte oder unsubstituierte C1-C30-Alkylsilylgruppe, eine substituierte oder unsubstituierte C5-C30-Arylsilylgruppe, eine Nitrogruppe, eine Cyanogruppe und eine Halogengruppe, mit der Maßgabe, dass R1 bis R5 jeweils optional an den Ring Q1 bis Q3 gebunden ist, um einen alicyclischen oder aromatischen monocyclischen oder polycyclischen Ring zu bilden, und R2 und R3 sowie R4 und R5 optional miteinander verbunden sind, um einen alicyclischen oder aromatischen monocyclischen oder polycyclischen Ring zu bilden.

2. Das organische lichtemittierende Bauteil gemäß Anspruch 1, wobei [Formel C] oder [Formel D] durch [Formel C-1] oder [Formel D-1] dargestellt ist: 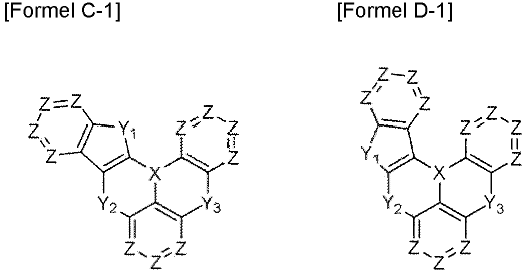 wobei
Z CR oder N ist, mit der Maßgabe, dass die Zs identisch oder voneinander verschieden sind und die Rs identisch oder voneinander verschieden sind,
wobei die Rs jeweils unabhängig voneinander ausgewählt sind aus Wasserstoff, Deuterium, einer substituierten oder unsubstituierten C1-C30-Alkylgruppe, einer substituierten oder unsubstituierten C6-C50-Arylgruppe, einer substituierten oder unsubstituierten C3-C30-Cycloalkylgruppe, einer substituierten oder unsubstituierten C2-C50-Heteroarylgruppe, einer substituierten oder unsubstituierten C1-C30-Alkoxygruppe, einer substituierten oder unsubstituierten C6-C30-Aryloxygruppe, einer substituierten oder unsubstituierten C1-C30-Alkylthioxygruppe, einer substituierten oder unsubstituierten C5-C30-Arylthioxygruppe, einer substituierten oder unsubstituierten C1-C30-Alkylaminogruppe, einer substituierten oder unsubstituierten C5-C30-Arylaminogruppe, einer substituierten oder unsubstituierten C1-C30-Alkylsilylgruppe, einer substituierten oder unsubstituierten C5-C30-Arylsilylgruppe, einer Nitrogruppe, einer Cyanogruppe, einer Halogengruppe und -N(R₆)(R₇) und
die Rs optional miteinander verbunden sind oder jedes davon optional mit einem benachbarten Substituenten verbunden ist, um mindestens einen alicyclischen oder aromatischen monocyclischen oder polycyclischen Ring zu bilden, und das Kohlenstoffatom des gebildeten alicyclischen, aromatischen monocyclischen oder polycyclischen Rings mit mindestens einem Heteroatom substituiert ist, das aus (N), einem Schwefelatom (S) und einem Sauerstoffatom (O) ausgewählt ist,
R₆ und R₇ sind identisch oder voneinander verschieden und sind jeweils unabhängig voneinander ausgewählt aus Wasserstoff, Deuterium, einer substituierten oder unsubstituierten C1-C30-Alkylgruppe, einer substituierten oder unsubstituierten C6-C50-Arylgruppe, einer substituierten oder unsubstituierten C3-C30-Cycloalkylgruppe und einer substituierten oder unsubstituierten C2-C50-Heteroarylgruppe, mit der Maßgabe, dass R₆ und R₇ optional miteinander verbunden sind, um einen alicyclischen oder aromatischen monocyclischen oder polycyclischen Ring zu bilden, und
X und Y₁ bis Y₃ wie in [Formel C] und [Formel D] oben definiert sind.

3. Das organische lichtemittierende Bauteil gemäß Anspruch 1, wobei [Formel C] oder [Formel D] durch eine der folgenden [Formel C-2], [Formel C-3] oder [Formel D-2] dargestellt sind: 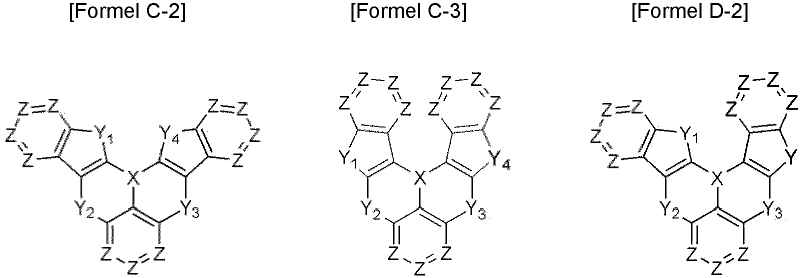 wobei
Z CR oder N ist, mit der Maßgabe, dass die Z identisch oder voneinander verschieden sind und die Rs identisch oder voneinander verschieden sind,
wobei die Rs jeweils unabhängig voneinander ausgewählt sind aus Wasserstoff, Deuterium, einer substituierten oder unsubstituierten C1-C30-Alkylgruppe, einer substituierten oder unsubstituierten C6-C50-Arylgruppe, einer substituierten oder unsubstituierten C3-C30-Cycloalkylgruppe, einer substituierten oder unsubstituierten C2-C50-Heteroarylgruppe, einer substituierten oder unsubstituierten C1-C30-Alkoxygruppe, einer substituierten oder unsubstituierten C6-C30-Aryloxygruppe, einer substituierten oder unsubstituierten C1-C30-Alkylthioxygruppe, einer substituierten oder unsubstituierten C5-C30-Arylthioxygruppe, einer substituierten oder unsubstituierten C1-C30-Alkylaminogruppe, einer substituierten oder unsubstituierten C5-C30-Arylamin-Gruppe, einer substituierten oder unsubstituierten C1-C30-Alkylsilyl-Gruppe, einer substituierten oder unsubstituierten C5-C30-Arylsilyl-Gruppe, einer Nitro-Gruppe, einer Cyano-Gruppe, einer Halogen-Gruppe und -N(R6)(R7), und
die Rs optional miteinander verbunden sind oder jedes davon optional mit einem benachbarten Substituenten verbunden ist, um mindestens einen alicyclischen oder aromatischen monocyclischen oder polycyclischen Ring zu bilden, und das Kohlenstoffatom des gebildeten alicyclischen, aromatischen monocyclischen oder polycyclischen Rings mit mindestens einem Heteroatom substituiert ist, das aus (N), einem Schwefelatom (S) und einem Sauerstoffatom (O) ausgewählt ist, R6 und R7 identisch oder voneinander verschieden sind und jeweils unabhängig voneinander ausgewählt sind aus Wasserstoff, Deuterium, einer substituierten oder unsubstituierten C1-C30-Alkylgruppe, einer substituierten oder unsubstituierten C6-C50-Arylgruppe, einer substituierten oder unsubstituierten C3-C30-Cycloalkylgruppe und einer substituierten oder unsubstituierten C2-C50-Heteroarylgruppe, mit der Maßgabe, dass R6 und R7 optional miteinander verbunden sind, um einen alicyclischen oder aromatischen monocyclischen oder polycyclischen Ring zu bilden, und
X und Y₁ bis Y₄ wie X und Y₁ bis Y₃ in [Formel C] und [Formel D] oben definiert sind.

4. Das organische lichtemittierende Bauteil gemäß Anspruch 2, wobei zumindest eines der Rs -N(R₆)(R₇) ist.

5. Das organische lichtemittierende Bauteil gemäß Anspruch 3, wobei zumindest eines der Rs -N(R₆)(R₇) ist.

6. Das organische lichtemittierende Bauteil gemäß Anspruch 1, wobei die durch [Formel A] oder [Formel B] dargestellte Verbindung aus den durch die folgenden Formeln dargestellten Verbindungen ausgewählt ist.

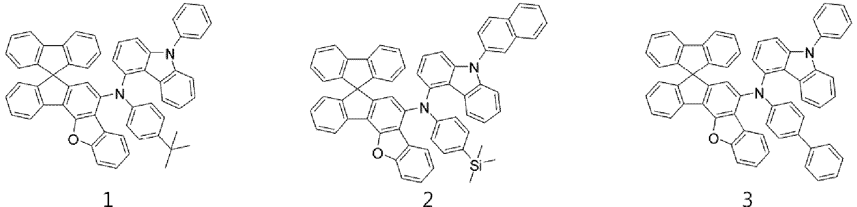

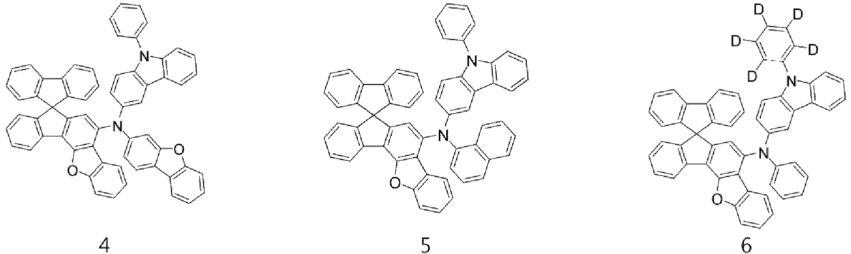

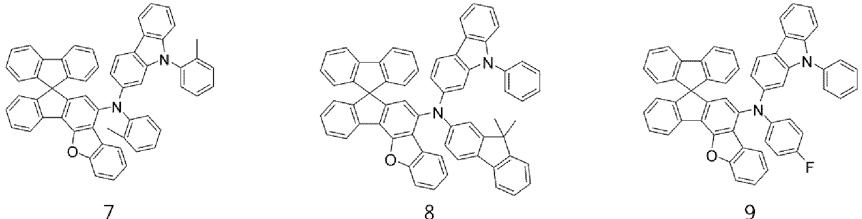

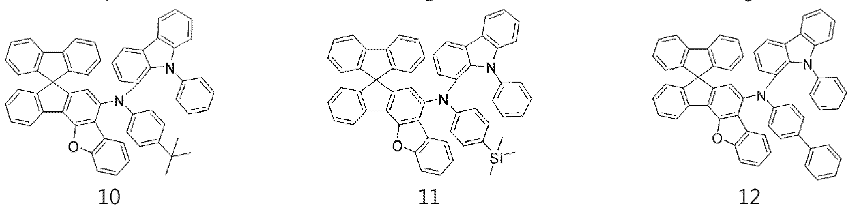

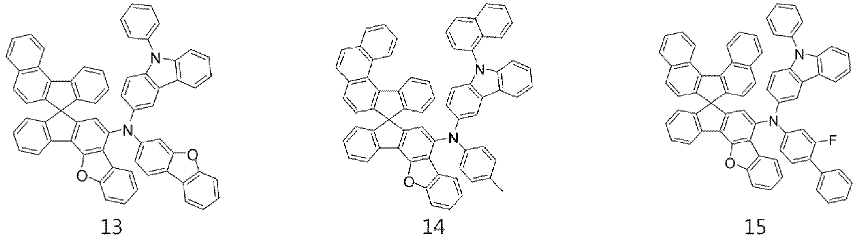

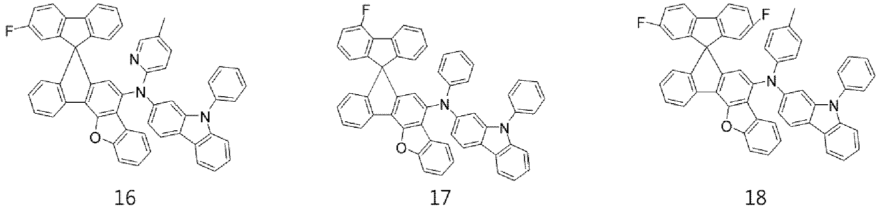

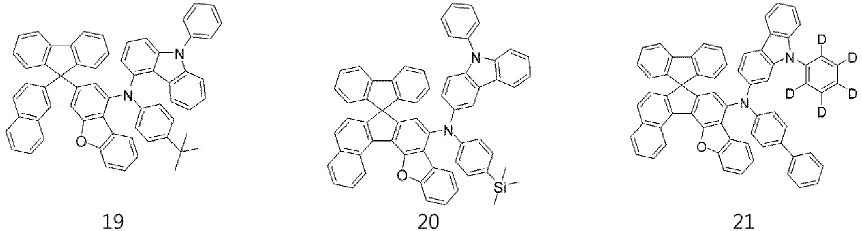

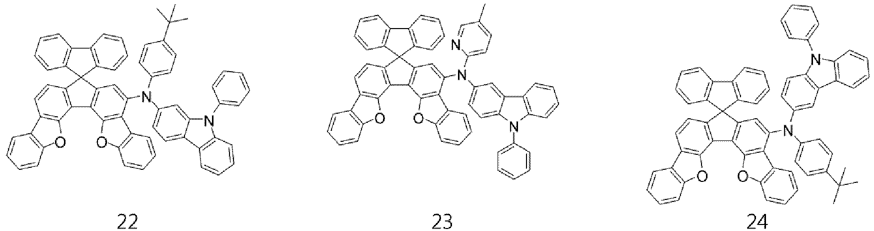

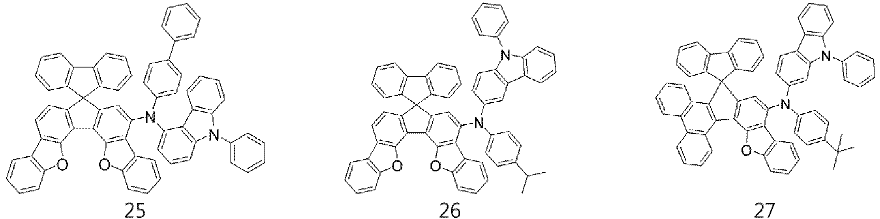

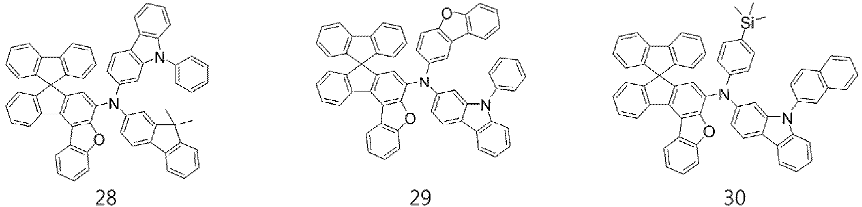

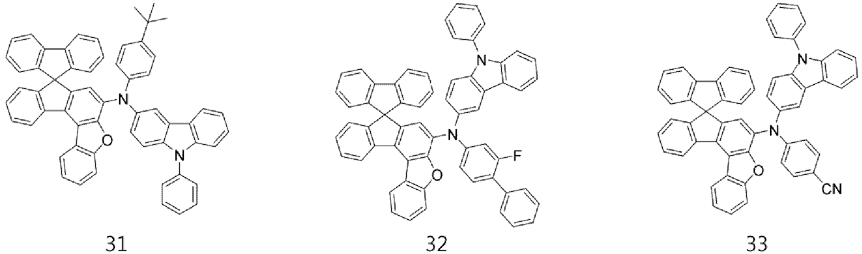

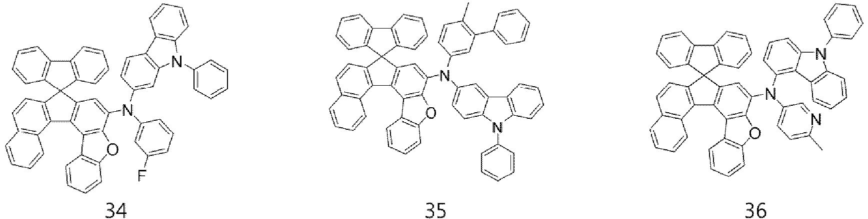

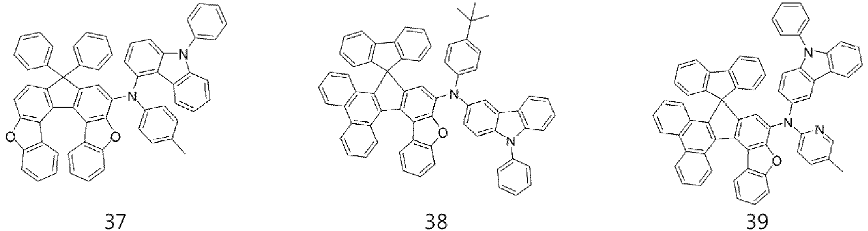

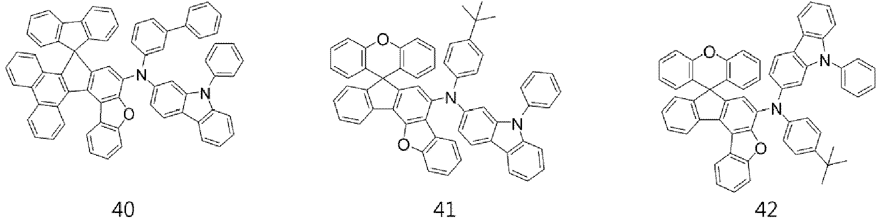

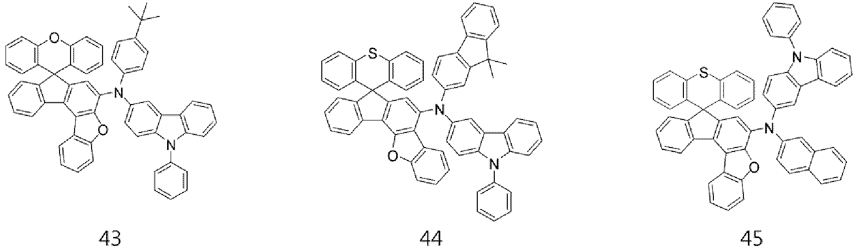

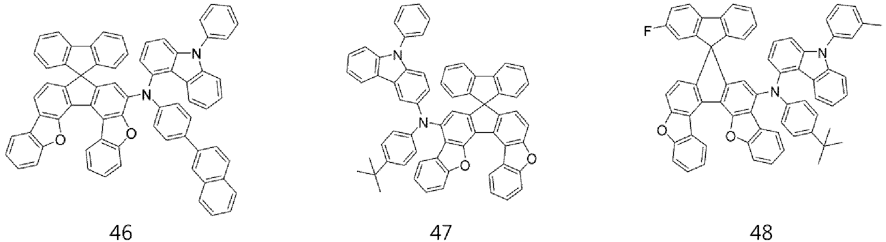

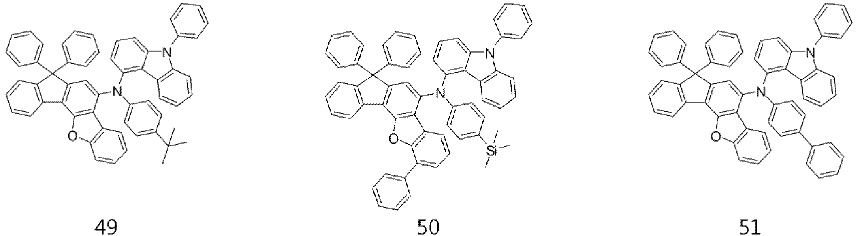

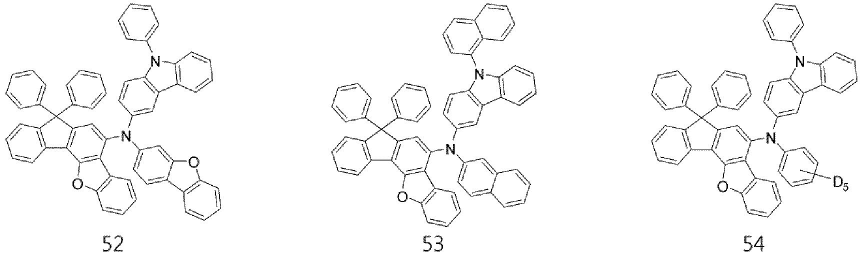

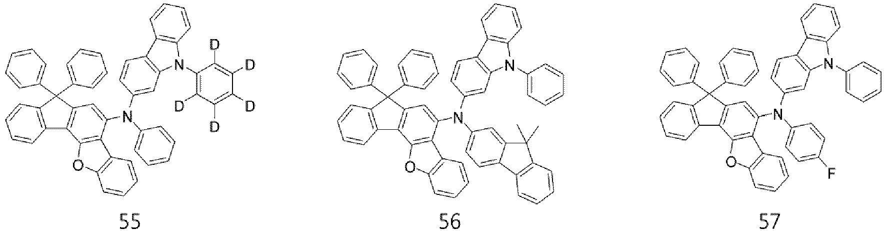

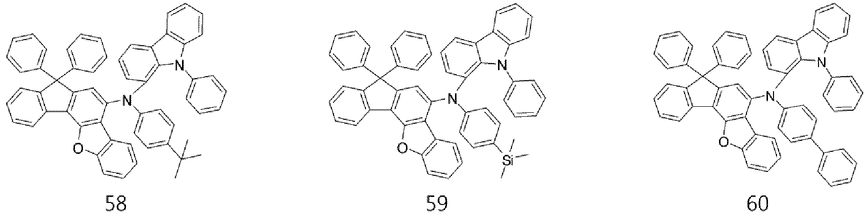

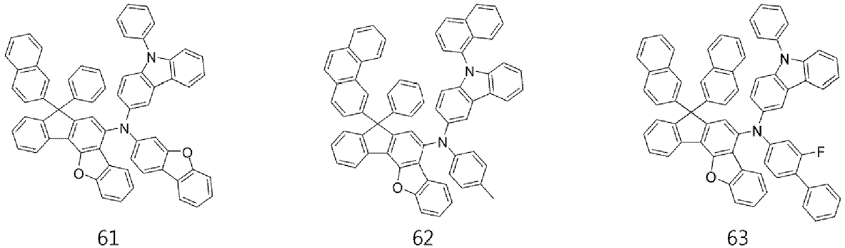

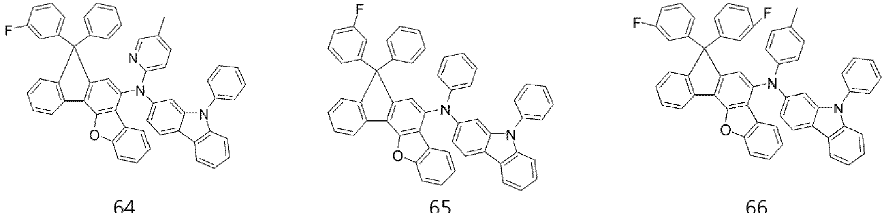

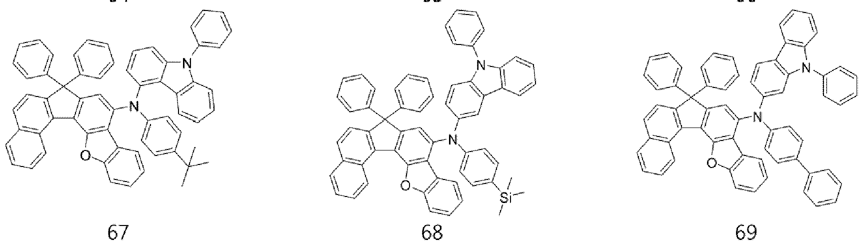

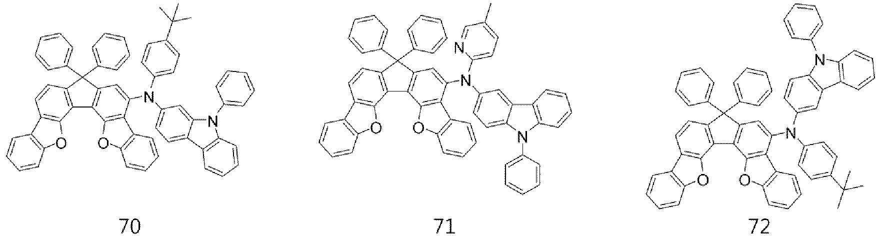

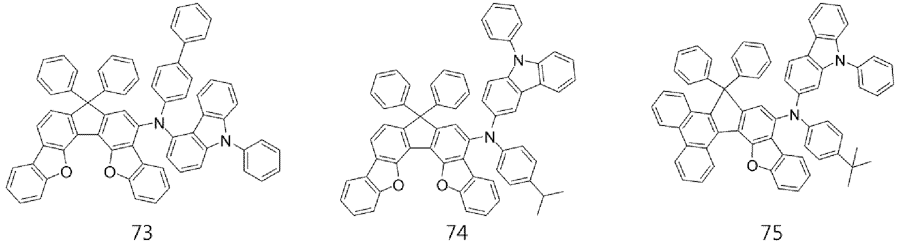

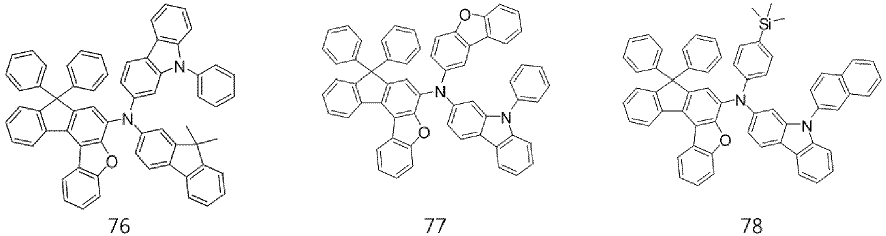

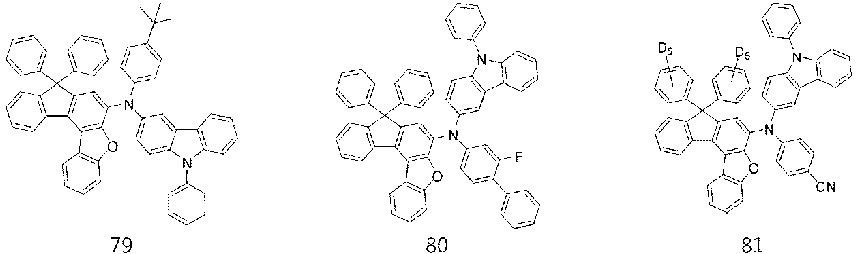

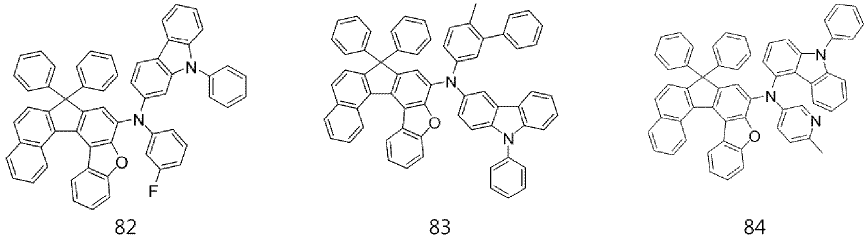

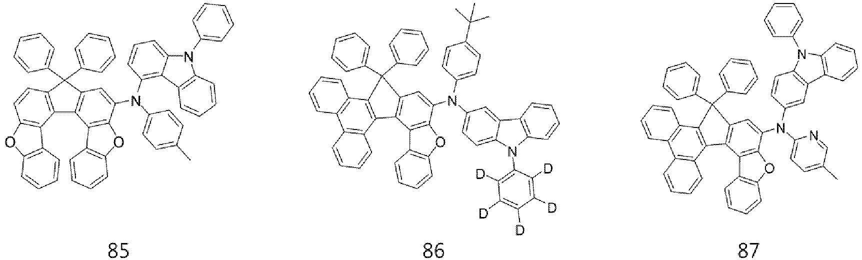

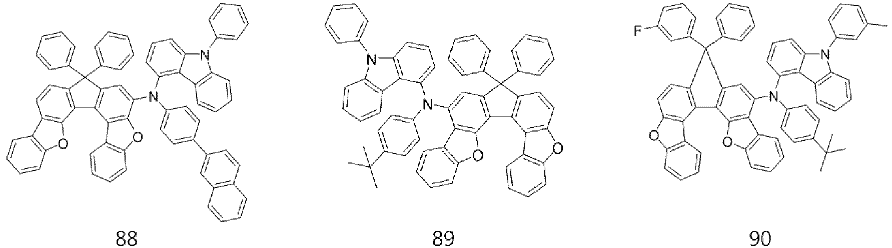

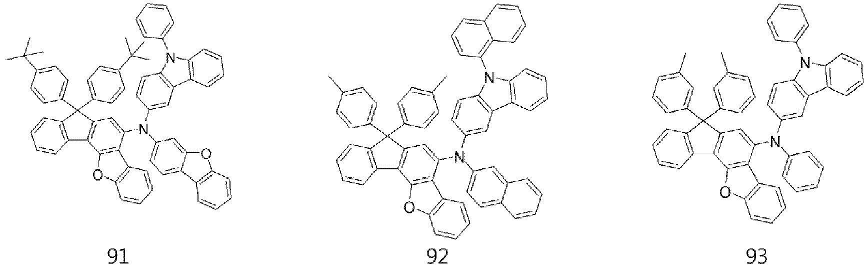

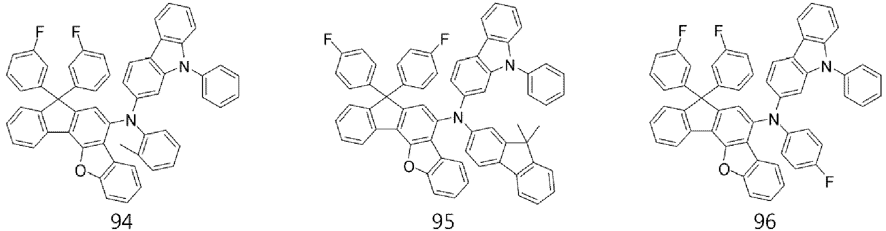

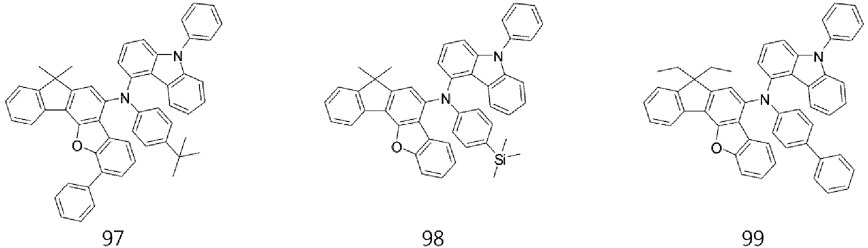

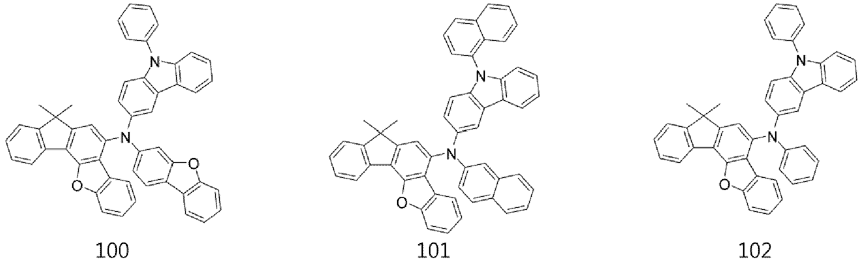

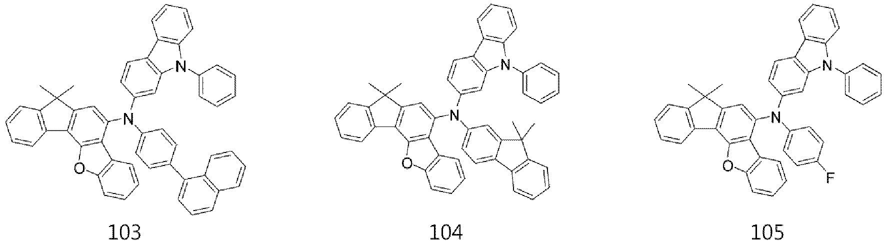

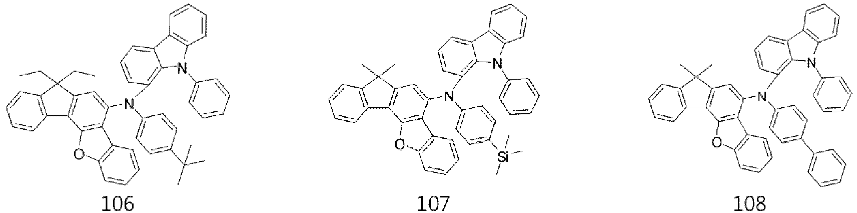

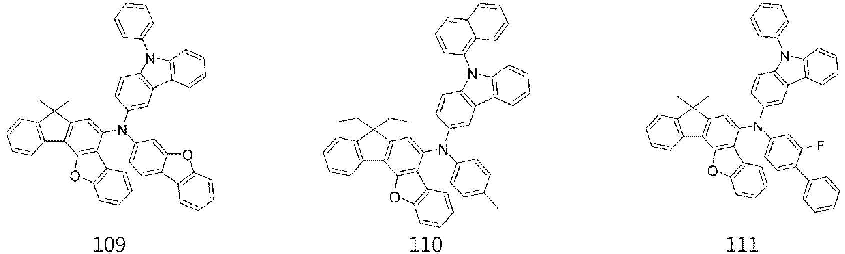

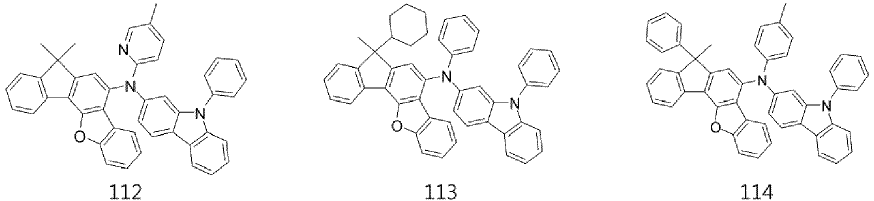

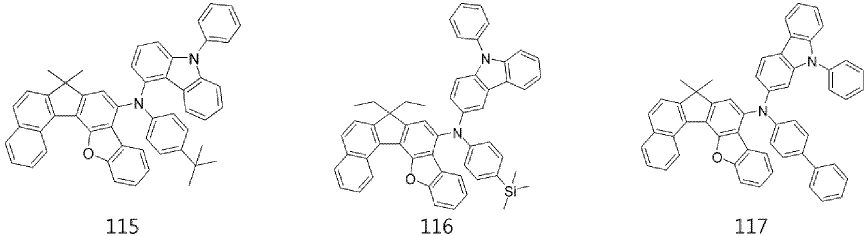

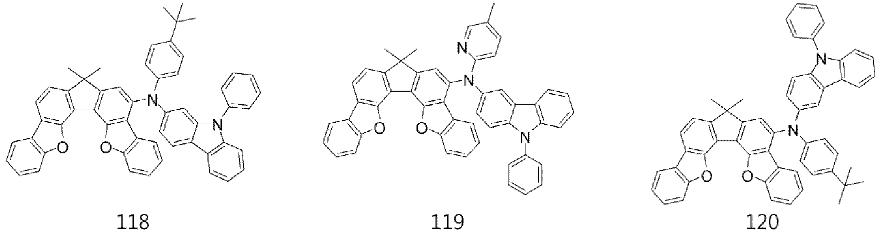

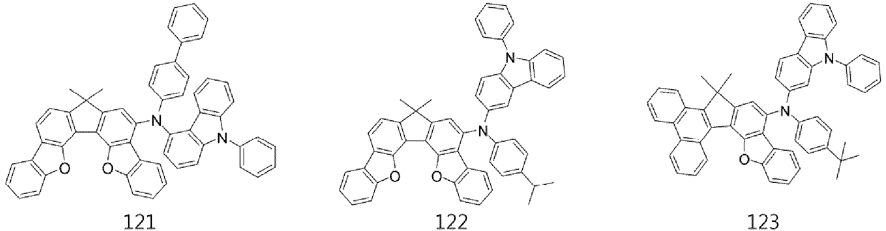

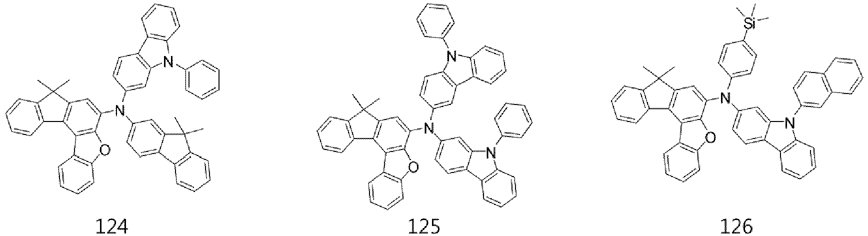

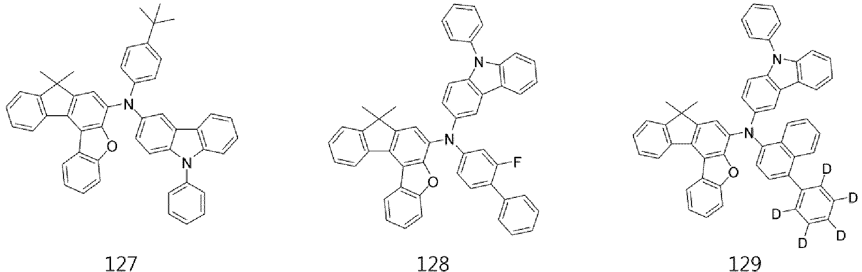

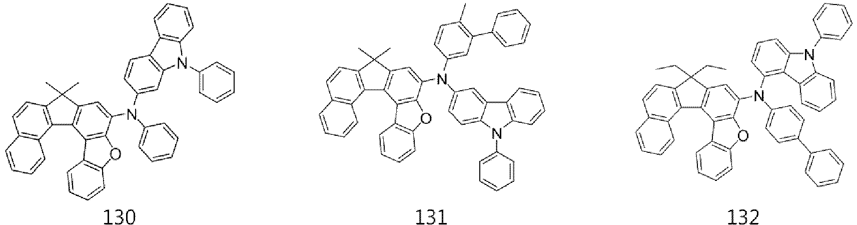

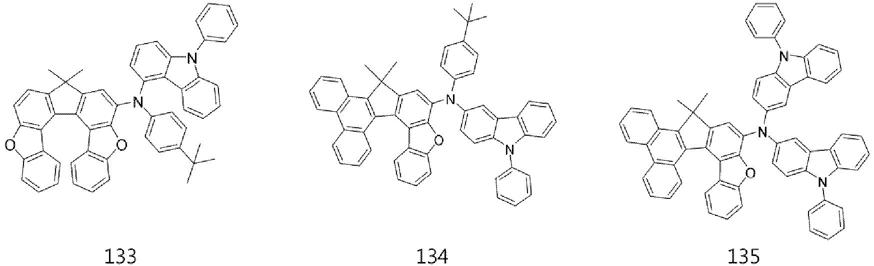

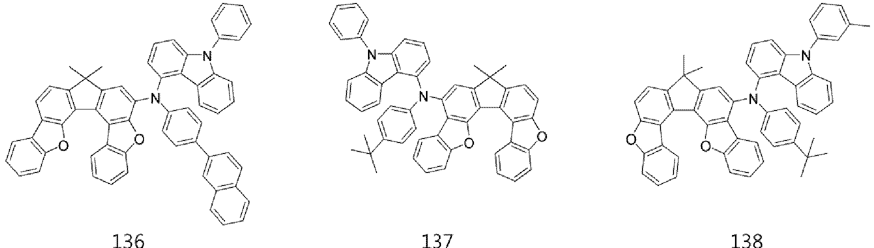

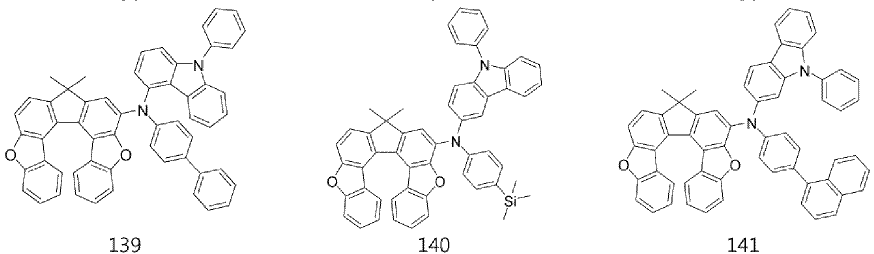

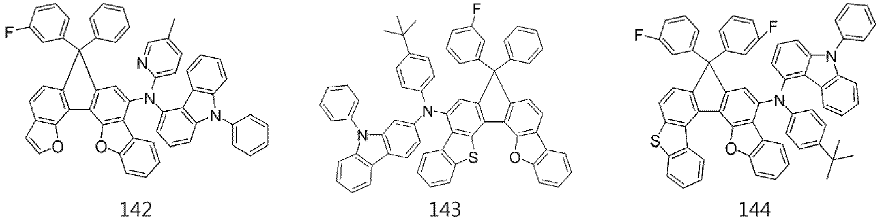

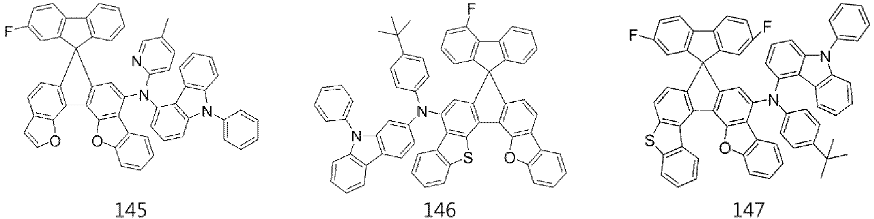

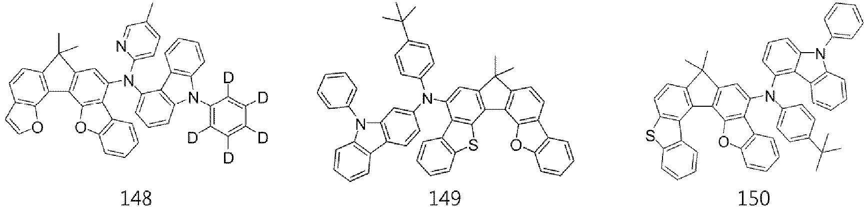

7. The organic light-emitting device according to claim 1, wherein the compound represented by [Formula C] or [Formula D] is selected from the compounds represented by the following formulas:

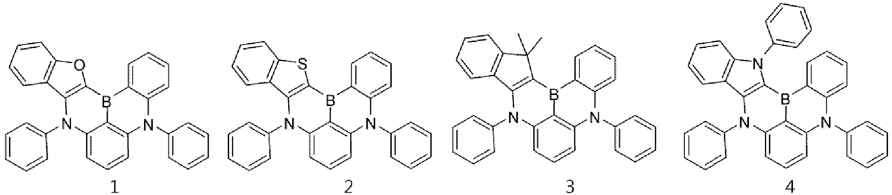

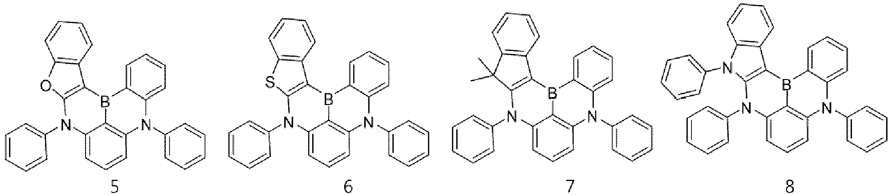

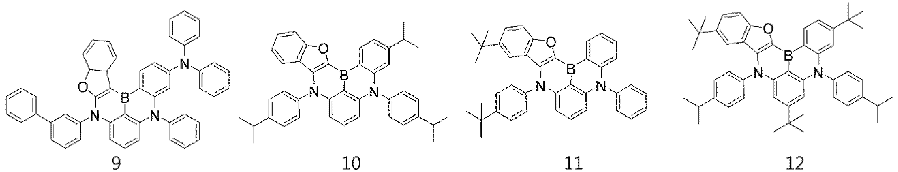

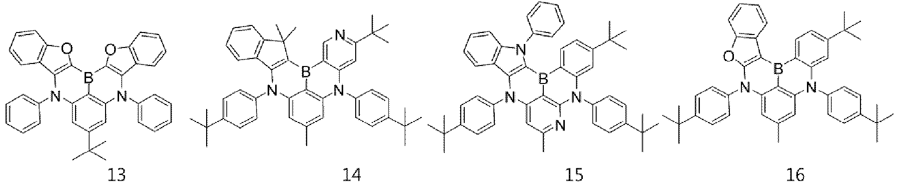

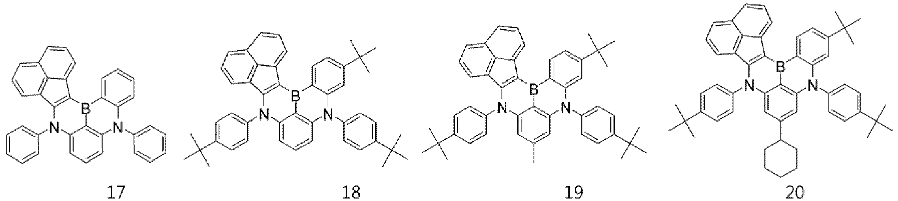

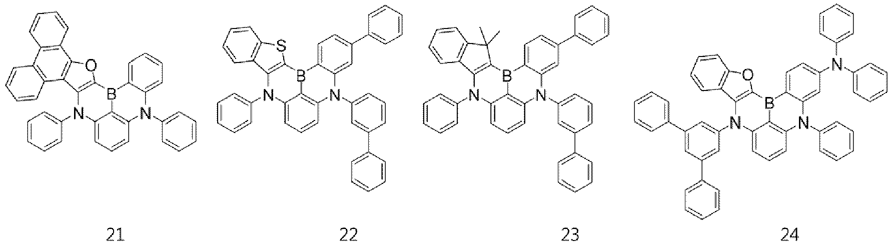

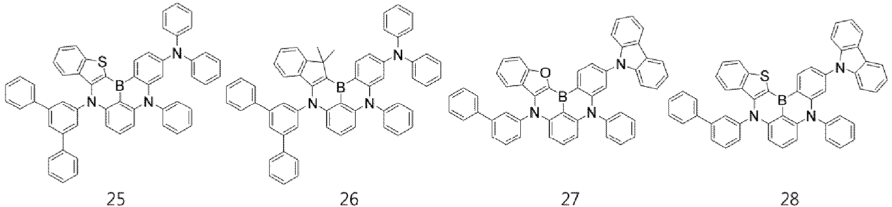

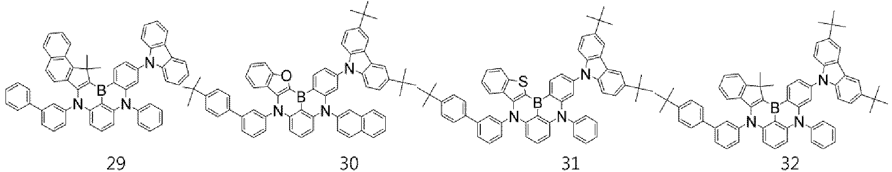

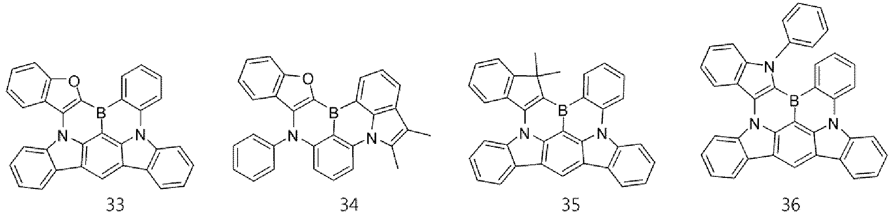

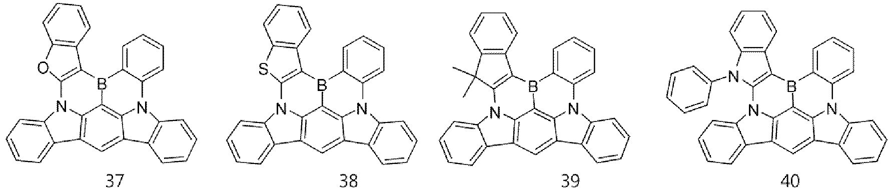

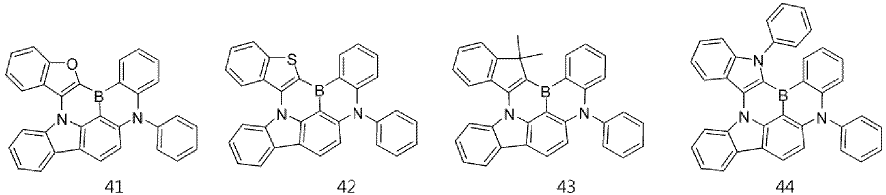

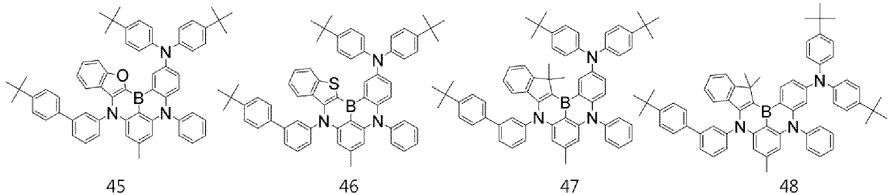

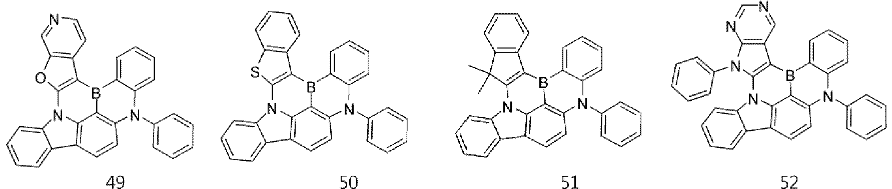

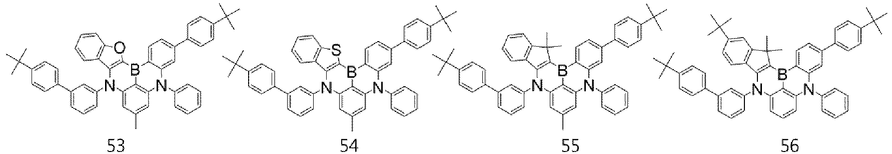

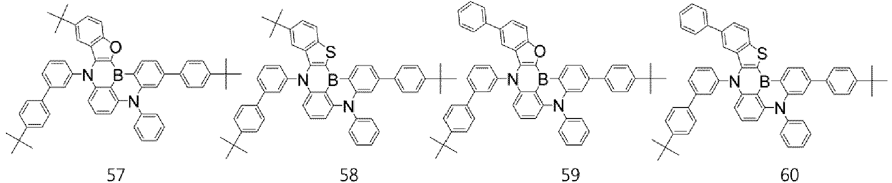

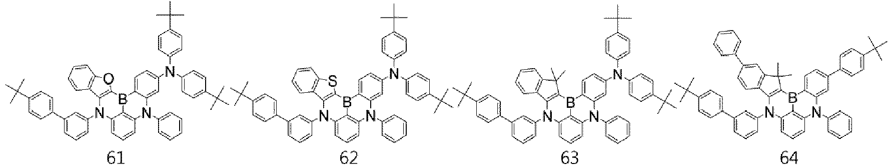

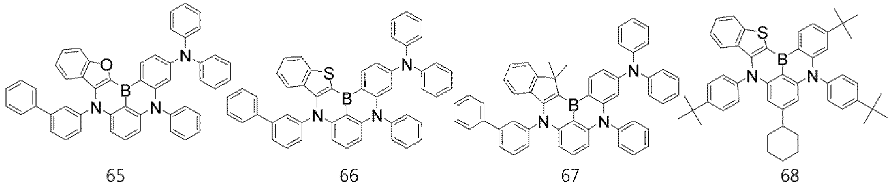

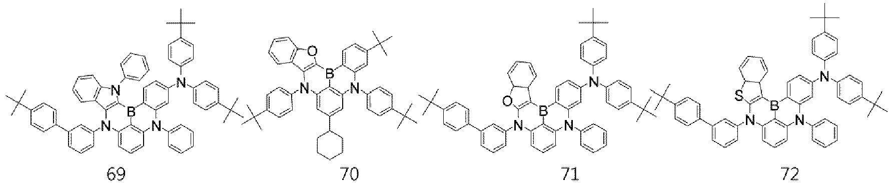

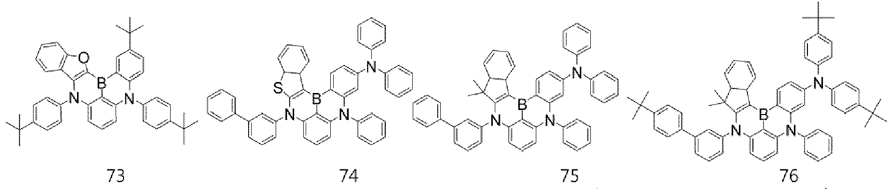

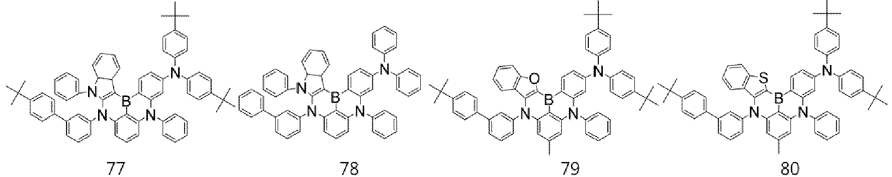

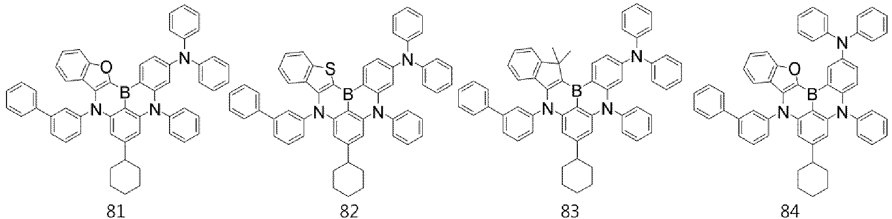

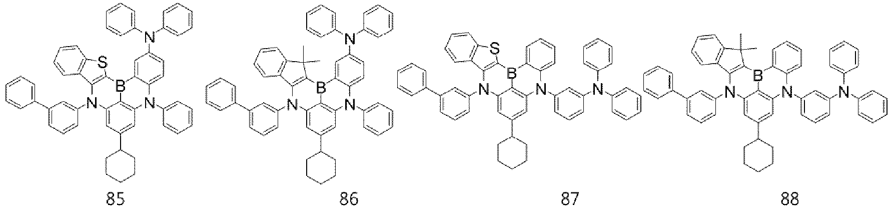

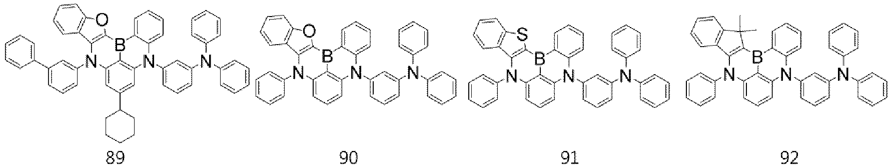

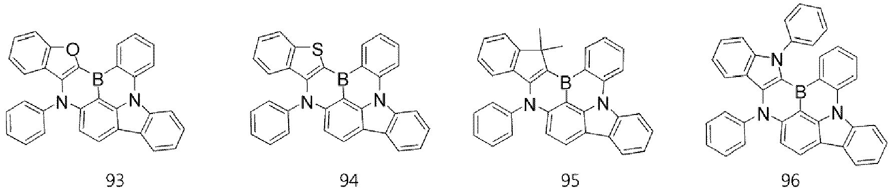

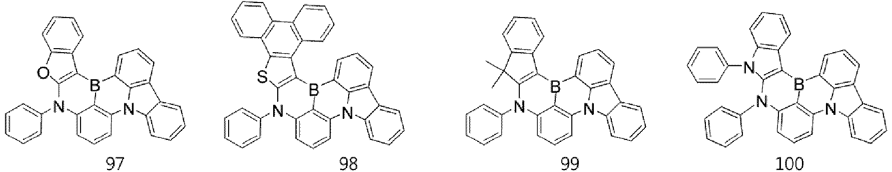

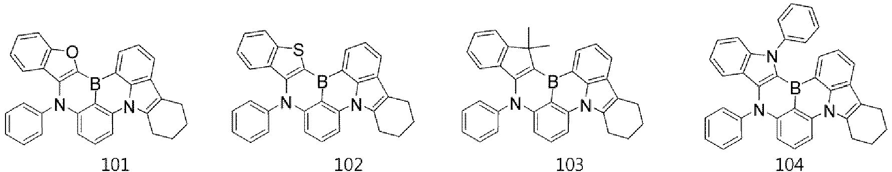

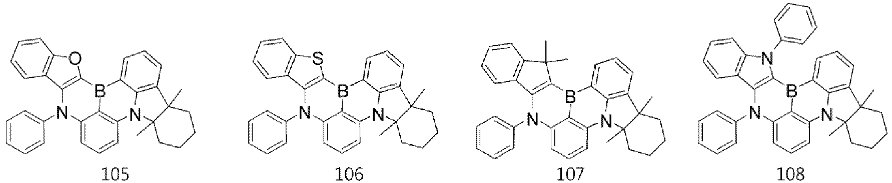

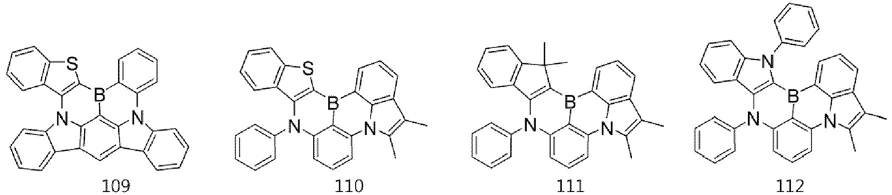

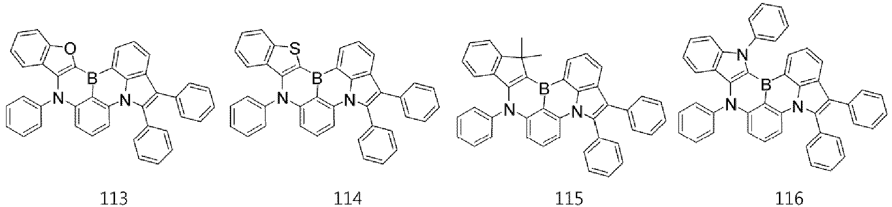

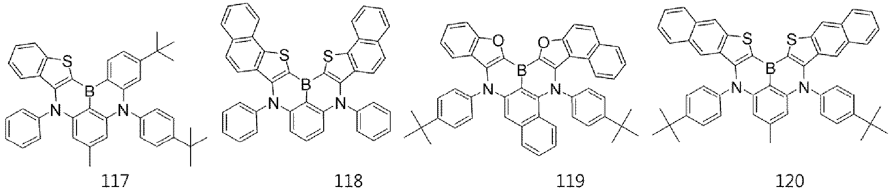

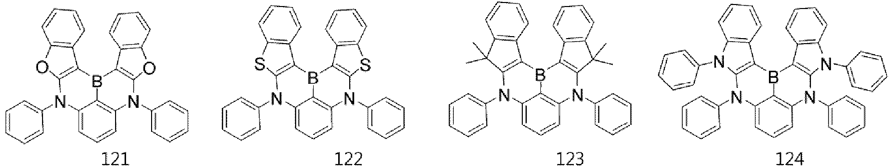

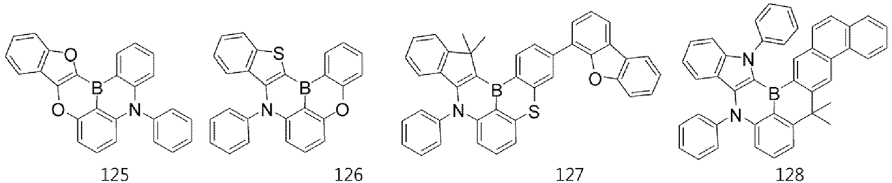

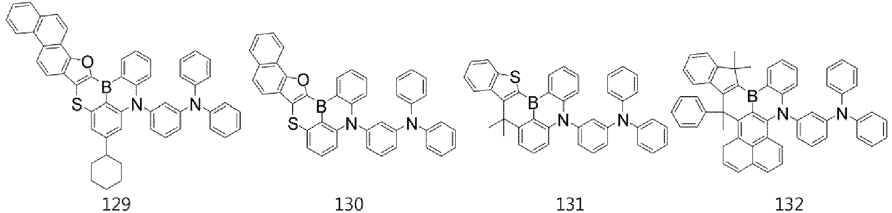

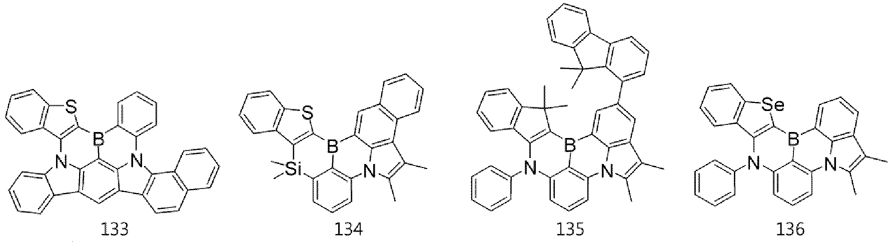

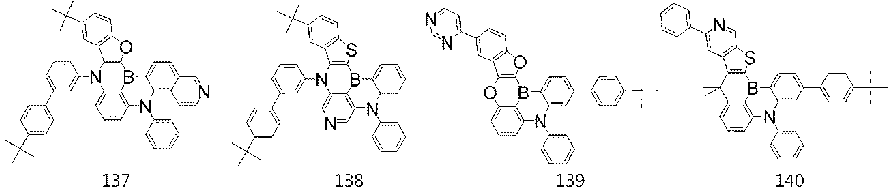

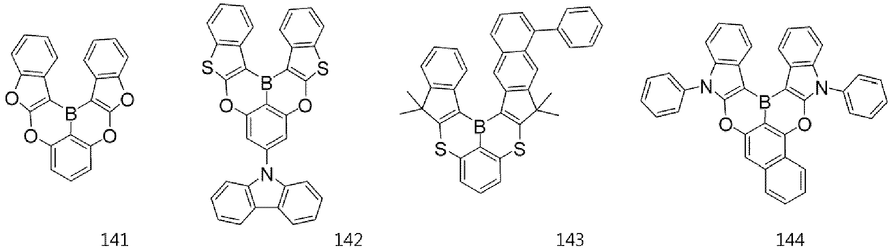

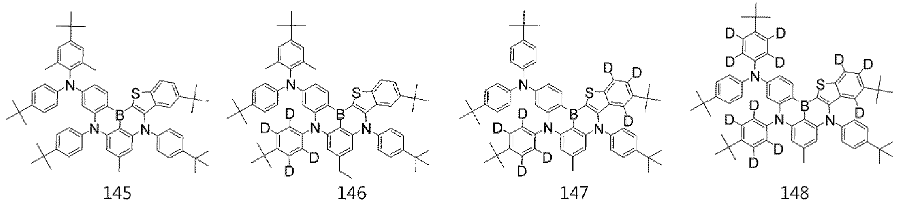

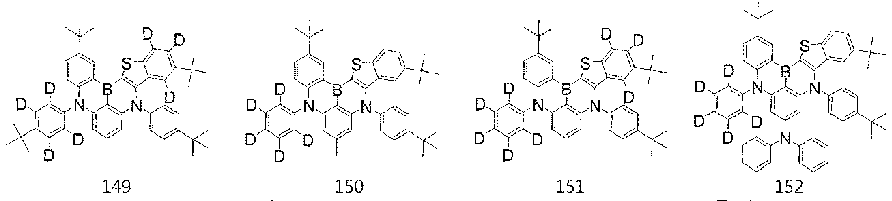

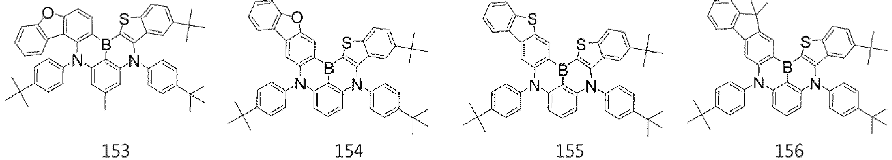

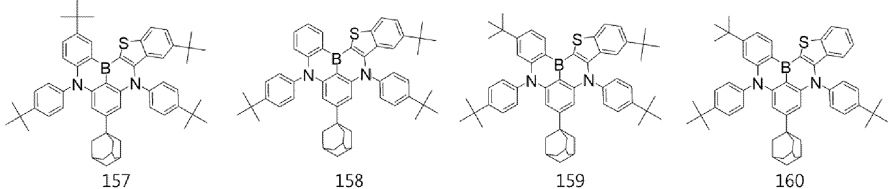

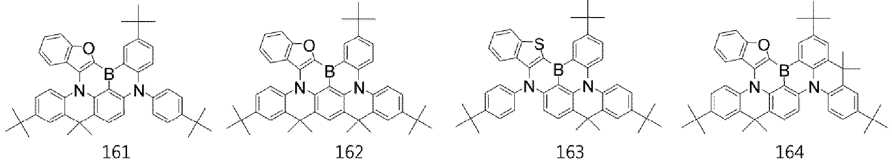

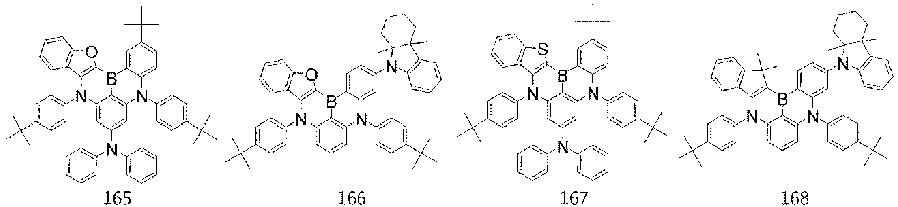

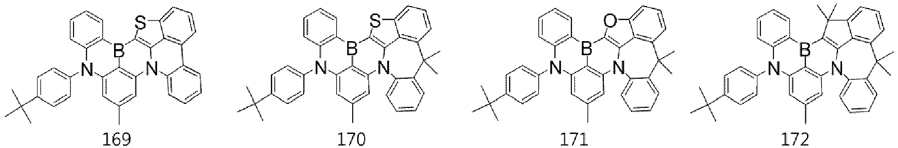

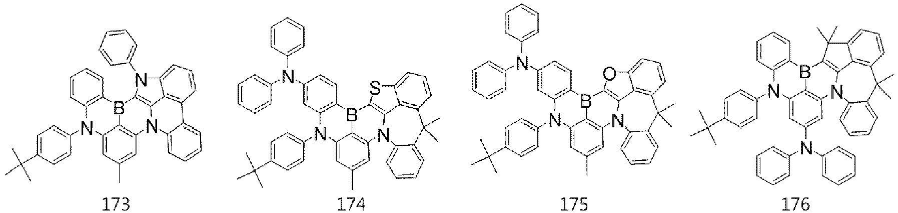

8. Das organische lichtemittierende Bauteil gemäß Anspruch 1, das zusätzlich zu der Lochinjektionsschicht, der Lochtransportschicht und der lichtemittierenden Schicht zwischen der ersten Elektrode und der zweiten Elektrode mindestens eine weitere Schicht umfasst, die ausgewählt ist aus der Gruppe bestehend aus einer Elektroneninjektionsschicht, einer Elektronentransportschicht, einer Elektronenblockierschicht, einer Lochblockierschicht und einer Lochhilfsschicht.

9. Das organische lichtemittierende Bauteil gemäß Anspruch 8, wobei mindestens eine der Schichten durch einen Abscheidungsprozess oder einen Lösungsprozess gebildet ist.

10. Das organische lichtemittierende Bauteil gemäß Anspruch 1, wobei das organische lichtemittierende Bauteil für ein Anzeigesystem oder Beleuchtungssystem verwendet wird, das aus Flachbildschirmen, flexiblen Anzeigesystemen, monochromatischen oder weißen Flachbildschirm-Beleuchtungssystemen, monochromatischen oder weißen flexiblen Beleuchtungssystemen, Fahrzeuganzeigesystemen und Anzeigesystemen für virtuelle oder erweiterte Realität ausgewählt ist.

## Revendications

1. Dispositif électroluminescent organique comprenant :
une première électrode ;
une deuxième électrode faisant face à la première électrode ; et
une couche d'injection de trous ou et une couche de transport de trous et une couche d'émission de lumière interposée entre la première électrode et la deuxième électrode,
(i) ladite couche d'injection de trous ou ladite couche de transport de trous comprenant au moins un composé représenté par les [formule A] ou [formule B] suivantes, et
(ii) ladite couche d'émission de lumière comprenant un composé représenté par les [formule C] ou [formule D] suivantes : 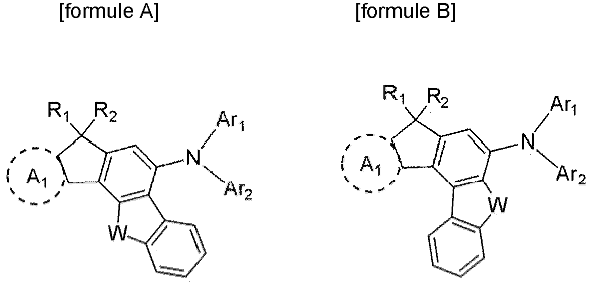
A₁ étant choisi dans un groupe aryle en C6-C30 substitué ou non substitué, et un groupe hétéroaryle en C2-C50 substitué ou non substitué,
W étant un atome d'oxygène (O) ou un atome de soufre (S),
R₁ and R₂ étant identiques ou différents l'un de l'autre, et étant choisis chacun indépendamment parmi hydrogène, deutérium, un groupe alkyle en C1-C30 substitué ou non substitué, un groupe cycloalkyle en C3-C30 substitué ou non substitué, un groupe aryle en C6-C50 substitué ou non substitué, et un groupe hétéroaryle en C2-C50 substitué ou non substitué, sous réserve que R₁ and R₂ sont optionnellement liés l'un à l'autre pour former un monocycle ou polycycle alicyclique ou aromatique,
Ar₁ and Ar₂ étant identiques ou différents l'un de l'autre, et étant choisis chacun indépendamment parmi un groupe aryle en C6-C50 substitué ou non substitué, et un groupe hétéroaryle en C2-C50 substitué ou non substitué, sous réserve qu'au moins un de Ar₁ et Ar₂ est représenté par la formule structurale 1 suivante :] 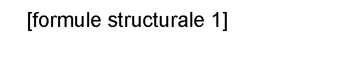 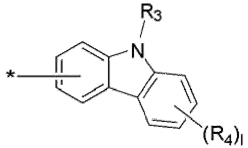
R₃ étant choisi parmi hydrogène, deutérium, un groupe alkyle en C1-C30 substitué ou non substitué, un groupe cycloalkyle en C3-C30 substitué ou non substitué, un groupe aryle en C6-C50 substitué ou non substitué, et un groupe hétéroaryle en C2-C50 substitué ou non substitué,
R₄ étant choisi parmi hydrogène, deutérium, un groupe cyano, un groupe halogène, un groupe hydroxyle, un groupe nitro, un groupe alkyle en C1-C24, un groupe alkyle halogéné en C1-C24, un groupe cycloalkyle en C1-C24, un groupe alcényle en C1-C24, un groupe alcynyle en C1-C24, un groupe hétéroalkyle en C1-C24, un groupe aryle en C6-C30, un groupe arylalkyle en C6-C30, un groupe hétéroaryle en C2-C30, un groupe hétéroarylalkyle en C2-C30, un groupe alkoxy en C1-C24, un groupe alkylamino en C1-C24, un groupe arylamino en C6-C30, un groupe hétéroarylamino en C2-C30, un groupe alkylsilyle en C1-C24, un groupe arylsilyle en C6-C30, et un groupe aryloxy en C6-C30,
I étant un entier de 0 à 4, pourvu que, lorsque I est égal ou supérieur à 2, les R₄'s sont identiques ou différents l'un de l'autre, et
"-*" désigne un site lié à un atome d'azote dans les positions Ar₁ et Ar₂ dans [formule A] ou [formule B], 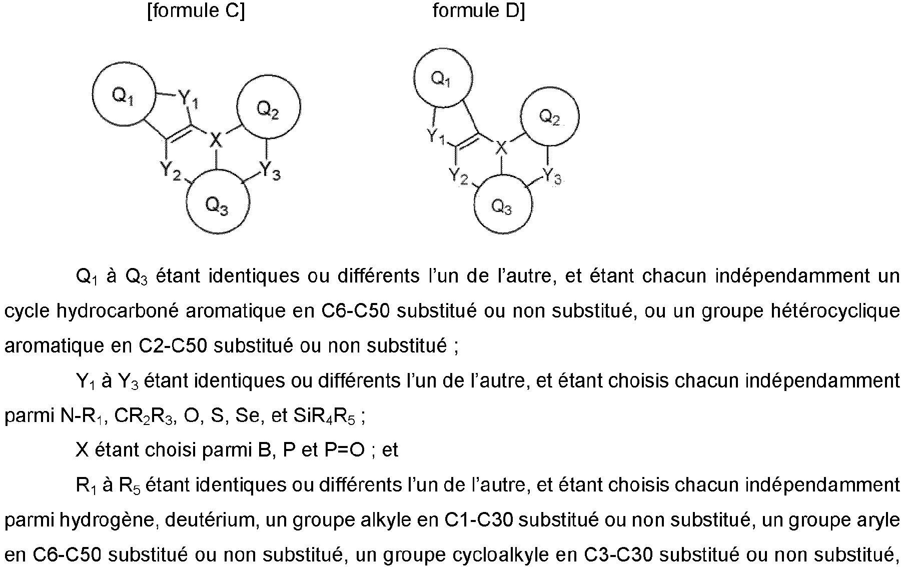
un groupe hétéroaryle en C2-C50 substitué ou non substitué, un groupe alkoxy en C1-C30 substitué ou non substitué, un groupe aryloxy en C6-C30 substitué ou non substitué, un groupe alkylthioxy en C1-C30 substitué ou non substitué, un groupe arylthioxy en C5-C30 substitué ou non substitué, un groupe alkylamine en C1-C30 substitué ou non substitué, un groupe arylamine en C5-C30 substitué ou non substitué, un groupe alkylsilyle en C1-C30 substitué ou non substitué, un groupe arylsilyle en C5-C30 substitué ou non substitué, un groupe nitro, un groupe cyano, et un groupe halogène, sous réserve que chacun des R₁ à R₅ est optionnellement lié au cycle Q₁ à Q₃ pour former en outre un monocycle ou polycycle alicyclique ou aromatique, et R₂ et R₃, et R₄ et R₅ sont optionnellement liés l'un à l'autre pour former en outre un monocycle ou polycycle alicyclique ou aromatique.

2. Dispositif électroluminescent organique selon la revendication 1, dans lequel [formule C] ou [formule D] est représentée par les [formule C-1] ou [formule D-1] suivantes : 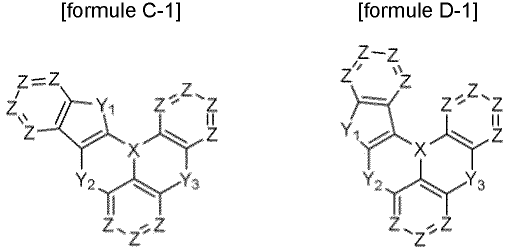
Z étant CR ou N, sous réserve que les Z's sont identiques ou différents l'un de l'autre et les R's sont identiques ou différents l'un de l'autre,
les R's étant choisis chacun indépendamment parmi hydrogène, deutérium, un groupe alkyle en C1-C30 substitué ou non substitué, un groupe aryle en C6-C50 substitué ou non substitué, un groupe cycloalkyle en C3-C30 substitué ou non substitué, un groupe hétéroaryle en C2-C50 substitué ou non substitué, un groupe alkoxy en C1-C30 substitué ou non substitué, un groupe aryloxy en C6-C30 substitué ou non substitué, un groupe alkylthioxy en C1-C30 substitué ou non substitué, un groupe arylthioxy en C5-C30 substitué ou non substitué, un groupe alkylamine en C1-C30 substitué ou non substitué, un groupe arylamine en C5-C30 substitué ou non substitué, un groupe alkylsilyle en C1-C30 substitué ou non substitué, un groupe arylsilyle en C5-C30 substitué ou non substitué, un groupe nitro, un groupe cyano, un groupe halogène et -N(R₆)(R₇), et
les R's étant optionnellement liés l'un à l'autre ou chacun de ceux-ci étant optionnellement lié à un substituent adjacent pour former au moins un monocycle ou polycycle alicyclique ou aromatique, et l'atome de carbone du monocycle ou polycycle alicyclique ou aromatique formé étant substitué par au moins un hétéroatome choisi parmi (N), un atome de soufre (S), et un atome d'oxygène (O),
R₆ et R₇ étant identiques ou différents l'un de l'autre et étant choisis chacun indépendamment parmi hydrogène, deutérium, un groupe alkyle en C1-C30 substitué ou non substitué, un groupe aryle en C6-C50 substitué ou non substitué, un groupe cycloalkyle en C3-C30 substitué ou non substitué, un groupe hétéroaryle en C2-C50 substitué ou non substitué, sous réserve que R₆ et R₇ sont optionnellement liés l'un à l'autre pour former un monocycle ou polycycle alicyclique ou aromatique, et
X et Y₁ à Y₃ étant tel que définis dans [formule C] et [formule D] ci-dessus.

3. Dispositif électroluminescent organique selon la revendication 1, dans lequel [formule C] ou [formule D] est représenté par l'un quelconque des [formule C-2], [formule C-3] et [formule D-2] suivantes : 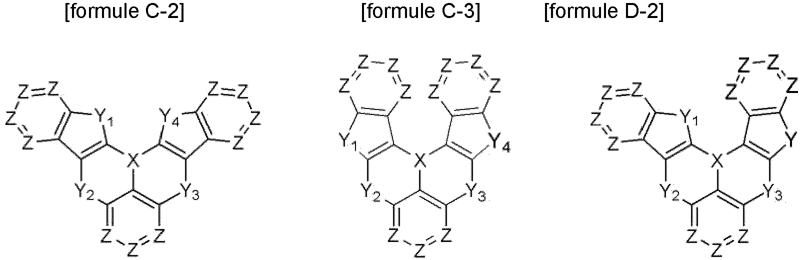
Z étant CR ou N, sous réserve que les Z's sont identiques ou différents l'un de l'autre et les R's sont identiques ou différents l'un de l'autre,
les R's étant choisis chacun indépendamment parmi hydrogène, deutérium, un groupe alkyle en C1-C30 substitué ou non substitué, un groupe aryle en C6-C50 substitué ou non substitué, un groupe cycloalkyle en C3-C30 substitué ou non substitué, un groupe hétéroaryle en C2-C50 substitué ou non substitué, un groupe alkoxy en C1-C30 substitué ou non substitué, un groupe aryloxy en C6-C30 substitué ou non substitué, un groupe alkylthioxy en C1-C30 substitué ou non substitué, un groupe arylthioxy en C5-C30 substitué ou non substitué, un groupe alkylamine en C1-C30 substitué ou non substitué, un groupe arylamine en C5-C30 substitué ou non substitué, un groupe alkylsilyle en C1-C30 substitué ou non substitué, un groupe arylsilyle en C5-C30 substitué ou non substitué, un groupe nitro, un groupe cyano, un groupe halogène et -N(R₆)(R₇), et
les R's étant optionnellement liés l'un à l'autre ou chacun de ceux-ci étant optionnellement lié à un substituent adjacent pour former au moins un monocycle ou polycycle alicyclique ou aromatique, et l'atome de carbone du monocycle ou polycycle alicyclique ou aromatique formé étant substitué par au moins un hétéroatome choisi parmi (N), un atome de soufre (S), et un atome d'oxygène (O),
R₆ et R₇ étant identiques ou différents l'un de l'autre et étant choisis chacun indépendamment parmi hydrogène, deutérium, un groupe alkyle en C1-C30 substitué ou non substitué, un groupe aryle en C6-C50 substitué ou non substitué, un groupe cycloalkyle en C3-C30 substitué ou non substitué, un groupe hétéroaryle en C2-C50 substitué ou non substitué, sous réserve que R₆ et R₇ sont optionnellement liés l'un à l'autre pour former un monocycle ou polycycle alicyclique ou aromatique, et
X et Y₁ à Y₄ étant tel que définis dans X et Y₁ à Y₃ [formule C] et [formule D] ci-dessus.

4. Dispositif électroluminescent organique selon la revendication 2, dans lequel au moins un des R's est -N(R₆)(R₇).

5. Dispositif électroluminescent organique selon la revendication 3, dans lequel au moins un des R's est -N(R₆)(R₇).

6. Dispositif électroluminescent organique selon la revendication 1, dans lequel le composé représenté par [formule A] ou [formule B] est choisi parmi les composés représentés par les formules suivantes.

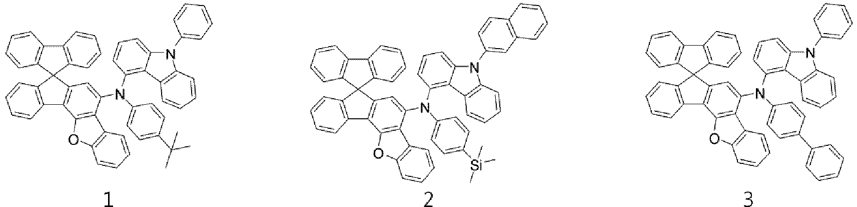

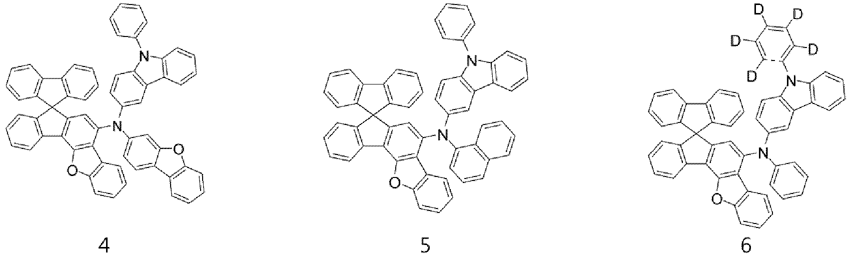

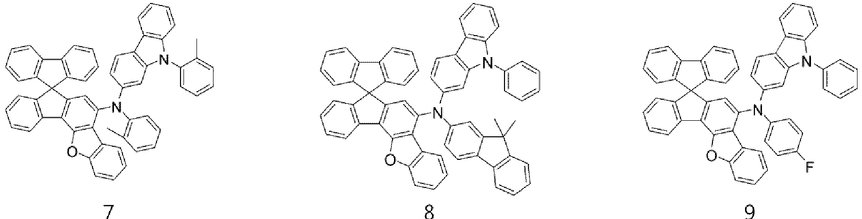

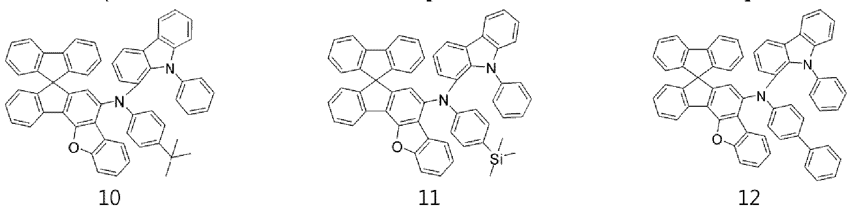

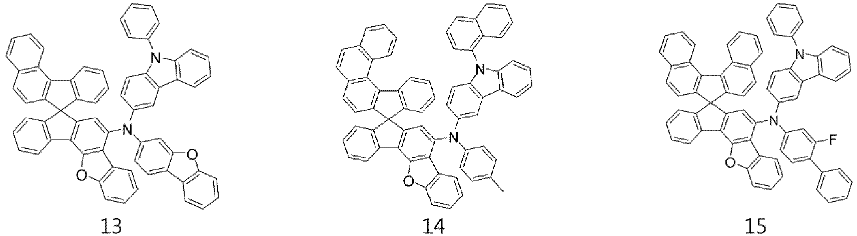

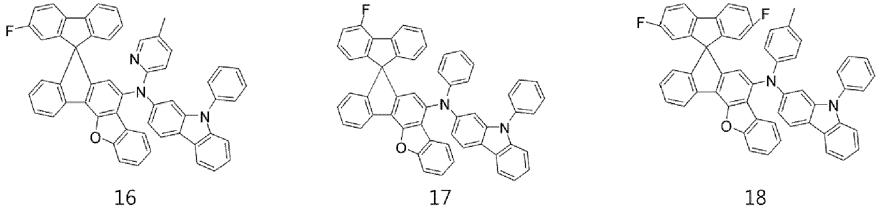

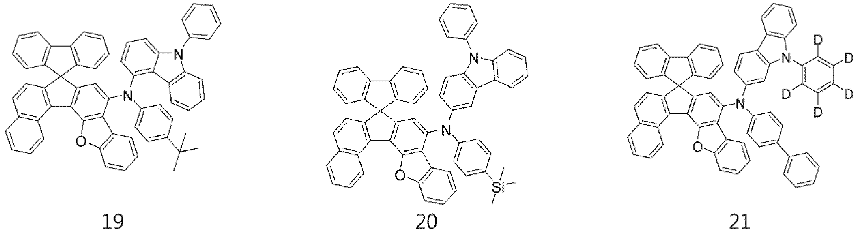

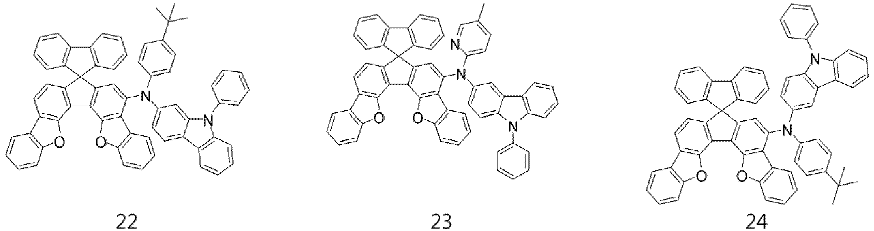

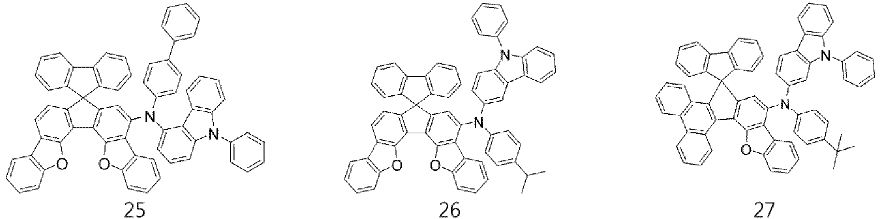

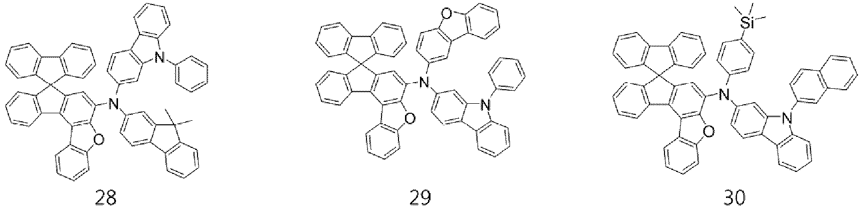

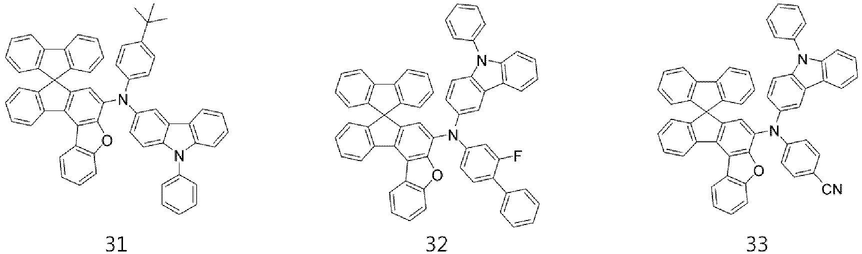

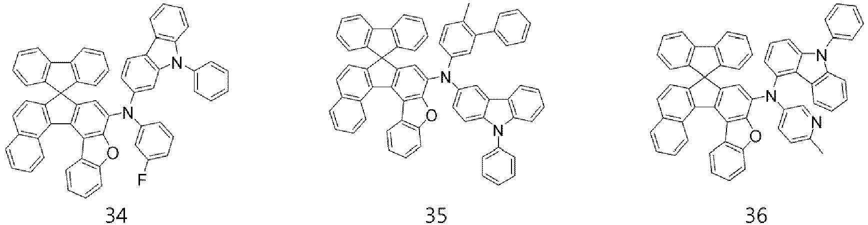

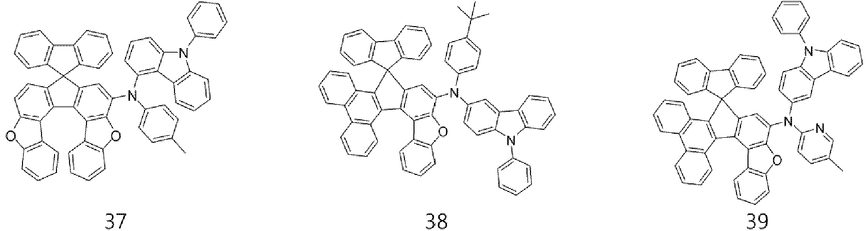

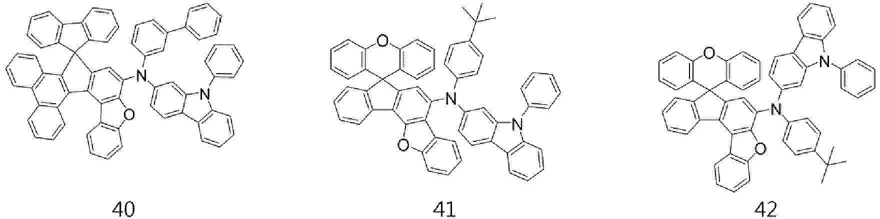

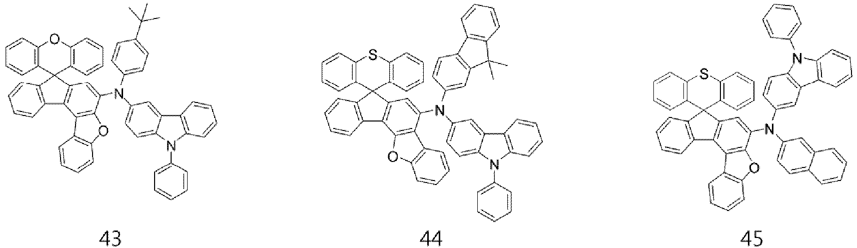

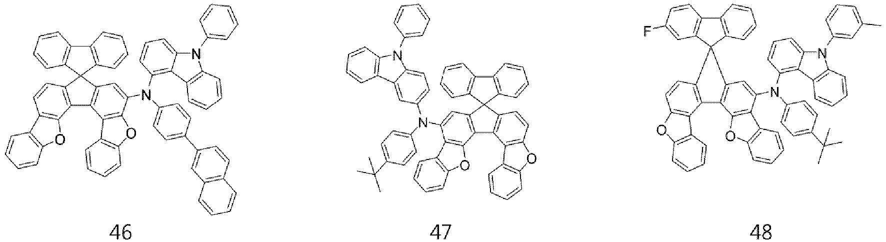

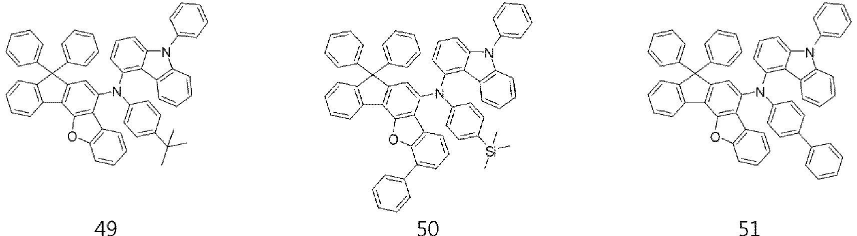

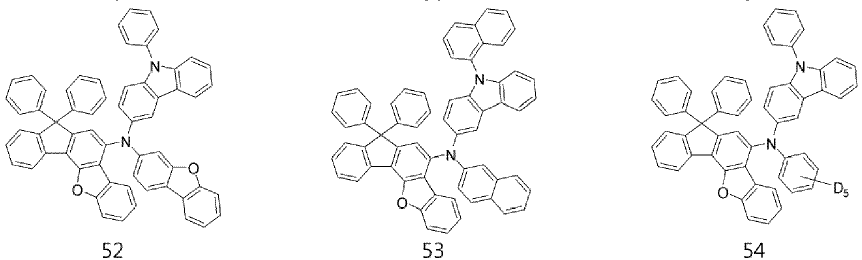

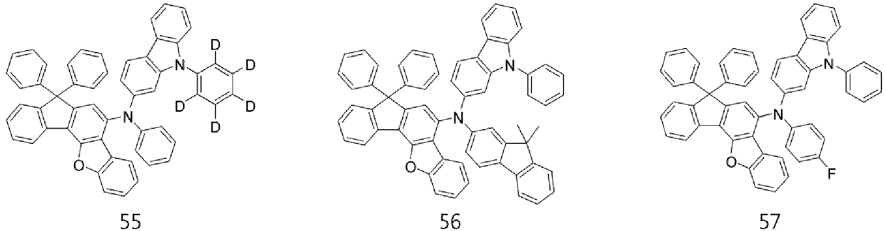

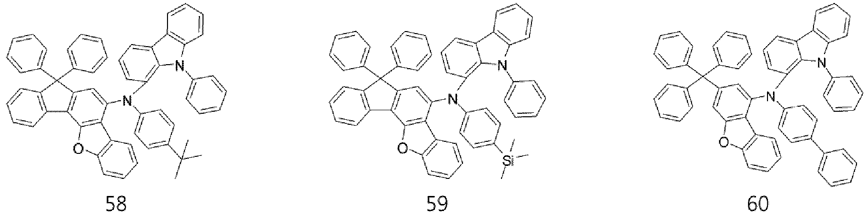

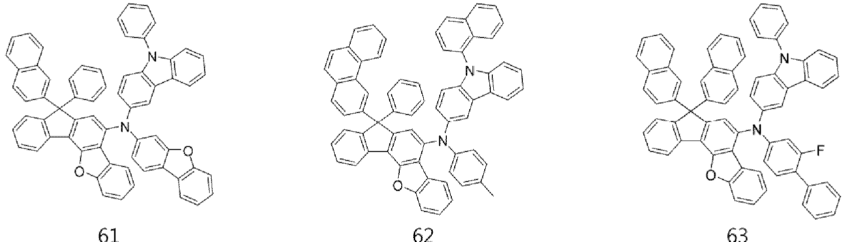

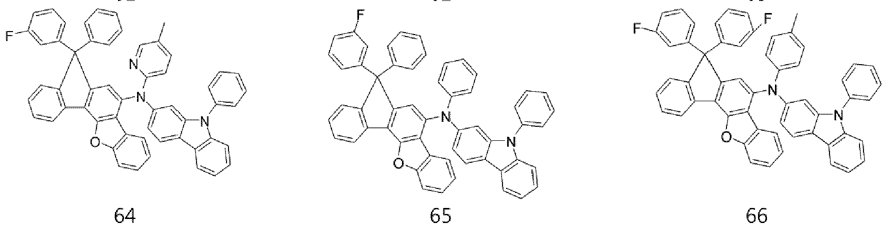

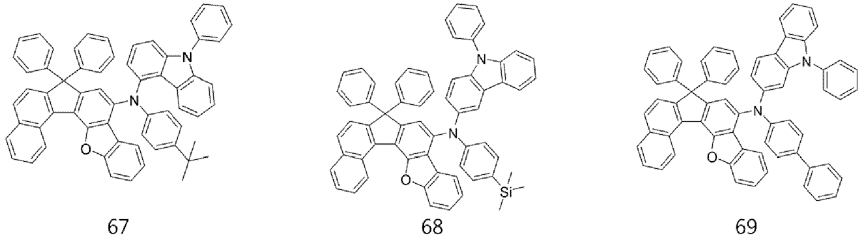

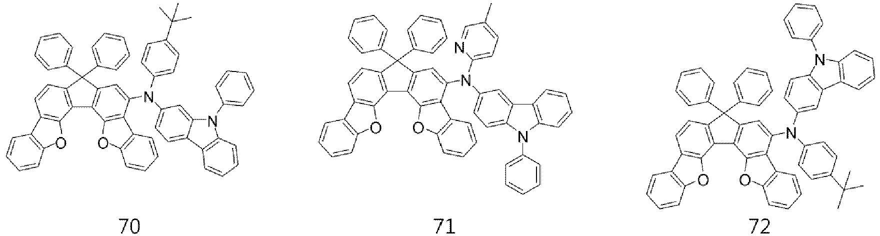

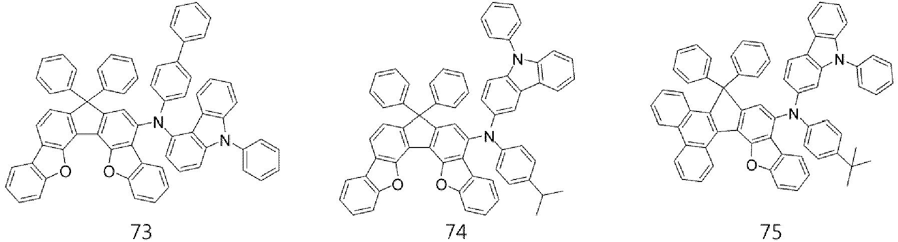

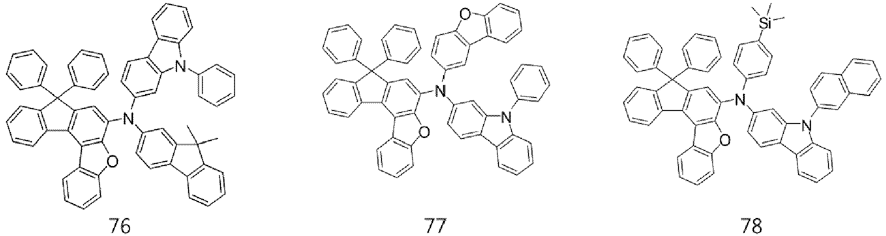

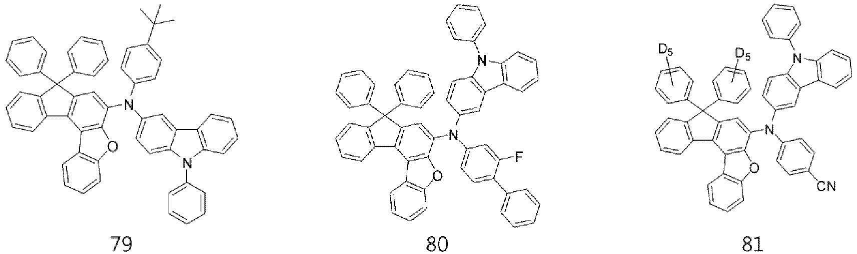

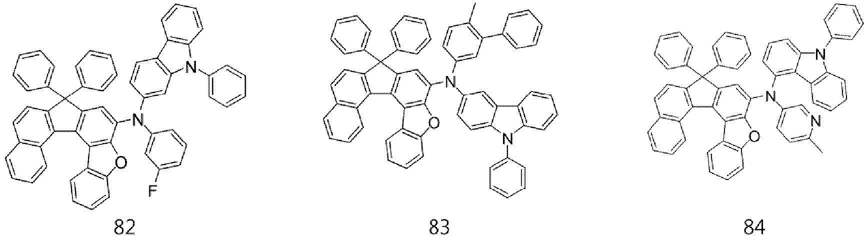

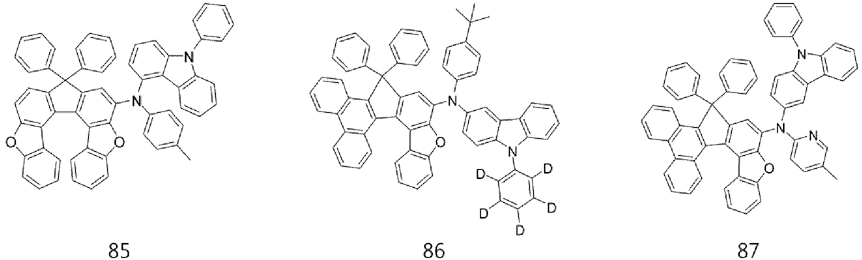

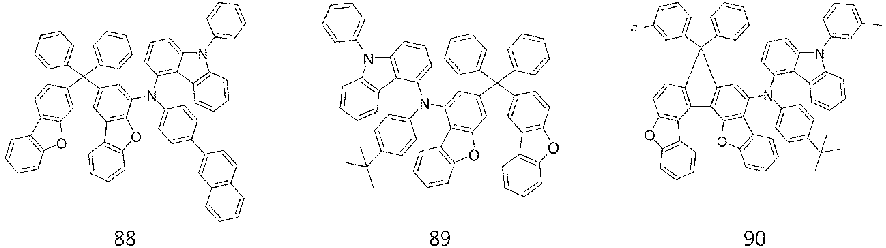

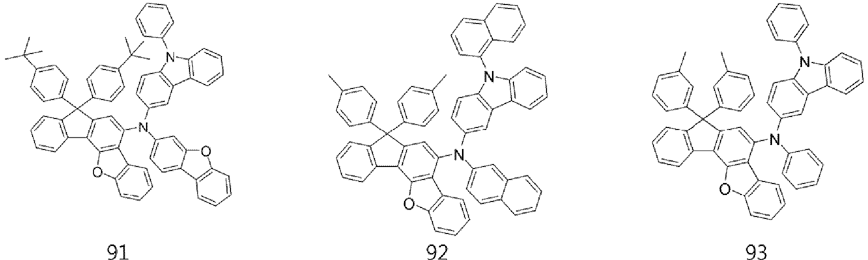

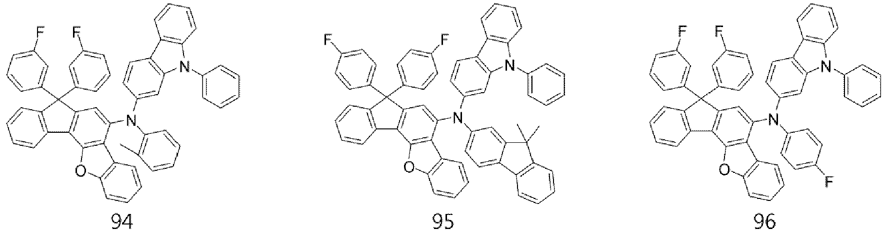

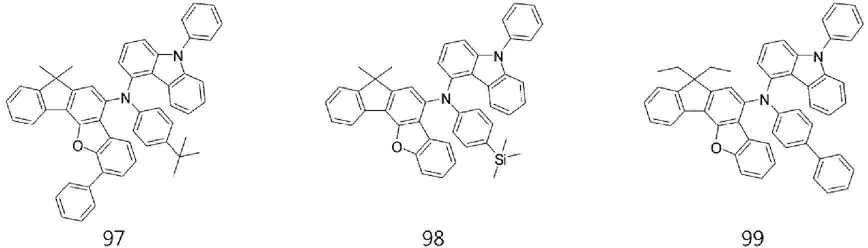

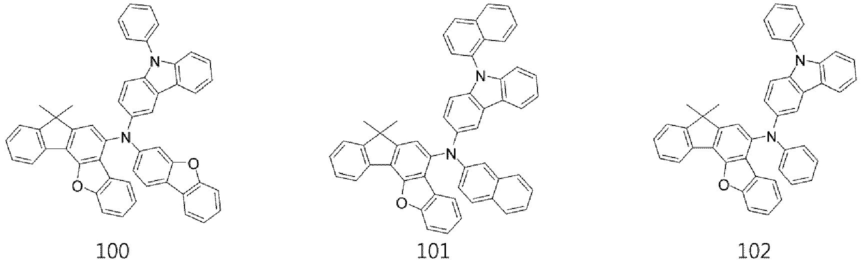

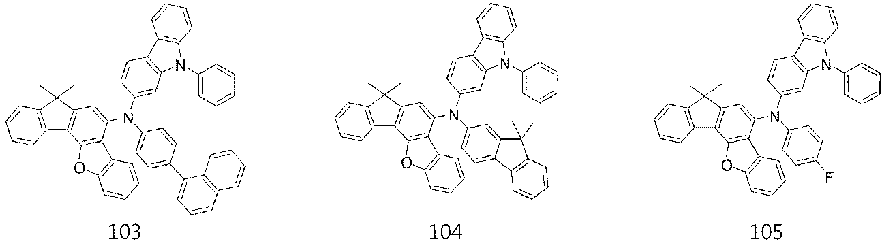

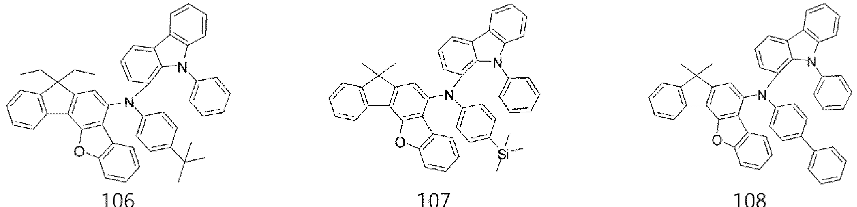

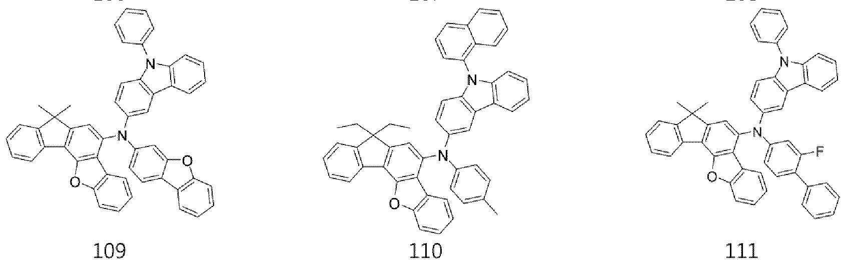

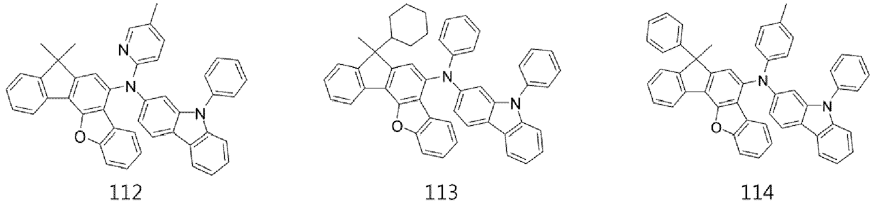

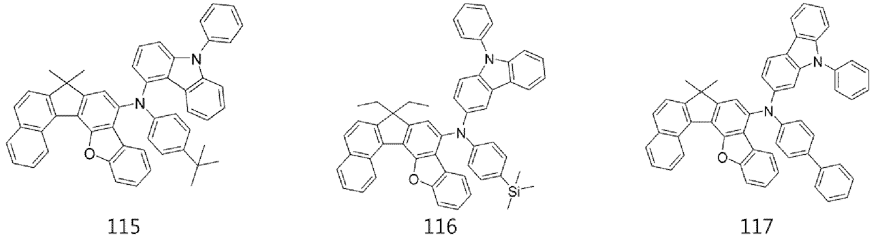

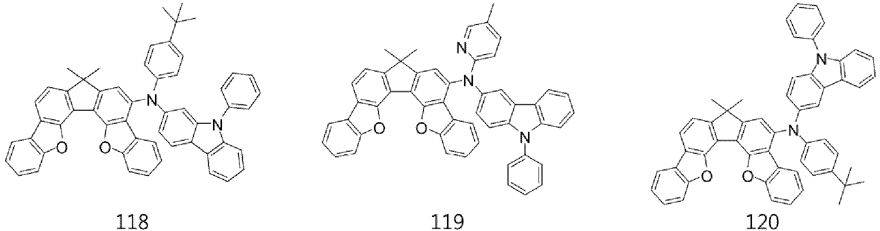

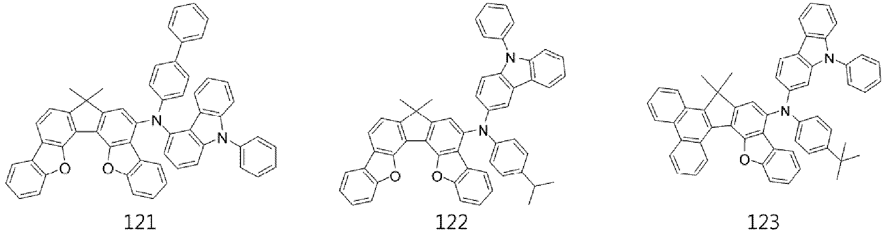

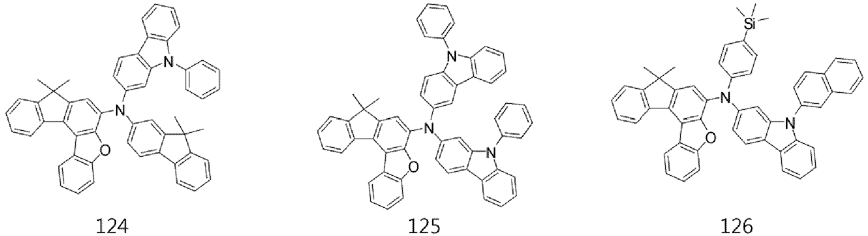

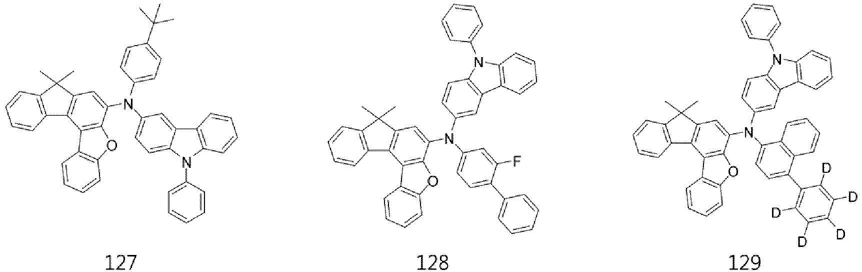

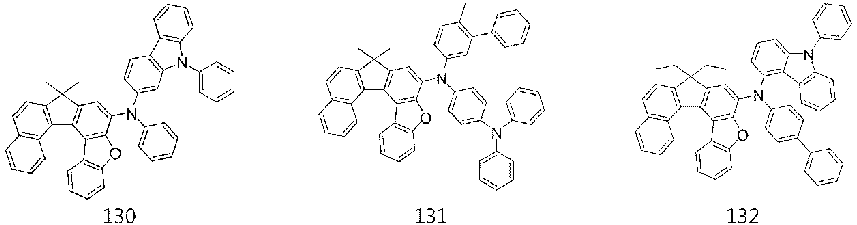

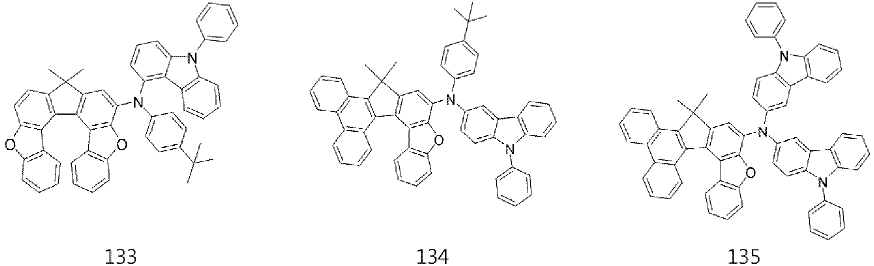

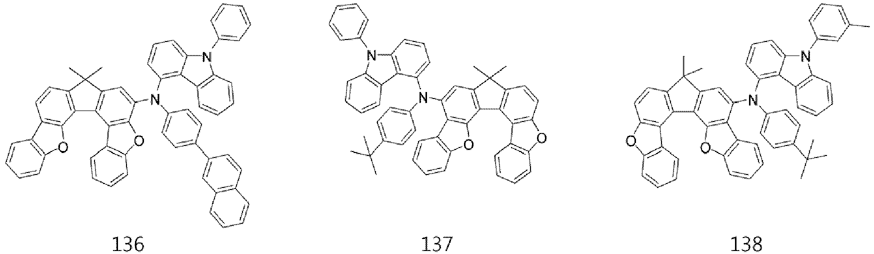

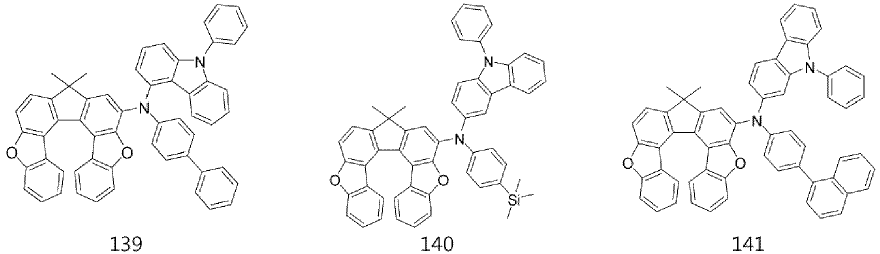

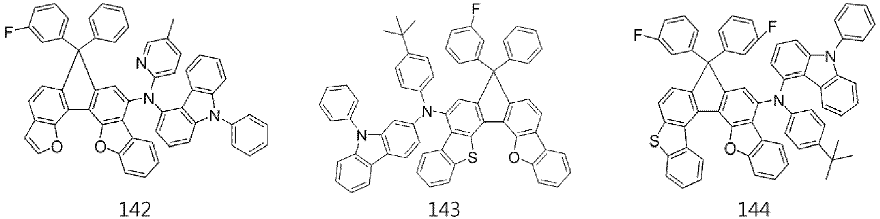

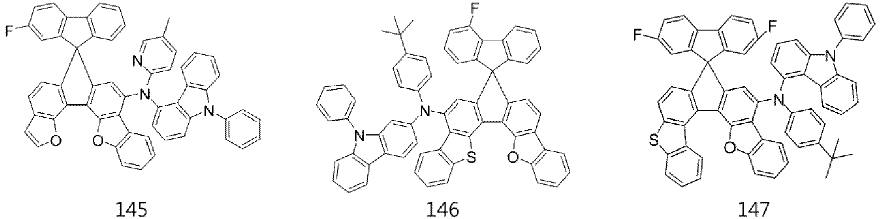

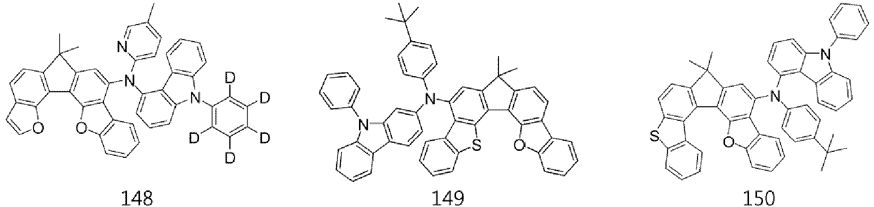

7. Dispositif électroluminescent organique selon la revendication 1, dans lequel le composé représenté par [formule C] ou [formule D] est choisi parmi les composés représentés par les formules suivantes.

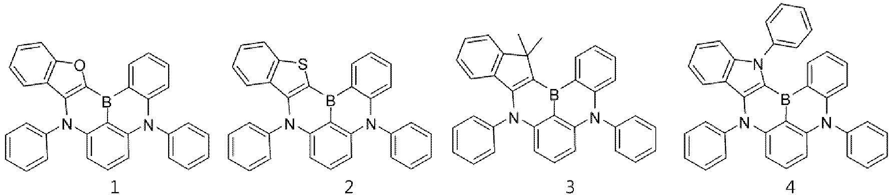

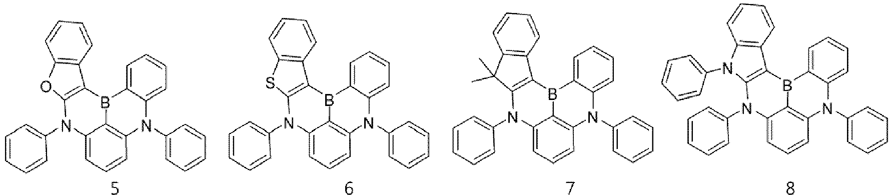

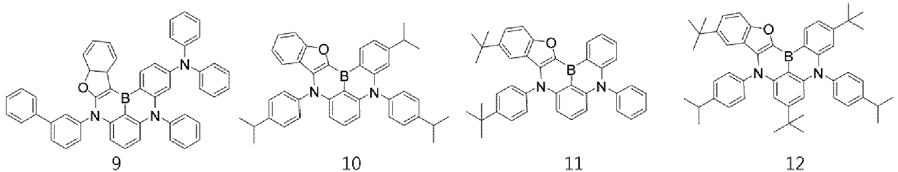

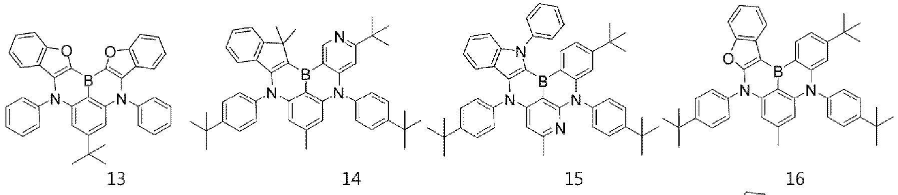

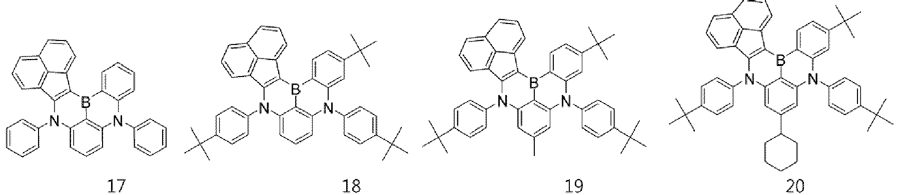

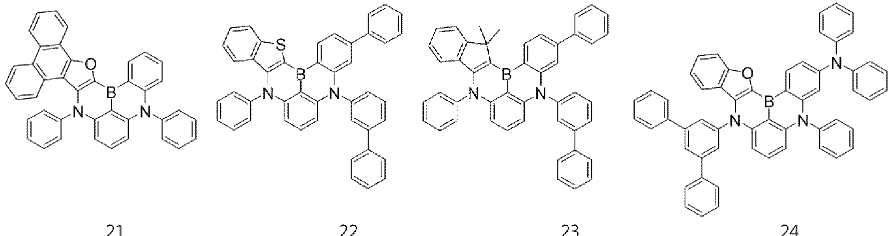

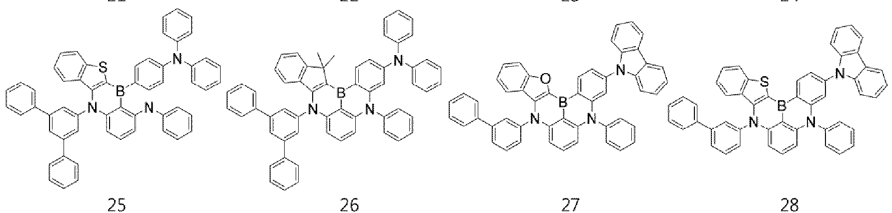

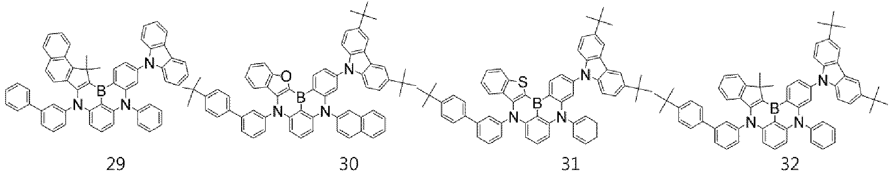

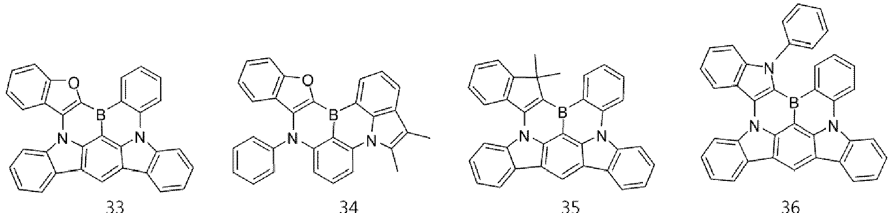

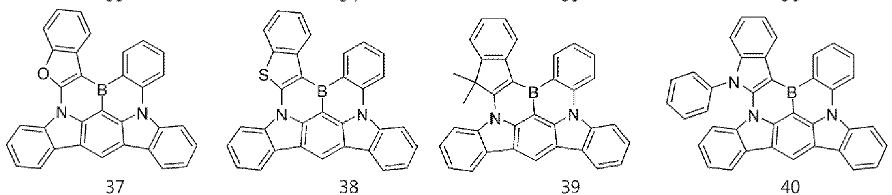

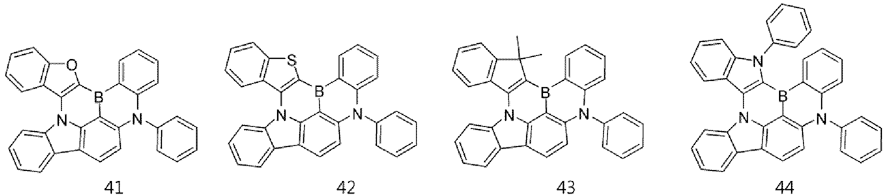

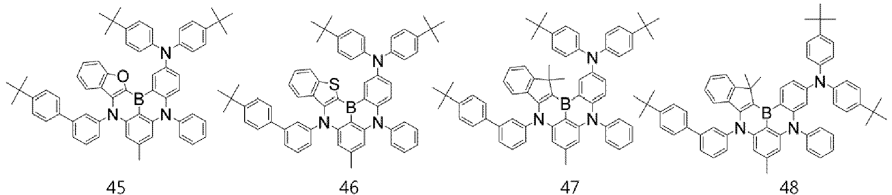

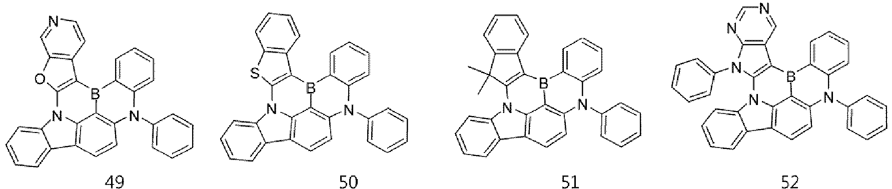

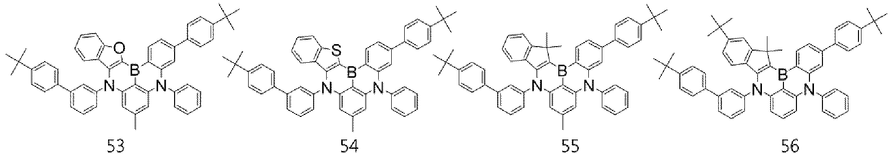

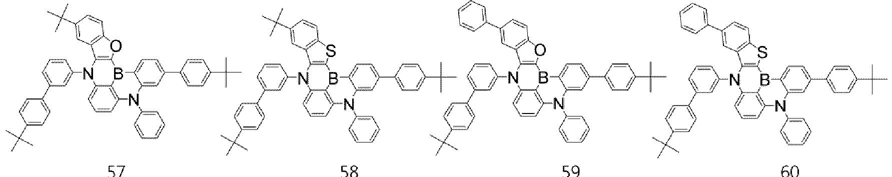

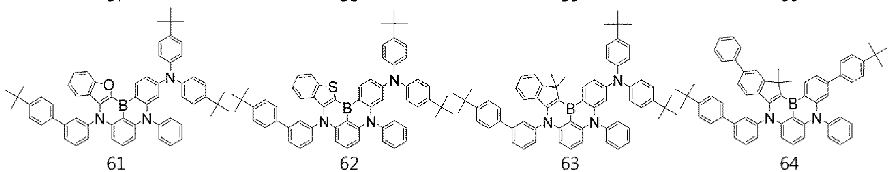

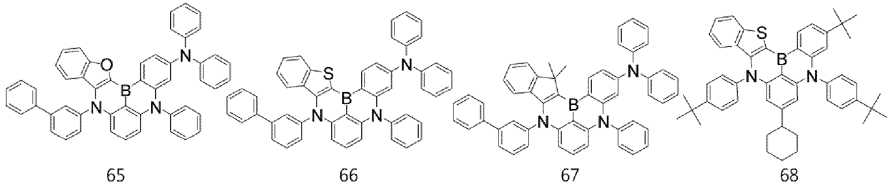

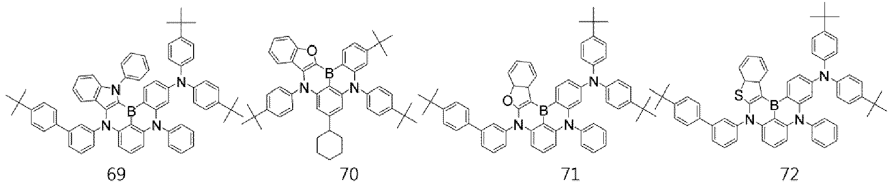

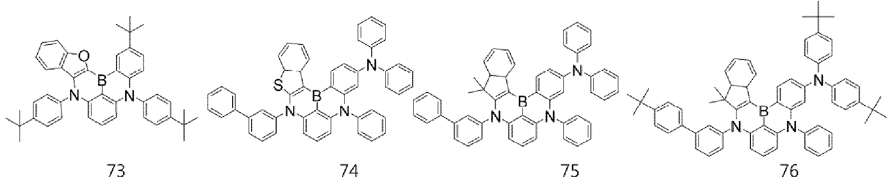

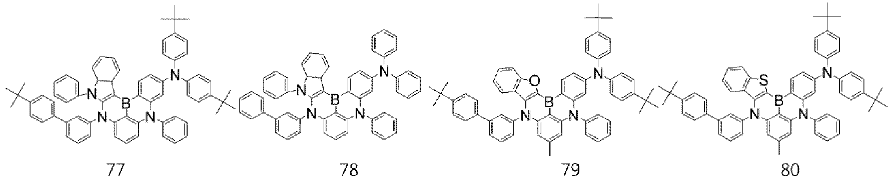

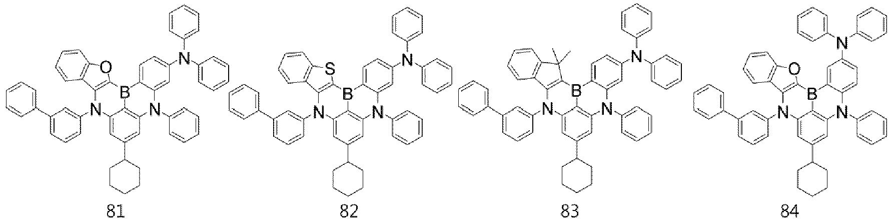

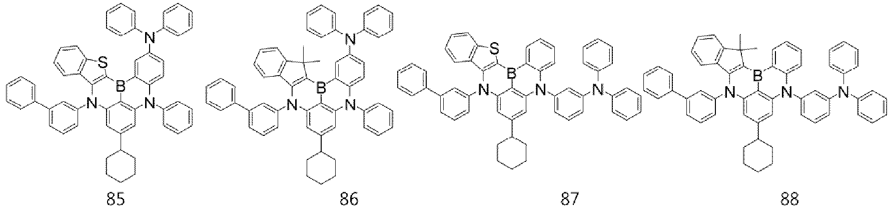

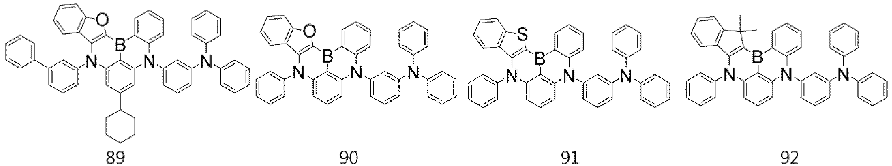

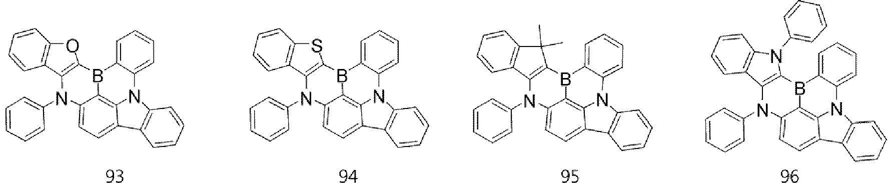

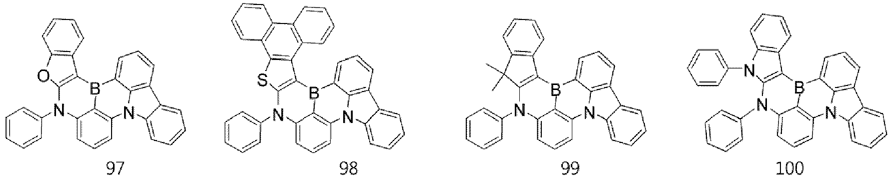

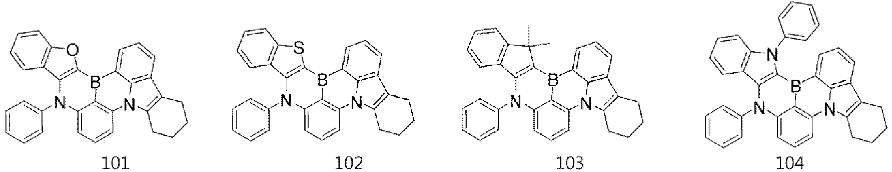

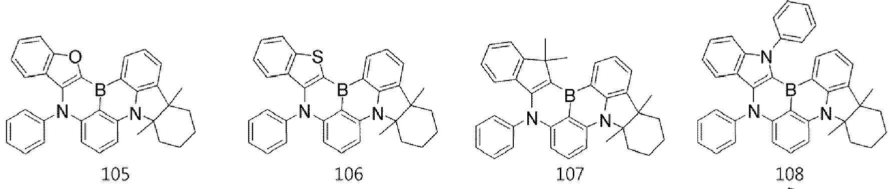

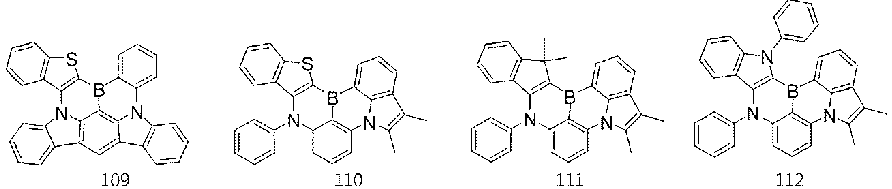

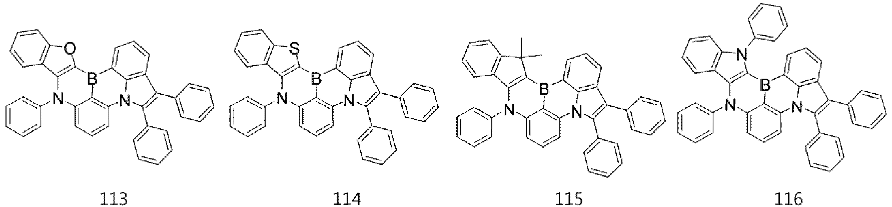

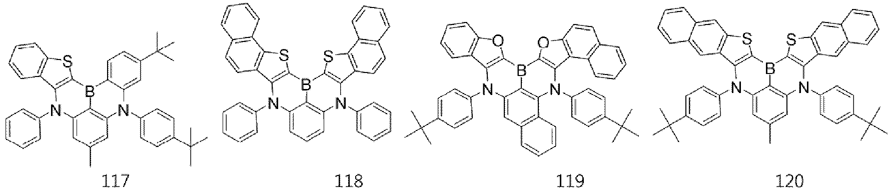

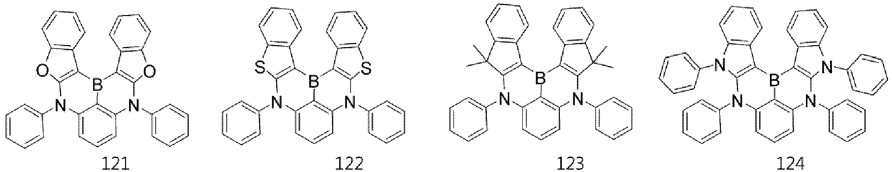

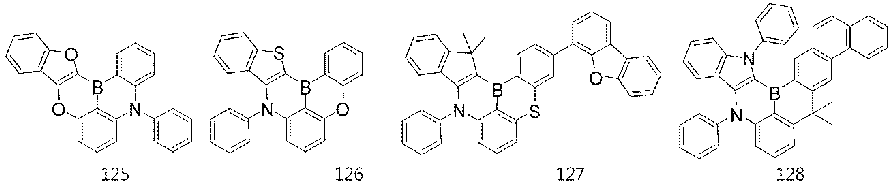

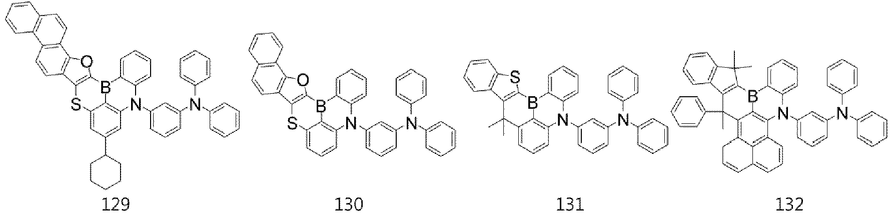

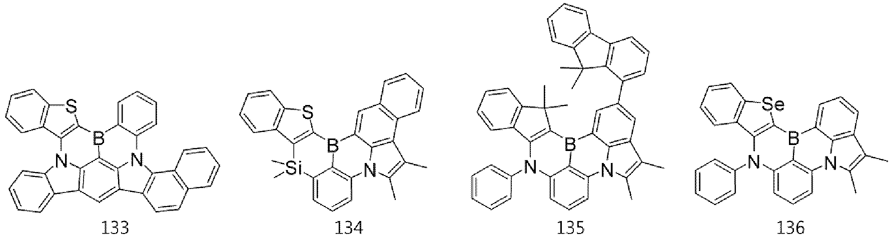

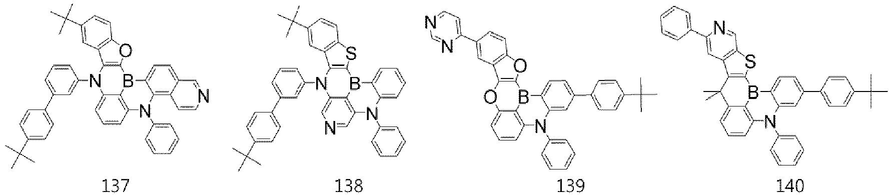

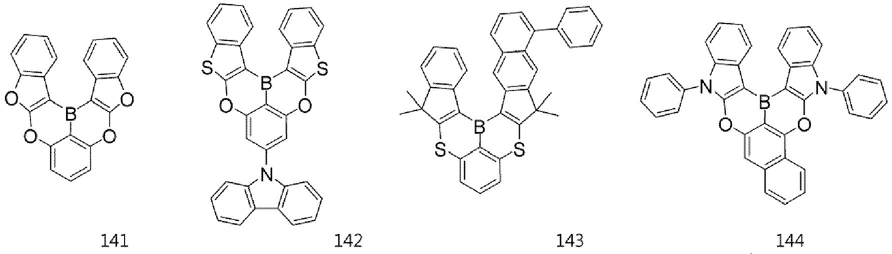

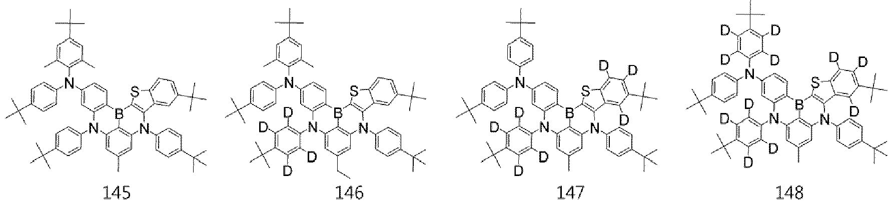

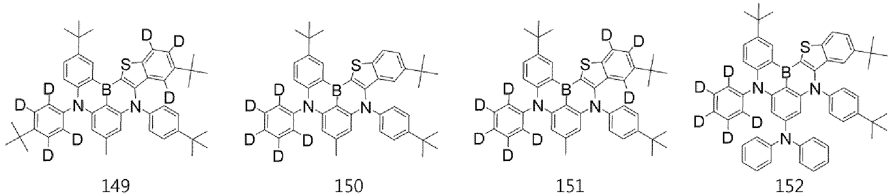

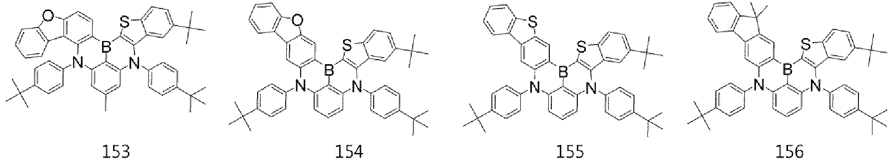

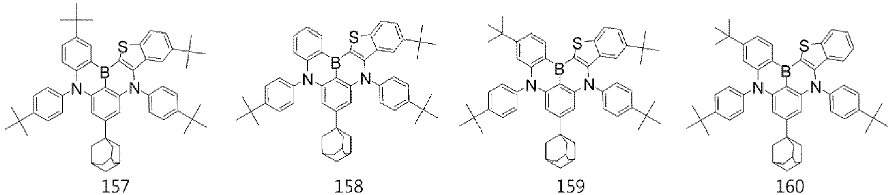

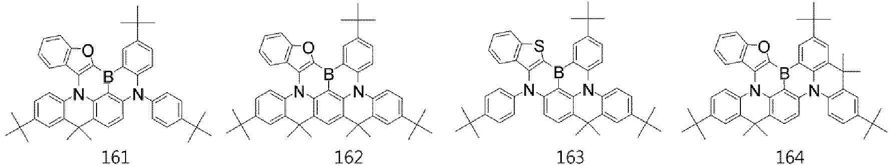

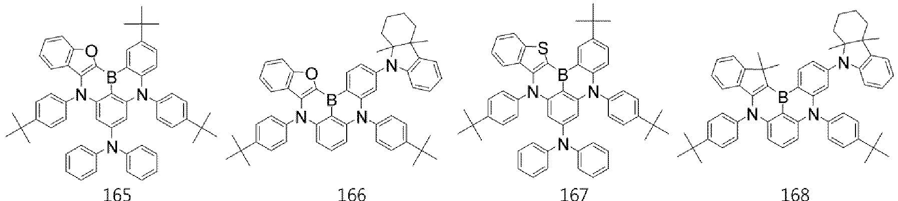

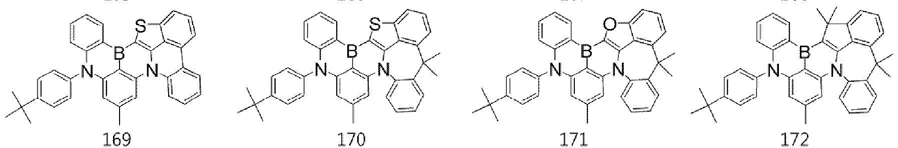

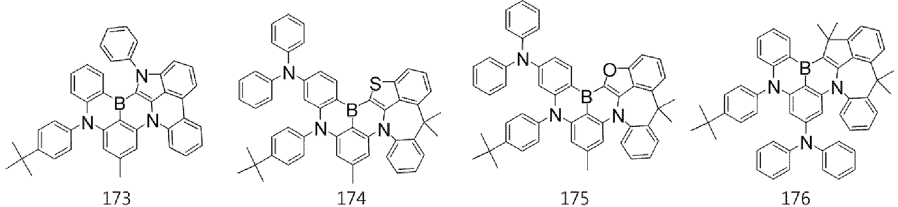

8. Dispositif électroluminescent organique selon la revendication 1, comprenant en outre au moins une couche choisie parmi une couche d'injection d'électrons, une couche de transport d'électrons, une couche de blocage d'électrons, une couche de blocage de trous et une couche auxiliaire de trous, outre la couche d'injection de trous, la couche de transport de trous et la couche d'émission de lumière, entre la première électrode et la deuxième électrode.

9. Dispositif électroluminescent organique selon la revendication 8, dans lequel au moins une couche choisie parmi les couches est formée par un processus de déposition ou un processus de solution.

10. Dispositif électroluminescent organique selon la revendication 1, ledit dispositif électroluminescent organique étant utilisé pour un système d'affichage ou d'éclairage choisi parmi des écrans plats, des écrans flexibles, des systèmes d'éclairage blanc à panneau plat, des systèmes flexibles d'éclairage monochromatique ou blanc, des écrans pour véhicules, et des écrans pour la réalité virtuelle ou augmentée.
